# EUROPEAN PATENT APPLICATION

(11) **EP 4 624 477 A1**
(43) Date of publication of application: **01.10.2025**
(21) Application number: 23902845.9
(22) Date of filing: 15.12.2023
(51) Int. Cl.: C07F 5/02, C09K 11/06

(54) **BORON-CONTAINING RESONANCE-TYPE ORGANIC COMPOUND AND ORGANIC ELECTROLUMINESCENT DEVICE COMPRISING SAME**

(30) Priority: 15.12.2022 CN 202211624214
(71) Applicant: Huawei Technologies Co., Ltd., Shenzhen, Guangdong 518129 (CN); Jiangsu Sunera Technology Co., Ltd, Wuxi, Jiangsu 214112 (CN)
(72) Inventor: ZHAN, Ge, Shenzhen, Guangdong 518129 (CN); ZHANG, Han, Shenzhen, Guangdong 518129 (CN); WU, Jiang, Shenzhen, Guangdong 518129 (CN); YANG, Minlang, Shenzhen, Guangdong 518129 (CN); LI, Chong, Wuxi, Jiangsu 214112 (CN); CAO, Xudong, Wuxi, Jiangsu 214112 (CN); LIANG, Xiao, Wuxi, Jiangsu 214112 (CN)
(74) Representative: Körber, Martin Hans
(86) International application number: PCT/CN2023/139297
(87) International publication number: WO 2024/125653

(57) **Abstract**

The present invention relates to a boron-containing resonance organic compound and an organic electroluminescent device including same, and belongs to the field of semiconductor technologies. A structure of the compound provided in the present invention is shown in general formula (1). When being used as a doping material in a light-emitting layer material of the organic electroluminescent device, the compound in the present invention can be used as a green light doping material of a light-emitting layer for the organic electroluminescent device, thereby improving a lifetime of the device.

## Description

### TECHNICAL FIELD

The present invention relates to the field of semiconductor technologies, and in particular, to a boron-containing resonance organic compound and an organic electroluminescent device including same.

### BACKGROUND

Compared with a liquid crystal display (LCD), an organic light-emitting diode (OLED) is lighter and thinner, and has high color contrast, low power consumption, fast response, high definition, flexibility, and other technical advantages, and is therefore expected to dominate future display terminal products. With the advent of the 5G era, the new information display industry is in urgent need of iterative development. Early low color gamut standards (BT.709 and DCIP3) can no longer meet requirements for development of technologies of high-quality display products. To meet performance requirements of ultra-high definition and higher image quality of display products, a next-generation display standard (BT.2020) drives OLED light-emitting materials to develop toward high color purity. This requires core light-emitting materials to have narrower emission spectra. At present, in commercialized OLED red, green, and blue color rendering technologies, a conventional fluorescent triplet-triplet conversion (TTF) technique is used for blue light. This technique offers low efficiency but high color purity, and has already largely met the BT.2020 display standard. A phosphorescence technique is used for green and red light. This technique offers high efficiency, and has approached the BT.2020 display standard for red light, but differs greatly from the high-definition display requirement for green light limited by a wide phosphorescence spectrum. Therefore, it is very critical to develop a green light OLED material with high color purity.

Since 2020, green light materials with a narrow full width at half maximum (full width at half maximum < 30 nm) based on a boron-nitrogen resonance structure have been successively reported: DOI:10.1002/adom.201902142, DOI:10.1002/anie.202008264, DOI:10.1021/jacs.0c10081, DOI:10.1038/s41467-022-32607-3, DOI:10.1002/anie.202202380, and the like, indicating that these materials have extremely high color purity and efficiency, and therefore have become a trend for the development of a green light OLED with high color purity. However, there are still many technical difficulties in the development of green light materials with ultra-high color purity containing a boron-nitrogen structure, and existing materials also have disadvantages: efficiency and a lifetime cannot meet requirements for mass production. The development of a green light material with a narrow full width at half maximum that is based on a boron-nitrogen resonance structure and that can meet actual application requirements is a key technical point for a next-generation display device with high color purity, wide color gamut coverage, high efficiency, and strong immersion.

In addition, a triplet exciton-sensitizing material (including but not limited to a TADF material and a phosphorescent material) and a fluorescent doping material are combined by using a sensitization technology. The triplet exciton-sensitizing material, used as an exciton-sensitizing medium, transfers energy to the fluorescent doping material through energy transfer by fully utilizing triplet excitons. In this way, 100% internal quantum efficiency of devices can also be reached. This technology can cover the shortage of insufficient exciton utilization of the fluorescent doping material, and effectively achieve the advantages of the fluorescent doping material such as a high fluorescence quantum yield, high device stability, high color purity, and a low price, having a broad application prospect in OLEDs. The sensitization technology can achieve efficiency comparable to that of phosphorescence, and a relatively narrow full width at half maximum. Therefore, development of a sensitization technology based on a boron-based light-emitting material with a narrow full width at half maximum offers unique advantages and strong potential for the BT.2020 display standard.

### SUMMARY

For the foregoing problems in the conventional technology, the present invention provides a boron-containing resonance organic compound and an organic electroluminescent device including same. The compound in the present invention is used as a green light doping material of a light-emitting layer for the organic electroluminescent device, so that a lifetime of the device can be significantly improved.

The present invention provides the following technical solutions. A boron-containing resonance organic compound is provided. A structure of the boron-containing resonance organic compound is shown in general formula (1):

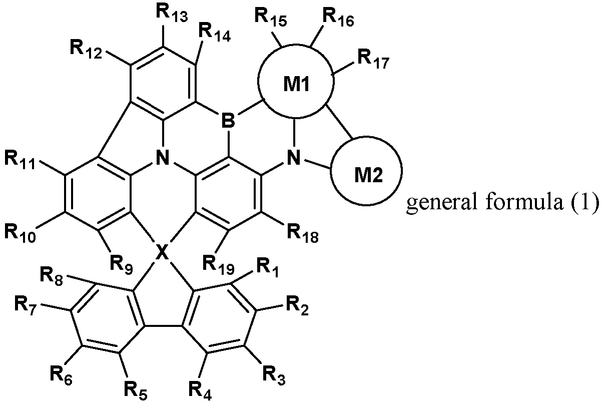

In general formula (1), R₁ to R₁₉ each time present each independently represent one of a hydrogen atom, a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted C₆-C₁₀ aryloxy, substituted or unsubstituted arylamido, substituted or unsubstituted C₆-C₃₀ aryl, substituted or unsubstituted C₂-C₃₀ heteroaryl, and substituted or unsubstituted C₂-C₃₀ boranyl;
any two adjacent groups in R₁ to R₁₄ are linkable to form a ring;
R₁₈ and R₁₉ are linkable to form a ring;
M₁ represents one of a substituted or unsubstituted C₆-C₃₀ aromatic ring and a substituted or unsubstituted 5-membered to 30-membered heteroaromatic ring;
M₂ represents an R-substituted or unsubstituted six-membered ring;
R represents one of a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted C₆-C₁₀ aryloxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
a substitution manner of R is a single-bond linkage or a polycyclic linkage;
R₁, R₂, R₃, R₄, R₅, R₆, R₇, R₈, R₁₈, and R₁₉ do not all represent a hydrogen atom when M₁ and M₂ both represent a substituted or unsubstituted benzene ring;
X represents a carbon atom or a silicon atom;
a substituent for substituting a substitutable group is optionally selected from one or more of a deuterium atom, a tritium atom, a halogen atom, cyano, C₁-C₁₀ alkyl, deuterium- or tritium-substituted C₁-C₁₀ alkyl, C₃-C₁₀ cycloalkyl, C₆-C₃₀ aryl, deuterium- or tritium-substituted C₆-C₃₀ aryl, 5-membered to 30-membered heteroaryl, and deuterium- or tritium-substituted C₂-C₃₀ heteroaryl; and
a heteroatom in the heteroaryl and the heteroaromatic ring is optionally selected from one or more of O, S, N, Si, and B.

The present invention further provides an organic light-emitting device, including a substrate, a first electrode, a second electrode, and a functional layer sequentially, where the functional layer is located between the first electrode and the second electrode, and the functional layer includes the boron-containing resonance organic compound according to the present invention.

The present invention further provides a material for an organic electroluminescent device, including the boron-containing resonance organic compound according to the present invention.

The present invention further provides use of the boron-containing resonance organic compound in an organic electroluminescent device.

The present invention further provides a display component, including the organic electroluminescent device according to the present invention.

The present invention further provides a lighting apparatus, including the organic electroluminescent device according to the present invention.

The present invention further provides an electronic device, carrying the organic electroluminescent device according to the present invention.

Compared with the conventional technology, the present invention has the following beneficial technical effects:
(1) The compound of the present invention can be used as a doping material for a light-emitting layer material when used in an organic electroluminescent device, can exhibit green fluorescence under the action of an electric field, and can be used in the field of organic electroluminescent lighting or organic electroluminescent display.
(2) The compound of the present invention, as a doping material, with a phosphorescent sensitizer introduced, can effectively improve a lifetime of a device.
(3) An FWHM on a spectrum of the compound of the present invention is narrow, so that a color gamut of a device can be effectively improved.

The compound of the present invention, characterized by a narrow full width at half maximum, can be used as a green light doping material of a light-emitting layer for an organic electroluminescent device, thereby improving a lifetime of the device.

### BRIEF DESCRIPTION OF DRAWINGS

FIG. 1 is a diagram of a structure of materials that are listed in the present invention and that are used in an OLED device, where
   1 is a transparent substrate layer, 2 is an anode layer, 3 is a hole injection layer, 4 is a hole transport layer, 5 is an electron blocking layer, 6 is a light-emitting layer, 7 is a hole blocking layer, 8 is an electron transport layer, 9 is an electron injection layer, and 10 is a cathode layer;
FIG. 2 shows a PL spectrum of compound 36 in a toluene solution (1×10⁻⁵ M) according to the present invention;

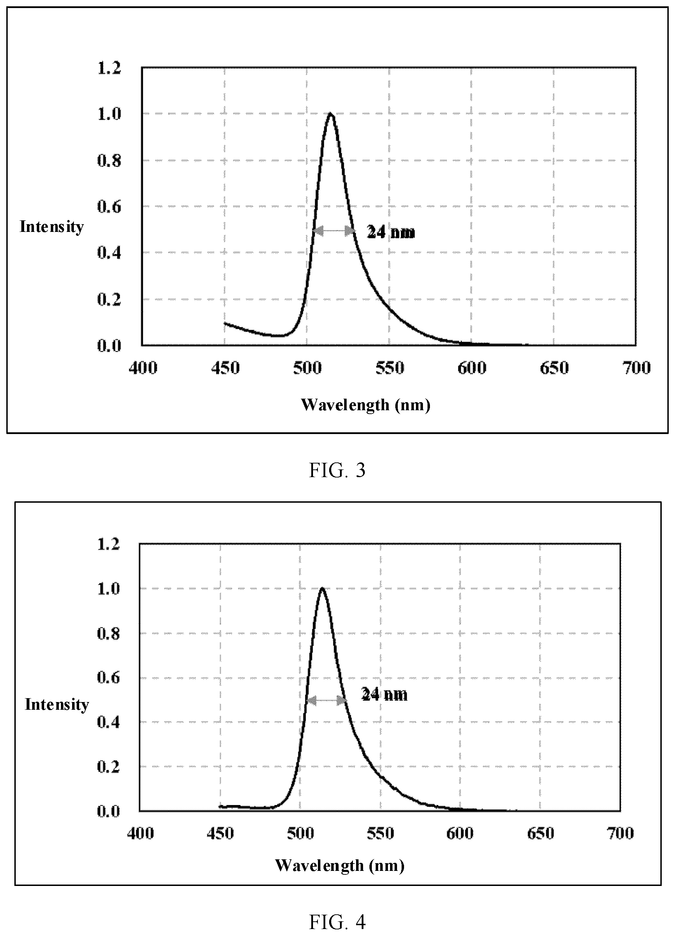

FIG. 3 shows a PL spectrum of compound 48 in a toluene solution (1×10⁻⁵ M) according to the present invention;
FIG. 4 shows a PL spectrum of compound 64 in a toluene solution (1×10⁻⁵ M) according to the present invention;

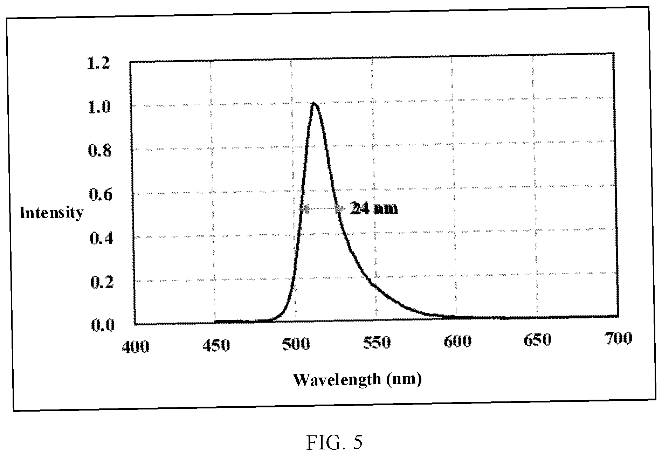

FIG. 5 shows a PL spectrum of compound 533 in a toluene solution (1×10⁻⁵ M) according to the present invention;

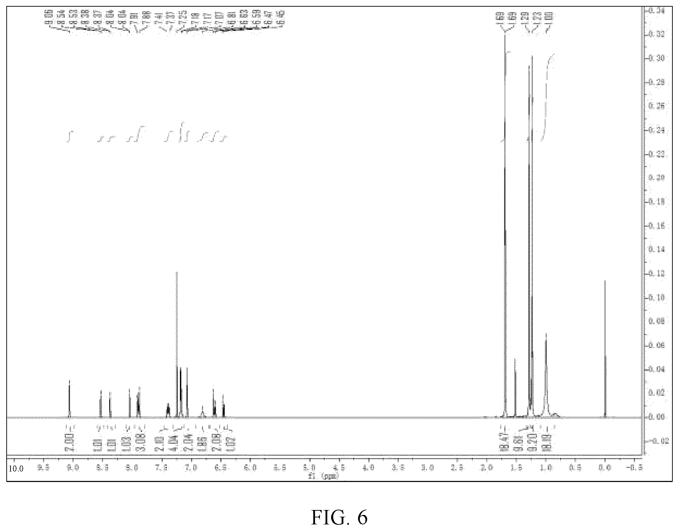

FIG. 6 shows a hydrogen nuclear magnetic resonance spectrum of compound 36 according to the present invention;

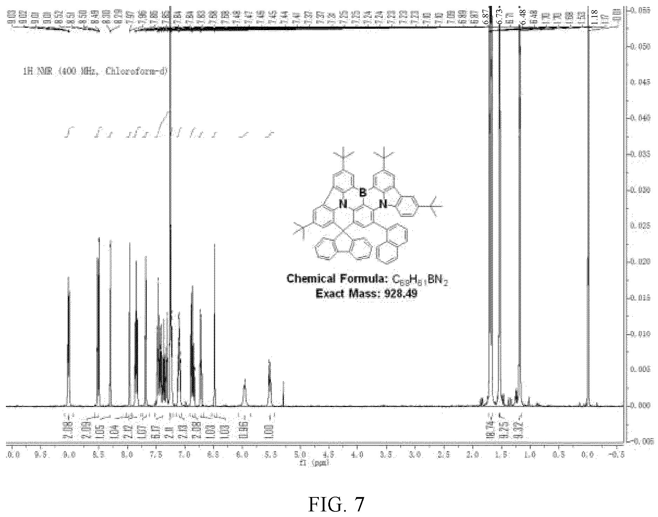

FIG. 7 shows a hydrogen nuclear magnetic resonance spectrum of compound 48 according to the present invention;

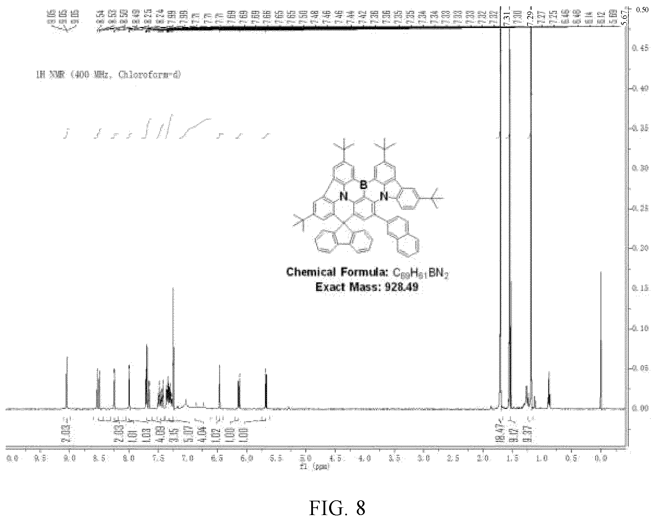

FIG. 8 shows a hydrogen nuclear magnetic resonance spectrum of compound 64 according to the present invention; and

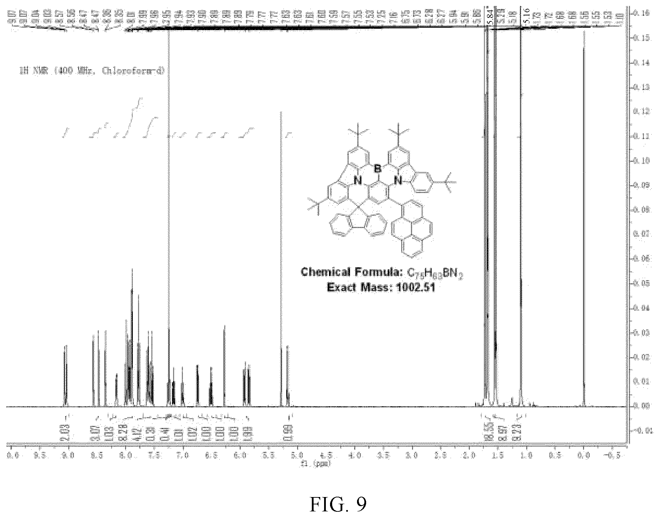

FIG. 9 shows a hydrogen nuclear magnetic resonance spectrum of compound 533 according to the present invention.

### DESCRIPTION OF EMBODIMENTS

The following specifically describes the present invention with reference to the accompanying drawings and embodiments.

In the present invention, when an electrode, an organic electroluminescent device, and another structure are described, words such as "upper", "lower", "top", and "bottom" that are used to represent orientations only represent orientations in a particular state, but do not mean that a related structure can only exist according to the orientations. On the contrary, if the structure can change in position, for example, be inverted, the orientations of the structure change correspondingly. Specifically, in the present invention, a "bottom" or "lower" side of an electrode is a side that is of the electrode and that is close to a substrate in a preparation process, and an opposite side that is away from the substrate is a "top" or "upper" side.

In the present invention, the "linkable to form a ring" and "may be linked to form a ring" mean that two groups may not be linked or may be linked to each other to form a ring. Preferably, the two groups are linked to form a ring by a C-C single bond, a C=C double bond, an O atom, an S atom, CQ₁Q₂, or NQ₃, where Q₁, Q₂, and Q₃ each represent substituted or unsubstituted C₁-C₁₀ alkyl, substituted or unsubstituted C₆-C₃₀ aryl, or substituted or unsubstituted C₂-C₃₀ heteroaryl. Preferably, the two groups may be linked to form a substituted or unsubstituted 6-membered to 30-membered aromatic ring, a substituted or unsubstituted 5-membered to 30-membered heteroaromatic ring, or a substituted or unsubstituted 5-membered to 30-membered aliphatic ring.

In the present invention, the substituted or unsubstituted arylamido in the present invention is 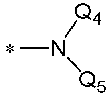 , where Q₄ and Q₅ each represent a substituted or unsubstituted aromatic group, and Q₄ and Q₅ each preferably represent substituted or unsubstituted C₆-C₃₀ aryl or substituted or unsubstituted C₂-C₃₀ heteroaryl.

In the present invention, substituted or unsubstituted C₆-C₃₀ aryl is substituted or unsubstituted phenyl, substituted or unsubstituted naphthyl, substituted or unsubstituted anthryl, substituted or unsubstituted fluorenyl, substituted or unsubstituted dimethylfluorenyl, substituted or unsubstituted diphenylfluorenyl, substituted or unsubstituted spirofluorenyl, substituted or unsubstituted phenanthryl, substituted or unsubstituted fused tetraphenyl, substituted or unsubstituted pyrenyl, substituted or unsubstituted diphenyl, substituted or unsubstituted p-terphenyl, substituted or unsubstituted m-terphenyl, substituted or unsubstituted chrysenyl, substituted or unsubstituted diphenylphenyl, substituted or unsubstituted perylenyl, substituted or unsubstituted indenyl, a combination thereof, or a fused ring of a combination of the foregoing groups, but is not limited thereto.

In the present invention, substituted or unsubstituted C₂-C₃₀ heteroaryl, substituted or unsubstituted C₅-C₃₀ heteroaryl, or substituted or unsubstituted 5-membered to 30-membered heteroaryl is substituted or unsubstituted furyl, substituted or unsubstituted thienyl, substituted or unsubstituted pyrrolyl, substituted or unsubstituted pyrazolyl, substituted or unsubstituted imidazolyl, substituted or unsubstituted triazolyl, substituted or unsubstituted oxazolyl, substituted or unsubstituted thiazolyl, substituted or unsubstituted oxadiazolyl, substituted or unsubstituted thiadiazolyl, substituted or unsubstituted pyridinyl, substituted or unsubstituted pyrimidinyl, substituted or unsubstituted pyrazinyl, substituted or unsubstituted triazinyl, substituted or unsubstituted benzofuryl, substituted or unsubstituted benzothienyl, substituted or unsubstituted benzimidazolyl, substituted or unsubstituted indolyl, substituted or unsubstituted quinolyl, substituted or unsubstituted isoquinolyl, substituted or unsubstituted quinazolinyl, substituted or unsubstituted quinoxalinyl, substituted or unsubstituted naphthyridinyl, substituted or unsubstituted benzoxazinyl, substituted or unsubstituted benzothiazinyl, substituted or unsubstituted acridinyl, substituted or unsubstituted phenazinyl, substituted or unsubstituted phenothiazinyl, substituted or unsubstituted phenoxazinyl, substituted or unsubstituted fluorenyl, substituted or unsubstituted dibenzofuryl, substituted or unsubstituted dibenzothienyl, substituted or unsubstituted carbazolyl, a combination thereof, or a fused ring of a combination of the foregoing groups, but is not limited thereto.

The C₁-C₁₀ alkyl (including linear alkyl and branched alkyl) in the present invention is methyl, ethyl, propyl, isopropyl, butyl, tert-butyl, isobutyl, sec-butyl, neo-pentyl, n-pentyl, isopentyl, octyl, heptyl, n-decyl, 1-methylpentyl, 2-methylpentyl, 3-methylpentyl, or 1-butylpentyl, but is not limited thereto.

The C₃-C₁₀ cycloalkyl in the present invention is a monovalent monocyclic saturated hydrocarbyl group containing 3 to 10 carbon atoms as ring-forming atoms. In this specification, C₄-C₉ cycloalkyl is preferred, more preferably C₅-C₈ cycloalkyl, particularly preferably C₅-C₇ cycloalkyl. Non-limiting examples thereof may include cyclopropyl, cyclobutyl, cyclopentyl, cyclohexyl, 4-methylcyclohexyl, 4,4-dimethylcyclohexyl, adamantyl, and cycloheptyl, but are not limited thereto.

The halogen atom in the present invention is a fluorine atom, a chlorine atom, a bromide atom, or an iodine atom.

The C₁-C₁₀ alkoxy in the present invention is methoxy, ethoxy, propoxy, butoxy, pentyloxy, hexyloxy, or isopropoxy, but is not limited thereto.

The C₂-C₁₀ alkenyl in the present invention is ethenyl, allyl, 1-butenyl, 2-butenyl, 3-butenyl, 1,3-butadienyl, 1-methylethenyl, styryl, 2,2-diphenylethenyl, 1,2-diphenylethenyl, 1,1-dimethylallyl, 1-methylallyl, 2-methylallyl, 1-phenylallyl, 2-phenylallyl, 3,3-diphenylallyl, 1,2-dimethylallyl, 1-phenyl-1-butenyl, 3-phenyl-1-butenyl, and the like, but is not limited thereto.

The C1-C10 alkynyl in the present invention is preferably C2-C8 alkynyl, more preferably C2-C5 alkynyl. Non-limiting examples thereof may include ethynyl, propynyl, n-butynyl, isobutynyl, n-pentynyl, isopentynyl, and neo-pentynyl, but are not limited thereto.

A substituent for substituting a group is optionally selected from one or more of a deuterium atom, a chlorine atom, a fluorine atom, trifluoromethyl, adamantyl, cyano, methyl, ethyl, propyl, isopropyl, tert-pentyl, tert-butyl, butyl, methoxy, phenyl, diphenyl, naphthyl, anthryl, phenanthryl, pyridinyl, pyrimidinyl, pyrazinyl, pyridazinyl, benzoxazolyl, benzothiazolyl, quinoxalinyl, quinolyl, isoquinolyl, furyl, thienyl, indolyl, pyrrolyl, dibenzofuryl, dibenzothienyl, 9,9-dimethylfluorenyl, spirofluorenyl, carbazolyl, N-phenylcarbazolyl, carbazolinyl, and azaphenanthryl.

The present invention provides a boron-containing resonance organic compound, where a structure of the boron-containing resonance organic compound is shown in general formula (1):

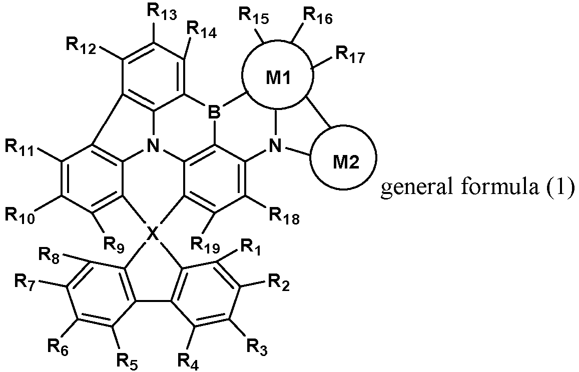

In general formula (1), R₁ to R₁₉ each time present each independently represent one of a hydrogen atom, a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted C₆-C₁₀ aryloxy, substituted or unsubstituted arylamido, substituted or unsubstituted C₆-C₃₀ aryl, substituted or unsubstituted C₂-C₃₀ heteroaryl, and substituted or unsubstituted C₂-C₃₀ boranyl;
any two adjacent groups in R₁ to R₁₄ are linkable to form a ring;
R₁₈ and R₁₉ are linkable to form a ring;
M₁ represents one of a substituted or unsubstituted C₆-C₃₀ aromatic ring and a substituted or unsubstituted 5-membered to 30-membered heteroaromatic ring;
M₂ represents an R-substituted or unsubstituted six-membered ring;
R represents one of a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted C₆-C₁₀ aryloxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
a substitution manner of R is a single-bond linkage or a polycyclic linkage;
R₁, R₂, R₃, R₄, R₅, R₆, R₇, R₈, R₁₈, and R₁₉ do not all represent a hydrogen atom when M₁ and M₂ both represent a substituted or unsubstituted benzene ring;
X represents a carbon atom or a silicon atom;
a substituent for substituting a substitutable group is optionally selected from one or more of a deuterium atom, a tritium atom, a halogen atom, cyano, C₁-C₁₀ alkyl, deuterium- or tritium-substituted C₁-C₁₀ alkyl, C₃-C₁₀ cycloalkyl, C₆-C₃₀ aryl, deuterium- or tritium-substituted C₆-C₃₀ aryl, 5-membered to 30-membered heteroaryl, and deuterium- or tritium-substituted C₂-C₃₀ heteroaryl; and
a heteroatom in the heteroaryl and the heteroaromatic ring is optionally selected from one or more of O, S, N, Si, and B.

In a preferred solution, in general formula (1), R₁ to R₁₉ each time present identically or differently represent one of a hydrogen atom, a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₁-C₁₀ alkoxy, substituted or unsubstituted C₁-C₁₀ aryloxy, substituted or unsubstituted arylamido, substituted or unsubstituted C₆-C₃₀ aryl, and substituted or unsubstituted C₂-C₃₀ heteroaryl;
any adjacent two of R₁ to R₁₄ are linkable to form a ring;
R₁₈ and R₁₉ are linkable to form a ring;
M₁ represents one of a substituted or unsubstituted C₆-C₃₀ aromatic ring and a substituted or unsubstituted 5-membered to 30-membered heteroaromatic ring;
M₂ represents a substituted or unsubstituted six-membered ring;
R₁ to R₈, R₁₈, and R₁₉ do not all represent a hydrogen atom when M₁ and M₂ both represent a substituted or unsubstituted benzene ring;
X represents C or Si; and
a substituent for substituting a group is optionally selected from any one of deuterium, tritium, a halogen atom, cyano, C₁-C₁₀ alkyl, deuterium- or tritium-substituted C₁-C₁₀ alkyl, C₆-C₃₀ aryl, deuterium- or tritium-substituted C₆-C₃₀ aryl, C₅-C₃₀ heteroaryl, and deuterium- or tritium-substituted C₂-C₃₀ heteroaryl.

In a preferred solution, a structure of the boron-containing resonance organic compound is shown in any one of general formula (1-1) to general formula (1-3):

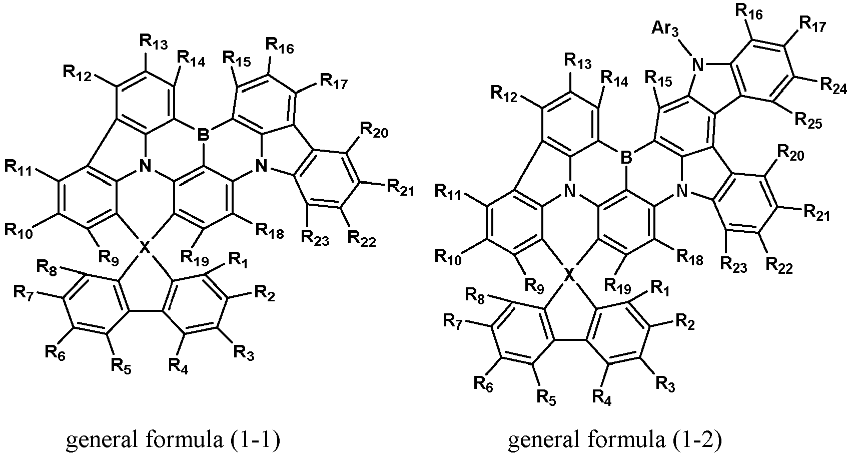

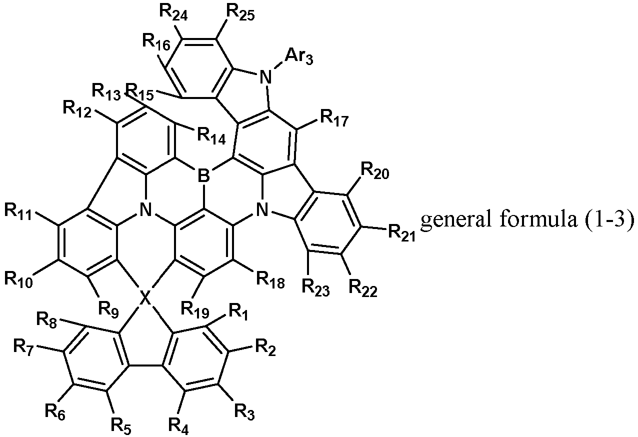

In general formula (1-1) to general formula (1-3), R₁ to R₂₅ each time present identically or differently represent one of a hydrogen atom, a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₁-C₁₀ alkoxy, substituted or unsubstituted C₁-C₁₀ aryloxy, substituted or unsubstituted arylamido, substituted or unsubstituted C₆-C₃₀ aryl, and substituted or unsubstituted C₂-C₃₀ heteroaryl;
any adjacent two of R₁ to R₂₅ are linkable to form a ring;
Ar₃ each time present identically or differently represents one of substituted or unsubstituted C₁-C₁₀ alkyl, substituted or unsubstituted C₃-C₁₀ cycloalkyl, substituted or unsubstituted C₁-C₁₀ alkoxy, substituted or unsubstituted C₁-C₁₀ aryloxy, substituted or unsubstituted arylamido, substituted or unsubstituted C₆-C₃₀ aryl, and substituted or unsubstituted C₂-C₃₀ heteroaryl;
X represents C or Si;
in general formula (1-1), R₁ to R₈, R₁₈, and R₁₉ do not all represent a hydrogen atom; and
a substituent for substituting a group is optionally selected from any one of deuterium, tritium, a halogen atom, cyano, C₁-C₁₀ alkyl, deuterium- or tritium-substituted C₁-C₁₀ alkyl, C₆-C₃₀ aryl, deuterium- or tritium-substituted C₆-C₃₀ aryl, C₅-C₃₀ heteroaryl, and deuterium- or tritium-substituted C₂-C₃₀ heteroaryl.

In a preferred solution, a structure of the boron-containing resonance organic compound is shown in any one of general formula (1-4) to general formula (1-6):

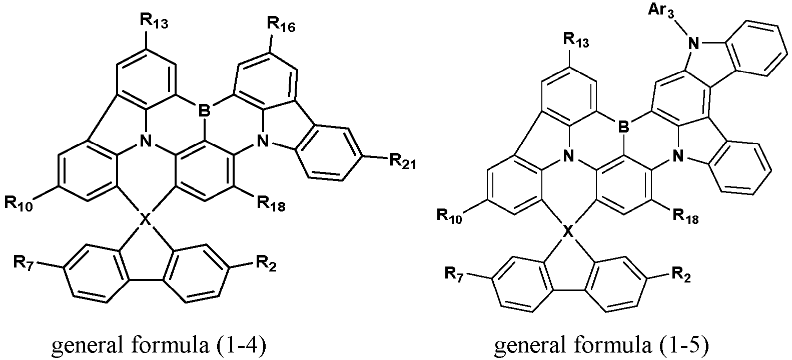

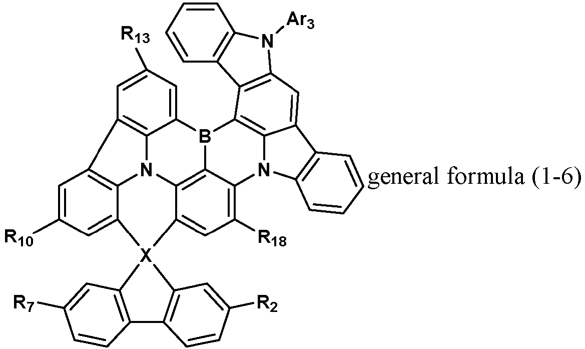

In general formula (1-4) to general formula (1-6), meanings of R₂, R₇, R₁₀, R₁₃, R₁₆, R₁₈, R₂₁, and X are the same as those defined according to claim 2;
Ar₃ represents one of substituted or unsubstituted C₁-C₁₀ alkyl, substituted or unsubstituted C₃-C₁₀ cycloalkyl, substituted or unsubstituted C₁-C₁₀ alkoxy, substituted or unsubstituted C₁-C₁₀ aryloxy, substituted or unsubstituted arylamido, substituted or unsubstituted C₆-C₃₀ aryl, and substituted or unsubstituted C₂-C₃₀ heteroaryl; and
a substituent for substituting a group is optionally selected from any one of deuterium, tritium, a halogen atom, cyano, C₁-C₁₀ alkyl, deuterium- or tritium-substituted C₁-C₁₀ alkyl, C₆-C₃₀ aryl, deuterium- or tritium-substituted C₆-C₃₀ aryl, C₅-C₃₀ heteroaryl, and deuterium- or tritium-substituted C₂-C₃₀ heteroaryl.

In a preferred solution, a structure of the boron-containing resonance organic compound is shown in any one of general formula (1-7) to general formula (1-12):

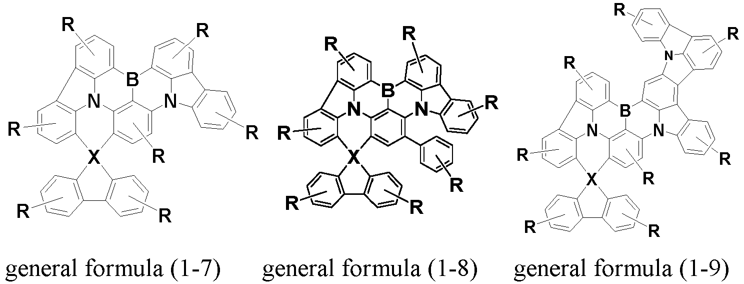

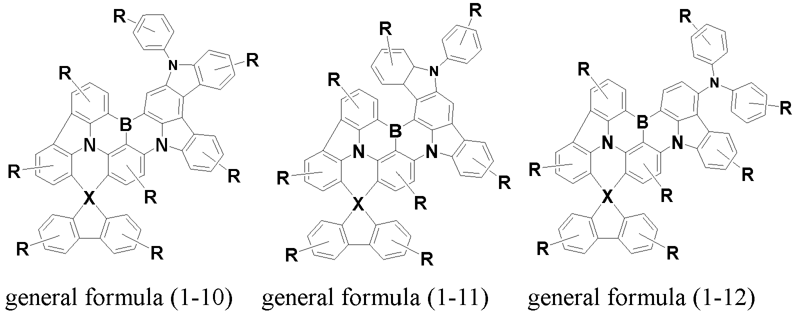

In general formula (1-7) to general formula (1-12), R each time present identically or differently represents one of a hydrogen atom, a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₁-C₁₀ alkoxy, substituted or unsubstituted C₁-C₁₀ aryloxy, substituted or unsubstituted arylamido, substituted or unsubstituted C₆-C₃₀ aryl, and substituted or unsubstituted C₂-C₃₀ heteroaryl;
X represents C or Si; and
a substituent for substituting a group is optionally selected from any one of deuterium, tritium, a halogen atom, cyano, C₁-C₁₀ alkyl, deuterium- or tritium-substituted C₁-C₁₀ alkyl, C₆-C₃₀ aryl, deuterium- or tritium-substituted C₆-C₃₀ aryl, C₅-C₃₀ heteroaryl, and deuterium- or tritium-substituted C₂-C₃₀ heteroaryl.

In a preferred solution, R and R₁ to R₂₅ each independently represent one of a hydrogen atom, a deuterium atom, a tritium atom, a fluorine atom, cyano, adamantyl, methyl, deuterated methyl, tritiated methyl, trifluoromethyl, ethyl, deuterated ethyl, tritiated ethyl, isopropyl, deuterated isopropyl, tritiated butyl, tert-butyl, deuterated tert-butyl, tritiated tert-butyl, cyclopentyl, deuterated cyclopentyl, tritiated cyclopentyl, methyl-substituted cyclopentyl, cyclohexyl, phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, tert-butyl-substituted dibenzofuryl, phenyl-substituted tert-butyl, xanthone, phenyl-substituted triazinyl, phenyl-substituted boranyl, methoxy, and tert-butoxy;
Ar₃ independently represents one of phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, phenyl-substituted amino, tert-butylbenzene-substituted amino, tert-butyl-substituted dibenzofuryl, phenyl-substituted tert-butyl, xanthone, phenyl-substituted triazinyl, phenyl-substituted boranyl, methoxy, and tert-butoxy;
M₁ represents one of phenyl, deuterated phenyl, diphenyl, deuterated diphenyl, triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, phenyl-substituted amino, tert-butyl-substituted dibenzofuryl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, and xanthone;
M₂ represents one of phenyl, deuterated phenyl, pyridinyl, phenyl-substituted pyridinyl, methyl-substituted phenyl, ethyl-substituted phenyl, isopropyl-substituted phenyl, and tert-butyl-substituted phenyl; and
a substituent for substituting a substitutable group is optionally selected from one or more of a deuterium atom, a chlorine atom, a fluorine atom, trifluoromethyl, adamantyl, cyano, methyl, ethyl, propyl, isopropyl, tert-pentyl, tert-butyl, butyl, methoxy, phenyl, diphenyl, naphthyl, anthryl, phenanthryl, pyridinyl, pyrimidinyl, pyrazinyl, pyridazinyl, benzoxazolyl, benzothiazolyl, quinoxalinyl, quinolyl, isoquinolyl, furyl, thienyl, indolyl, pyrrolyl, dibenzofuryl, dibenzothienyl, 9,9-dimethylfluorenyl, spirofluorenyl, carbazolyl, N-phenylcarbazolyl, carbazolinyl, and azaphenanthryl.

In a preferred solution, R and R₁ to R₂₅ each independently represent the following structures:
any one of a hydrogen atom, cyano, 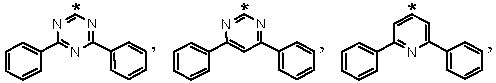 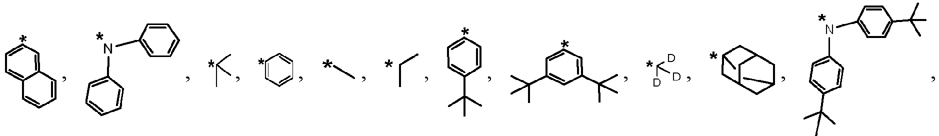 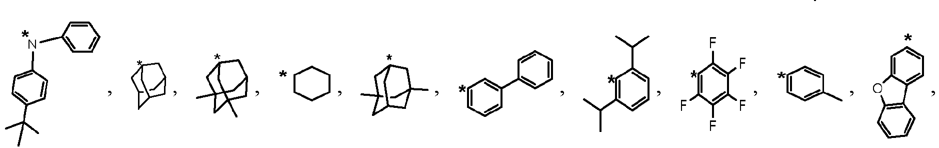 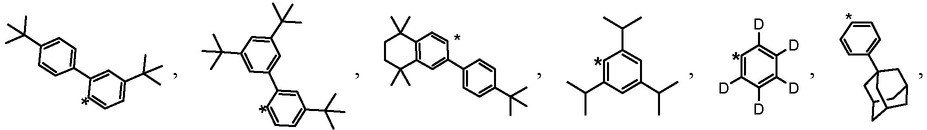 and 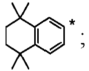
Ar₃ represents the following structures:
   any one of 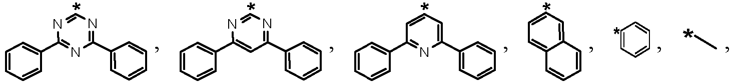 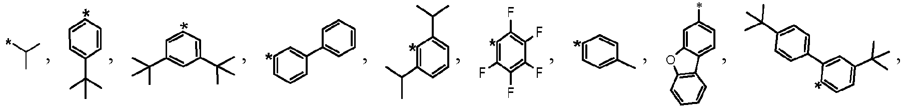 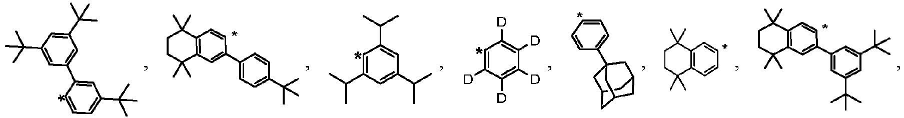 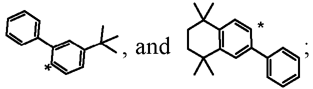
   M₁ represents any one of the following ring structures: 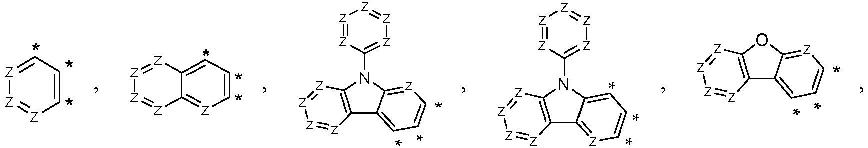 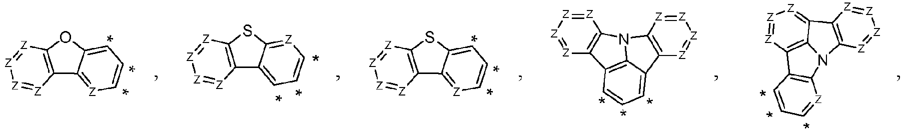 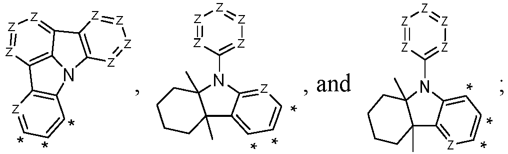
   M₂ represents the following ring structure: 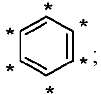
   Z represents C-Rₐ; and
   Rₐ each time present independently represents one of a hydrogen atom, a deuterium atom, a tritium atom, a halogen atom, cyano, adamantyl, methyl, deuterated methyl, tritiated methyl, trifluoromethyl, ethyl, deuterated ethyl, tritiated ethyl, isopropyl, deuterated isopropyl, tritiated isopropyl, tert-butyl, deuterated tert-butyl, tritiated tert-butyl, cyclopentyl, deuterated cyclopentyl, tritiated cyclopentyl, methyl-substituted cyclopentyl, cyclohexyl, phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, phenyl-substituted amino, tert-butylbenzene-substituted amino, tert-butyl-substituted dibenzofuryl, phenyl-substituted tert-butyl, xanthone, phenyl-substituted triazinyl, phenyl-substituted boranyl, methoxy, and tert-butoxy.

In a preferred solution, a structure of the boron-containing resonance organic compound is shown in general formula (A-1):

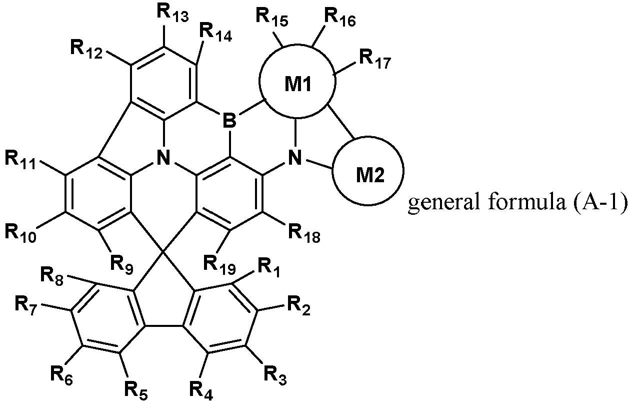

In general formula (A-1), R₁ to R₁₉ each time present each independently represent one of a hydrogen atom, a deuterium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
any two adjacent groups in R₁ to R₁₉ are linkable to form a ring;
M₁ represents one of a substituted or unsubstituted C₆-C₃₀ aromatic ring and a substituted or unsubstituted 5-membered to 30-membered heteroaromatic ring;
M₂ represents an R-substituted or unsubstituted six-membered ring;
R represents one of a deuterium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
a substitution manner of R is a single-bond linkage or a polycyclic linkage;
R₁, R₂, R₃, R₄, R₅, R₆, R₇, R₈, R₁₈, and R₁₉ do not all represent a hydrogen atom when M₁ and M₂ both represent a substituted or unsubstituted benzene ring;
a substituent for substituting a substitutable group is optionally selected from one or more of a deuterium atom, a halogen atom, cyano, C₁-C₁₀ alkyl, C₃-C₁₀ cycloalkyl, C₆-C₃₀ aryl, and 5-membered to 30-membered heteroaryl; and
a heteroatom in the heteroaryl and the heteroaromatic ring is optionally selected from one or more of O, S, N, Si, and B.

In a preferred solution, a structure of the boron-containing resonance organic compound is shown in general formula (A-2):

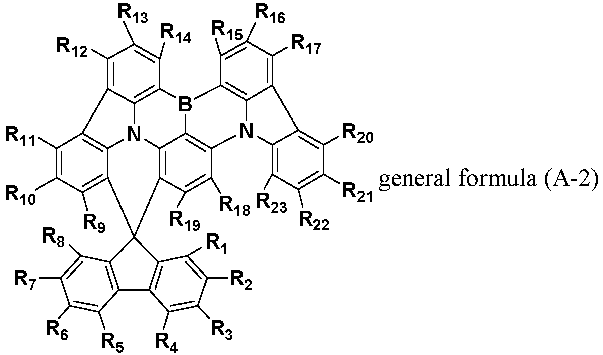

In general formula (A-2), R₁ to R₂₃ each time present each independently represent one of a hydrogen atom, a deuterium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
any two adjacent groups in R₁ to R₂₃ are linkable to form a ring;
R₁, R₂, R₃, R₄, R₅, R₆, R₇, R₈, R₁₈, and R₁₉ do not all represent a hydrogen atom;
a substituent for substituting a substitutable group is optionally selected from one or more of a deuterium atom, a halogen atom, cyano, C₁-C₁₀ alkyl, C₃-C₁₀ cycloalkyl, C₆-C₃₀ aryl, and 5-membered to 30-membered heteroaryl; and
a heteroatom in the heteroaryl is optionally selected from one or more of O, S, N, Si, and B.

In a preferred solution, a structure of the boron-containing resonance organic compound is shown in general formula (A-3):

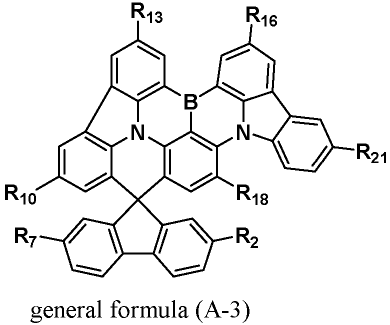

In general formula (A-3), R₂, R₇, R₁₀, R₁₃, R₁₆, and R₂₁ each time present each independently represent one of a hydrogen atom, a deuterium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
R₁₈ represents one of a deuterium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
a substituent for substituting a substitutable group is optionally selected from one or more of a deuterium atom, a halogen atom, cyano, C₁-C₁₀ alkyl, C₃-C₁₀ cycloalkyl, C₆-C₃₀ aryl, and 5-membered to 30-membered heteroaryl; and
a heteroatom in the heteroaryl is optionally selected from one or more of O, S, N, Si, and B.

In a preferred solution, M₁ represents any one of the following substituted or unsubstituted groups: phenyl, naphthyl, anthryl, phenanthryl, pyridinyl, quinolyl, furyl, thienyl, benzofuryl, benzothienyl, dibenzofuryl, dibenzothienyl, N-phenylcarbazolyl, 9,9-dimethylfluorenyl, indolo[3,2,1-jk]carbazolyl, 1,1,4,4-tetramethyl-1,2,3,4-tetrahydronaphthyl, and spirofluorenyl;
M₂ represents any one of the following R-substituted or unsubstituted groups: phenyl, naphthyl, anthryl, phenanthryl, pyridinyl, and quinolyl;
R represents a deuterium atom, a halogen atom, cyano, substituted or unsubstituted methyl, substituted or unsubstituted ethyl, substituted or unsubstituted isopropyl, substituted or unsubstituted tert-butyl, substituted or unsubstituted cyclohexyl, substituted or unsubstituted adamantyl, substituted or unsubstituted phenyl, substituted or unsubstituted diphenyl, substituted or unsubstituted triphenyl, substituted or unsubstituted naphthyl, substituted or unsubstituted anthryl, substituted or unsubstituted phenanthryl, substituted or unsubstituted pyridinyl, substituted or unsubstituted quinolyl, substituted or unsubstituted furyl, substituted or unsubstituted thienyl, substituted or unsubstituted benzofuryl, substituted or unsubstituted benzothienyl, substituted or unsubstituted dibenzofuryl, substituted or unsubstituted dibenzothienyl, substituted or unsubstituted carbazolyl, substituted or unsubstituted N-phenylcarbazolyl, substituted or unsubstituted 9,9-dimethylfluorenyl, substituted or unsubstituted 9,9-diphenylfluorenyl, substituted or unsubstituted spirofluorenyl, substituted or unsubstituted amido, or substituted or unsubstituted triazinyl;
R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀, R₂₁, R₂₂, and R₂₃ each independently represent a hydrogen atom, a deuterium atom, a halogen atom, cyano, substituted or unsubstituted methyl, substituted or unsubstituted ethyl, substituted or unsubstituted isopropyl, substituted or unsubstituted tert-butyl, substituted or unsubstituted cyclohexyl, substituted or unsubstituted adamantyl, substituted or unsubstituted phenyl, substituted or unsubstituted diphenyl, substituted or unsubstituted triphenyl, substituted or unsubstituted naphthyl, substituted or unsubstituted anthryl, substituted or unsubstituted phenanthryl, substituted or unsubstituted pyridinyl, substituted or unsubstituted quinolyl, substituted or unsubstituted furyl, substituted or unsubstituted thienyl, substituted or unsubstituted benzofuryl, substituted or unsubstituted benzothienyl, substituted or unsubstituted dibenzofuryl, substituted or unsubstituted dibenzothienyl, substituted or unsubstituted carbazolyl, substituted or unsubstituted N-phenylcarbazolyl, substituted or unsubstituted 9,9-dimethylfluorenyl, substituted or unsubstituted 9,9-diphenylfluorenyl, substituted or unsubstituted spirofluorenyl, substituted or unsubstituted amido, or substituted or unsubstituted triazinyl; and
a substituent for substituting a group is optionally selected from one or more of a deuterium atom, a chlorine atom, a fluorine atom, trifluoromethyl, adamantyl, cyano, methyl, ethyl, propyl, isopropyl, tert-pentyl, tert-butyl, butyl, methoxy, phenyl, diphenyl, naphthyl, anthryl, phenanthryl, pyridinyl, pyrimidinyl, pyrazinyl, pyridazinyl, benzoxazolyl, benzothiazolyl, quinoxalinyl, quinolyl, isoquinolyl, furyl, thienyl, indolyl, pyrrolyl, dibenzofuryl, dibenzothienyl, 9,9-dimethylfluorenyl, spirofluorenyl, carbazolyl, N-phenylcarbazolyl, carbazolinyl, and azaphenanthryl.

In a preferred solution, M₁ represents the following structures:
any one of 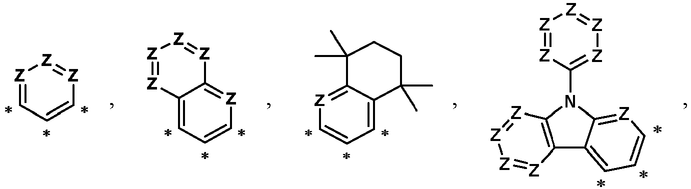 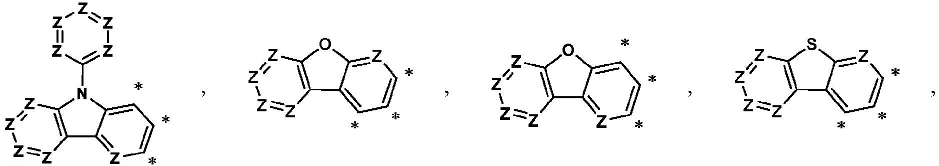 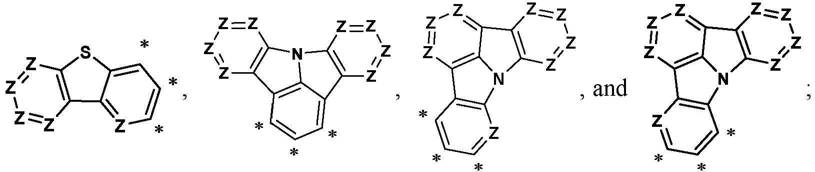
M₂ represents the following structures:
   any one of 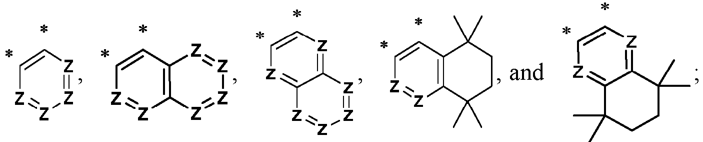
   Z represents C-(H) or C-(R); and
   R, R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀, R₂₁, R₂₂, and R₂₃ each independently represent the following structures:
      any one of a hydrogen atom, a deuterium atom, methyl, ethyl, isopropyl, tert-butyl, cyano, trifluoromethyl,

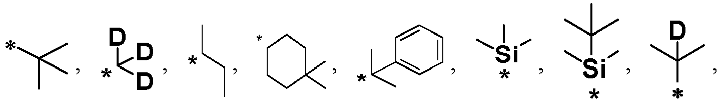

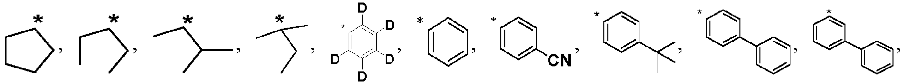

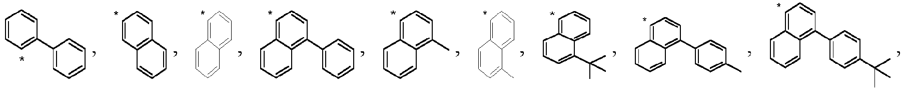

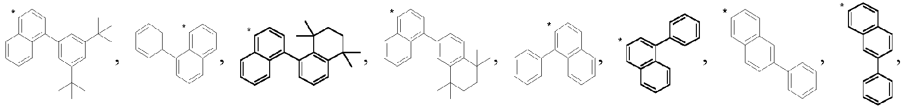

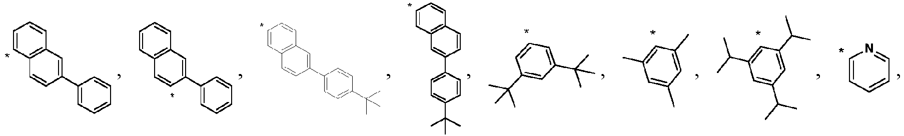

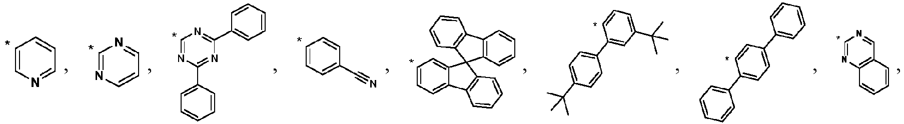

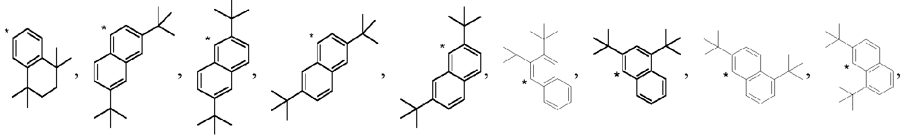

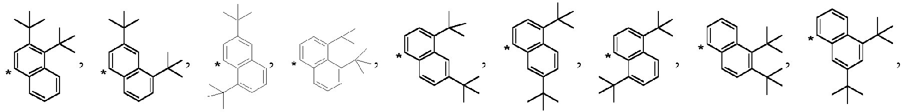

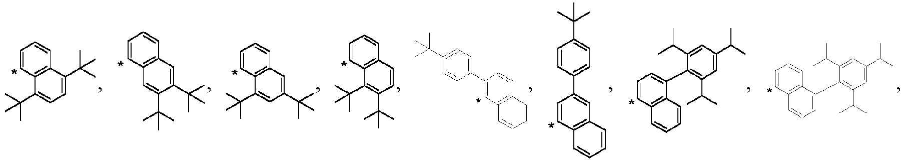

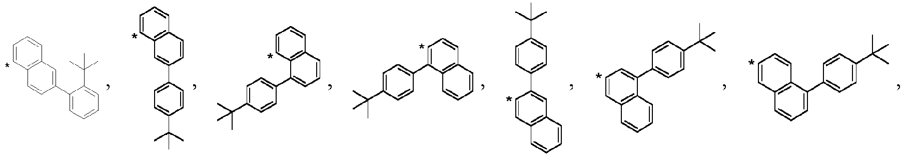

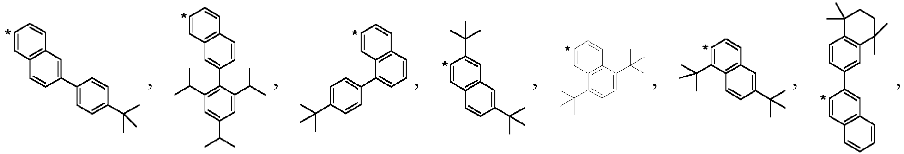

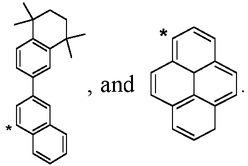

In a preferred solution, M₁ represents the following structures:
any one of 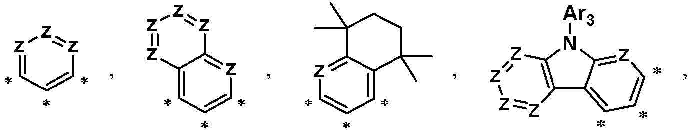 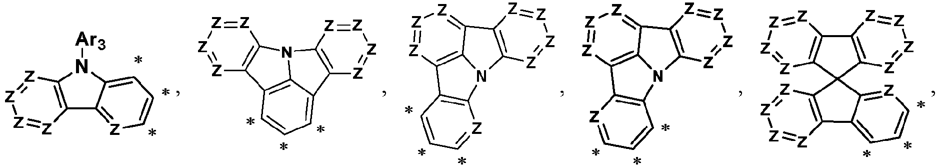 and 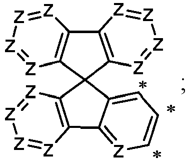
M₂ represents the following structures:
   any one of 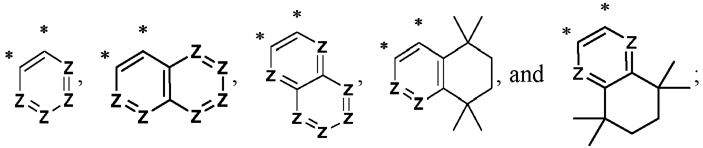
   Z represents C-(H) or C-(R);
   R, R₁, R₂, R₃, R₄, R₅, R₆, R₇, R₈, R₉, R₁₀, R₁₁, R₁₂, R₁₃, R₁₄, R₁₅, R₁₆, R₁₇, R₂₀, R₂₁, R₂₂, and R₂₃ each independently represent the following structures:
      any one of a hydrogen atom, a deuterium atom, methyl, ethyl, isopropyl, tert-butyl, trifluoromethyl, 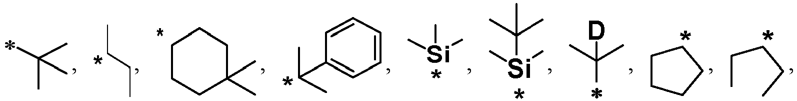 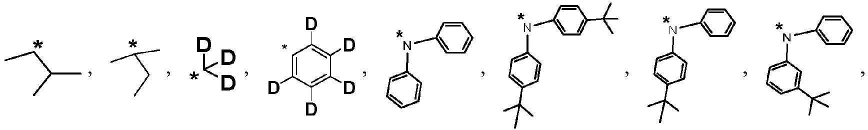 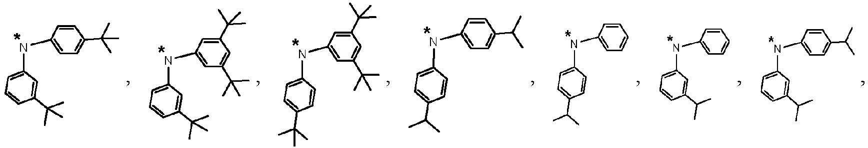 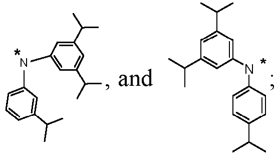
      R₁₈ and R₁₉ each independently represent the following structures:
         any one of a hydrogen atom, cyano, tert-butyl, 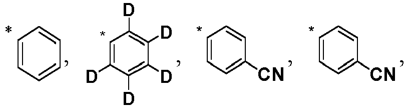 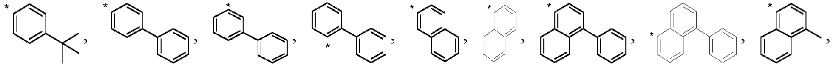 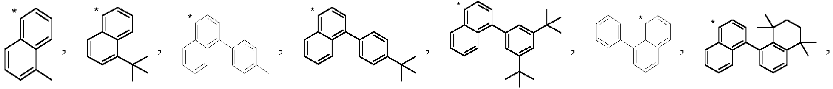 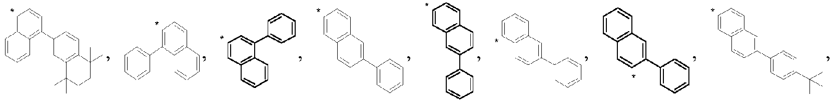 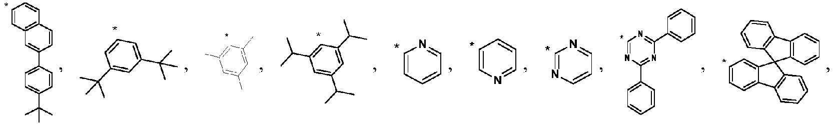 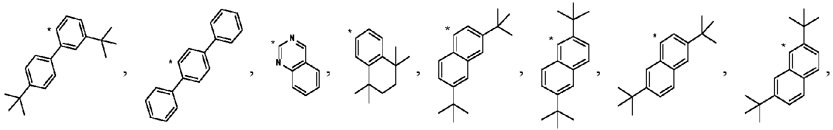 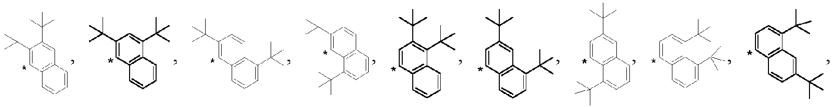 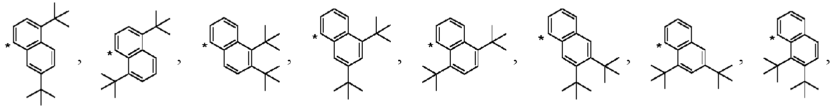 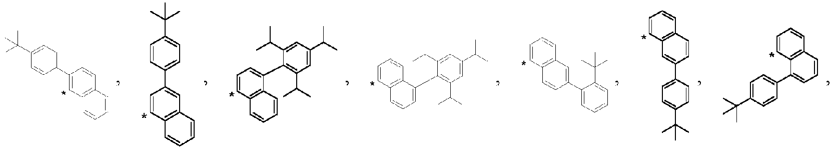 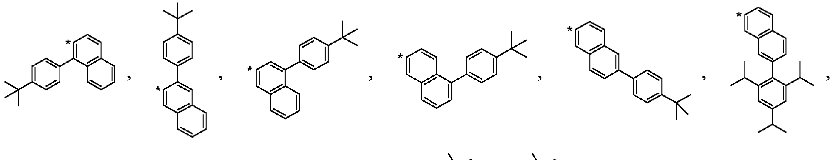 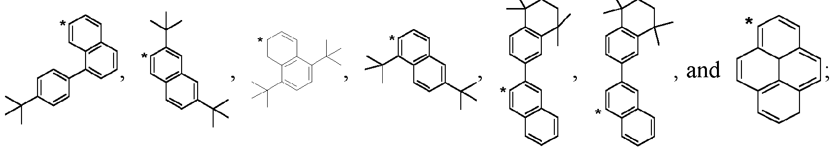 and
         Ar₃ represents the following structures:
            any one of

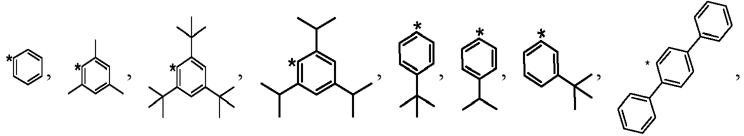

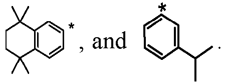

In a preferred solution, a specific structural formula of the boron-containing resonance organic compound is any one of the following structures:

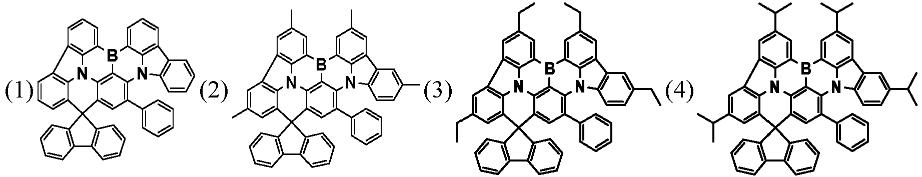

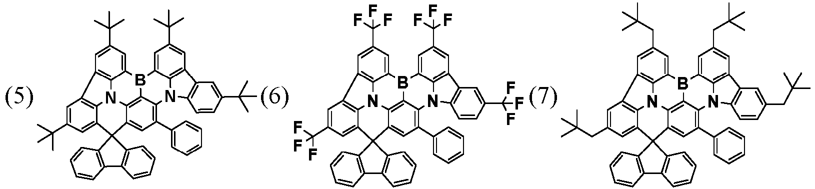

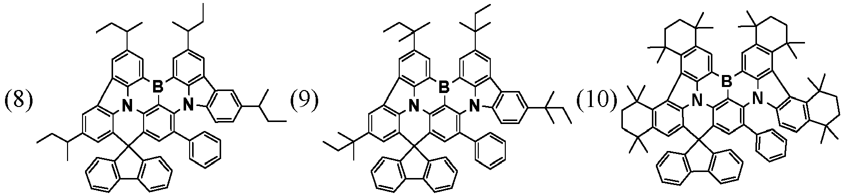

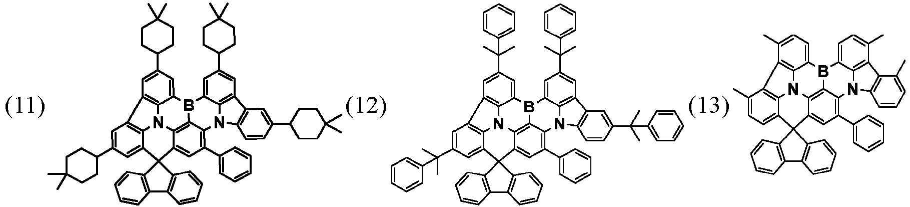

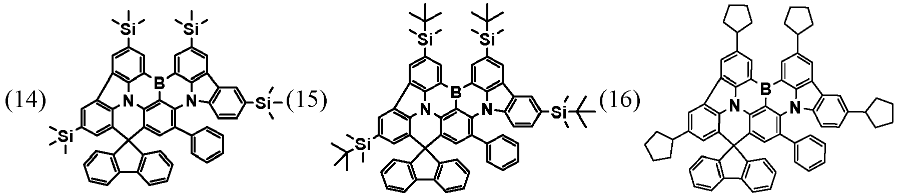

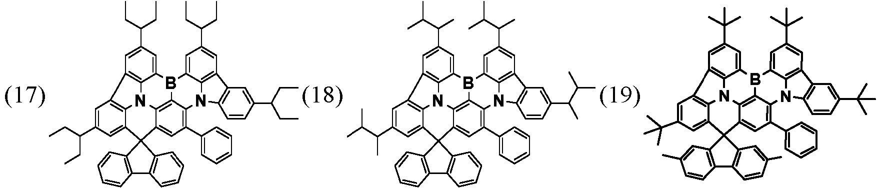

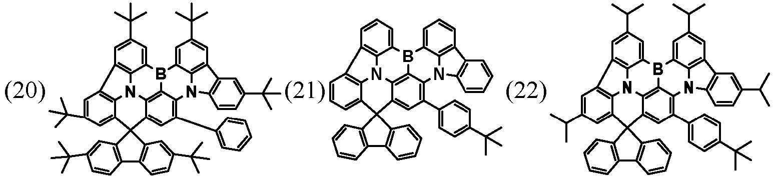

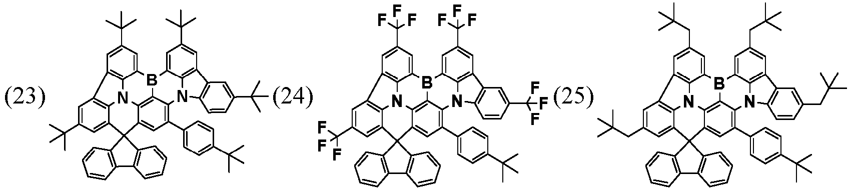

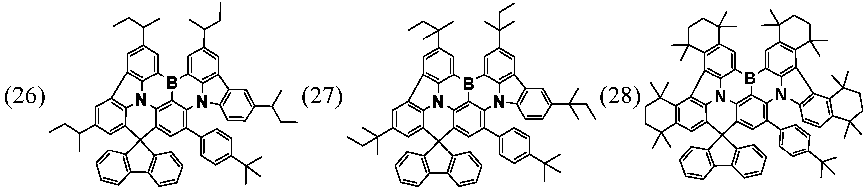

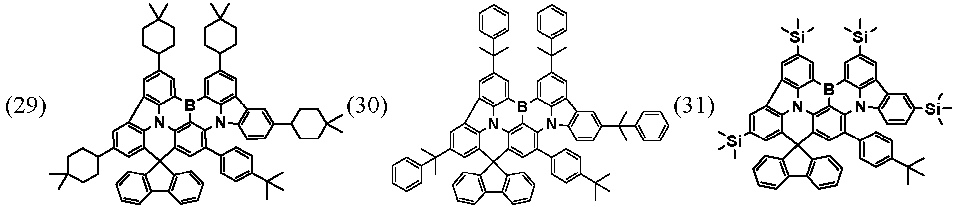

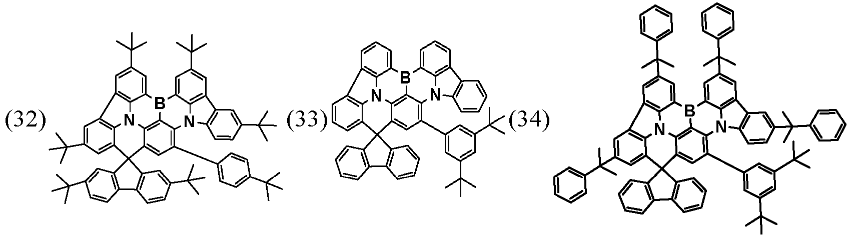

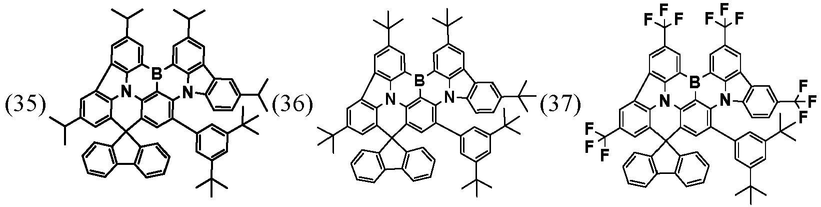

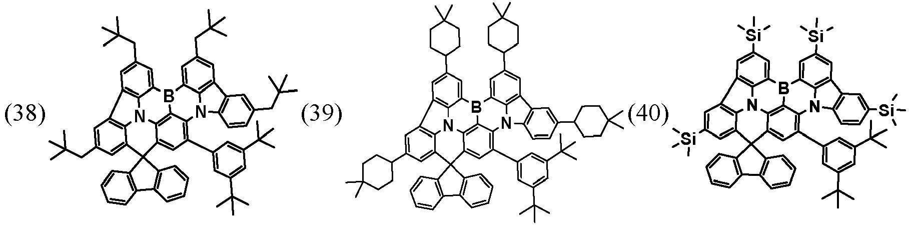

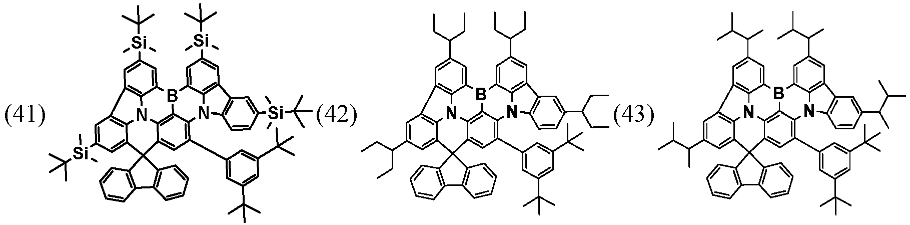

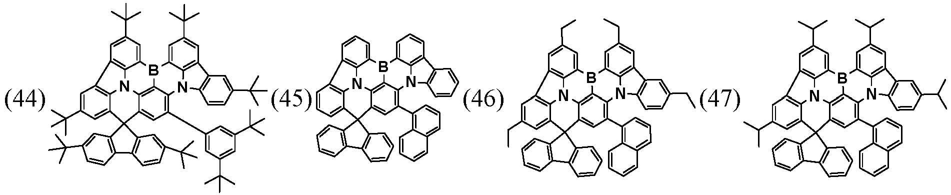

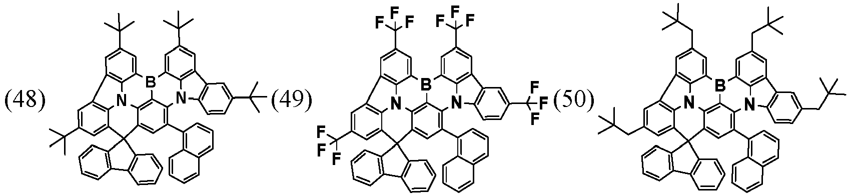

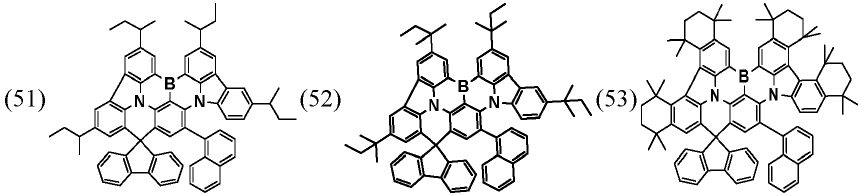

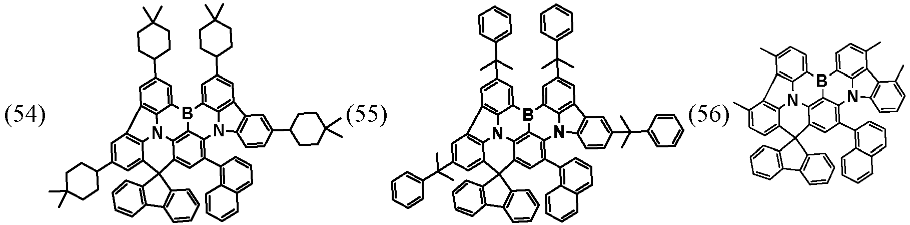

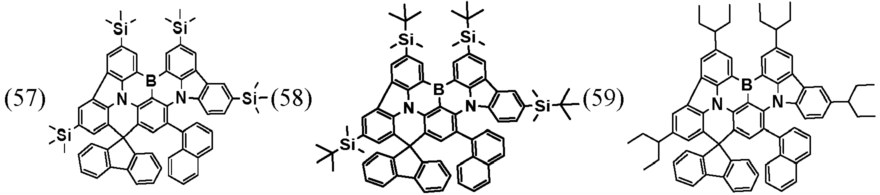

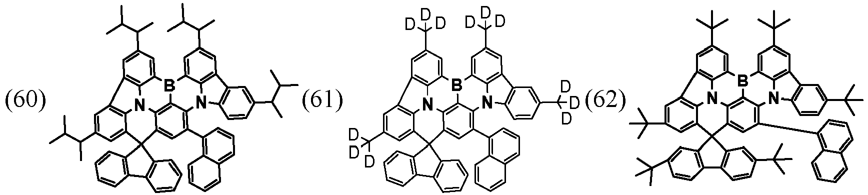

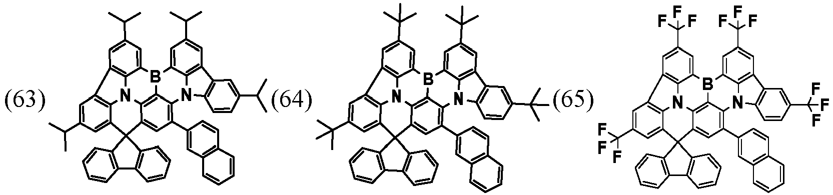

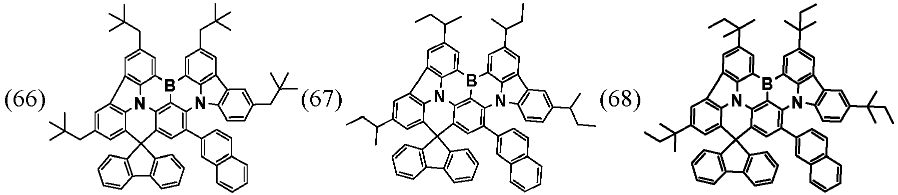

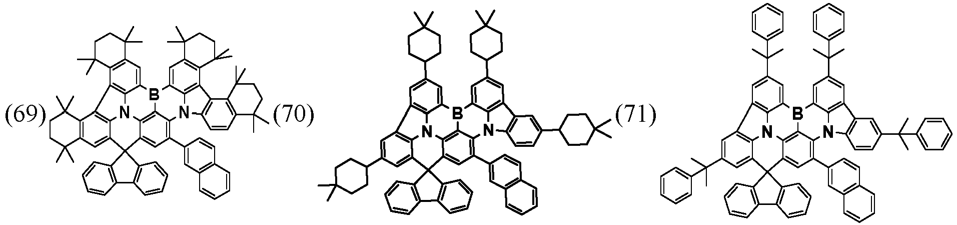

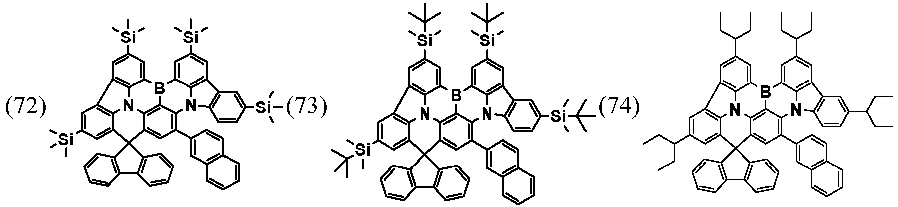

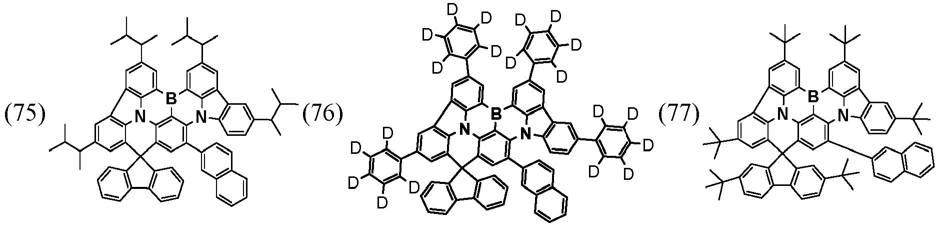

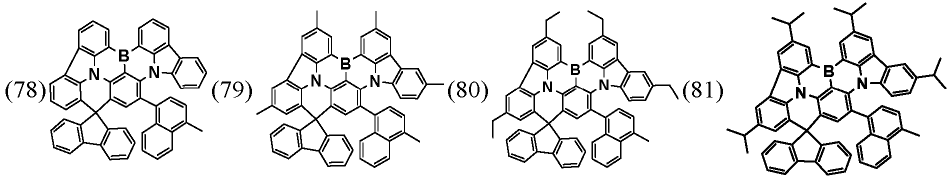

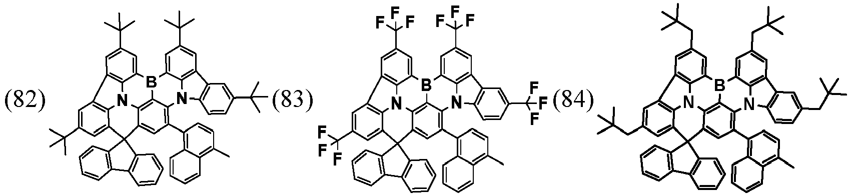

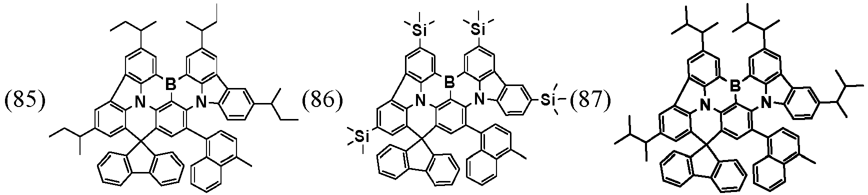

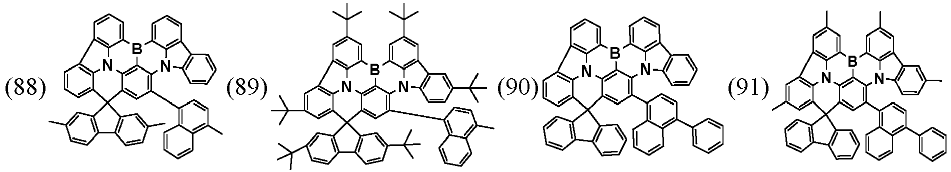

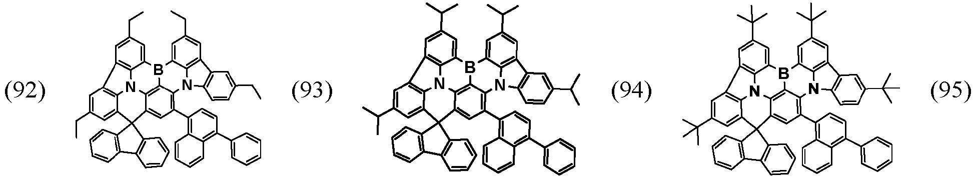

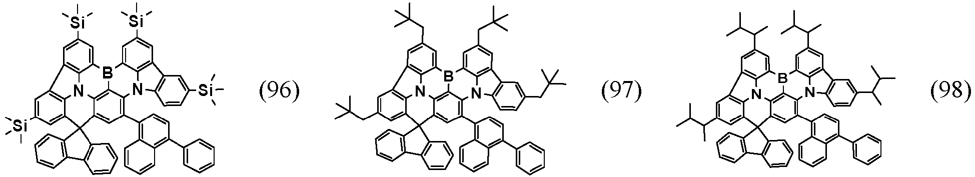

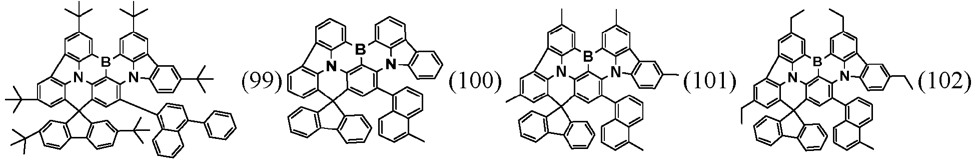

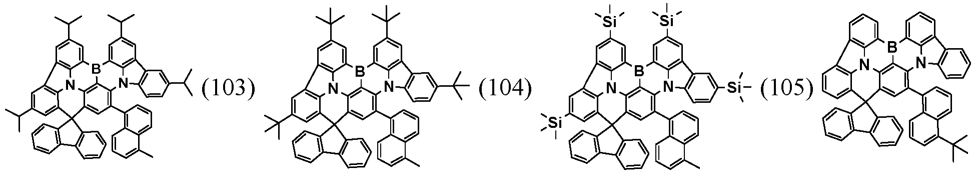

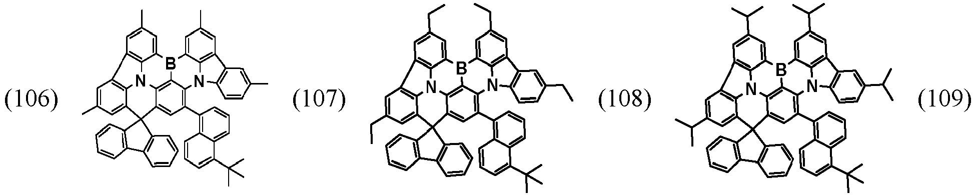

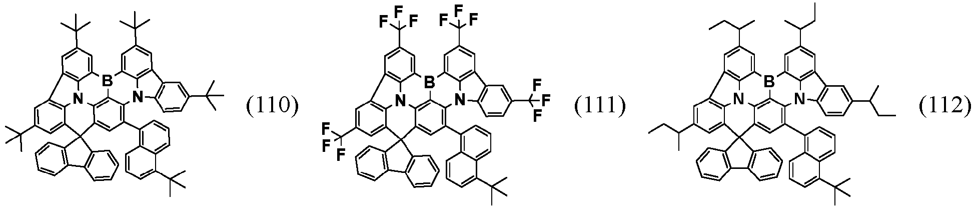

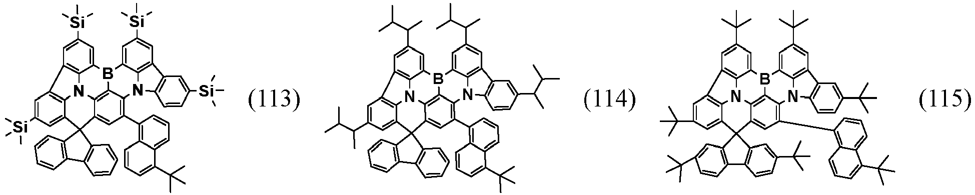

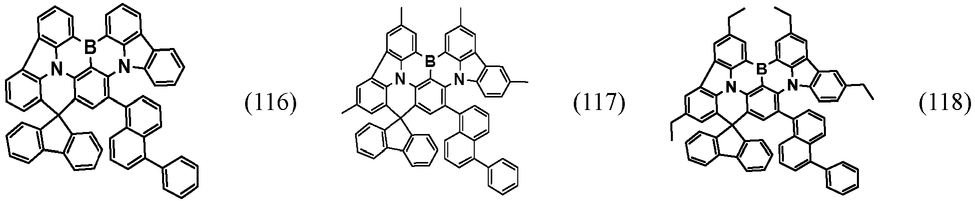

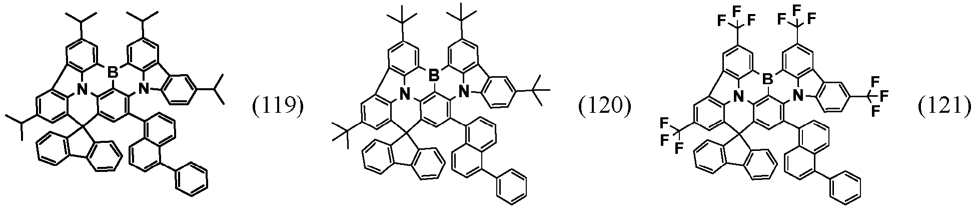

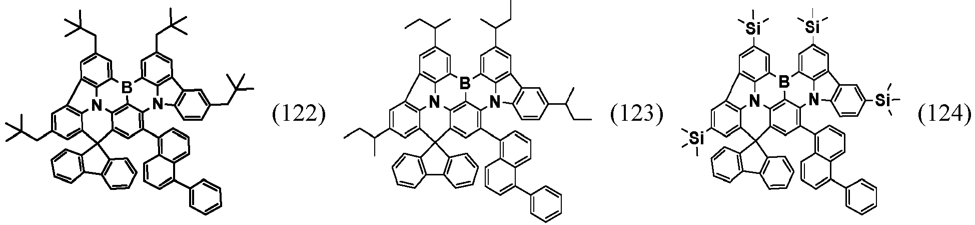

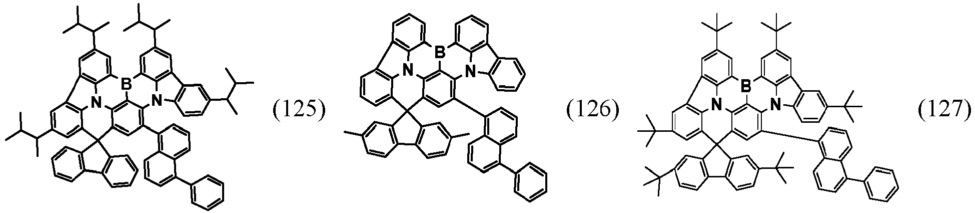

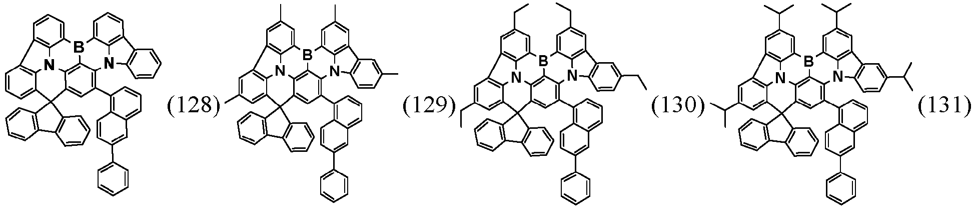

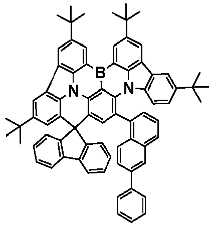

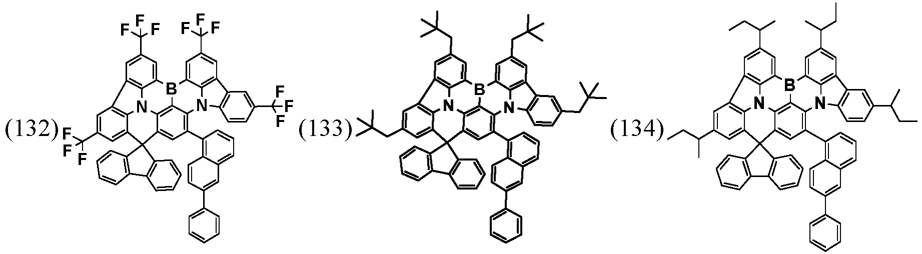

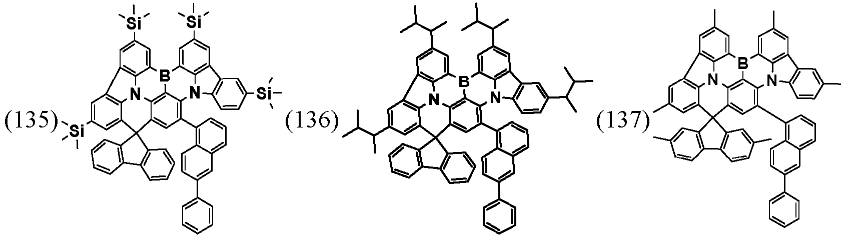

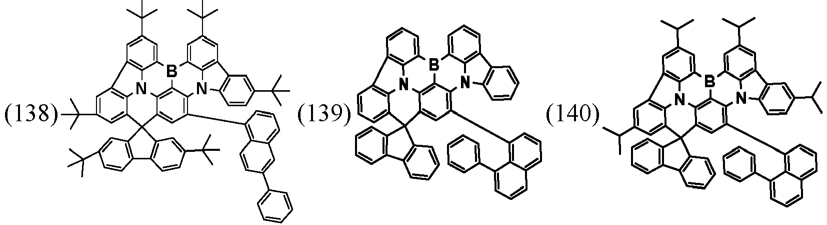

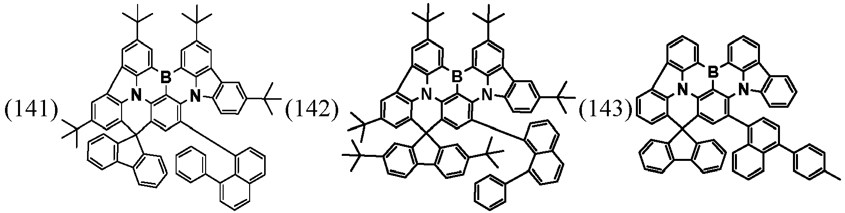

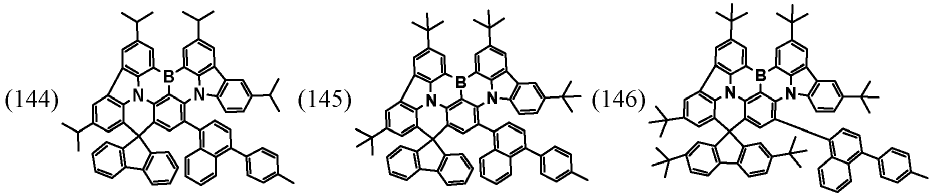

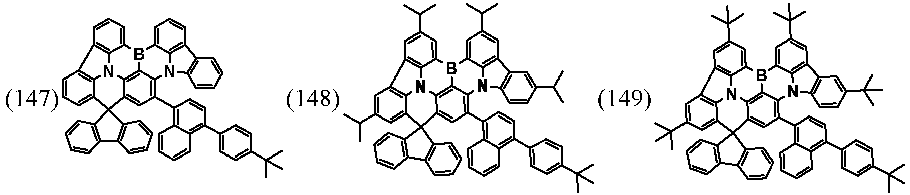

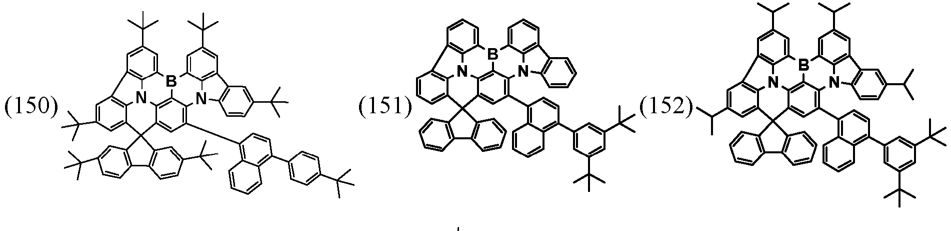

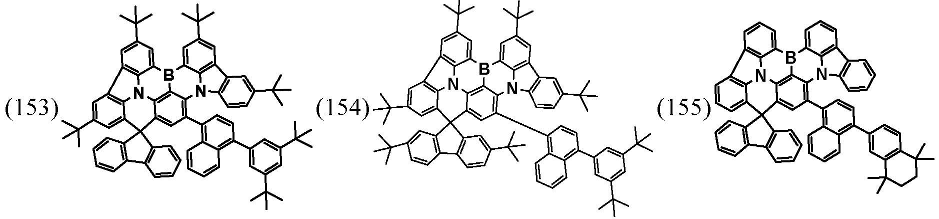

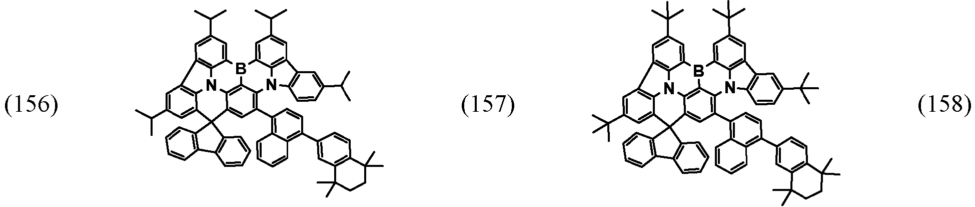

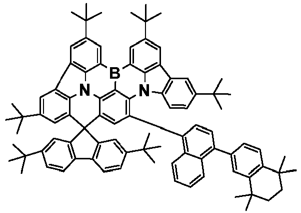

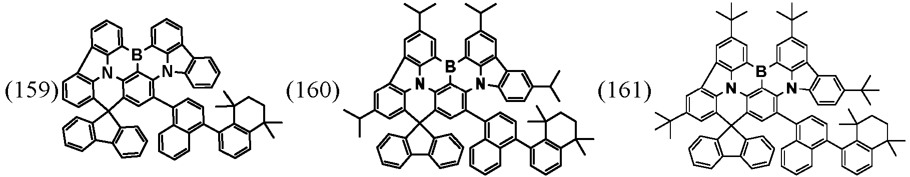

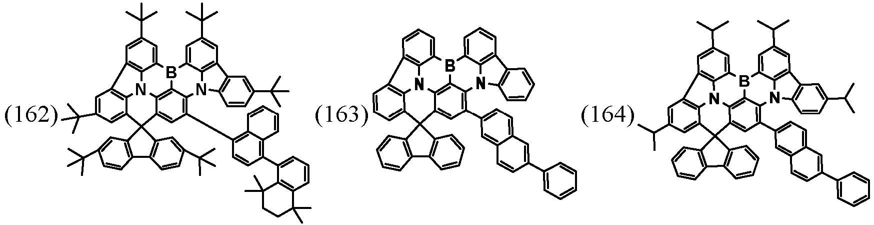

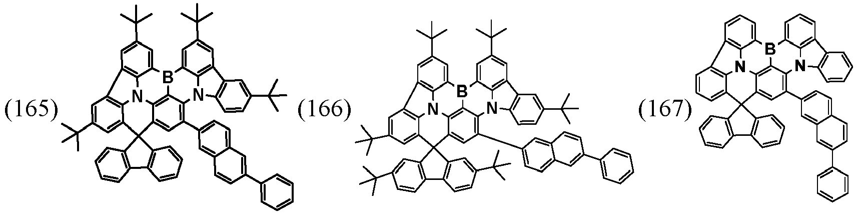

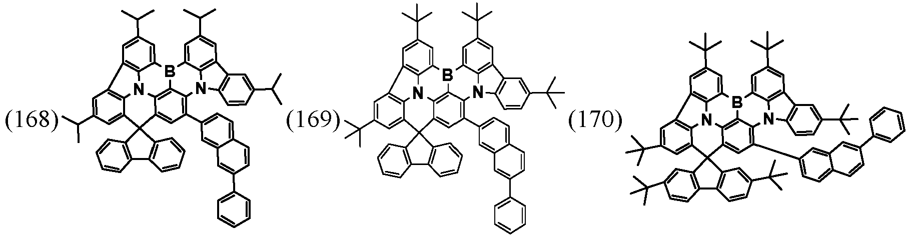

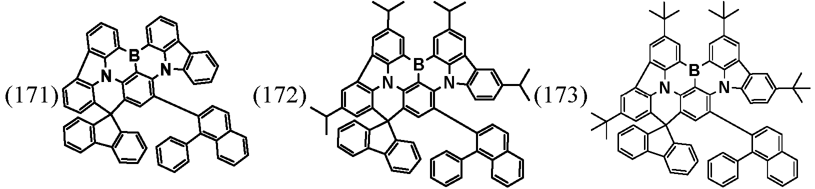

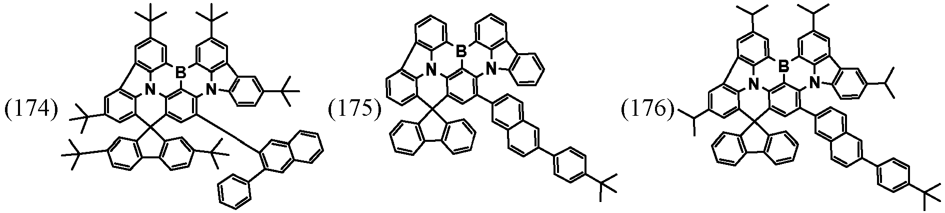

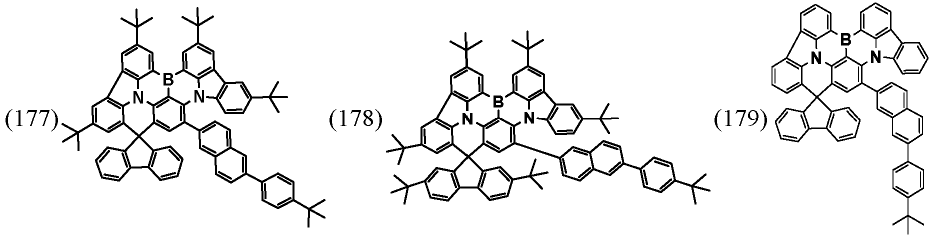

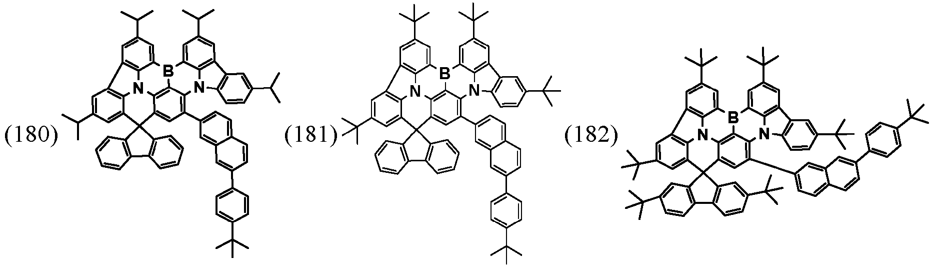

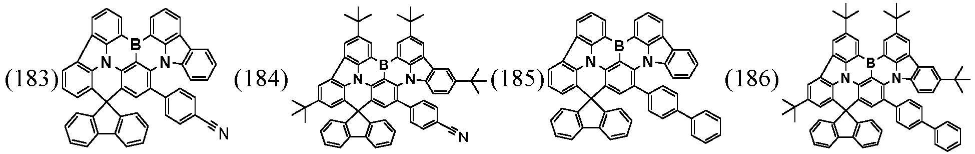

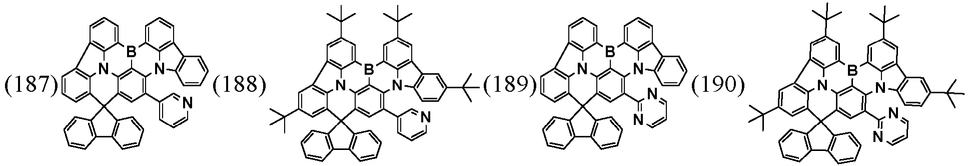

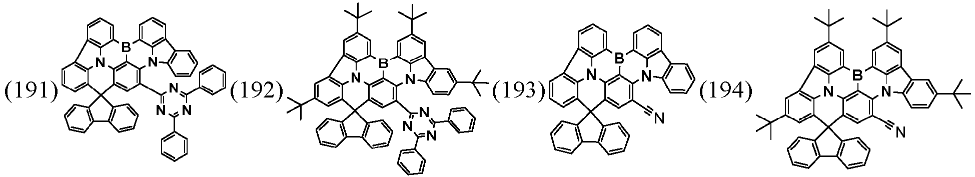

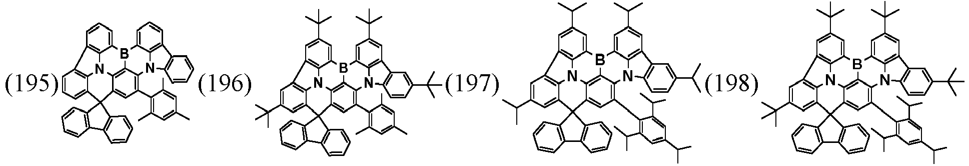

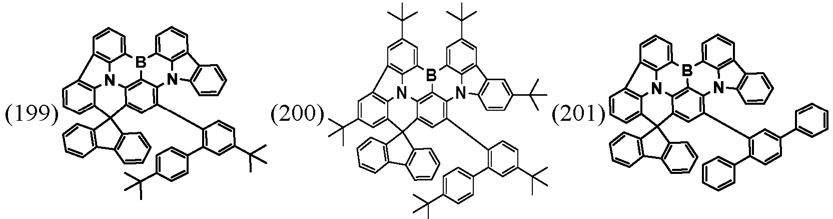

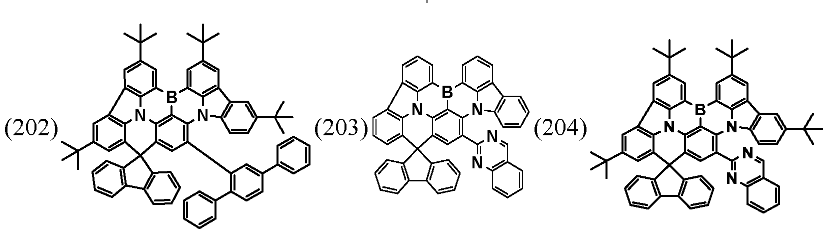

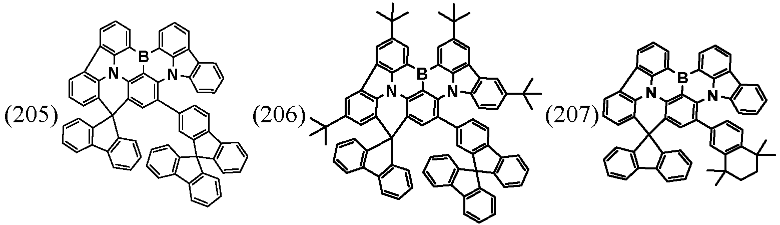

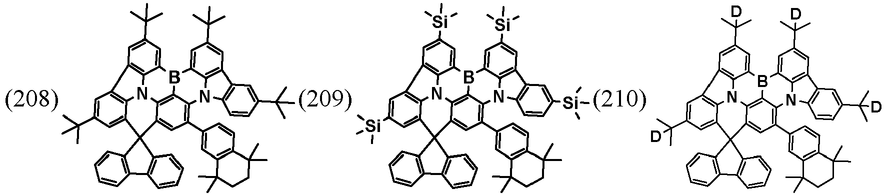

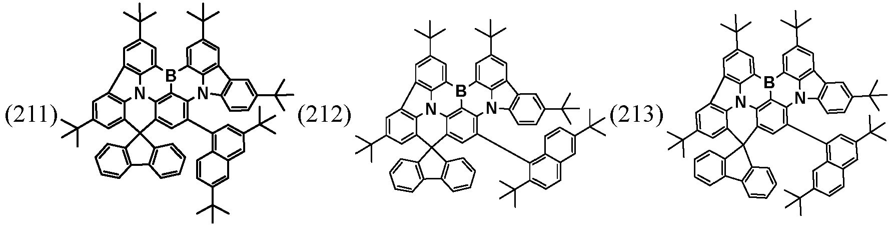

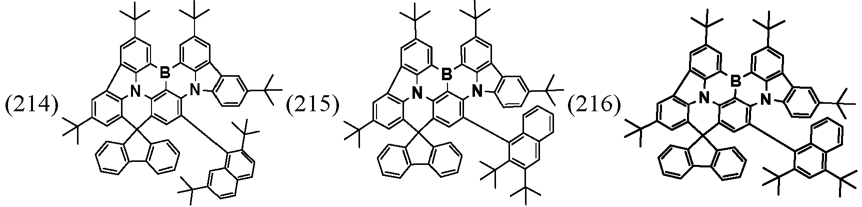

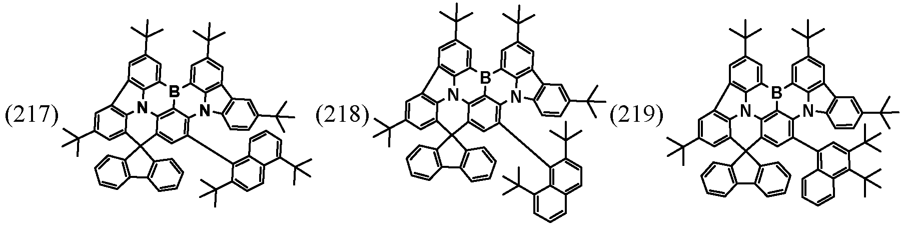

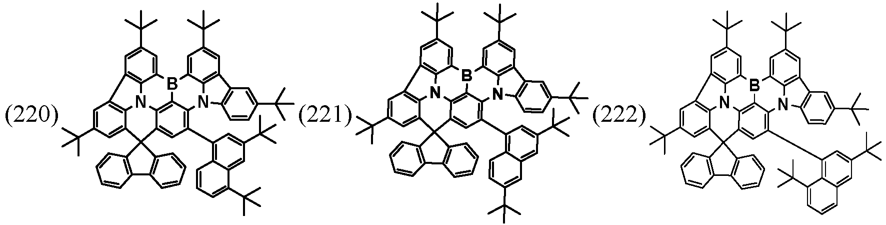

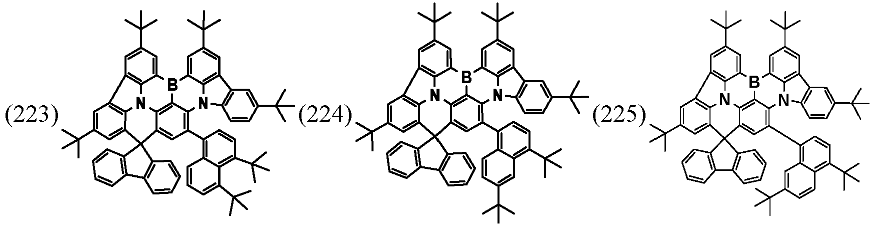

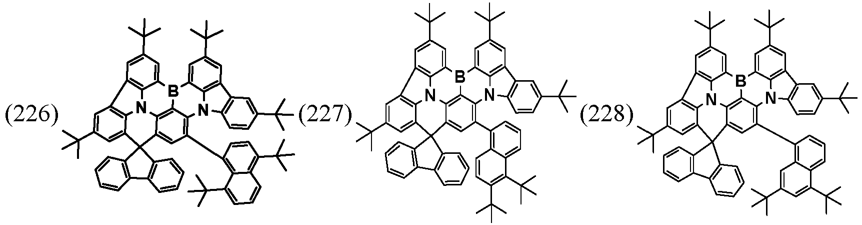

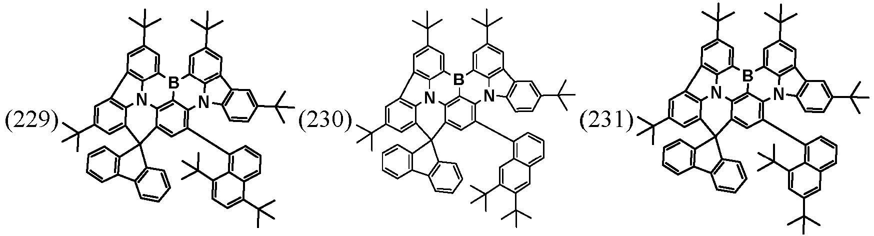

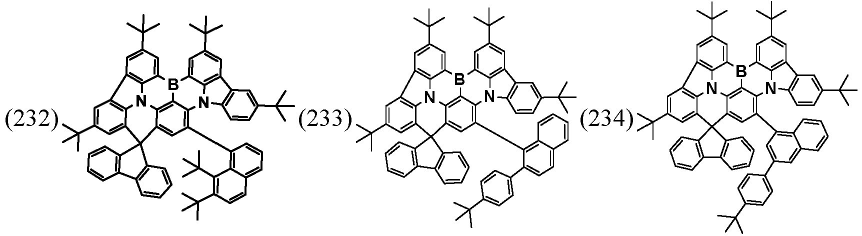

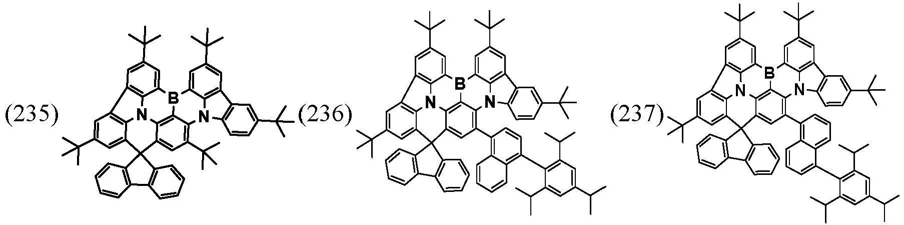

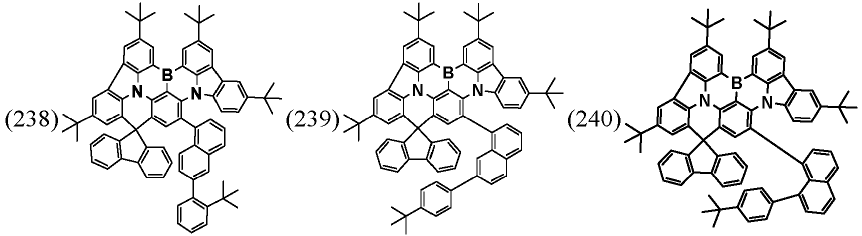

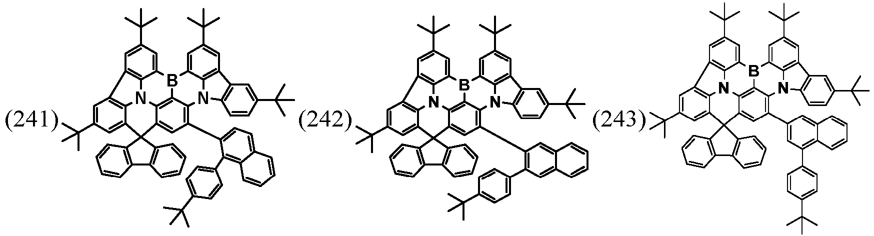

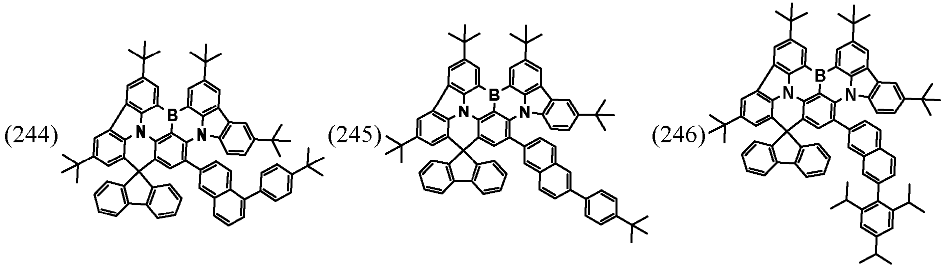

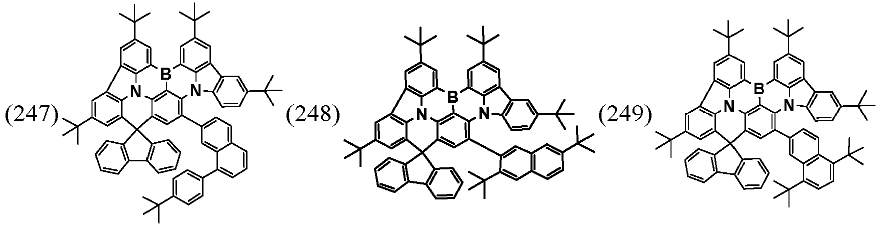

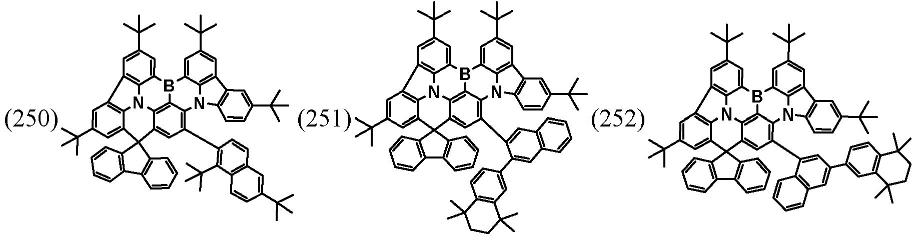

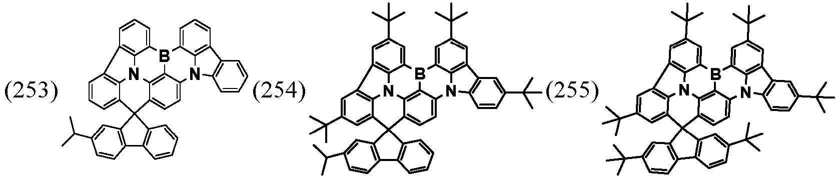

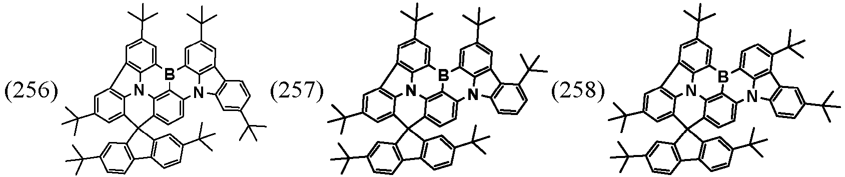

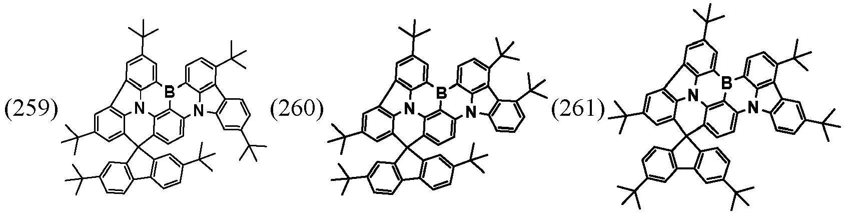

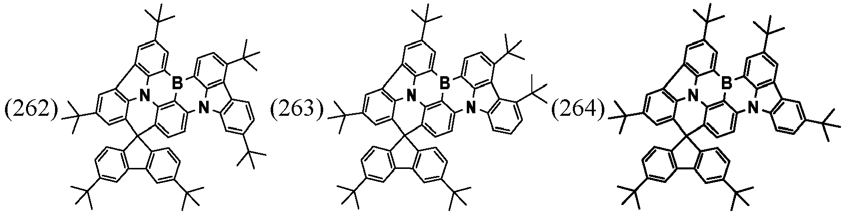

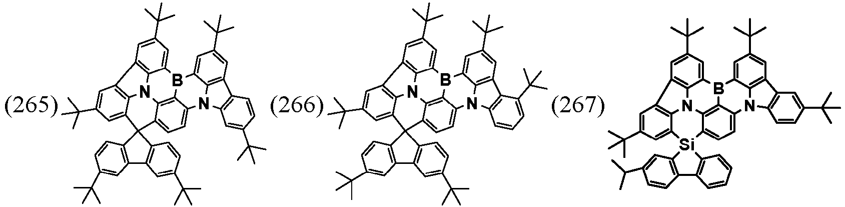

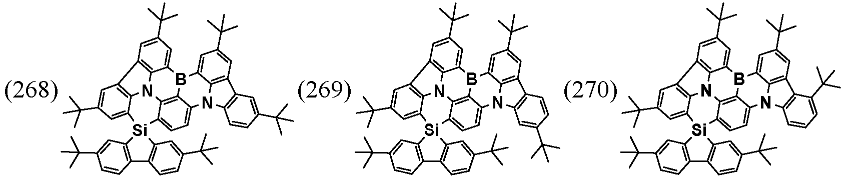

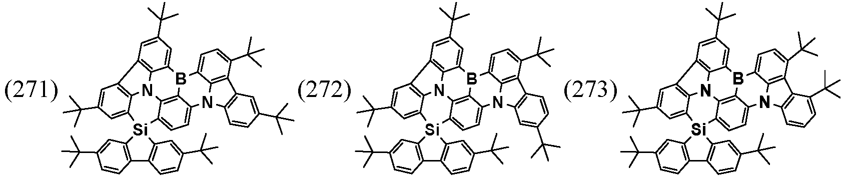

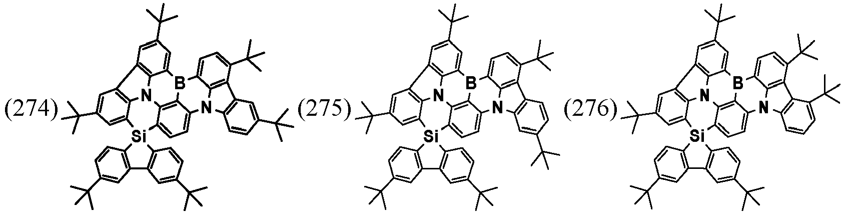

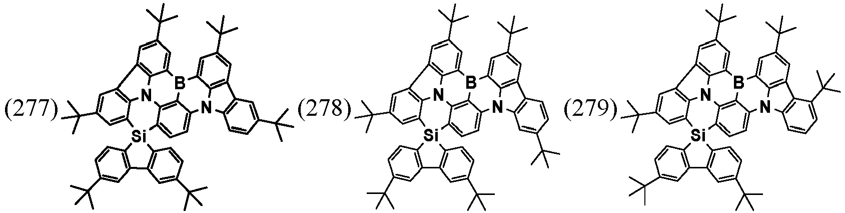

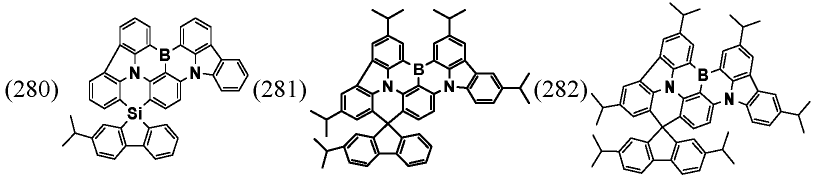

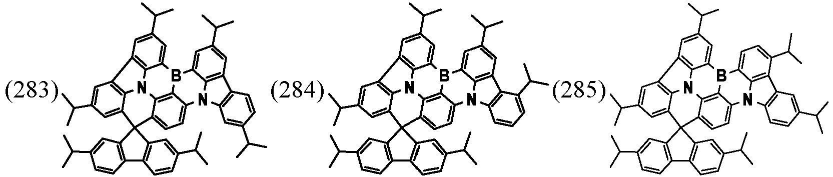

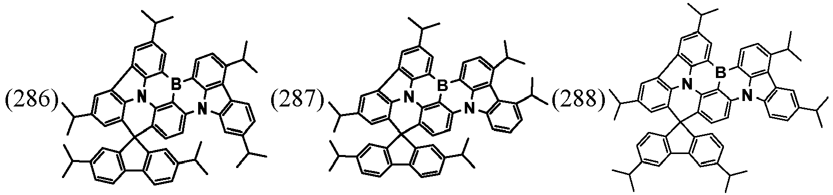

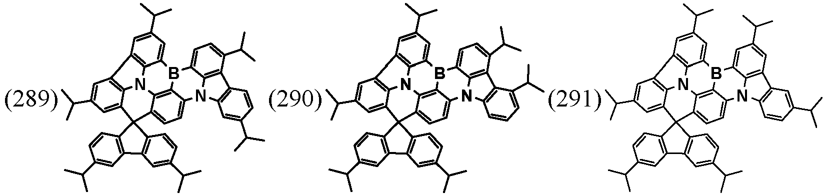

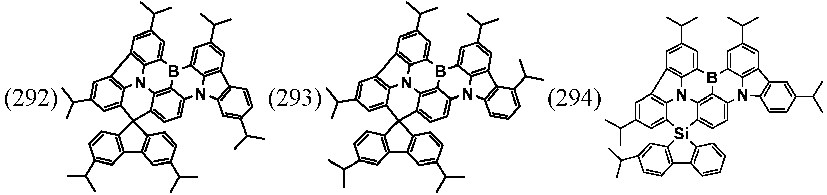

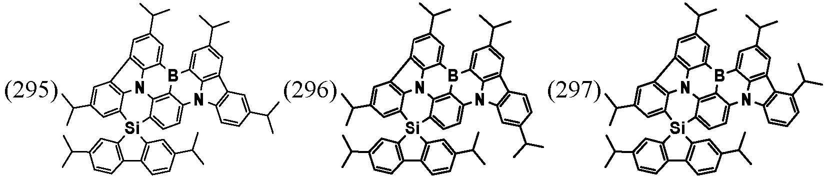

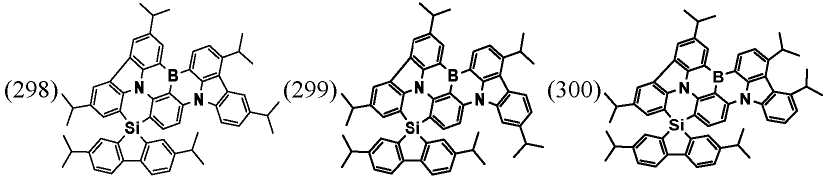

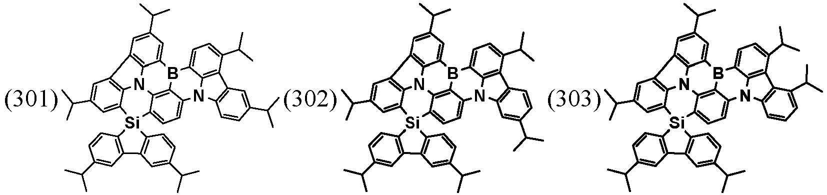

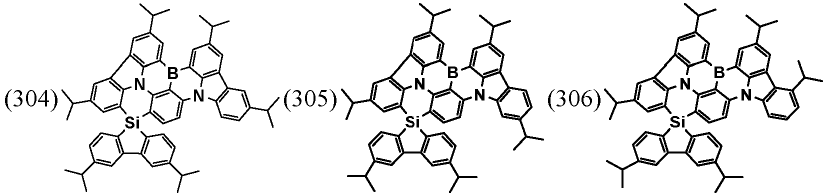

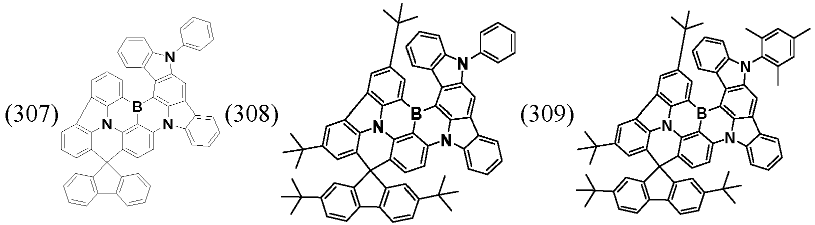

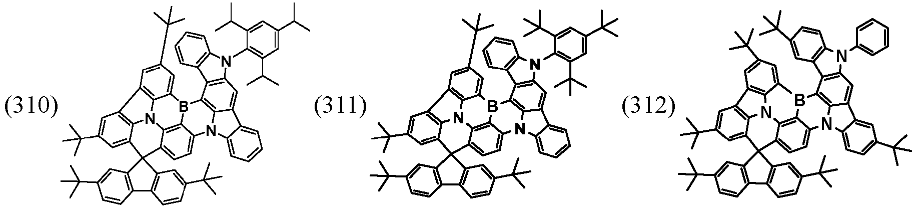

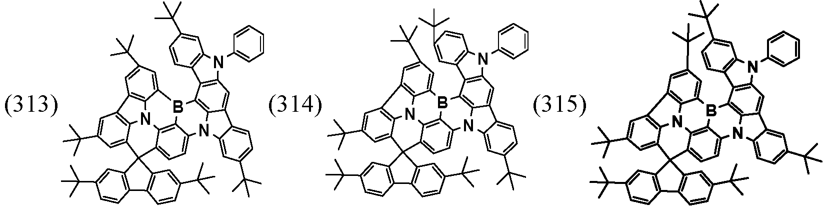

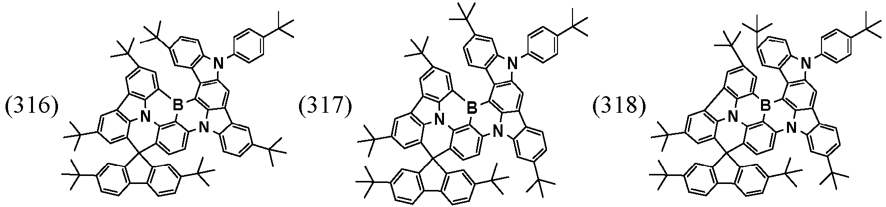

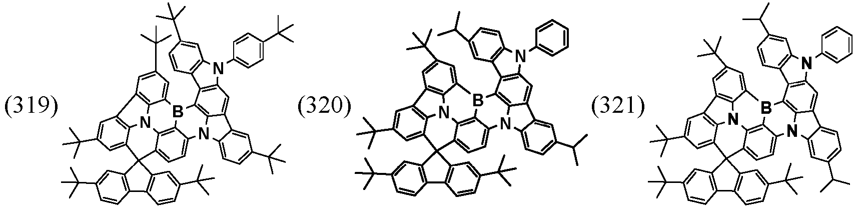

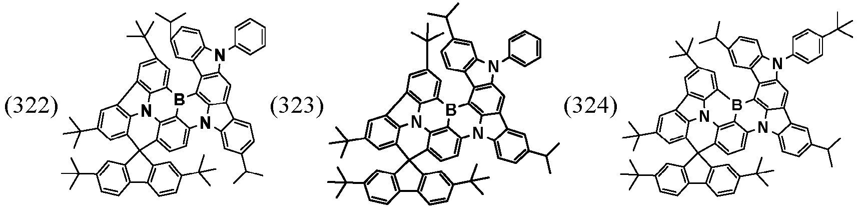

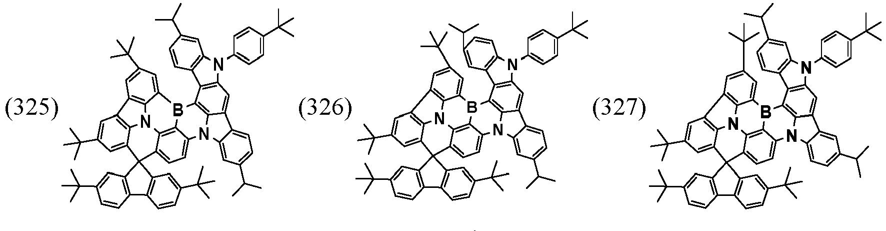

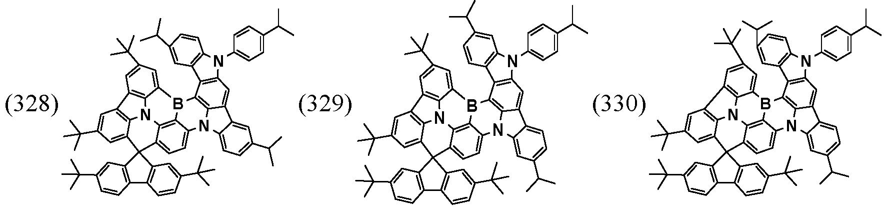

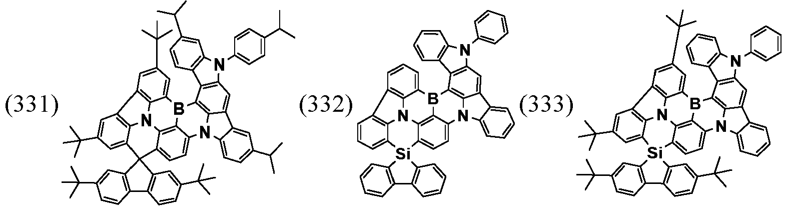

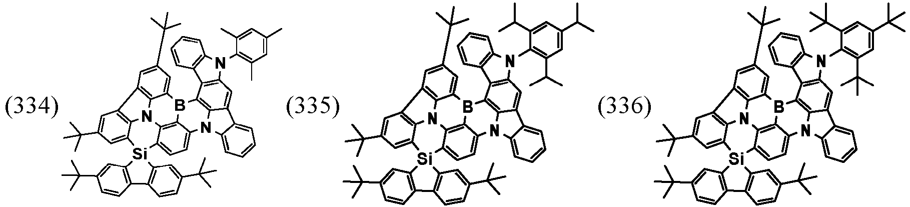

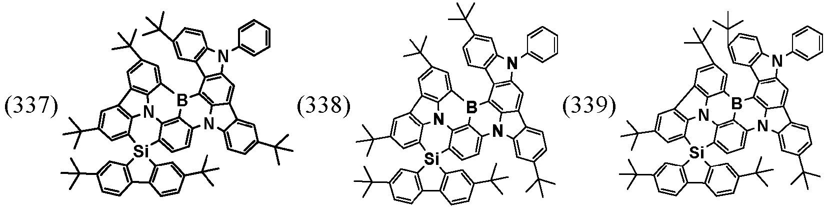

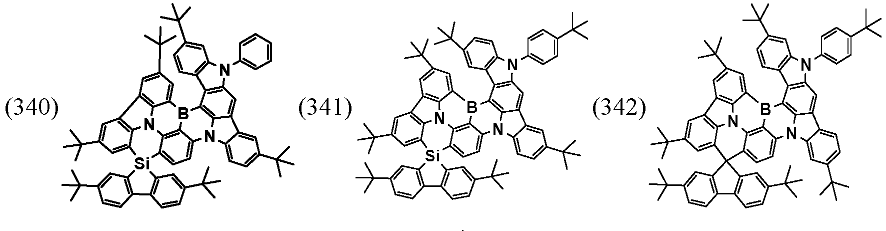

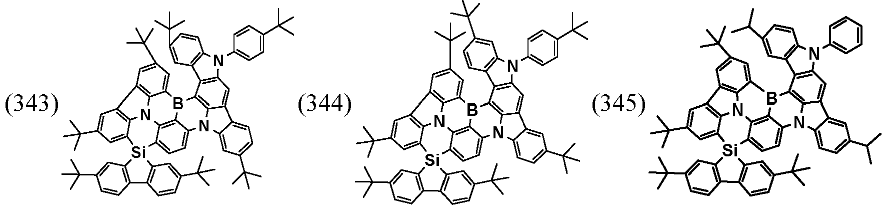

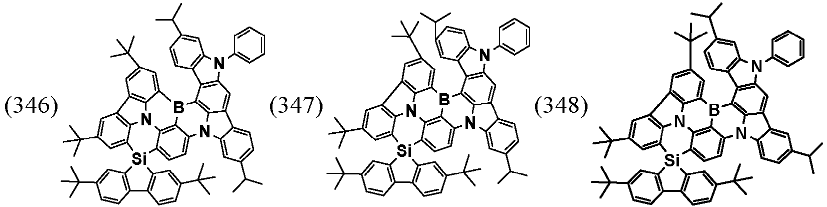

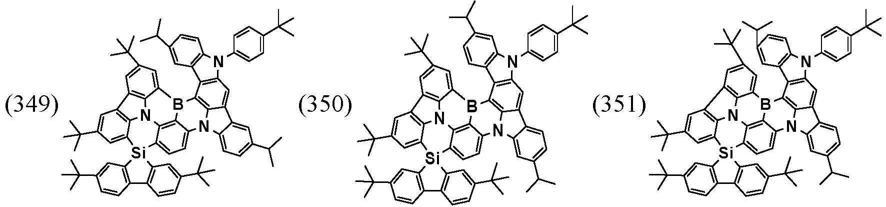

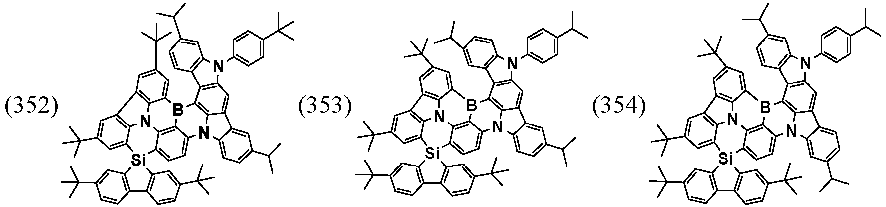

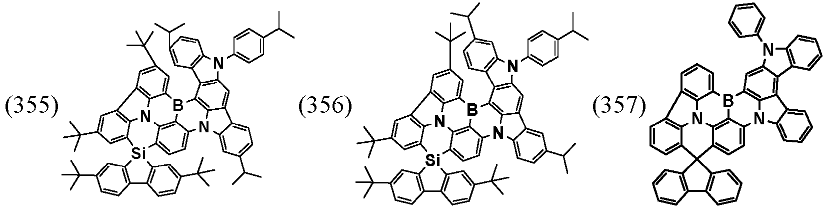

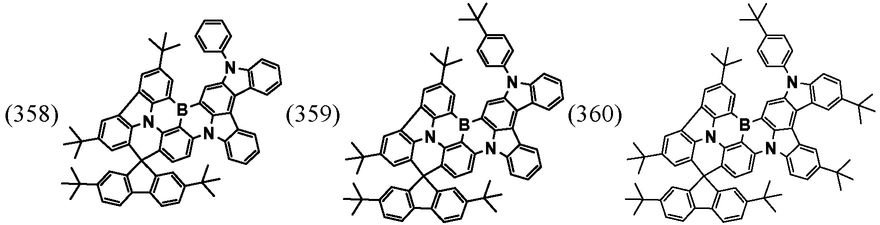

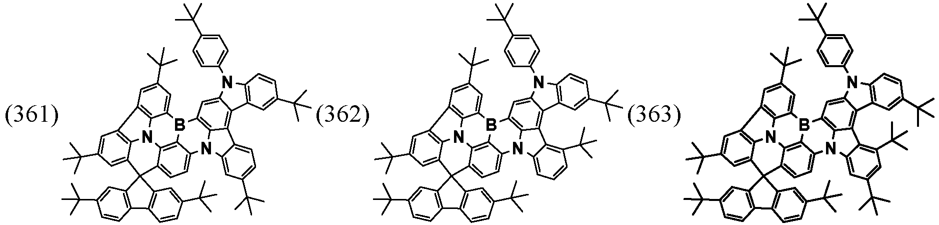

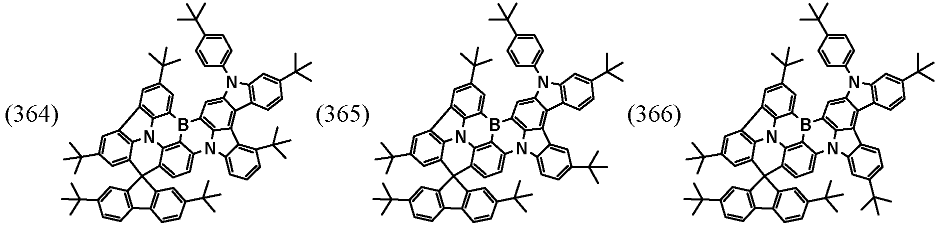

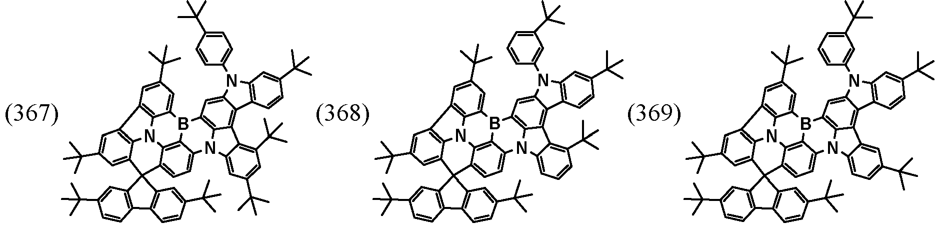

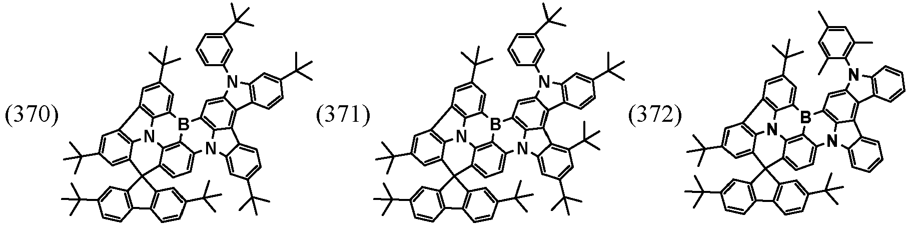

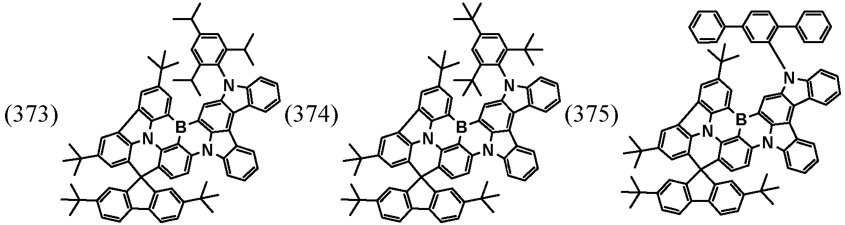

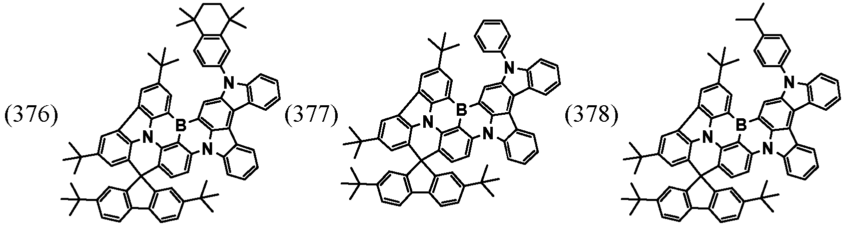

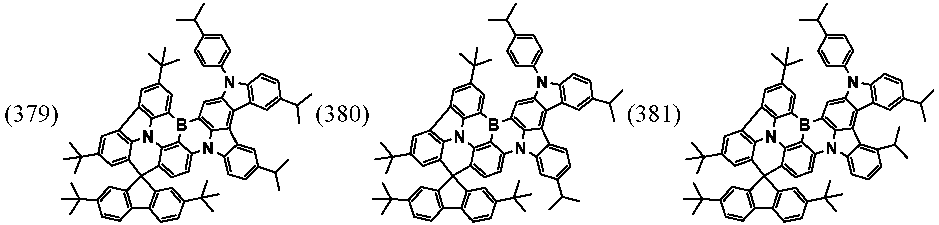

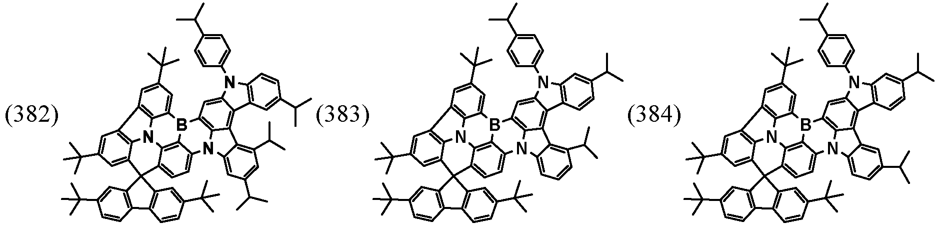

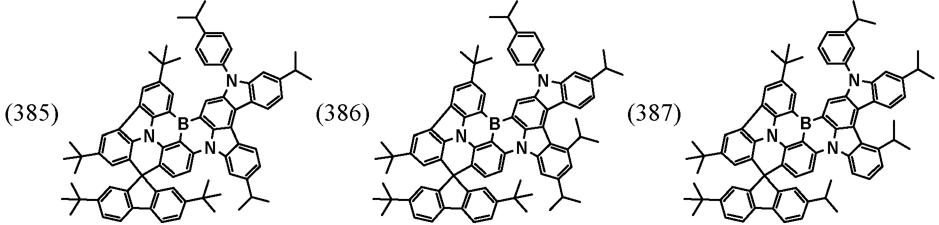

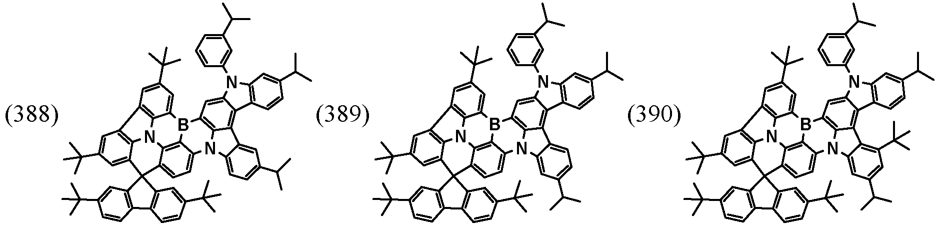

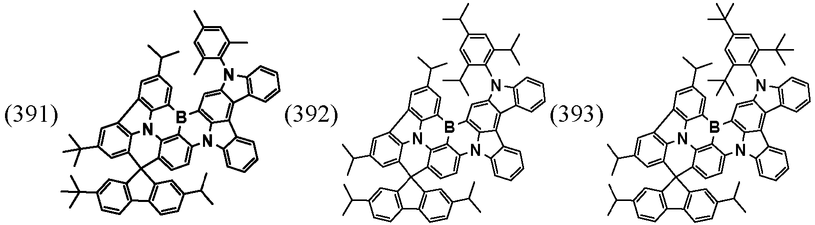

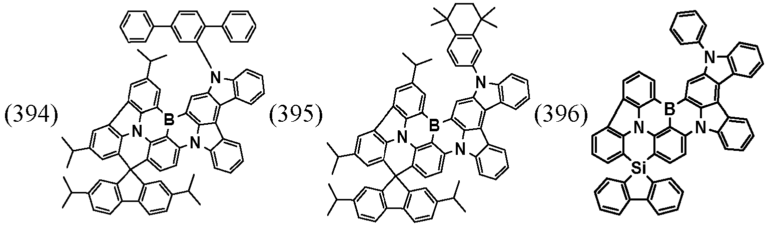

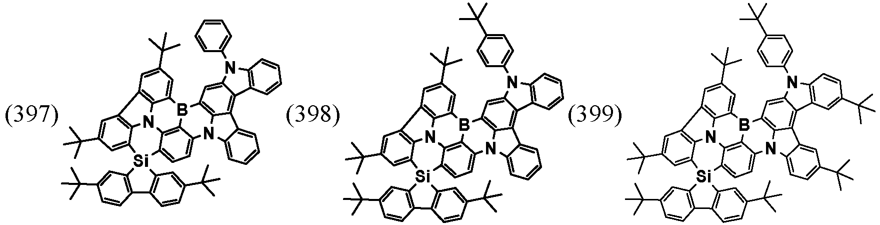

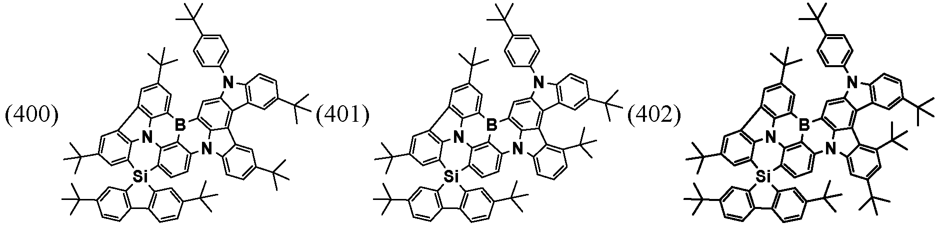

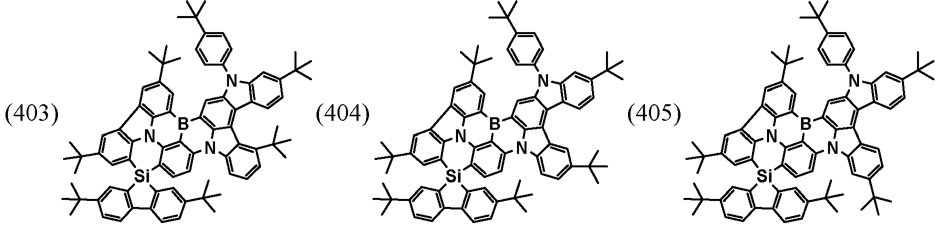

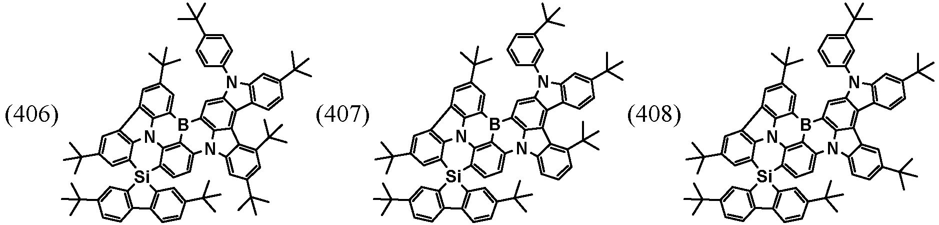

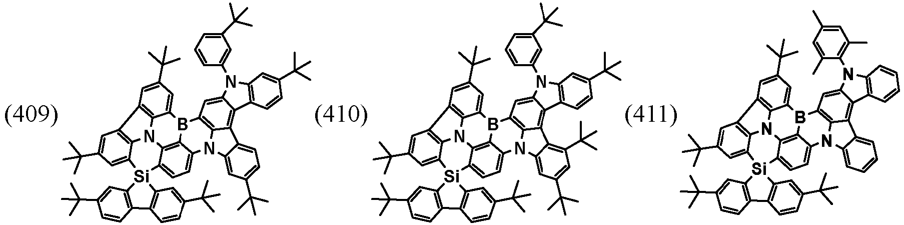

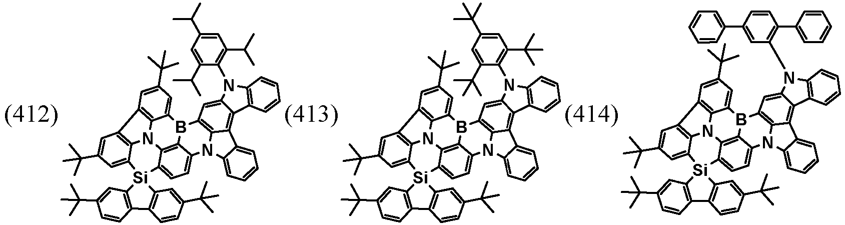

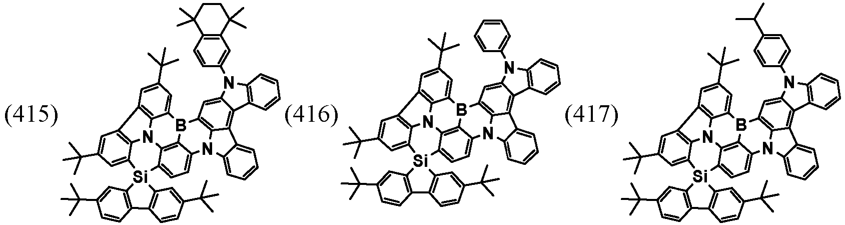

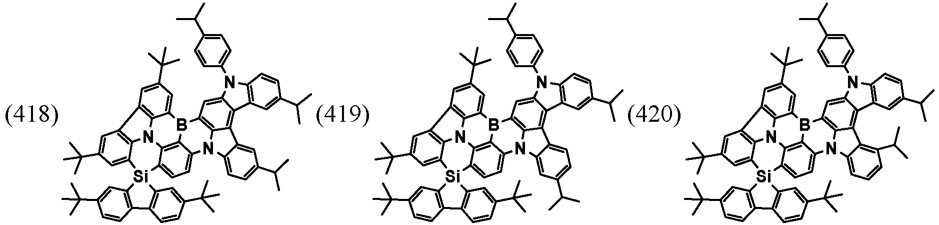

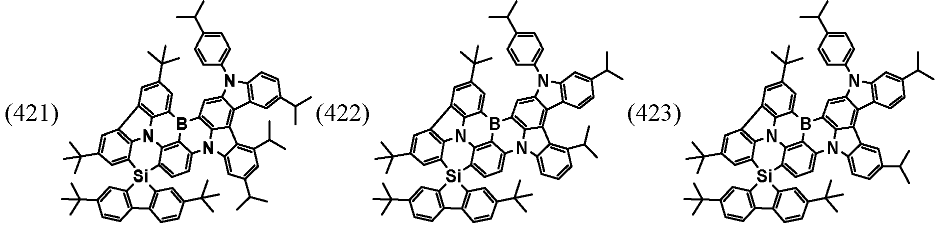

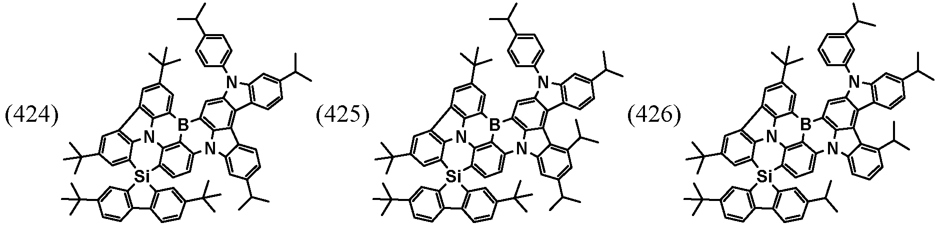

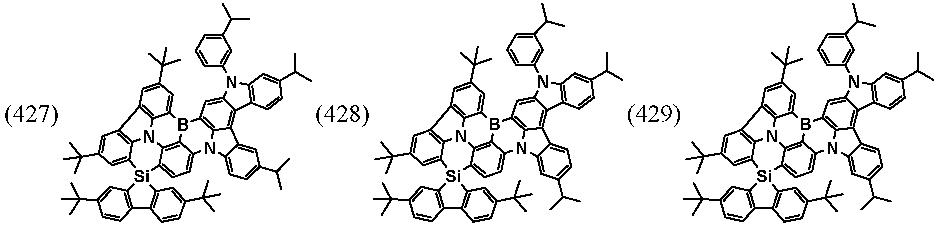

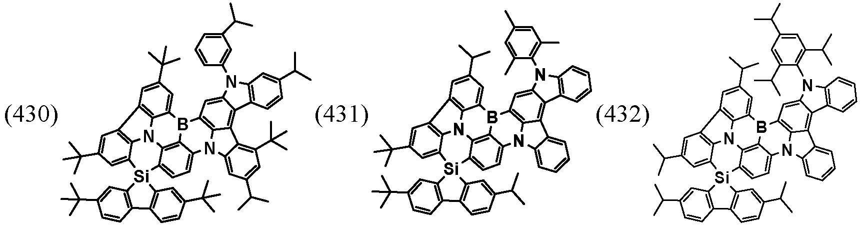

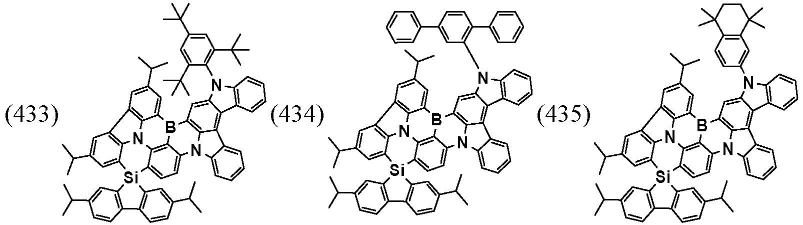

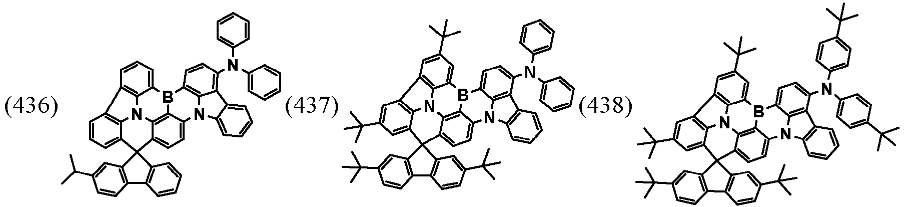

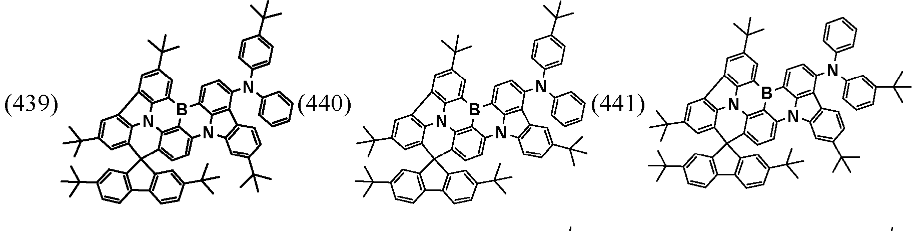

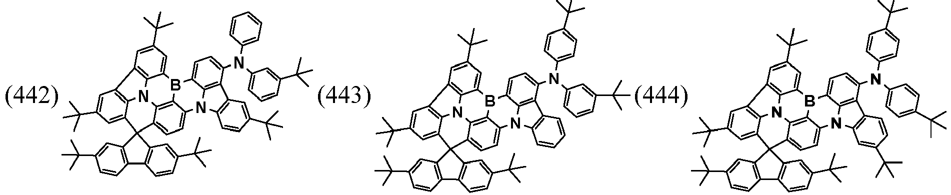

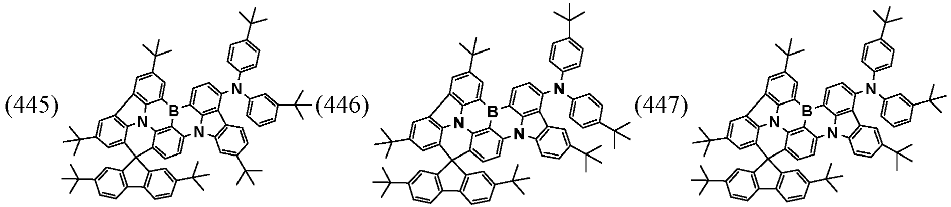

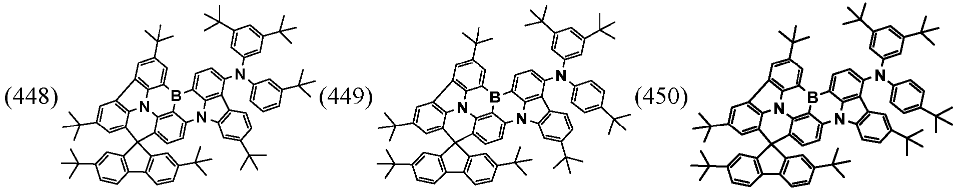

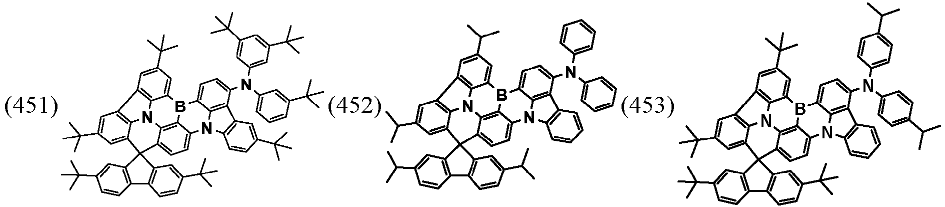

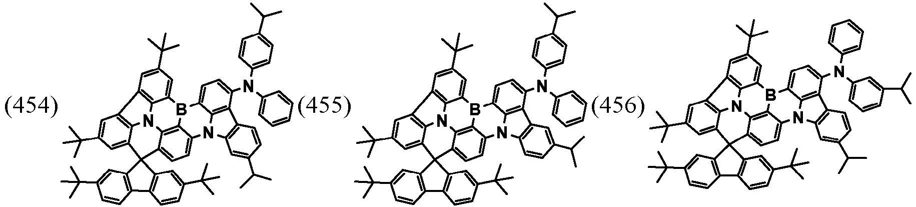

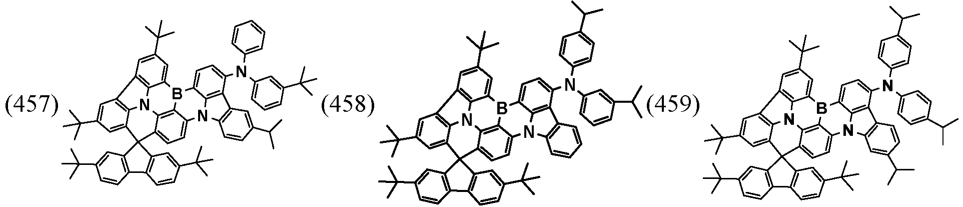

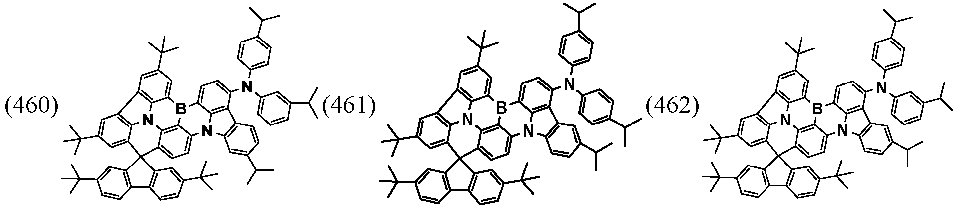

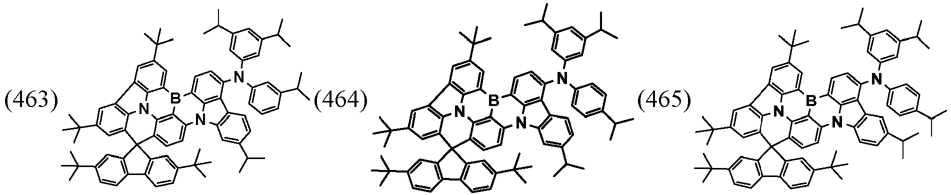

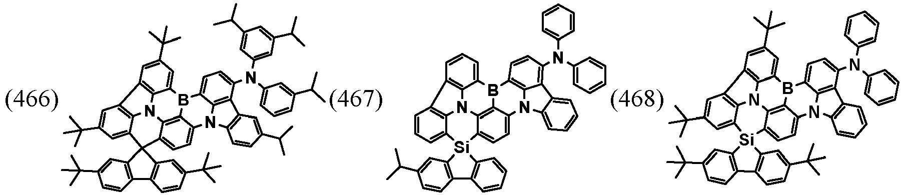

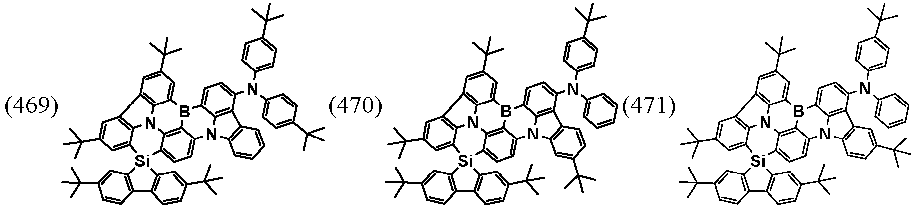

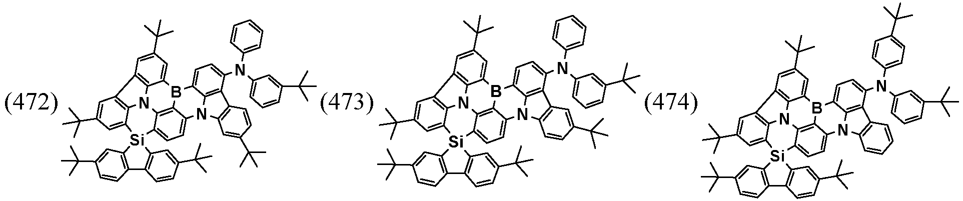

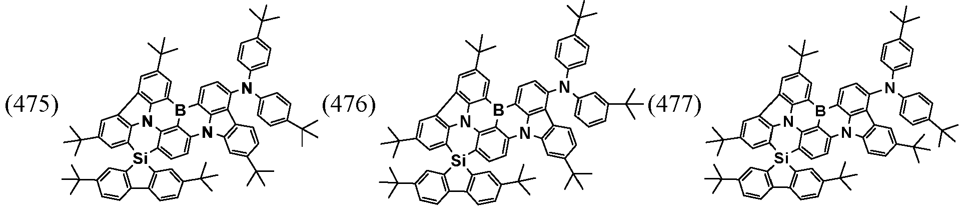

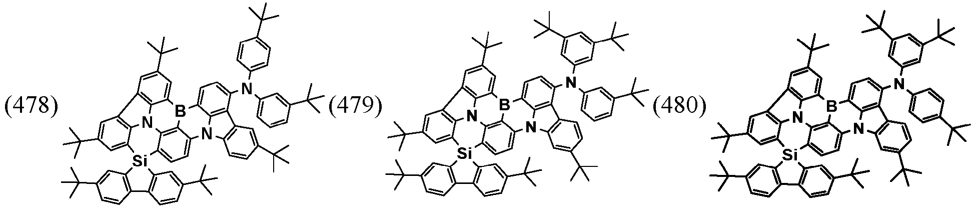

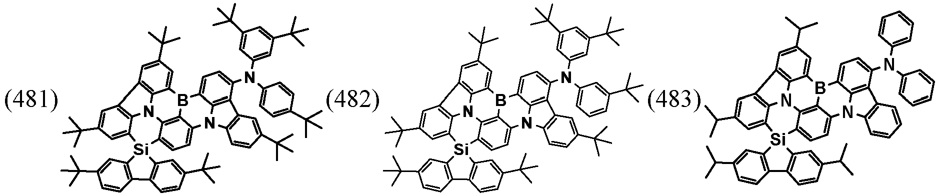

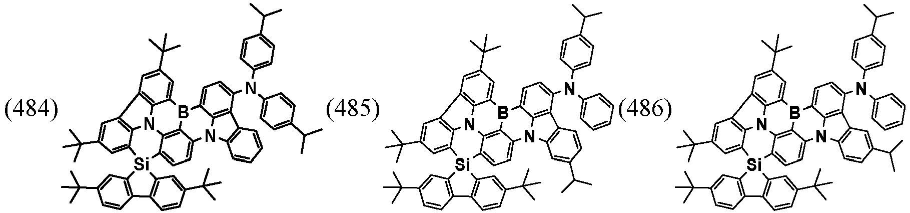

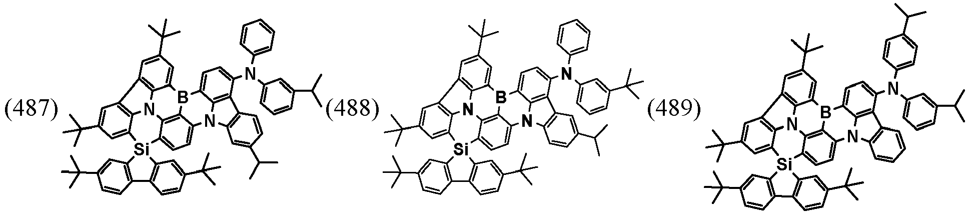

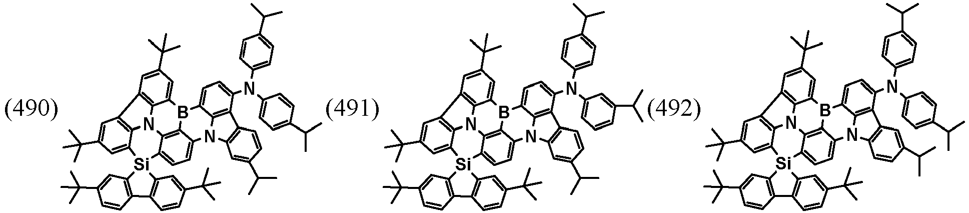

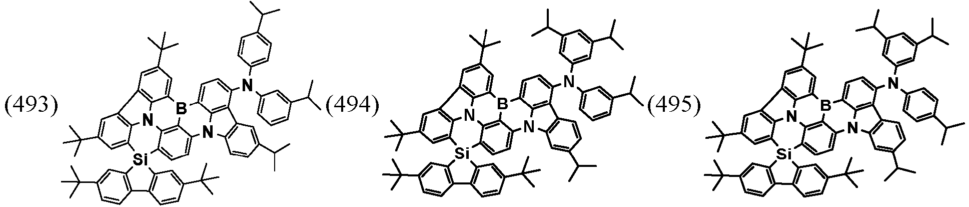

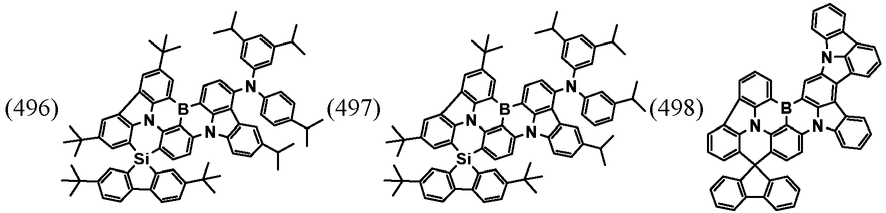

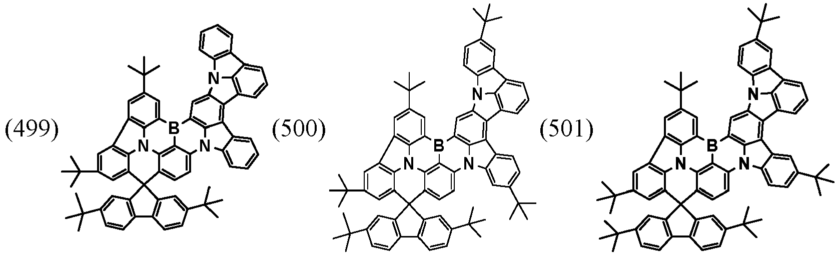

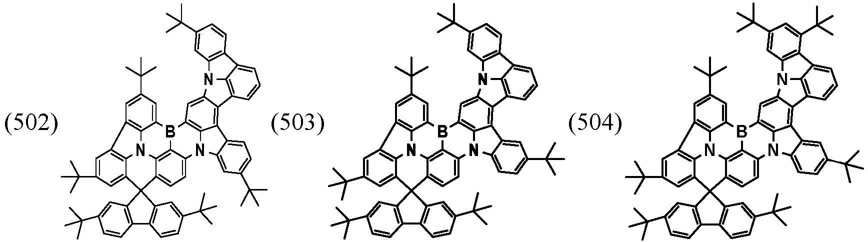

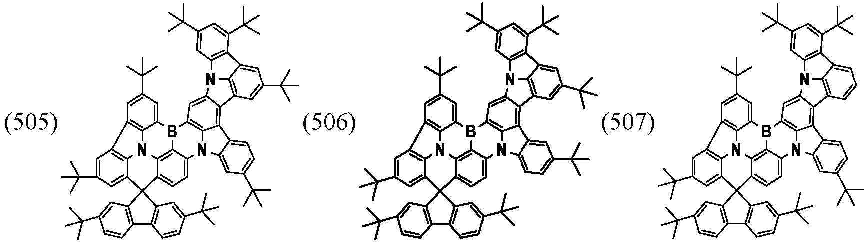

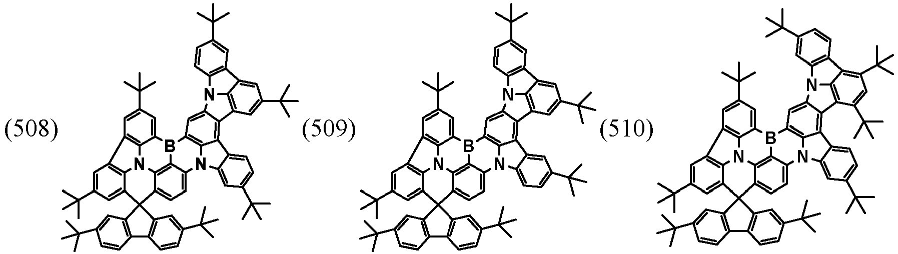

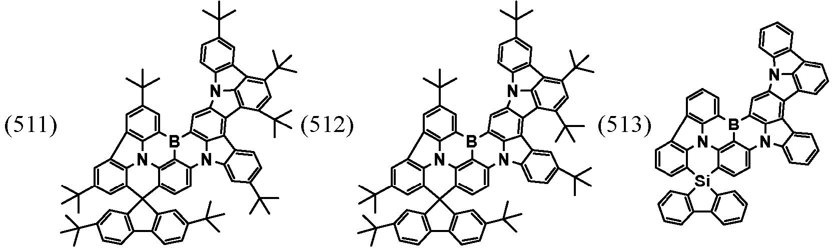

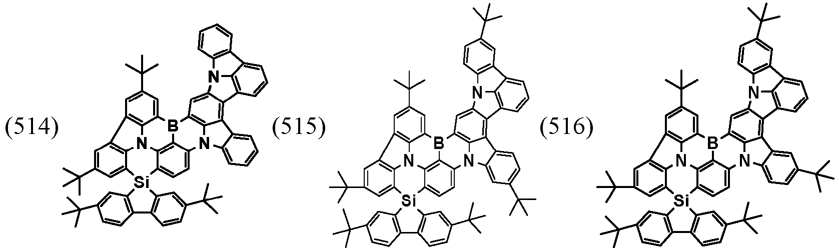

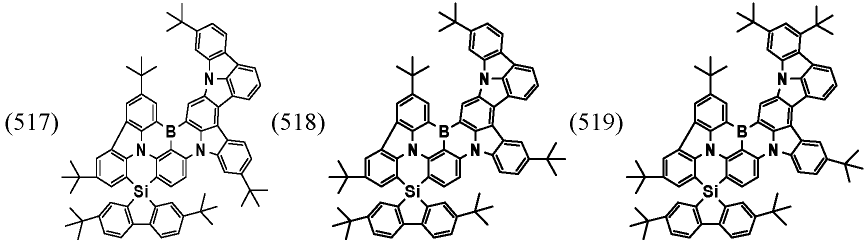

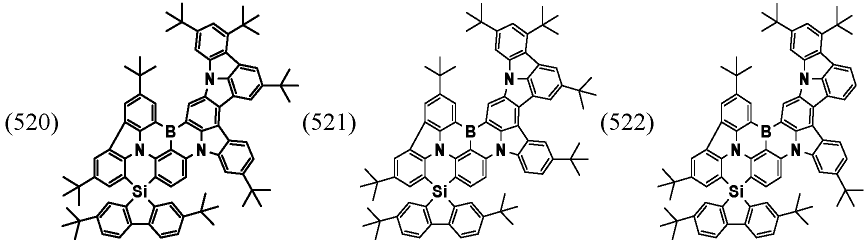

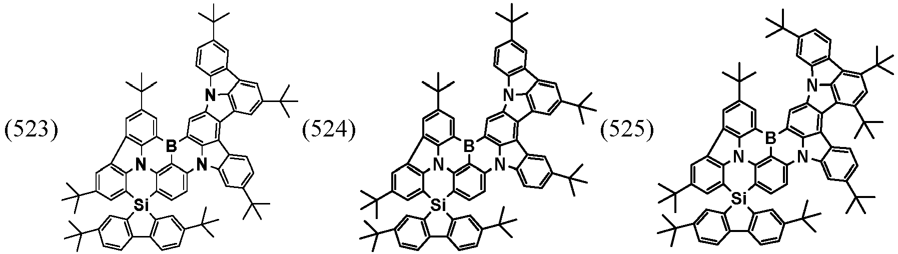

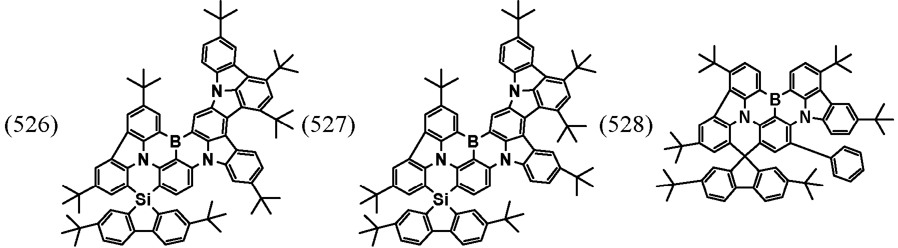

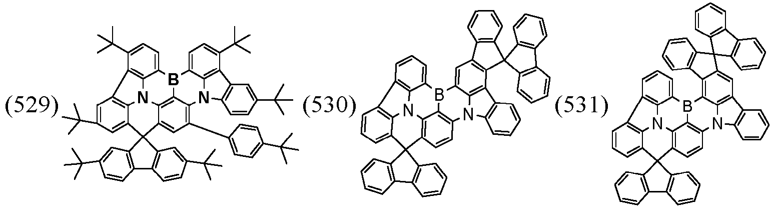

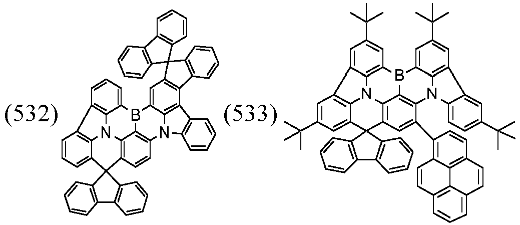

The present invention further provides an organic light-emitting device, including a substrate, a first electrode, a second electrode, and a functional layer sequentially, where the functional layer is located between the first electrode and the second electrode, and the functional layer includes the boron-containing resonance organic compound.

In a preferred solution, the functional layer includes a light-emitting layer, the light-emitting layer includes a host material and a doping material, and the doping material is the boron-containing resonance organic compound.

In a preferred solution, the functional layer includes a light-emitting layer, the light-emitting layer includes a first host material, a second host material, and a doping material, at least one of the first host material and the second host material is a TADF material, and the doping material is the boron-containing resonance organic compound.

In a preferred solution, the functional layer includes a light-emitting layer, the light-emitting layer includes a host material, an exciton-sensitizing material, and a doping material, the exciton-sensitizing material is a complex containing a metal element, and the doping material is the boron-containing resonance organic compound.

The present invention further provides a material for an organic electroluminescent device, including the foregoing boron-containing resonance organic compound according to the present invention.

The present invention further provides use of the boron-containing resonance organic compound in an organic electroluminescent device.

In a preferred solution, an organic light-emitting functional layer includes a light-emitting layer, and the boron-containing resonance organic compound in the present invention is used in the light-emitting layer.

The present invention further provides a display component, including the organic electroluminescent device according to the present invention.

The present invention further provides a lighting apparatus, including the organic electroluminescent device according to the present invention.

The present invention further provides an electronic device, carrying the organic electroluminescent device according to the present invention.

The organic electroluminescent device in the present invention may be a bottom-emitting organic electroluminescent device, a top-emitting organic electroluminescent device, or a tandem organic electroluminescent device. This is not specifically limited.

The organic electroluminescent device in the present invention includes a substrate, a first electrode, an organic light-emitting functional layer, and a second electrode. The organic light-emitting functional layer includes a hole transport region, a light-emitting layer, and an electron transport region. The hole transport region includes a hole injection layer, a hole transport layer, and an electron blocking layer. The electron transport region includes a hole blocking layer, an electron transport layer, and an electron injection layer. In addition, a CPL layer may be further provided on the second electrode.

Any substrate commonly used in the organic electroluminescent device may be used as the substrate of the organic electroluminescent device in the present invention, for example, a transparent substrate such as a glass or transparent PI film substrate, or an opaque substrate such as a silicon substrate. Different substrates have different mechanical strength, thermal stability, transparency, surface smoothness, and waterproofness. A direction in which the substrate is used varies based on different properties of the substrate. In the present invention, a transparent PI film substrate is preferably used. A thickness of the substrate is not specifically limited.

The first electrode is formed on the substrate. The first electrode and the second electrode may be opposite to each other. The first electrode may be an anode. The first electrode may be a transmissive electrode, a semi-transmissive electrode, or a reflective electrode. When the first electrode is a transmissive electrode, the first electrode may be formed by using a transparent metal oxide, such as an indium-tin oxide (ITO), an indium-zinc oxide (IZO), zinc oxide (ZnO), or an indium-tin-zinc oxide (ITZO). When the first electrode is a semi-transmissive electrode or a reflective electrode, the first electrode may include Ag, Mg, Al, Pt, Pd, Au, Ni, Nd, Ir, Cr, or another metal, or may be an alloy of several metals, or a combination of a metal, a metal oxide, and a metal alloy. A thickness of the first electrode layer depends on a material used, and is usually 50 nm to 500 nm, preferably 70 nm to 300 nm, more preferably 100 nm to 200 nm.

An organic functional material layer provided between the first electrode and the second electrode sequentially includes, from bottom to top, a hole transport region, a light-emitting layer, and an electron transport region.

In the present invention, the hole transport region of the organic electroluminescent device may be listed as a hole injection layer, a hole transport layer, an electron blocking layer, and the like.

Any material may be selected from known related materials for organic electroluminescent devices to be used as a material of the hole injection layer, the hole transport layer, and the electron blocking layer.

The hole injection layer includes a host organic material that can conduct holes, and also includes a P-type doping material with a deep HOMO energy level (a corresponding LUMO energy level is also very deep). Based on an empirical summary, to implement smooth injection of holes from the anode to an organic film layer, as long as a HOMO energy level of a host organic material used for a buffer layer on an interface of the anode to conduct holes has specific characteristics with that of the P-type doping material, a charge transfer state between the host material and the doping material can be generated, and ohmic contact between the buffer layer and the anode can be formed, implementing efficient injection from the electrode to hole injection conduction.

In view of the foregoing empirical summary, different P-type doping materials are required to match hole host organic materials with different HOMO energy levels, so that ohmic contact on the interface can be formed, improving hole injection effect.

In an implementation of the present invention, the hole injection layer includes a charge-conductive P-type doping material selected from the following: quinone derivatives such as tetracyanoquinodimethane (TCNQ) and 2,3,5,6-tetrafluoro-tetracyano-1,4-benzoquinodimethane (F4-TCNQ); or hexaazatriphenylene derivatives such as 2,3,6,7,10,11-hexacyano-1,4,5,8,9,12-hexaazatriphenylene (HAT-CN); or cyclopropane derivatives such as 2-(7-dicyanomethylene-1,3,4,5,6,8,9,10-octafluoro-7H-pyrene-2-ylidene)-malononitrile; or metal oxides such as tungsten oxide and molybdenum oxide, but not limited thereto.

In the hole injection layer of the present invention, a ratio of the used hole transport material to the P-type doping material is 99:1 to 95:5, preferably 99:1 to 97:3, by mass.

A thickness of the hole injection layer of the present invention may be 5 nm to 100 nm, preferably 5 nm to 50 nm, more preferably 5 nm to 20 nm, but the thickness is not limited to this range.

Preferably, a material of the hole transport layer of the present invention may be optionally selected from the following compounds disclosed in the conventional technology:

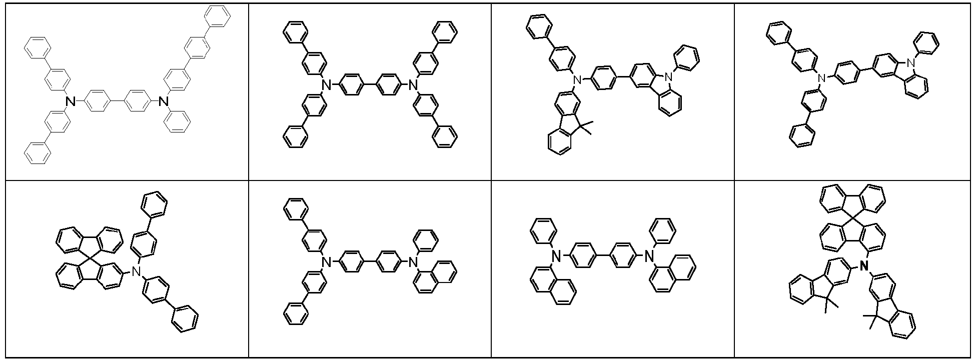

Preferably, the material of the hole transport layer and the host organic material in the hole injection layer of the present invention are selected from a same compound.

A thickness of the hole transport layer of the present invention may be 5 nm to 200 nm, preferably 10 nm to 150 nm, more preferably 20 nm to 100 nm, but the thickness is not limited to this range.

In an implementation of the present invention, a material of the electron blocking layer of the present invention may be optionally selected from the following compounds disclosed in the conventional technology:

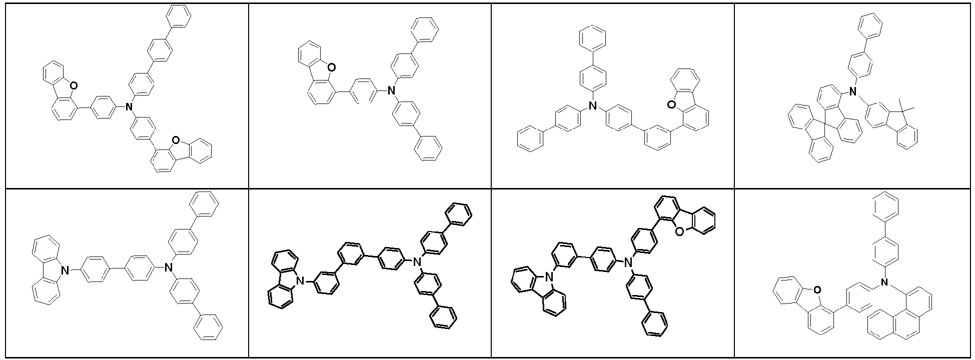

A thickness of the electron blocking layer of the present invention may be 1 nm to 50 nm, preferably 5 nm to 40 nm, but the thickness is not limited to this range.

After the hole injection layer, the hole transport layer, and the electron blocking layer are formed, a corresponding light-emitting layer is formed on the electron blocking layer.

The light-emitting layer may include a host material and a doping material. A green light host material common in the art may be used for the host material. The boron-containing resonance organic compound shown in general formula (1) in the present invention is used for the doping material.

The light-emitting layer may include a single-host material or a double-host material.

The double-host material includes a first host material and a second host material. Preferably, at least one of the first host material and the second host material is a TADF material.

The TADF material is a material with thermally activated delayed fluorescence properties, characterized by a small energy gap between a first excited singlet state and a first excited triplet state. In this case, both generated singlet excitons and triplet excitons can be used in the device, so that a utilization rate of excitons generated by excitation inside the device can be as close to 100% as possible. Compared with a conventional fluorescent material, the TADF material has a higher exciton utilization rate.

The light-emitting layer may include a host material, an exciton-sensitizing material, and a doping material.

The exciton-sensitizing material is a material that enables a light-emitting material in the light-emitting layer to make full use of excitons, so that the light-emitting layer exhibits an emission spectrum of a sensitized material. An exciton sensitizer may provide functions such as exciton capture, exciton conversion, and exciton transfer in the electroluminescent device. The combination of the boron-containing resonance organic compound shown in general formula (1) of the present invention and the exciton-sensitizing material significantly improves device efficiency and resolves problems such as exciton annihilation in the device and efficiency reduction.

In the light-emitting layer of the present invention, a ratio of the used host material to the doping material is 99:1 to 70:30, preferably 99:1 to 85:15, more preferably 97:3 to 87:13, by mass.

A thickness of the light-emitting layer may be adjusted to optimize light-emitting efficiency and a drive voltage. A preferred thickness range is 5 nm to 50 nm, further preferably 10 nm to 50 nm, more preferably 15 nm to 40 nm, but the thickness is not limited to this range.

In the present invention, the electron transport region may sequentially include, from bottom to top, a hole blocking layer, an electron transport layer, and an electron injection layer that are provided on the light-emitting layer, but is not limited thereto.

The hole blocking layer is a layer that blocks holes injected from the anode to pass through the light-emitting layer to enter the cathode, thereby prolonging a lifetime of the device and improving efficiency of the device. The hole blocking layer of the present invention may be provided on the light-emitting layer. A compound known in the conventional technology with a hole blocking function may be used for a material of the hole blocking layer of the organic electroluminescent device of the present invention, for example:

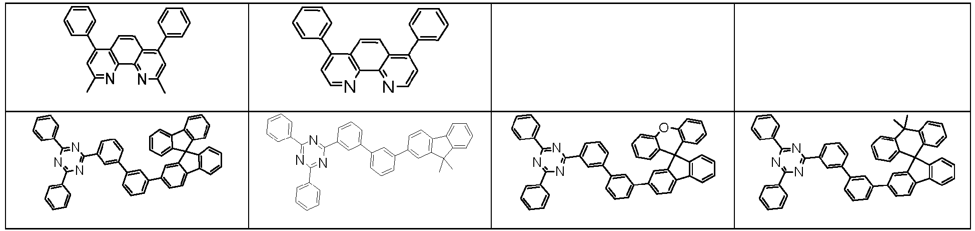

A thickness of the hole blocking layer of the present invention may be 2 nm to 200 nm, preferably 5 nm to 150 nm, more preferably 5 nm to 50 nm, but the thickness is not limited to this range.

The electron transport layer may be provided on the light-emitting layer or the hole blocking layer (if present). A material of the electron transport layer is a material that can easily receive electrons from the cathode and transfer the received electrons to the light-emitting layer. A material with high electron mobility is preferred. A material disclosed in the conventional technology for an electron transport layer of an organic electroluminescent device may be used for the electron transport layer of the organic electroluminescent device of the present invention, for example:

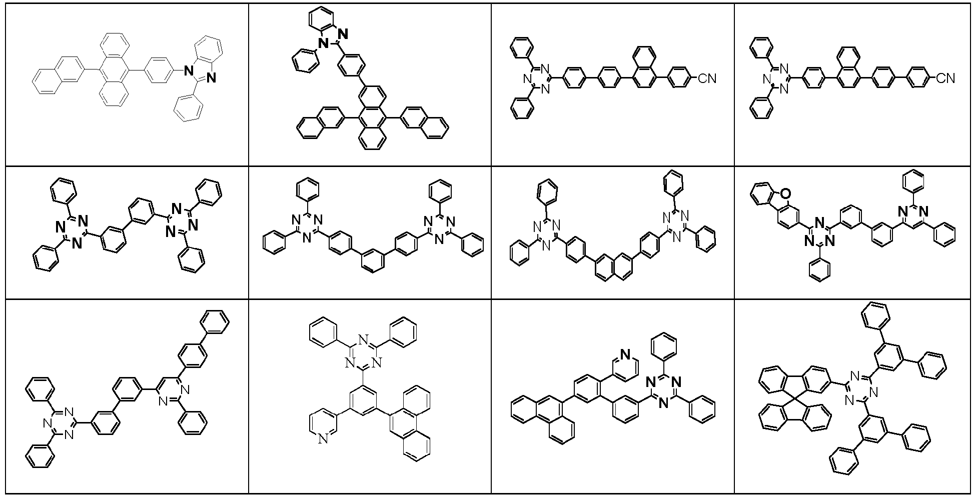

In a preferred implementation of the present invention, the electron transport layer further includes another conventional compound for the electron transport layer, such as Alq3 or LiQ, preferably LiQ.

A thickness of the electron transport layer of the present invention may be 10 nm to 80 nm, preferably 20 nm to 60 nm, more preferably 25 nm to 45 nm, but the thickness is not limited to this range.

The electron injection layer may be provided on the electron transport layer. Usually, a material of the electron injection layer is preferably a material with a low work function, so that electrons are easily injected into the organic functional material layer. A material disclosed in the conventional technology for an electron injection layer of an organic electroluminescent device may be used for the material of the electron injection layer of the organic electroluminescent device of the present invention, such as LiF, Cs₂CO₃, CsF, Csq, NaF, MgF₂, CaF₂, Al₂O₃, and Yb.

A thickness of the electron injection layer of the present invention may be 0.1 nm to 5 nm, preferably 0.5 nm to 3 nm, more preferably 0.8 nm to 1.5 nm, but the thickness is not limited to this range.

The second electrode may be provided on the electron transport region. The second electrode may be a cathode. The second electrode may be a transmissive electrode, a semi-transmissive electrode, or a reflective electrode. When the second electrode is a transmissive electrode, the second electrode may include, for example, Li, Yb, Ca, LiF/Ca, LiF/Al, Al, Mg, BaF₂, Ba, Ag, or a compound or mixture thereof. When the second electrode is a semi-transmissive electrode or a reflective electrode, the second electrode may include Ag, Mg, Yb, Al, Pt, Pd, Au, Ni, Nd, Ir, Cr, Li, Ca, LiF/Ca, LiF/Al, Mo, Ti, or a compound or mixture thereof, but is not limited thereto. A thickness of the cathode depends on a material used.

The organic electroluminescent device of the present invention may further include a packaging structure. The packaging structure may be a protective structure that prevents external substances such as moisture and oxygen from entering the organic layer of the organic electroluminescent device. The packaging structure may be, for example, a can, such as a glass can or a metal can; or a film covering the entire surface of the organic layer.

A method for preparing the organic electroluminescent device in the present invention includes laminating an anode, a hole injection layer, a hole transport layer, an electron blocking layer, an organic film layer, an electron transport layer, an electron injection layer, a cathode, and an optional cover layer successively on a substrate. For this method, vacuum deposition, vacuum evaporation, spin coating, casting, an LB method, inkjet printing, laser printing, LITI, or another method may be used, but are not limited thereto. In the present invention, the layers are formed preferably by using a vacuum evaporation method. A person skilled in the art may generally select process conditions for the vacuum evaporation method according to an actual requirement.

### Preparation of compounds

### Embodiment 1 Synthesis of compound 5:

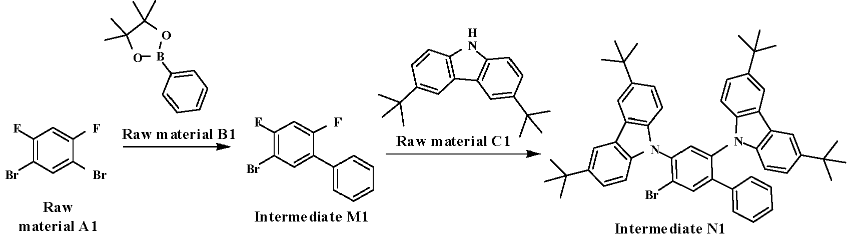

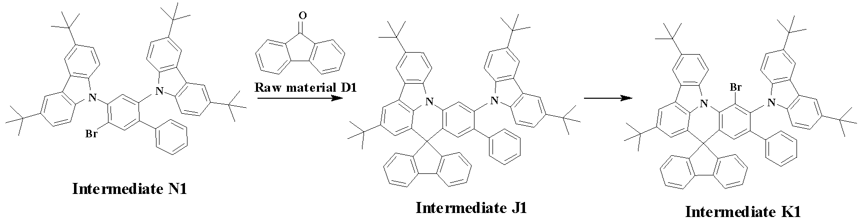

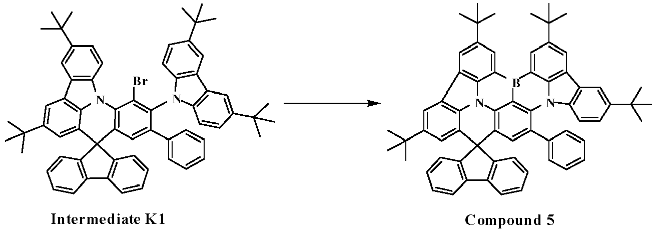

### Synthesis of intermediate M1:

Raw material A1 (11 mmol, 2.99 g) and raw material B1 (10 mmol, 2.04 g) are added to a three-neck flask and dissolved with a mixed solvent (70 mL of toluene, 35 mL of ethanol), and then Pd(PPh₃)₄ (0.10 mmol, 0.12 g) and 15 mL of 3 mol/L aqueous K₂CO₃ solution are added. The mixture is heated and refluxed under nitrogen protection to react for 12 h. The reaction mixture is sampled and spotted on a plate to confirm that the reaction is completed. After cooled down to room temperature, the reaction mixture is filtered through a diatomaceous earth pad, and washed with chloroform. The resulting filtrate is evaporated under vacuum. The obtained residue is purified by silica gel column chromatography with hexane/toluene as an eluent to obtain intermediate M1.

### Synthesis of intermediate N1:

Intermediate M1 (18.4 mmol, 4.95 g) and cesium carbonate (55.2 mmol, 18.0 g) are added to a two-neck flask, and 120 mL of anhydrous DMF is added under nitrogen protection. The mixture is stirred at room temperature for 30 min. Raw material C1 (40.5 mmol, 11.32 g) is added under nitrogen protection. The solution is refluxed under magnetic stirring for 24 h, and then cooled down, filtered, washed, dried, and subject to column chromatography to obtain intermediate N1.

### Synthesis of intermediate J1:

Intermediate N1 (5.1 mmol, 4.02 g) is dissolved in 50 mL of tetrahydrofuran (THF) solution. 2.3 mL of solution of n-butyllithium (2.5 M, 5.7 mmol) in n-hexane is slowly added at - 78°C with nitrogen introduced. The mixture is stirred at -78°C for 2 h. Then, 15 mL of solution of raw material D1 (5.5 mmol, 1.0 g) in tetrahydrofuran is slowly added. Then, the reaction mixture is warmed slowly to room temperature and stirred overnight. 20 mL of dilute hydrochloric acid (1 M) solution, distilled water, and ethyl acetate are added to the reaction mixture. The aqueous layer is separated and subject to extraction with ethyl acetate three times. The organic layers are combined and dried over sodium sulfate, and then filtered. The solvent is removed under reduced pressure. Then, the crude product is dissolved in anhydrous dichloromethane. Then, 47% boron trifluoride-diethyl ether is added slowly. The reaction mixture is stirred overnight and then quenched slowly with an aqueous NaHCO₃ solution. Then, the aqueous layer is separated, subject to extraction with dichloromethane, dried over sodium sulfate, filtered, concentrated through rotary evaporation, and subject to column chromatography, to obtain intermediate J1.

### Synthesis of intermediate K1:

Intermediate J1 (20.0 mmol, 17.42 g) and 200 mL of glacial acetic acid are sequentially added to a three-neck flask under nitrogen protection. The mixture is cooled down in a cryogenic bath to 0°C and has to be protected from light. NBS (25 mmol, 4.45 g) is added in batches. The mixture is stirred at 0°C for 11 h. The reaction solution is concentrated and purified by silica gel column chromatography, to obtain intermediate K1.

### Synthesis of compound 5:

Intermediates K1 (10 mmol, 9.50 g) and 90 mL of o-dichlorobenzene are added to a sealed pressure-resistant tube under nitrogen protection. A solution (30 mmol, 12 mL) of 2.5 M n-butyllithium in n-hexane is added at -78°C. The system is heated to 60°C to react for 2 h. Next, boron tribromide (15 mmol, 1.5 mL) is added at 0°C. Then, the system is transferred to a place at room temperature to further react for 5 h. Then, N,N-diisopropylethylamine (20 mmol, 3.5 mL) is added to the system at 0°C, and then the system is heated to 200°C to react for 12 h. After the reaction, the organic layer is concentrated under reduced pressure and then purified by silica gel column chromatography, to obtain compound 5. A full width at half maximum in a toluene solution (1×10⁻⁵ M) is 26 nm.

### Embodiment 2 Synthesis of compound 36:

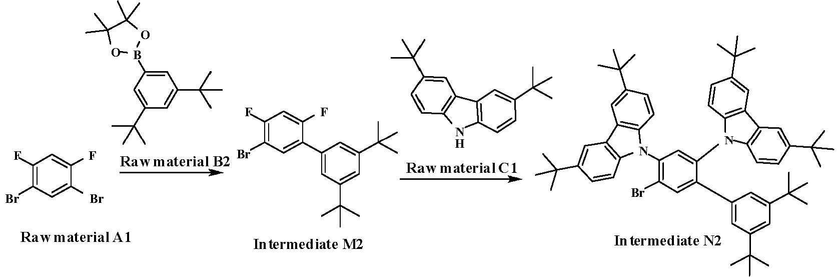

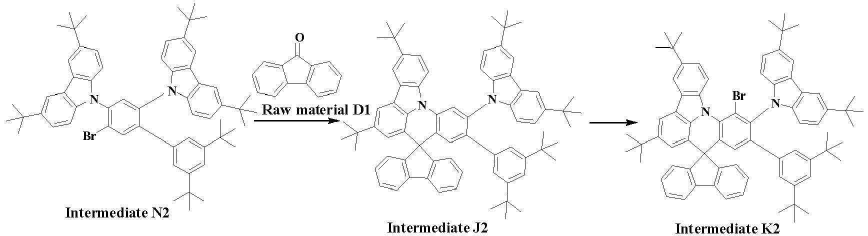

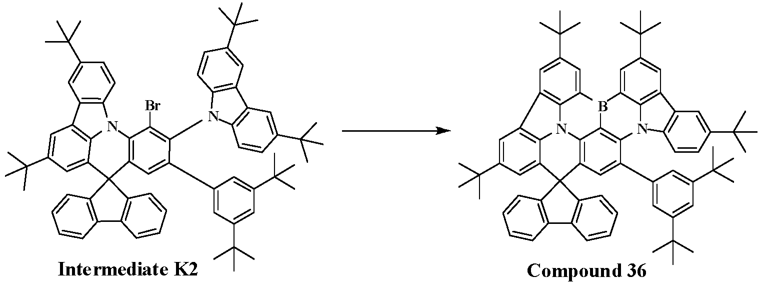

### Synthesis of intermediate M2:

Raw material A1 (11 mmol, 2.99 g) and raw material B2 (10 mmol, 3.16 g) are added to a three-neck flask and dissolved with a mixed solvent (70 mL of toluene, 35 mL of ethanol), and then Pd(PPh₃)₄ (0.10 mmol, 0.12 g) and 15 mL of 3 mol/L aqueous K₂CO₃ solution are added. The mixture is heated and refluxed under nitrogen protection to react for 14 h. The reaction mixture is sampled and spotted on a plate to confirm that the reaction is completed. After cooled down to room temperature, the reaction mixture is filtered through a diatomaceous earth pad, and washed with chloroform. The resulting filtrate is evaporated under vacuum. The obtained residue is purified by silica gel column chromatography with hexane/toluene as an eluent to obtain intermediate M2.

### Synthesis of intermediate N2:

Intermediate M2 (18.4 mmol, 7.02 g) and cesium carbonate (55.2 mmol, 18.0 g) are added to a two-neck flask, and 120 mL of anhydrous DMF is added under nitrogen protection. The mixture is stirred at room temperature for 35 min. Raw material C1 (40.5 mmol, 11.32 g) is added under nitrogen protection. The solution is refluxed under magnetic stirring for 20 h, and then cooled down, filtered, washed, dried, and subject to column chromatography to obtain intermediate N2.

### Synthesis of intermediate J2:

Intermediate N2 (5.1 mmol, 4.59 g) is dissolved in 50 mL of tetrahydrofuran (THF) solution. 2.3 mL of solution of n-butyllithium (2.5 M, 5.7 mmol) in n-hexane is slowly added at - 78°C with nitrogen introduced. The mixture is stirred at -78°C for 3 h. Then, 15 mL of solution of raw material D1 (5.5 mmol, 1.0 g) in tetrahydrofuran is slowly added. Then, the reaction mixture is warmed slowly to room temperature and stirred overnight. 20 mL of dilute hydrochloric acid (1 M) solution, distilled water, and ethyl acetate are added to the reaction mixture. The aqueous layer is separated and subject to extraction with ethyl acetate three times. The organic layers are combined and dried over sodium sulfate, and then filtered. The solvent is removed under reduced pressure. Then, the crude product is dissolved in anhydrous dichloromethane. Then, 47% boron trifluoride-diethyl ether is added slowly. The reaction mixture is stirred overnight and then quenched slowly with an aqueous NaHCO₃ solution. Then, the aqueous layer is separated, subject to extraction with dichloromethane, dried over sodium sulfate, filtered, concentrated through rotary evaporation, and subject to column chromatography, to obtain intermediate J2.

### Synthesis of intermediate K2:

Intermediate J2 (20.0 mmol, 19.67 g) and 200 mL of glacial acetic acid are sequentially added to a three-neck flask under nitrogen protection. The mixture is cooled down in a cryogenic bath to 0°C and has to be protected from light. NBS (25 mmol, 4.45 g) is added in batches. The mixture is stirred at 0°C for 12 h. The reaction solution is concentrated and purified by silica gel column chromatography, to obtain intermediate K2.

### Synthesis of compound 36:

Intermediates K2 (10 mmol, 10.6 g) and 90 mL of o-dichlorobenzene are added to a sealed pressure-resistant tube under nitrogen protection. A solution (30 mmol, 12 mL) of 2.5 M n-butyllithium in n-hexane is added at -78°C. The system is heated to 60°C to react for 3 h. Next, boron tribromide (15 mmol, 1.5 mL) is added at 0°C. Then, the system is transferred to a place at room temperature to further react for 6 h. Then, N,N-diisopropylethylamine (20 mmol, 3.5 mL) is added to the system at 0°C, and then the system is heated to 200°C to react for 11 h. After the reaction, the organic layer is concentrated under reduced pressure and then purified by silica gel column chromatography, to obtain compound 36. A full width at half maximum in a toluene solution (1×10⁻⁵ M) is 28 nm.

### Embodiment 3 Synthesis of compound 119:

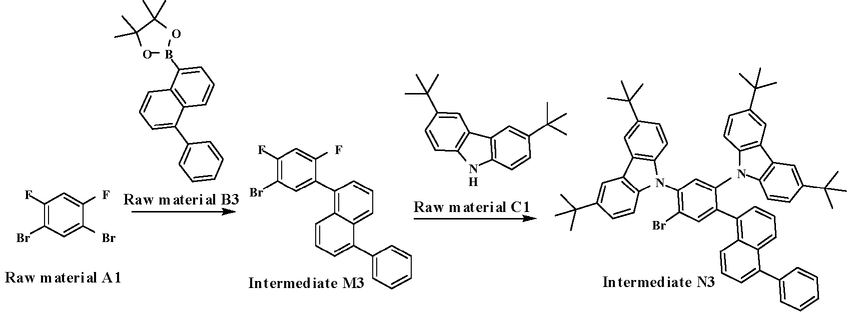

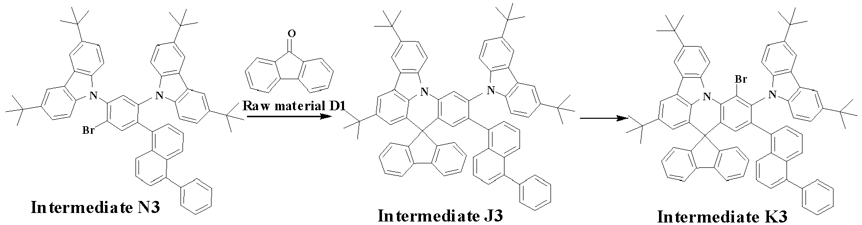

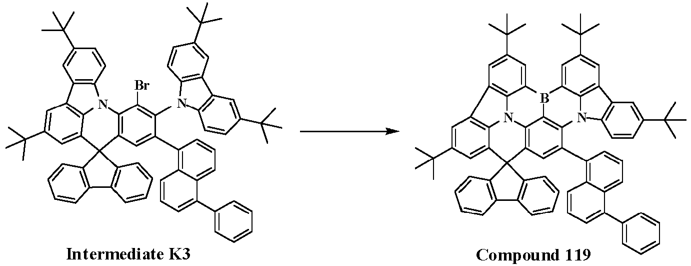

### Synthesis of intermediate M3:

Raw material A1 (11 mmol, 2.99 g) and raw material B3 (10 mmol, 3.3 g) are added to a three-neck flask and dissolved with a mixed solvent (70 mL of toluene, 35 mL of ethanol), and then Pd(PPh₃)₄ (0.10 mmol, 0.12 g) and 15 mL of 3 mol/L aqueous K₂CO₃ solution are added. The mixture is heated and refluxed under nitrogen protection to react for 12 h. The reaction mixture is sampled and spotted on a plate to confirm that the reaction is completed. After cooled down to room temperature, the reaction mixture is filtered through a diatomaceous earth pad, and washed with chloroform. The resulting filtrate is evaporated under vacuum. The obtained residue is purified by silica gel column chromatography with hexane/toluene as an eluent to obtain intermediate M3.

### Synthesis of intermediate N3:

Intermediate M3 (18.4 mmol, 7.27 g) and cesium carbonate (55.2 mmol, 18.0 g) are added to a two-neck flask, and 120 mL of anhydrous DMF is added under nitrogen protection. The mixture is stirred at room temperature for 35 min. Raw material C1 (40.5 mmol, 11.32 g) is added under nitrogen protection. The solution is refluxed under magnetic stirring for 23 h, and then cooled down, filtered, washed, dried, and subject to column chromatography to obtain intermediate N3.

### Synthesis of intermediate J3:

Intermediate N3 (5.1 mmol, 4.66 g) is dissolved in 60 mL of tetrahydrofuran (THF) solution. 2.3 mL of solution of n-butyllithium (2.5 M, 5.7 mmol) in n-hexane is slowly added at - 78°C with nitrogen introduced. The mixture is stirred at -78°C for 2.5 h. Then, 15 mL of solution of raw material D1 (5.5 mmol, 1.0 g) in tetrahydrofuran is slowly added. Then, the reaction mixture is warmed slowly to room temperature and stirred overnight. 20 mL of dilute hydrochloric acid (1 M) solution, distilled water, and ethyl acetate are added to the reaction mixture. The aqueous layer is separated and subject to extraction with ethyl acetate three times. The organic layers are combined and dried over sodium sulfate, and then filtered. The solvent is removed under reduced pressure. Then, the crude product is dissolved in anhydrous dichloromethane. Then, 47% boron trifluoride-diethyl ether is added slowly. The reaction mixture is stirred overnight and then quenched slowly with an aqueous NaHCO₃ solution. Then, the aqueous layer is separated, subject to extraction with dichloromethane, dried over sodium sulfate, filtered, concentrated through rotary evaporation, and subject to column chromatography, to obtain intermediate J3.

### Synthesis of intermediate K3:

Intermediate J3 (20.0 mmol, 19.95 g) and 220 mL of glacial acetic acid are sequentially added to a three-neck flask under nitrogen protection. The mixture is cooled down in a cryogenic bath to 0°C and has to be protected from light. NBS (25 mmol, 4.45 g) is added in batches. The mixture is stirred at 0°C for 12 h. The reaction solution is concentrated and purified by silica gel column chromatography, to obtain intermediate K3.

### Synthesis of compound 119:

Intermediates K3 (10 mmol, 10.76 g) and 120 mL of o-dichlorobenzene are added to a sealed pressure-resistant tube under nitrogen protection. A solution (30 mmol, 12 mL) of 2.5 M n-butyllithium in n-hexane is added at -78°C. The system is heated to 60°C to react for 3 h. Next, boron tribromide (15 mmol, 1.5 mL) is added at 0°C. Then, the system is transferred to a place at room temperature to further react for 6 h. Then, N,N-diisopropylethylamine (20 mmol, 3.5 mL) is added to the system at 0°C, and then the system is heated to 200°C to react for 13 h. After the reaction, the organic layer is concentrated under reduced pressure and then purified by silica gel column chromatography, to obtain compound 119. A full width at half maximum in a toluene solution (1×10⁻⁵ M) is 27 nm.

### Embodiment 4 Synthesis of compound 149:

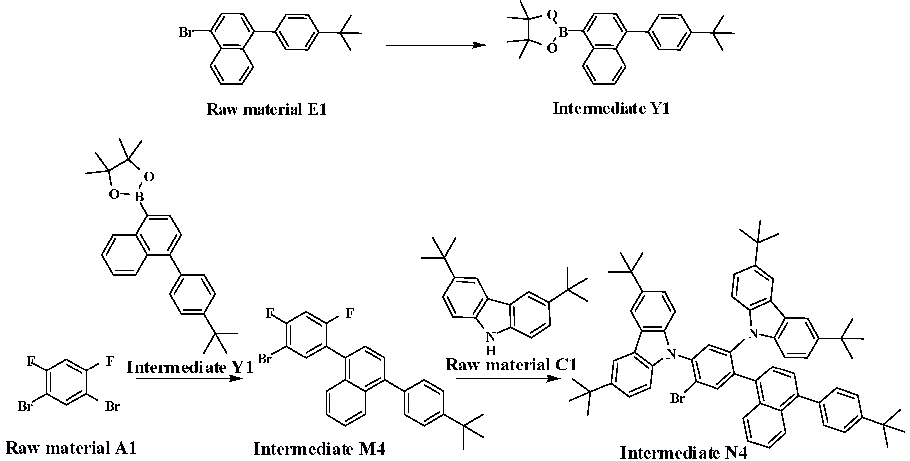

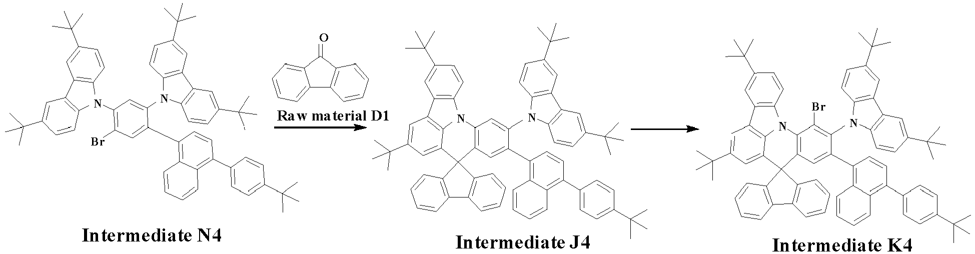

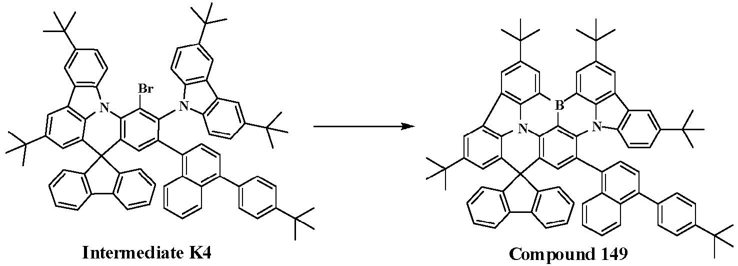

### Synthesis of intermediate Y1:

Raw material E1(2.50 mmol, 0.85 g), B₂pin₂ (2.75 mmol, 0.70 g), PdCl₂(dppf) (0.12 mmol, 0.09 g), AcOK (6.55 mmol, 0.64 g), and 1,4-Dioxane (10 mL) are added to a three-neck flask, and heated and refluxed at 110°C in a nitrogen atmosphere for 2 h. After cooled down to room temperature, the reaction mixture is filtered through a diatomaceous earth pad, and washed with chloroform. The resulting filtrate is evaporated under vacuum. The obtained residue is purified by silica gel column chromatography with hexane/ethyl acetate as an eluent to obtain intermediate Y1.

### Synthesis of intermediate M4:

Raw material A1 (11 mmol, 2.99 g) and intermediate Y1 (10 mmol, 3.86 g) are added to a three-neck flask and dissolved with a mixed solvent (70 mL of toluene, 35 mL of ethanol), and then Pd(PPh₃)₄ (0.10 mmol, 0.12 g) and 15 mL of 3 mol/L aqueous K₂CO₃ solution are added. The mixture is heated and refluxed under nitrogen protection to react for 15 h. The reaction mixture is sampled and spotted on a plate to confirm that the reaction is completed. After cooled down to room temperature, the reaction mixture is filtered through a diatomaceous earth pad, and washed with chloroform. The resulting filtrate is evaporated under vacuum. The obtained residue is purified by silica gel column chromatography with hexane/toluene as an eluent to obtain intermediate M4.

### Synthesis of intermediate N4:

Intermediate M4 (18.4 mmol, 8.3 g) and cesium carbonate (55.2 mmol, 18.0 g) are added to a two-neck flask, and 120 mL of anhydrous DMF is added under nitrogen protection. The mixture is stirred at room temperature for 40 min. Raw material C1 (40.5 mmol, 11.3 g) is added under nitrogen protection. The solution is refluxed under magnetic stirring for 21 h, and then cooled down, filtered, washed, dried, and subject to column chromatography to obtain intermediate N4.

### Synthesis of intermediate J4:

Intermediate N4 (5.1 mmol, 4.95 g) is dissolved in 50 mL of tetrahydrofuran (THF) solution. 2.3 mL of solution of n-butyllithium (2.5 M, 5.7 mmol) in n-hexane is slowly added at - 78°C with nitrogen introduced. The mixture is stirred at -78°C for 2.5 h. Then, 15 mL of solution of raw material D1 (5.5 mmol, 1.0 g) in tetrahydrofuran is slowly added. Then, the reaction mixture is warmed slowly to room temperature and stirred overnight. 20 mL of dilute hydrochloric acid (1 M) solution, distilled water, and ethyl acetate are added to the reaction mixture. The aqueous layer is separated and subject to extraction with ethyl acetate three times. The organic layers are combined and dried over sodium sulfate, and then filtered. The solvent is removed under reduced pressure. Then, the crude product is dissolved in anhydrous dichloromethane. Then, 47% boron trifluoride-diethyl ether is added slowly. The reaction mixture is stirred overnight and then quenched slowly with an aqueous NaHCO₃ solution. Then, the aqueous layer is separated, subject to extraction with dichloromethane, dried over sodium sulfate, filtered, concentrated through rotary evaporation, and subject to column chromatography, to obtain intermediate J4.

### Synthesis of intermediate K4:

Intermediate J4 (20.0 mmol, 21.07 g) and 230 mL of glacial acetic acid are sequentially added to a three-neck flask under nitrogen protection. The mixture is cooled down in a cryogenic bath to 0°C and has to be protected from light. NBS (25 mmol, 4.45 g) is added in batches. The mixture is stirred at 0°C overnight. The reaction solution is concentrated and purified by silica gel column chromatography, to obtain intermediate K4.

### Synthesis of compound 149:

Intermediates K4 (10 mmol, 11.32 g) and 120 mL of o-dichlorobenzene are added to a sealed pressure-resistant tube under nitrogen protection. A solution (30 mmol, 12 mL) of 2.5 M n-butyllithium in n-hexane is added at -78°C. The system is heated to 60°C to react for 3.5 h. Next, boron tribromide (15 mmol, 1.5 mL) is added at 0°C. Then, the system is transferred to a place at room temperature to further react for 7 h. Then, N,N-diisopropylethylamine (20 mmol, 3.5 mL) is added to the system at 0°C, and then the system is heated to 200°C to react for 12 h. After the reaction, the organic layer is concentrated under reduced pressure and then purified by silica gel column chromatography, to obtain compound 149. A full width at half maximum in a toluene solution (1×10⁻⁵ M) is 29 nm.

### Embodiment 5 Synthesis of compound 165:

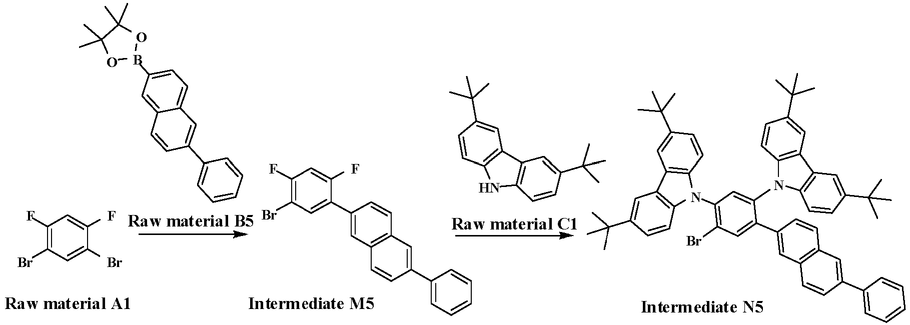

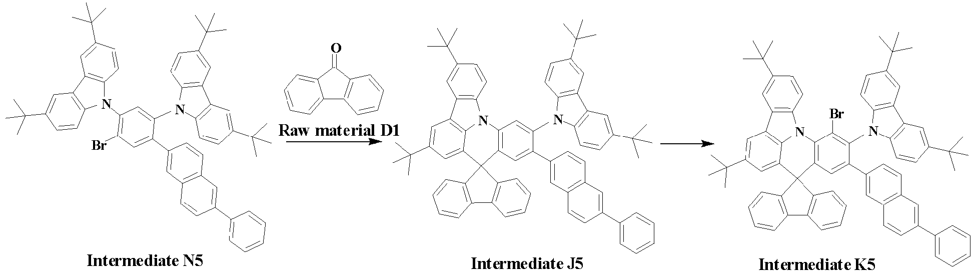

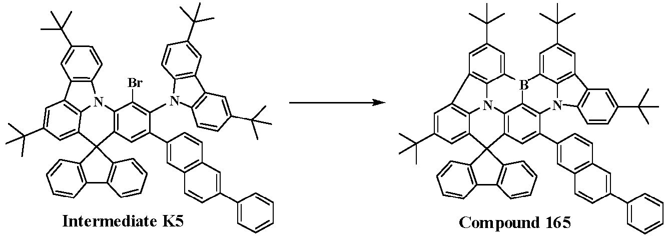

### Synthesis of intermediate M5:

Raw material A1 (11 mmol, 2.99 g) and raw material B5 (10 mmol, 3.3 g) are added to a three-neck flask and dissolved with a mixed solvent (70 mL of toluene, 35 mL of ethanol), and then Pd(PPh₃)₄ (0.10 mmol, 0.12 g) and 15 mL of 3 mol/L aqueous K₂CO₃ solution are added. The mixture is heated and refluxed under nitrogen protection to react for 12.5 h. The reaction mixture is sampled and spotted on a plate to confirm that the reaction is completed. After cooled down to room temperature, the reaction mixture is filtered through a diatomaceous earth pad, and washed with chloroform. The resulting filtrate is evaporated under vacuum. The obtained residue is purified by silica gel column chromatography with hexane/toluene as an eluent to obtain intermediate M5.

### Synthesis of intermediate N5:

Intermediate M5 (18.4 mmol, 7.27 g) and cesium carbonate (55.2 mmol, 18.0 g) are added to a two-neck flask, and 120 mL of anhydrous DMF is added under nitrogen protection. The mixture is stirred at room temperature for 35 min. Raw material C1 (40.5 mmol, 11.32 g) is added under nitrogen protection. The solution is refluxed under magnetic stirring for 22 h, and then cooled down, filtered, washed, dried, and subject to column chromatography to obtain intermediate N5.

### Synthesis of intermediate J5:

Intermediate N5 (5.1 mmol, 4.66 g) is dissolved in 50 mL of tetrahydrofuran (THF) solution. 2.3 mL of solution of n-butyllithium (2.5 M, 5.7 mmol) in n-hexane is slowly added at - 78°C with nitrogen introduced. The mixture is stirred at -78°C for 2.5 h. Then, 15 mL of solution of raw material D1 (5.5 mmol, 1.0 g) in tetrahydrofuran is slowly added. Then, the reaction mixture is warmed slowly to room temperature and stirred overnight. 20 mL of dilute hydrochloric acid (1 M) solution, distilled water, and ethyl acetate are added to the reaction mixture. The aqueous layer is separated and subject to extraction with ethyl acetate three times. The organic layers are combined and dried over sodium sulfate, and then filtered. The solvent is removed under reduced pressure. Then, the crude product is dissolved in anhydrous dichloromethane. Then, 47% boron trifluoride-diethyl ether is added slowly. The reaction mixture is stirred overnight and then quenched slowly with an aqueous NaHCO₃ solution. Then, the aqueous layer is separated, subject to extraction with dichloromethane, dried over sodium sulfate, filtered, concentrated through rotary evaporation, and subject to column chromatography, to obtain intermediate J5.

### Synthesis of intermediate K5:

Intermediate J5 (20.0 mmol, 19.95 g) and 220 mL of glacial acetic acid are sequentially added to a three-neck flask under nitrogen protection. The mixture is cooled down in a cryogenic bath to 0°C and has to be protected from light. NBS (25 mmol, 4.45 g) is added in batches. The mixture is stirred at 0°C for 12.5 h. The reaction solution is concentrated and purified by silica gel column chromatography, to obtain intermediate K5.

### Synthesis of compound 165:

Intermediates K5 (10 mmol, 10.76 g) and 120 mL of o-dichlorobenzene are added to a sealed pressure-resistant tube under nitrogen protection. A solution (30 mmol, 12 mL) of 2.5 M n-butyllithium in n-hexane is added at -78°C. The system is heated to 60°C to react for 2 h. Next, boron tribromide (15 mmol, 1.5 mL) is added at 0°C. Then, the system is transferred to a place at room temperature to further react for 5.5 h. Then, N,N-diisopropylethylamine (20 mmol, 3.5 mL) is added to the system at 0°C, and then the system is heated to 200°C to react for 12 h. After the reaction, the organic layer is concentrated under reduced pressure and then purified by silica gel column chromatography, to obtain compound 165. A full width at half maximum in a toluene solution (1×10⁻⁵ M) is 27 nm.

### Embodiment 6 Synthesis of compound 208:

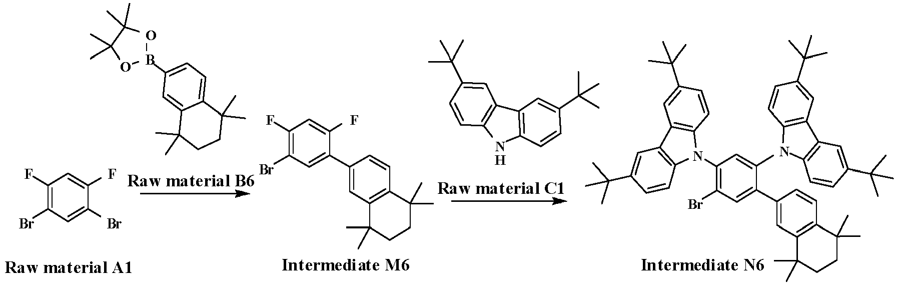

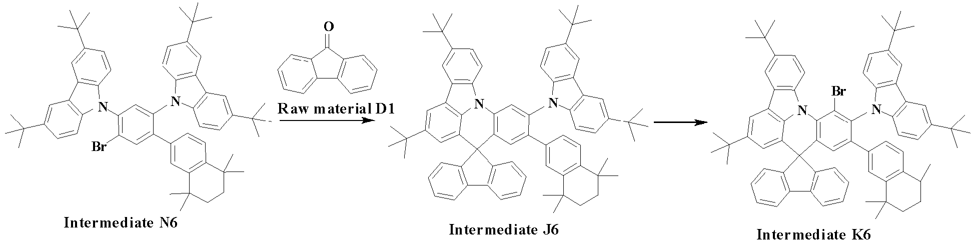

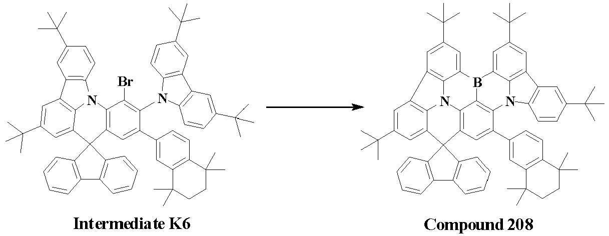

### Synthesis of intermediate M6:

Raw material A1 (11 mmol, 2.99 g) and raw material B6 (10 mmol, 3.14 g) are added to a three-neck flask and dissolved with a mixed solvent (70 mL of toluene, 35 mL of ethanol), and then Pd(PPh₃)₄ (0.10 mmol, 0.12 g) and 15 mL of 3 mol/L aqueous K₂CO₃ solution are added. The mixture is heated and refluxed under nitrogen protection to react for 12 h. The reaction mixture is sampled and spotted on a plate to confirm that the reaction is completed. After cooled down to room temperature, the reaction mixture is filtered through a diatomaceous earth pad, and washed with chloroform. The resulting filtrate is evaporated under vacuum. The obtained residue is purified by silica gel column chromatography with hexane/toluene as an eluent to obtain intermediate M6.

### Synthesis of intermediate N6:

Intermediate M6 (18.4 mmol, 6.98 g) and cesium carbonate (55.2 mmol, 18.0 g) are added to a two-neck flask, and 120 mL of anhydrous DMF is added under nitrogen protection. The mixture is stirred at room temperature for 25 min. Raw material C1 (40.5 mmol, 11.32 g) is added under nitrogen protection. The solution is refluxed under magnetic stirring for 20 h, and then cooled down, filtered, washed, dried, and subject to column chromatography to obtain intermediate N6.

### Synthesis of intermediate J6:

Intermediate N6 (5.1 mmol, 4.58 g) is dissolved in 50 mL of tetrahydrofuran (THF) solution. 2.3 mL of solution of n-butyllithium (2.5 M, 5.7 mmol) in n-hexane is slowly added at - 78°C with nitrogen introduced. The mixture is stirred at -78°C for 1.5 h. Then, 15 mL of solution of raw material D1 (5.5 mmol, 1.0 g) in tetrahydrofuran is slowly added. Then, the reaction mixture is warmed slowly to room temperature and stirred overnight. 20 mL of dilute hydrochloric acid (1 M) solution, distilled water, and ethyl acetate are added to the reaction mixture. The aqueous layer is separated and subject to extraction with ethyl acetate three times. The organic layers are combined and dried over sodium sulfate, and then filtered. The solvent is removed under reduced pressure. Then, the crude product is dissolved in anhydrous dichloromethane. Then, 47% boron trifluoride-diethyl ether is added slowly. The reaction mixture is stirred overnight and then quenched slowly with an aqueous NaHCO₃ solution. Then, the aqueous layer is separated, subject to extraction with dichloromethane, dried over sodium sulfate, filtered, concentrated through rotary evaporation, and subject to column chromatography, to obtain intermediate J6.

### Synthesis of intermediate K6:

Intermediate J6 (20.0 mmol, 19.63 g) and 220 mL of glacial acetic acid are sequentially added to a three-neck flask under nitrogen protection. The mixture is cooled down in a cryogenic bath to 0°C and has to be protected from light. NBS (25 mmol, 4.45 g) is added in batches. The mixture is stirred at 0°C for 11.5 h. The reaction solution is concentrated and purified by silica gel column chromatography, to obtain intermediate K6.

### Synthesis of compound 208:

Intermediates K6 (10 mmol, 10.6 g) and 120 mL of o-dichlorobenzene are added to a sealed pressure-resistant tube under nitrogen protection. A solution (30 mmol, 12 mL) of 2.5 M n-butyllithium in n-hexane is added at -78°C. The system is heated to 60°C to react for 2 h. Next, boron tribromide (15 mmol, 1.5 mL) is added at 0°C. Then, the system is transferred to a place at room temperature to further react for 5.5 h. Then, N,N-diisopropylethylamine (20 mmol, 3.5 mL) is added to the system at 0°C, and then the system is heated to 200°C to react for 12 h. After the reaction, the organic layer is concentrated under reduced pressure and then purified by silica gel column chromatography, to obtain compound 208. A full width at half maximum in a toluene solution (1×10⁻⁵ M) is 28 nm.

### Embodiment 7 Synthesis of compound 255:

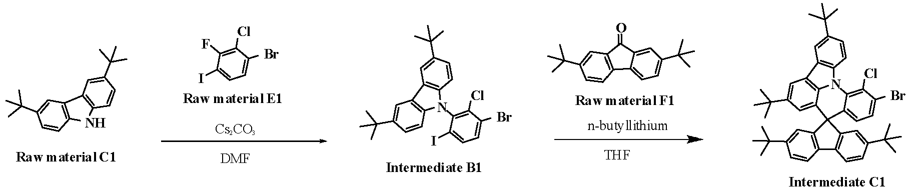

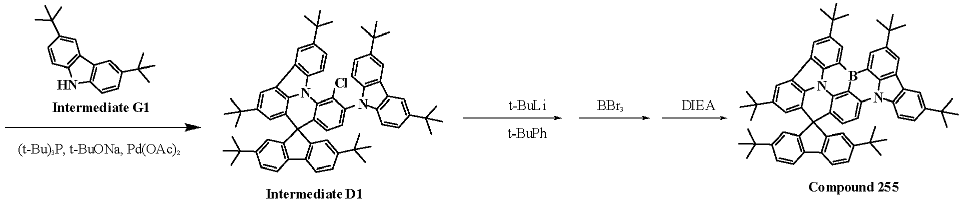

Synthesis of intermediate B1: Raw material E1 (1.68 g, 5 mmol) and cesium carbonate (4.07 g, 12.5 mmol) are added to a two-neck flask, and 50 mL of anhydrous DMF is added under nitrogen protection. The mixture is stirred at room temperature for 30 min. Raw material C1 (1.4 g, 5 mmol) is added under nitrogen protection. The mixture is stirred at 140°C under nitrogen protection for 12 h, and then filtered, washed, dried, and subject to column chromatography (PE:EA = 20:1) to obtain intermediate B1.

Synthesis of intermediate C1: Intermediate B1 (3.03 g, 5.1 mmol) is dissolved in 50 mL of tetrahydrofuran (THF) solution. 3.8 mL of solution of n-butyllithium (1.6 M) in n-hexane is slowly added at 0°C with nitrogen introduced. The mixture is stirred at 0°C for 2 h. Then, 10 mL of solution of raw material F1 (3.71 g, 12.7 mmol) in tetrahydrofuran is slowly added. Then, the reaction mixture is warmed slowly to room temperature and stirred overnight. A dilute hydrochloric acid solution, distilled water, and ethyl acetate are added to the reaction mixture. The aqueous layer is separated and subject to extraction with ethyl acetate three times. The organic layers are combined and dried over sodium sulfate, and then filtered. The solvent is removed under reduced pressure. Then, the crude product is dissolved in anhydrous dichloromethane. Then, 47% boron trifluoride-diethyl ether is added slowly. The reaction mixture is stirred overnight and then quenched slowly with an aqueous NaHCO₃ solution. Then, the aqueous layer is separated, subject to extraction with dichloromethane, dried over sodium sulfate, filtered, concentrated through rotary evaporation, and subject to column chromatography, to obtain intermediate C1.

Synthesis of intermediate D1: In a nitrogen atmosphere, intermediate C1 (1.86 g, 2.5 mmol) is dissolved in 50 mL of toluene solution, and raw material intermediate G1 (0.70 g, 2.5 mmol), tri-tert-butylphosphine (0.025 g, 0.125 mmol), sodium tert-butoxide (0.62 g, 6.5 mmol), and palladium acetate (0.01 g, 0.04 mmol) are added. The mixture is stirred vigorously. The resulting mixture is refluxed at 105°C for 10 h and then cooled down to room temperature. Then, ethyl acetate (100 mL) is added. The mixture is washed with deionized water (100 mL) three times, and dried over anhydrous magnesium sulfate overnight. Then, ethyl acetate is evaporated under reduced pressure. The remaining mixture is poured into 100 mL of petroleum ether under stirring. The mixture is filtered to obtain intermediate D1.

Synthesis of compound 255: In a nitrogen atmosphere at 0°C, 10 mL of solution of tert-butyllithium (1.6 M) in n-pentane is slowly added to 300 mL of solution of intermediate D1 (11.77 g, 12.5 mmol) in tert-butylbenzene. The mixture is stirred at 60°C for 2 h. Then, n-pentane is removed under vacuum. Boron tribromide (6.26 g, 25 mmol) is added at 0°C. Then, the reaction mixture is stirred at room temperature for 1 h. N,N-diisopropylethylamine (DIEA) (3.25 g, 25.2 mmol) is added at 0°C. After reaching room temperature, the reaction mixture is stirred at 130°C for 6 h. Then, the reaction mixture is cooled down to room temperature. Methanol is added to the reaction mixture to remove residual BBr₃. The mixture is separated and subject to extraction with water and dichloromethane. The organic layers are combined, condensed under vacuum, and subject to column chromatography, to obtain compound 255.

### Embodiment 8 Synthesis of compound 48:

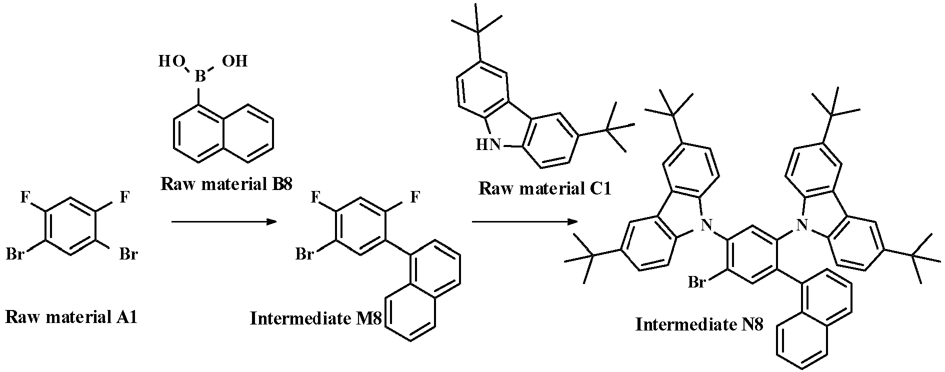

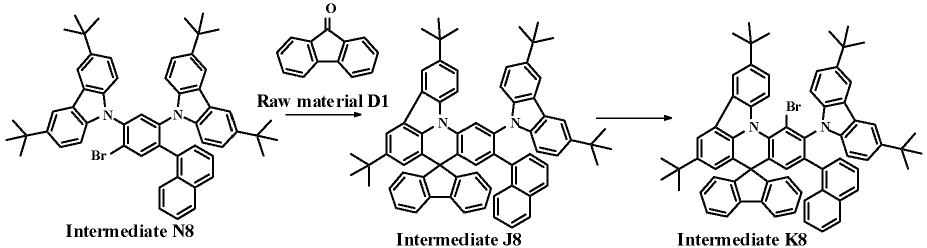

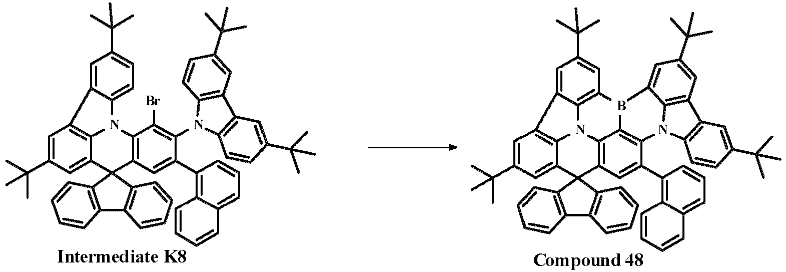

### Synthesis of intermediate M8:

Raw material A1 (10 mmol, 2.71 g) and raw material B8 (10 mmol, 1.72 g) are added to a three-neck flask and dissolved with a mixed solvent (60 mL of toluene, 30 mL of ethanol), and then Pd(PPh₃)₄ (0.10 mmol, 0.12 g) and 15 mL of 3 mol/L aqueous K₂CO₃ solution are added. The mixture is heated and refluxed under nitrogen protection to react for 12.5 h. The reaction mixture is sampled and spotted on a plate to confirm that the reaction is completed. After cooled down to room temperature, the reaction mixture is filtered through a diatomaceous earth pad, and washed with chloroform. The resulting filtrate is evaporated under vacuum. The obtained residue is purified by silica gel column chromatography with hexane/toluene as an eluent to obtain intermediate M8.

### Synthesis of intermediate N8:

Intermediate M8 (20 mmol, 6.38 g) and cesium carbonate (50 mmol, 16.3 g) are added to a two-neck flask, and 80 mL of anhydrous DMF is added under nitrogen protection. The mixture is stirred at room temperature for 35 min. Raw material C1 (50 mmol, 14.0 g) is added under nitrogen protection. The solution is refluxed under magnetic stirring for 22 h, and then cooled down, filtered, washed, dried, and subject to column chromatography to obtain intermediate N8.

### Synthesis of intermediate J8:

Intermediate N8 (10 mmol, 8.38 g) is dissolved in 100 mL of tetrahydrofuran (THF) solution. 4.4 mL of solution of n-butyllithium (2.5 M, 11 mmol) in n-hexane is slowly added at - 78°C with nitrogen introduced. The mixture is stirred at -78°C for 2.5 h. Then, 30 mL of solution of raw material D1 (11 mmol, 1.98 g) in tetrahydrofuran is slowly added. Then, the reaction mixture is warmed slowly to room temperature and stirred overnight. 40 mL of dilute hydrochloric acid (1 M) solution, distilled water, and ethyl acetate are added to the reaction mixture. The aqueous layer is separated and subject to extraction with ethyl acetate three times. The organic layers are combined and dried over sodium sulfate, and then filtered. The solvent is removed under reduced pressure. Then, the crude product is dissolved in anhydrous dichloromethane. Then, 47% boron trifluoride-diethyl ether is added slowly. The reaction mixture is stirred overnight and then quenched slowly with an aqueous NaHCO₃ solution. Then, the aqueous layer is separated, subject to extraction with dichloromethane, dried over sodium sulfate, filtered, concentrated through rotary evaporation, and subject to column chromatography, to obtain intermediate J8.

### Synthesis of intermediate K8:

Intermediate J8 (10.0 mmol, 9.21 g) and 100 mL of glacial acetic acid are sequentially added to a three-neck flask under nitrogen protection. The mixture is cooled down in a cryogenic bath to 0°C and has to be protected from light. NBS (15.0 mmol, 2.67 g) is added in batches. The mixture is stirred at 0°C for 12.5 h. The reaction solution is concentrated and purified by silica gel column chromatography, to obtain intermediate K8.

### Synthesis of compound 48:

Intermediates K8 (10 mmol, 10.0 g) and 120 mL of tert-butylbenzene are added to a sealed pressure-resistant tube under nitrogen protection. A solution (12 mmol, 4.8 mL) of 2.5 M n-butyllithium in n-hexane is added at -78°C. The system is heated to 60°C to react for 2 h. Next, boron tribromide (15 mmol, 1.5 mL) is added at 0°C. Then, the system is transferred to a place at room temperature to further react for 5.5 h. Then, N,N-diisopropylethylamine (20 mmol, 3.5 mL) is added to the system at 0°C, and then the system is heated to 165°C to react for 12 h. After the reaction, the organic layer is concentrated under reduced pressure and then purified by silica gel column chromatography, to obtain compound 48. A full width at half maximum in a toluene solution (1×10⁻⁵ M) is 24 nm.

### Embodiment 9 Synthesis of compound 64:

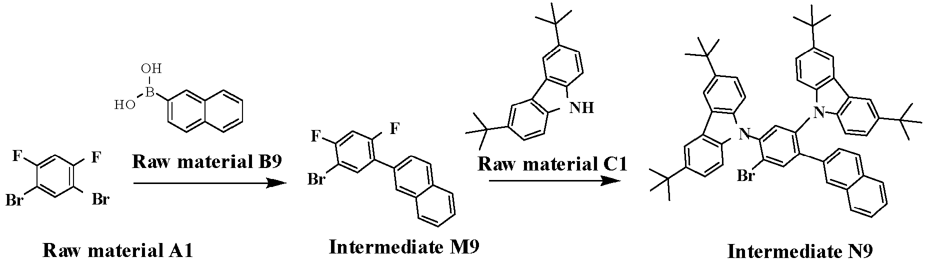

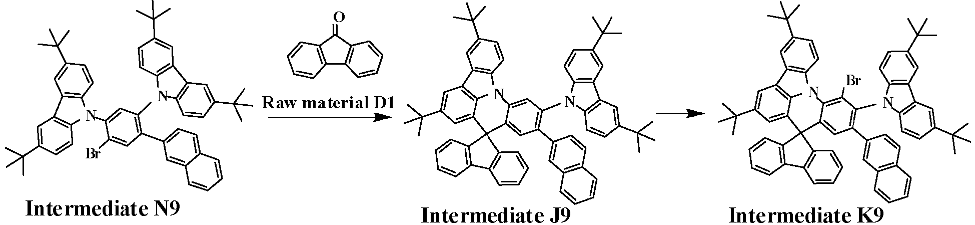

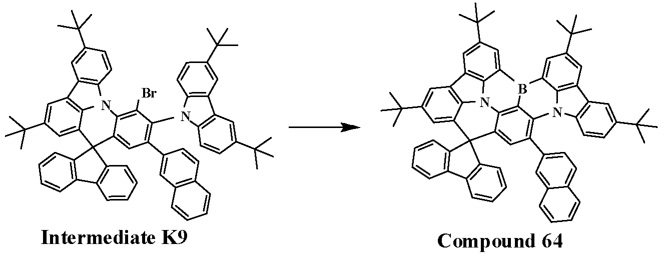

### Synthesis of intermediate M9:

Raw material A1 (10 mmol, 2.71 g) and raw material B9 (10 mmol, 1.72 g) are added to a three-neck flask and dissolved with a mixed solvent (60 mL of toluene, 30 mL of ethanol), and then Pd(PPh₃)₄ (0.10 mmol, 0.12 g) and 15 mL of 3 mol/L aqueous K₂CO₃ solution are added. The mixture is heated and refluxed under nitrogen protection to react for 12.5 h. The reaction mixture is sampled and spotted on a plate to confirm that the reaction is completed. After cooled down to room temperature, the reaction mixture is filtered through a diatomaceous earth pad, and washed with chloroform. The resulting filtrate is evaporated under vacuum. The obtained residue is purified by silica gel column chromatography with hexane/toluene as an eluent to obtain intermediate M9.

### Synthesis of intermediate N9:

Intermediate M9 (20 mmol, 6.38 g) and cesium carbonate (50 mmol, 16.3 g) are added to a two-neck flask, and 80 mL of anhydrous DMF is added under nitrogen protection. The mixture is stirred at room temperature for 35 min. Raw material C1 (50 mmol, 14.0 g) is added under nitrogen protection. The solution is refluxed under magnetic stirring for 22 h, and then cooled down, filtered, washed, dried, and subject to column chromatography to obtain intermediate N9.

### Synthesis of intermediate J9:

Intermediate N9 (10 mmol, 8.38 g) is dissolved in 100 mL of tetrahydrofuran (THF) solution. 4.4 mL of solution of n-butyllithium (2.5 M, 11 mmol) in n-hexane is slowly added at - 78°C with nitrogen introduced. The mixture is stirred at -78°C for 2.5 h. Then, 30 mL of solution of raw material D1 (11 mmol, 1.98 g) in tetrahydrofuran is slowly added. Then, the reaction mixture is warmed slowly to room temperature and stirred overnight. 40 mL of dilute hydrochloric acid (1 M) solution, distilled water, and ethyl acetate are added to the reaction mixture. The aqueous layer is separated and subject to extraction with ethyl acetate three times. The organic layers are combined and dried over sodium sulfate, and then filtered. The solvent is removed under reduced pressure. Then, the crude product is dissolved in anhydrous dichloromethane. Then, 47% boron trifluoride-diethyl ether is added slowly. The reaction mixture is stirred overnight and then quenched slowly with an aqueous NaHCO₃ solution. Then, the aqueous layer is separated, subject to extraction with dichloromethane, dried over sodium sulfate, filtered, concentrated through rotary evaporation, and subject to column chromatography, to obtain intermediate J9.

### Synthesis of intermediate K9:

Intermediate J9 (10.0 mmol, 9.21 g) and 100 mL of glacial acetic acid are sequentially added to a three-neck flask under nitrogen protection. The mixture is cooled down in a cryogenic bath to 0°C and has to be protected from light. NBS (15.0 mmol, 2.67 g) is added in batches. The mixture is stirred at 0°C for 12.5 h. The reaction solution is concentrated and purified by silica gel column chromatography, to obtain intermediate K9.

### Synthesis of compound 64:

Intermediates K9 (10 mmol, 10.0 g) and 120 mL of tert-butylbenzene are added to a sealed pressure-resistant tube under nitrogen protection. A solution (12 mmol, 4.8 mL) of 2.5 M n-butyllithium in n-hexane is added at -78°C. The system is heated to 60°C to react for 2 h. Next, boron tribromide (15 mmol, 1.5 mL) is added at 0°C. Then, the system is transferred to a place at room temperature to further react for 5.5 h. Then, N,N-diisopropylethylamine (20 mmol, 3.5 mL) is added to the system at 0°C, and then the system is heated to 165°C to react for 12 h. After the reaction, the organic layer is concentrated under reduced pressure and then purified by silica gel column chromatography, to obtain compound 64. A full width at half maximum in a toluene solution (1×10⁻⁵ M) is 24 nm.

### Embodiment 10 Synthesis of compound 533:

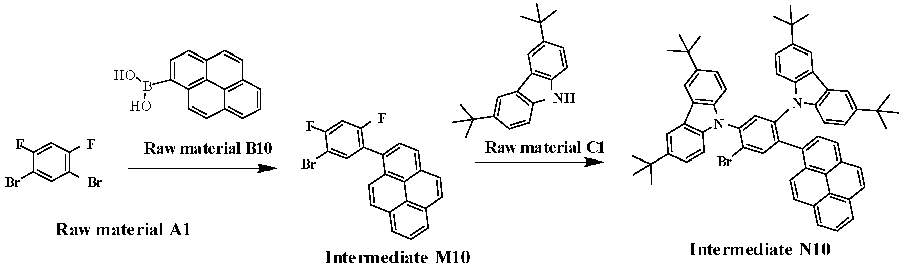

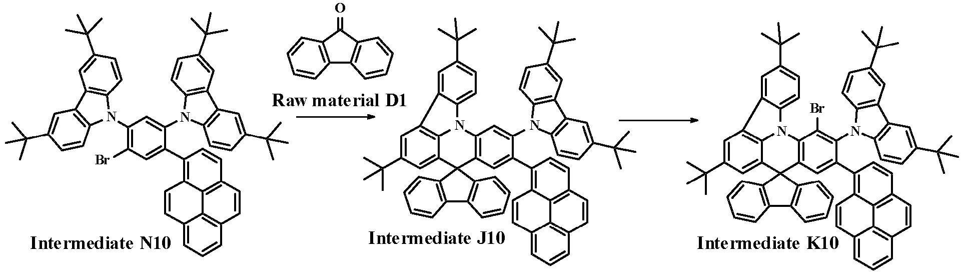

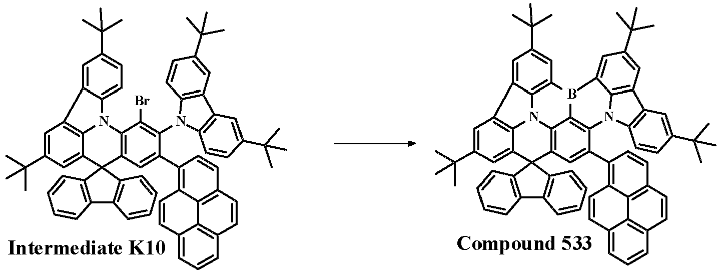

### Synthesis of intermediate M10:

Raw material A1 (10 mmol, 2.71 g) and raw material B10 (10 mmol, 2.46 g) are added to a three-neck flask and dissolved with a mixed solvent (60 mL of toluene, 30 mL of ethanol), and then Pd(PPh₃)₄ (0.10 mmol, 0.12 g) and 15 mL of 3 mol/L aqueous K₂CO₃ solution are added. The mixture is heated and refluxed under nitrogen protection to react for 12.5 h. The reaction mixture is sampled and spotted on a plate to confirm that the reaction is completed. After cooled down to room temperature, the reaction mixture is filtered through a diatomaceous earth pad, and washed with chloroform. The resulting filtrate is evaporated under vacuum. The obtained residue is purified by silica gel column chromatography with hexane/toluene as an eluent to obtain intermediate M10.

### Synthesis of intermediate N10:

Intermediate M10 (20 mmol, 7.86 g) and cesium carbonate (50 mmol, 16.3 g) are added to a two-neck flask, and 80 mL of anhydrous DMF is added under nitrogen protection. The mixture is stirred at room temperature for 35 min. Raw material C1 (50 mmol, 14.0 g) is added under nitrogen protection. The solution is refluxed under magnetic stirring for 22 h, and then cooled down, filtered, washed, dried, and subject to column chromatography to obtain intermediate N10.

### Synthesis of intermediate J10:

Intermediate N10 (10 mmol, 9.12 g) is dissolved in 100 mL of tetrahydrofuran (THF) solution. 4.4 mL of solution of n-butyllithium (2.5 M, 11 mmol) in n-hexane is slowly added at - 78°C with nitrogen introduced. The mixture is stirred at -78°C for 2.5 h. Then, 30 mL of solution of raw material D1 (11 mmol, 1.98 g) in tetrahydrofuran is slowly added. Then, the reaction mixture is warmed slowly to room temperature and stirred overnight. 40 mL of dilute hydrochloric acid (1 M) solution, distilled water, and ethyl acetate are added to the reaction mixture. The aqueous layer is separated and subject to extraction with ethyl acetate three times. The organic layers are combined and dried over sodium sulfate, and then filtered. The solvent is removed under reduced pressure. Then, the crude product is dissolved in anhydrous dichloromethane. Then, 47% boron trifluoride-diethyl ether is added slowly. The reaction mixture is stirred overnight and then quenched slowly with an aqueous NaHCO₃ solution. Then, the aqueous layer is separated, subject to extraction with dichloromethane, dried over sodium sulfate, filtered, concentrated through rotary evaporation, and subject to column chromatography, to obtain intermediate J10.

### Synthesis of intermediate K10:

Intermediate J10 (10.0 mmol, 9.95 g) and 100 mL of glacial acetic acid are sequentially added to a three-neck flask under nitrogen protection. The mixture is cooled down in a cryogenic bath to 0°C and has to be protected from light. NBS (15.0 mmol, 2.67 g) is added in batches. The mixture is stirred at 0°C for 12.5 h. The reaction solution is concentrated and purified by silica gel column chromatography, to obtain intermediate K10.

### Synthesis of compound 533:

Intermediates K10 (10 mmol, 10.7 g) and 120 mL of tert-butylbenzene are added to a sealed pressure-resistant tube under nitrogen protection. A solution (12 mmol, 4.8 mL) of 2.5 M n-butyllithium in n-hexane is added at -78°C. The system is heated to 60°C to react for 2 h. Next, boron tribromide (15 mmol, 1.5 mL) is added at 0°C. Then, the system is transferred to a place at room temperature to further react for 5.5 h. Then, N,N-diisopropylethylamine (20 mmol, 3.5 mL) is added to the system at 0°C, and then the system is heated to 200°C to react for 12 h. After the reaction, the organic layer is concentrated under reduced pressure and then purified by silica gel column chromatography, to obtain compound 533. A full width at half maximum in a toluene solution (1×10⁻⁵ M) is 24 nm.

The following target compounds are synthesized with reference to the preparation process of compound 255 in Embodiment 7, with same reaction conditions and same raw material C1. The difference lies in that raw materials E, raw materials F, and intermediates G listed in the following table are used.

| Embodiment number | Raw material E | Raw material F | Intermediate G | Target compound |
|---|---|---|---|---|
| 7 | 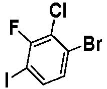 Raw material E1 | 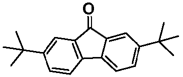 Raw material F1 | 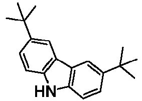 Intermediate G1 | 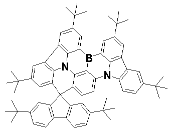 Compound 255 |
| 11 | 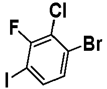 Raw material E1 | 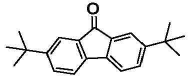 Raw material F1 | 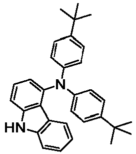 Intermediate G3 | 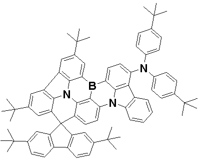 Compound 438 |
| 12 | 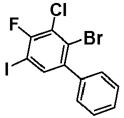 Raw material E3 | 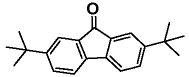 Raw material F1 | 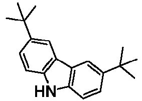 Intermediate G1 | 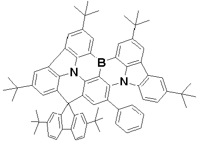 Compound 20 |
| 13 | 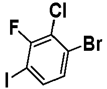 Raw material E1 | 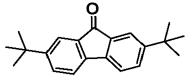 Raw material F1 | 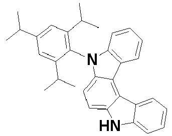 Intermediate G5 | 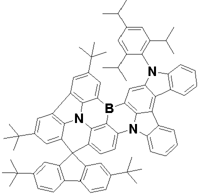 Compound 373 |

### Synthesis of an intermediate G series:

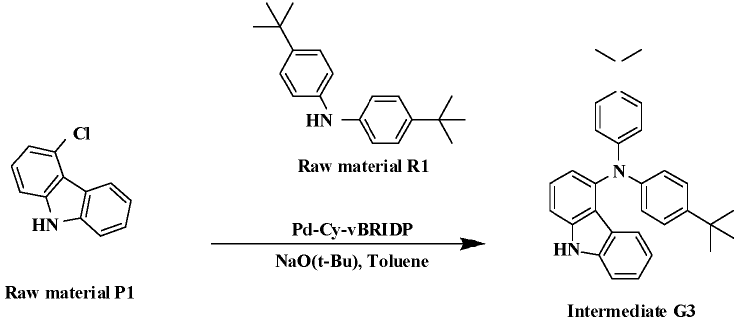

Synthesis of intermediate G3: NaO(t-Bu) (3.36 g, 35 mmol), 100 mL of dehydrated toluene, raw material R1 (8.45 g, 30 mmol), raw material P1 (6.55 g, 32.5 mmol), and a Pd-Cy-vBRIDP catalyst (0.25 g, 0.5 mmol) are added sequentially under continuous stirring with nitrogen introduced. The obtained suspension is heated with silicone oil to 100°C, stirred continuously at 100°C with nitrogen introduced for 2 h, and then subject to extraction with ethyl acetate three times. The organic phases are combined, dried over anhydrous sodium sulfate, filtered, and concentrated to obtain a crude product. The crude product is purified by recrystallization (ethyl acetate/petroleum ether) to obtain intermediate G3.

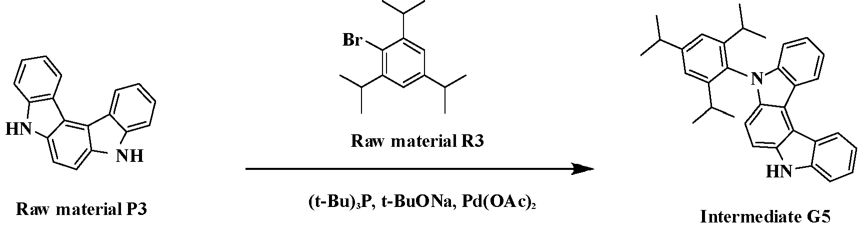

Synthesis of intermediate G5: Raw material R3 (7.08 g, 25 mmol) is dissolved in 100 mL of toluene solution, and raw material P3 (6.41 g, 25 mmol), tri-tert-butylphosphine (0.26 g, 1.25 mmol), sodium tert-butoxide (6.25 g, 65 mmol), and palladium acetate (0.09 g, 0.4 mmol) are added. The mixture is stirred vigorously. The resulting mixture is refluxed at 105°C for 11 h and then cooled down to room temperature. Then, ethyl acetate (100 mL) is added. The mixture is washed with deionized water (100 mL) three times, and dried over anhydrous magnesium sulfate overnight. Then, ethyl acetate is evaporated under reduced pressure. The remaining mixture is poured into 100 mL of petroleum ether under stirring. The mixture is filtered to obtain intermediate G5.

Structural characterization of the compounds obtained in the embodiments is shown in Table 1.

**Table 1**

| Compound | Structural characterization |
|---|---|
| 5 | Elemental analysis (C₆₅H₅₉BN₂): theoretical value: C, 88.82; H, 6.77; N, 3.19; test value: C, 88.83; H, 6.79; N, 3.11. LC-MS: measured value: 879.42 ([M+H]⁺), exact mass: 878.48. |
| 36 | Elemental analysis (C₇₃H₇₅BN₂): theoretical value: C, 88.46; H, 7.63; N, 2.83; test value: C, 88.40; H, 7.66; N, 2.86. LC-MS: measured value: 991.76 ([M+H]⁺), exact mass: 990.60. |
| 119 | Elemental analysis (C₇₅H₆₅BN₂): theoretical value: C, 89.62; H, 6.52; N, 2.79; test value: C, 89.57; H, 6.55; N, 2.81. LC-MS: measured value: 1005.48 ([M+H]⁺), exact mass: 1004.52. |
| 149 | Elemental analysis (C₇₉H₇₃BN₂): theoretical value: C, 89.41; H, 6.93; N, 2.64; test value: C, 89.43; H, 6.86; N, 2.61. LC-MS: measured value: 1061.45 ([M+H]⁺), exact mass: 1060.59. |
| 165 | Elemental analysis (C₇₅H₆₅BN₂): theoretical value: C, 89.62; H, 6.52; N, 2.79; test value: C, 89.60; H, 6.58; N, 2.82. LC-MS: measured value: 1005.54 ([M+H]⁺), exact mass: 1004.52. |
| 208 | Elemental analysis (C₇₃H₇₃BN₂): theoretical value: C, 88.64; H, 7.44; N, 2.83; test value: C, 88.66; H, 7.40; N, 2.80. LC-MS: measured value: 989.47 ([M+H]⁺), exact mass: 988.59. |
| 48 | Elemental analysis (C₆₉H₆₁BN₂): theoretical value: C, 89.20; H, 6.62; N, 3.02; test value: C, 89.21; H, 6.58; N, 3.01. LC-MS: measured value: 929.43 ([M+H]⁺), exact mass: 928.49. |
| 64 | Elemental analysis (C₆₉H₆₁BN₂): theoretical value: C, 89.20; H, 6.62; N, 3.02; test value: C, 89.22; H, 6.65; N, 3.01. LC-MS: measured value: 929.38 ([M+H]⁺), exact mass: 928.49. |
| 533 | Elemental analysis (C₇₅H₆₃BN₂): theoretical value: C, 89.80; H, 6.33; N, 2.79; test value: C, 89.81; H, 6.36; N, 2.78. LC-MS: measured value: 1003.54 ([M+H]⁺), exact mass: 1002.51. |
| 255 | Elemental analysis (C₆₇H₇₁BN₂): theoretical value: C, 87.94; H, 7.82; N, 3.06; test value: C, 87.96; H, 7.74; N, 3.10. LC-MS: measured value: 915.54 ([M+H]⁺), exact mass: 914.57. |
| 373 | Elemental analysis (C₈₀H₈₀BN₃): theoretical value: C, 87.80; H, 7.37; N, 3.84; test value: C, 87.71; H, 7.31; N, 3.89. LC-MS: measured value: 1094.58 ([M+H]⁺), exact mass: 1093.64. |
| 438 | Elemental analysis (C₇₉H₈₀BN₃): theoretical value: C, 87.67; H, 7.45; N, 3.88; test value: C, 87.57; H, 7.41; N, 3.79. LC-MS: measured value: 1082.84 ([M+H]⁺), exact mass: 1081.64. |
| 20 | Elemental analysis (C₇₃H₇₅BN₂): theoretical value: C, 88.46; H, 7.63; N, 2.83; test value: C, 88.38; H, 7.60; N, 2.89. LC-MS: measured value: 991.66 ([M+H]⁺), exact mass: 990.60. |

PLQY of compound 255 is 98%, and FWHM of compound 255 is 25 nm.

PLQY of compound 373 is 94%, and FWHM of compound 373 is 26 nm.

PLQY of compound 438 is 98%, and FWHM of compound 438 is 25 nm.

PLQY of compound 20 is 97%, and FWHM of compound 20 is 25 nm.

Note: PLQY (fluorescence quantum yield) and FWHM (full width at half maximum) of compound 255, compound 373, compound 438, and compound 20 in a film state are measured by the Horiba Fluorolog-3 series fluorescence spectrometer.

The following describes in detail effect of use of the OLED material synthesized in the present invention in a device by using Device Embodiments 1 to 13 and Device Comparative Examples 1 and 2. Through comparison between Device Embodiments 2 to 13, Device Comparative Examples 1 and 2, and Device Embodiment 1 in the present invention, manufacturing processes of devices are exactly the same, used substrate materials and electrode materials are the same, and thicknesses of the electrode materials are also the same. The difference lies in that light-emitting layer materials in the devices are changed. Table 2-1 and Table 3 show layer structures and test results respectively of the device embodiments.

### Device Embodiment 1

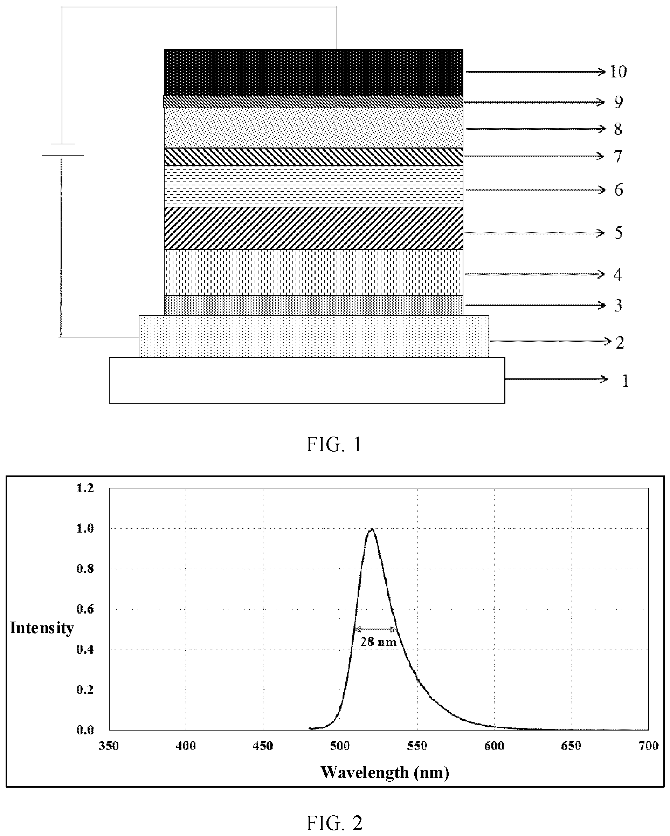

As shown in FIG. 1, a transparent substrate layer 1 is a transparent PI film. An ITO anode layer 2 (with a thickness of 150 nm) is washed sequentially with a cleaner (Semiclean M-L20) and pure water, dried, and then cleaned by ultraviolet-ozone to remove organic residues from the transparent ITO surface. 10 nm thick HT-1 and HI-1 are deposited by using a vacuum evaporation device on the cleaned ITO anode layer 2 to be used as a hole injection layer 3, where a mass ratio of HT-1 to HI-1 is 97:3. Next, 60 nm thick HT-1 is deposited as a hole transport layer 4. Then, 30 nm thick EB-1 is deposited as an electron blocking layer 5. After the electron blocking material is deposited, a light-emitting layer 6 of the OLED light-emitting device is prepared using GH-1 and GH-2 as a host material and using compound 5 as a doping material, where a mass ratio of GH-1 to GH-2 to compound 5 is 69:30:1, and a thickness of the light-emitting layer is 30 nm. 5 nm thick HB-1 is further deposited under vacuum on the light-emitting layer 6 to form a hole blocking layer 7. 30 nm thick ET-1 and Liq are further deposited under vacuum on the hole blocking layer 7 to form an electron transport layer 8, where a mass ratio of ET-1 to Liq is 1: 1. A 1 nm thick LiF layer is prepared by using a vacuum evaporation device on the electron transport layer 8 to form an electron injection layer 9. An 80 nm thick Mg:Ag electrode layer is prepared by using a vacuum evaporation device on the electron injection layer 9 to form a cathode layer 10, where a mass ratio of Mg to Ag is 1:9.

The following describes in detail effect of use of the OLED material synthesized in the present invention in a device by using Device Embodiments 14 to 26 and Device Comparative Examples 3 and 4. Through comparison between Device Embodiments 15 to 26, Device Comparative Examples 3 and 4, and Device Embodiment 14 in the present invention, manufacturing processes of devices are exactly the same, used substrate materials and electrode materials are the same, and thicknesses of the electrode materials are also the same. The difference lies in that light-emitting layer materials in the devices are changed. Table 2-2 and Table 3 show layer structures and test results respectively of the device embodiments.

### Device Embodiment 14

A transparent substrate layer 1 is a transparent PI film. An ITO anode layer 2 (with a thickness of 150 nm) is washed sequentially with a cleaner (Semiclean M-L20) and pure water, dried, and then cleaned by ultraviolet-ozone to remove organic residues from the transparent ITO surface. 10 nm thick HT-1 and HI-1 are deposited by using a vacuum evaporation device on the cleaned ITO anode layer 2 to be used as a hole injection layer 3, where a mass ratio of HT-1 to HI-1 is 97:3. Next, 60 nm thick HT-1 is deposited as a hole transport layer 4. Then, 30 nm thick EB-1 is deposited as an electron blocking layer 5. After the electron blocking material is deposited, a light-emitting layer 6 of the OLED light-emitting device is prepared using GH-1 and GH-2 as a host material, using GD-1 as a first doping material, and using compound 5 as a second doping material, where a mass ratio of GH-1 to GH-2 to GD-1 to compound 5 is 66:30:3:1, and a thickness of the light-emitting layer is 30 nm. 5 nm thick HB-1 is further deposited under vacuum on the light-emitting layer 6 to form a hole blocking layer 7. 30 nm thick ET-1 and Liq are further deposited under vacuum on the hole blocking layer 7 to form an electron transport layer 8, where a mass ratio of ET-1 to Liq is 1: 1. A 1 nm thick LiF layer is prepared by using a vacuum evaporation device on the electron transport layer 8 to form an electron injection layer 9. An 80 nm thick Mg:Ag electrode layer is prepared by using a vacuum evaporation device on the electron injection layer 9 to form a cathode layer 10, where a mass ratio of Mg to Ag is 1:9.

Molecular structural formulas of the related materials are shown as follows:

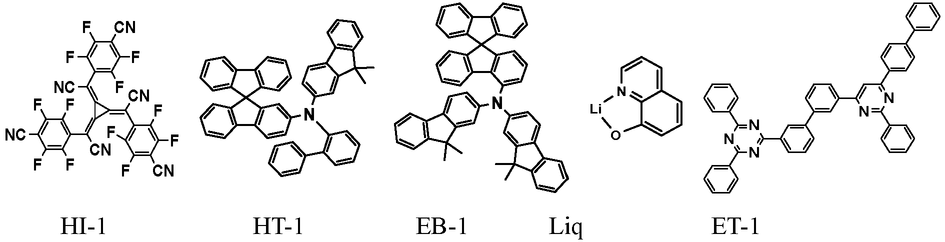

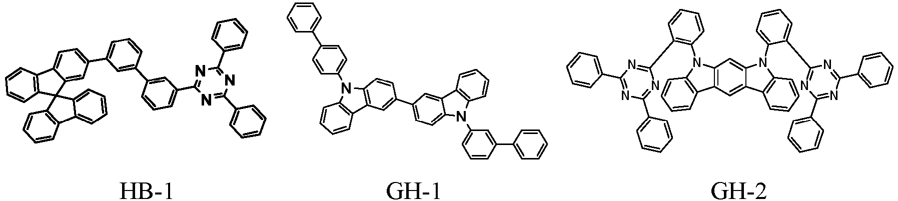

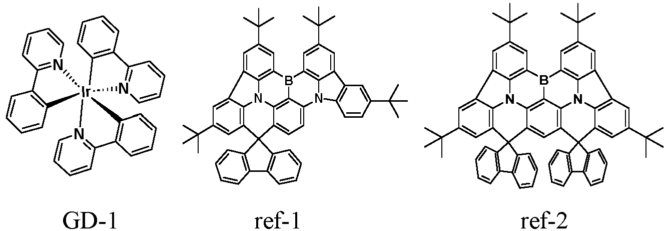

After the foregoing OLED light-emitting devices are manufactured, the anode and the cathode are connected by a well-known drive circuit, and current efficiency of the device and a lifetime of the device are measured. Table 2-1 and Table 2-2 show the device embodiments and comparative examples prepared by using the same method. Table 3 shows the test results of the current efficiency and lifetime of the obtained devices.

**Table 2-1**

| Device embodi ment number | Hole injection layer /Thickness | Hole transport layer /Thickness | Electron blocking layer /Thickness | Light-emitting layer /Thickness | Hole blocking layer /Thickness | Electron transport layer /Thickness | Electron injection layer /Thickness | Cathode layer /Thickness |
|---|---|---|---|---|---|---|---|---|
| Device Embodi ment 1 | HT-1:HI-1 = 97:3 (10 nm) | HT-1 (60 nm) | EB-1 (30 nm) | GH-1:GH-2:compou nd 5 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 2 | HT-1:HI-1 = 97:3 (10 nm) | HT-1 (60 nm) | EB-1 (30 nm) | GH-1:GH-2:compou nd 36 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 3 | HT-1:HI-1 = 97:3 (10 nm) | HT-1 (60 nm) | EB-1 (30 nm) | GH-1:GH-2:compou nd 119 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 4 | HT-1:HI-1 = 97:3 (10 nm) | HT-1 (60 nm) | EB-1 (30 nm) | GH-1:GH-2:compou nd 149 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 5 | HT-1:HI-1 = 97:3 (10 nm) | HT-1 (60 nm) | EB-1 (30 nm) | GH-1:GH-2:compou nd 165 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 6 | HT-1:HI-1 = 97:3 (10 nm) | HT-1 (60 nm) | EB-1 (30 nm) | GH-1:GH-2:compou nd 208 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 7 | HT-1:HI-1 = 97:3 (10 nm) | HT-1 (60 nm) | EB-1 (30 nm) | GH-1:GH-2:compou nd 255 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 8 | HT-1:HI-1 = 97:3 (10 nm) | HT-1 (60 nm) | EB-1 (30 nm) | GH-1:GH-2:compou nd 438 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 9 | HT-1:HI-1 = 97:3 (10 nm) | HT-1 (60 nm) | EB-1 (30 nm) | GH-1:GH-2:compou nd 20 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 10 | HT-1:HI-1 = 97:3 (10 nm) | HT-1 (60 nm) | EB-1 (30 nm) | GH-1:GH-2:compou nd 373 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 11 | HT-1:HI-1 = 97:3 (10 nm) | HT-1 (60 nm) | EB-1 (30 nm) | GH-1:GH-2:compou nd 48 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 12 | HT-1:HI-1 = 97:3 (10 nm) | HT-1 (60 nm) | EB-1 (30 nm) | GH-1:GH-2:compou nd 64 = 69:30:1 (30 nm) | HB-1 (5 nm) | ET-1:Liq = 1:1 (30 nm) | LiF (1 nm) | Mg:Ag = 1:9 (80 nm) |
| Device Embodi ment 13 | HT-1:HI-1 = 97:3 (10 nm) | HT-1 (60 nm) | EB-1 (30 nm) | GH-1:GH-2:compou nd 533 = 69:30:1 (30 nm) | HB-1 (5 nm) | ET-1:Liq = 1:1 (30 nm) | LiF (1 nm) | Mg:Ag = 1:9 (80 nm) |
| Device Compar ative Exampl e 1 | HT-1:HI-1 = 97:3 (10 nm) | HT-1 (60 nm) | EB-1 (30 nm) | GH-1:GH-2:ref-1 = 69:30:1 (30 nm) | HB-1 (5 nm) | ET-1:Liq = 1:1 (30 nm) | LiF (1 nm) | Mg:Ag = 1:9 (80 nm) |
| Device Compar ative Exampl e 2 | HT-1:HI-1 = 97:3 (10 nm) | HT-1 (60 nm) | EB-1 (30 nm) | GH-1:GH-2:ref-2 = 69:30:1 (30 nm) | HB-1 (5 nm) | ET-1:Liq = 1:1 (30 nm) | LiF (1 nm) | Mg:Ag = 1:9 (80 nm) |

**Table 2-2**

| Device embodi ment number | Hole injection layer/Thic kness | Hole transport layer/Thi ckness | Electron blocking layer/Thi ckness | Light-emitting layer /Thickness | Hole blocking layer/Thic kness | Electron transport layer/Thic kness | Electron injection layer/Thi ckness | Cathode layer/Thi ckness |
|---|---|---|---|---|---|---|---|---|
| Device Embodiment 14 | HT-1:HI-1 = 97:3 (10 nm) | HT-1 (60 nm) | EB-1 (30 nm) | GH-1:GH-2:GD-1: compoun d 5 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 15 | HT-1:HI-1 = 97:3 (10 nm) | HT-1 (60 nm) | EB-1 (30 nm) | GH-1:GH-2:GD-1:compoun d 36 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 16 | HT-1:HI-1 = 97:3 (10 nm) | HT-1 (60 nm) | EB-1 (30 nm) | GH-1:GH-2:GD-1: compoun d 119 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 17 | HT-1:HI-1 = 97:3 (10 nm) | HT-1 (60 nm) | EB-1 (30 nm) | GH-1:GH-2:GD-1: compoun d 149 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 18 | HT-1:HI-1 = 97:3 (10 nm) | HT-1 (60 nm) | EB-1 (30 nm) | GH-1:GH-2:GD-1: compoun d 165 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 19 | HT-1:HI-1 = 97:3 (10 nm) | HT-1 (60 nm) | EB-1 (30 nm) | GH-1:GH-2:GD-1: compoun d 208 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 20 | HT-1:HI-1 = 97:3 (10 nm) | HT-1 (60 nm) | EB-1 (30 nm) | GH-1:GH-2:GD-1: compoun d 255 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 21 | HT-1:HI-1 = 97:3 (10 nm) | HT-1 (60 nm) | EB-1 (30 nm) | GH-1:GH-2:GD-1: compoun d 438 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 22 | HT-1:HI-1 = 97:3 (10 nm) | HT-1 (60 nm) | EB-1 (30 nm) | GH-1:GH-2:GD-1: compoun d 20 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 23 | HT-1:HI-1 = 97:3 (10 nm) | HT-1 (60 nm) | EB-1 (30 nm) | GH-1:GH-2:GD-1: compoun d 373 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 24 | HT-1:HI-1 = 97:3 (10 nm) | HT-1 (60 nm) | EB-1 (30 nm) | GH-1:GH-2:GD-1: compoun d48 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 25 | HT-1:HI-1 = 97:3 (10 nm) | HT-1 (60 nm) | EB-1 (30 nm) | GH-1:GH-2:GD-1: compoun d 64 = 66:30:3:1 (30 nm) | HB-1 (5 nm) | ET-1:Liq = 1:1 (30 nm) | LiF (1 nm) | Mg:Ag = 1:9 (80 nm) |
| Device Embodi ment 26 | HT-1:HI-1 = 97:3 (10 nm) | HT-1 (60 nm) | EB-1 (30 nm) | GH-1:GH-2:GD-1: compoun d 533 = 66:30:3:1 (30 nm) | HB-1 (5 nm) | ET-1:Liq = 1:1 (30 nm) | LiF (1 nm) | Mg:Ag = 1:9 (80 nm) |
| Device Compar ative Exampl e 3 | HT-1:HI-1 = 97:3 (10 nm) | HT-1 (60 nm) | EB-1 (30 nm) | GH-1:GH-2:GD-1:ref-1 = 66:30:3:1 (30 nm) | HB-1 (5 nm) | ET-1:Liq = 1:1 (30 nm) | LiF (1 nm) | Mg:Ag = 1:9 (80 nm) |
| Device Compar ative Exampl e 4 | HT-1:HI-1 = 97:3 (10 nm) | HT-1 (60 nm) | EB-1 (30 nm) | GH-1:GH-2:GD-1:ref-2 = 66:30:3:1 (30 nm) | HB-1 (5 nm) | ET-1:Liq = 1:1 (30 nm) | LiF (1 nm) | Mg:Ag = 1:9 (80 nm) |

**Table 3**

| Device embodiment | Current efficiency (cd/A) | Luminesc ence peak (nm) | LT95 lifetime (H) | Device embodiment | Current efficiency (cd/A) | Luminescence peak (nm) | LT95 lifetime (H) |
|---|---|---|---|---|---|---|---|
| Embodiment 1 | 54.15 | 520 | 232.2 | Embodiment 14 | 59.29 | 521 | 371.2 |
| Embodiment 2 | 56.92 | 525 | 238.3 | Embodiment 15 | 61.52 | 524 | 374.5 |
| Embodiment 3 | 63.79 | 526 | 269.4 | Embodiment 16 | 69.37 | 525 | 422.9 |
| Embodiment 4 | 61.87 | 522 | 276.1 | Embodiment 17 | 66.96 | 523 | 441.6 |
| Embodiment 5 | 60.63 | 525 | 289.3 | Embodiment 18 | 65.43 | 526 | 450.8 |
| Embodiment 6 | 57.97 | 528 | 255.7 | Embodiment 19 | 63.04 | 527 | 405.1 |
| Embodiment 7 | 61.38 | 510 | 221 | Embodiment 20 | 65.10 | 512 | 321 |
| Embodiment 8 | 57.04 | 516 | 242 | Embodiment 21 | 61.28 | 518 | 338 |
| Embodiment 9 | 60.64 | 523 | 239 | Embodiment 22 | 64.59 | 523 | 338 |
| Embodiment 10 | 61.88 | 523 | 268 | Embodiment 23 | 66.28 | 526 | 367 |
| Embodiment 11 | 59.32 | 520 | 285.6 | Embodiment 24 | 66.52 | 521 | 398.5 |
| Embodiment 12 | 58.44 | 521 | 281.3 | Embodiment 25 | 63.27 | 520 | 376.8 |
| Embodiment 13 | 52.29 | 519 | 320.4 | Embodiment 26 | 60.53 | 520 | 523.6 |
| Comparative Example 1 | 51.23 | - | 188 | Comparative Example 3 | 53.63 | - | 269 |
| Comparative Example 2 | 59.43 | - | 61 | Comparative Example 4 | 68.16 | - | 107 |

| | | | | | | | |
|---|---|---|---|---|---|---|---|
| Note: The current efficiency and luminescence peak are measured by using an IVL (current-voltage-luminance) measurement system (Suzhou Fstar Scientific Instruments Co., Ltd.); a lifetime testing system is an EAS-62C OLED device lifetime tester from Japan Giken company; LT95 is time taken for the device luminance to decay to 95%; and all data is measured at 10 mA/cm². | | | | | | | |

It can be learned from the device data results in Table 3 that the luminescence peak of the compound in the present invention is 510 nm to 550 nm, which can achieve good green luminescence effect; compared with Device Comparative Examples 1 and 3, the device efficiency and lifetime of the organic light-emitting device, whether of a single-doped system or a double-doped system, in the present invention are greatly improved compared with an OLED device with a known material; and compared with Device Comparative Examples 2 and 4, the lifetime of the organic light-emitting device, whether of a single-doped system or a double-doped system, in the present invention is greatly improved compared with an OLED device with a known material.

In conclusion, the foregoing descriptions are merely preferred embodiments of the present invention, but are not intended to limit the present invention. Any modification, equivalent replacement, and improvement made within the spirit and principle of the present invention shall fall within the protection scope of the present invention.

## Claims

1. A boron-containing resonance organic compound, wherein a structure of the boron-containing resonance organic compound is shown in general formula (1): 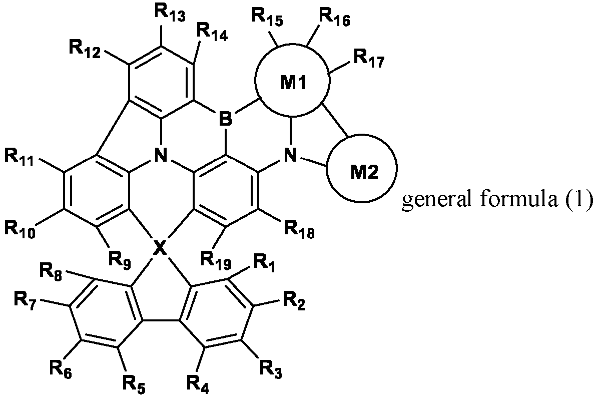
in general formula (1), R₁ to R₁₉ each time present each independently represent one of a hydrogen atom, a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted C₆-C₁₀ aryloxy, substituted or unsubstituted arylamido, substituted or unsubstituted C₆-C₃₀ aryl, substituted or unsubstituted C₂-C₃₀ heteroaryl, and substituted or unsubstituted C₂-C₃₀ boranyl;
any two adjacent groups in R₁ to R₁₄ are linkable to form a ring;
R₁₈ and R₁₉ are linkable to form a ring;
M₁ represents one of a substituted or unsubstituted C₆-C₃₀ aromatic ring and a substituted or unsubstituted 5-membered to 30-membered heteroaromatic ring;
M₂ represents an R-substituted or unsubstituted six-membered ring;
R represents one of a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted C₆-C₁₀ aryloxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
a substitution manner of R is a single-bond linkage or a polycyclic linkage;
R₁, R₂, R₃, R₄, R₅, R₆, R₇, R₈, R₁₈, and R₁₉ do not all represent a hydrogen atom when M₁ and M₂ both represent a substituted or unsubstituted benzene ring;
X represents a carbon atom or a silicon atom;
a substituent for substituting a substitutable group is optionally selected from one or more of a deuterium atom, a tritium atom, a halogen atom, cyano, C₁-C₁₀ alkyl, deuterium- or tritium-substituted C₁-C₁₀ alkyl, C₃-C₁₀ cycloalkyl, C₆-C₃₀ aryl, deuterium- or tritium-substituted C₆-C₃₀ aryl, 5-membered to 30-membered heteroaryl, and deuterium- or tritium-substituted C₂-C₃₀ heteroaryl; and
a heteroatom in the heteroaryl and the heteroaromatic ring is optionally selected from one or more of O, S, N, Si, and B.

2. The boron-containing resonance organic compound according to claim 1, wherein in general formula (1), R₁ to R₁₉ each time present identically or differently represent one of a hydrogen atom, a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₁-C₁₀ alkoxy, substituted or unsubstituted C₁-C₁₀ aryloxy, substituted or unsubstituted arylamido, substituted or unsubstituted C₆-C₃₀ aryl, and substituted or unsubstituted C₂-C₃₀ heteroaryl;
any adjacent two of R₁ to R₁₄ are linkable to form a ring;
R₁₈ and R₁₉ are linkable to form a ring;
M₁ represents one of a substituted or unsubstituted C₆-C₃₀ aromatic ring and a substituted or unsubstituted 5-membered to 30-membered heteroaromatic ring;
M₂ represents a substituted or unsubstituted six-membered ring;
R₁ to R₈, R₁₈, and R₁₉ do not all represent a hydrogen atom when M₁ and M₂ both represent a substituted or unsubstituted benzene ring;
X represents C or Si; and
a substituent for substituting a group is optionally selected from any one of deuterium, tritium, a halogen atom, cyano, C₁-C₁₀ alkyl, deuterium- or tritium-substituted C₁-C₁₀ alkyl, C₆-C₃₀ aryl, deuterium- or tritium-substituted C₆-C₃₀ aryl, C₅-C₃₀ heteroaryl, and deuterium- or tritium-substituted C₂-C₃₀ heteroaryl.

3. The boron-containing resonance organic compound according to claim 2, wherein a structure of the boron-containing resonance organic compound is shown in any one of general formula (1-1) to general formula (1-3): 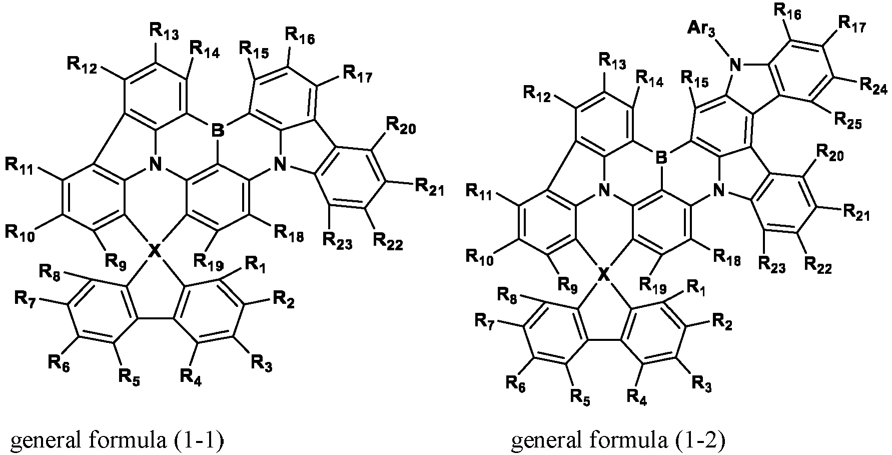 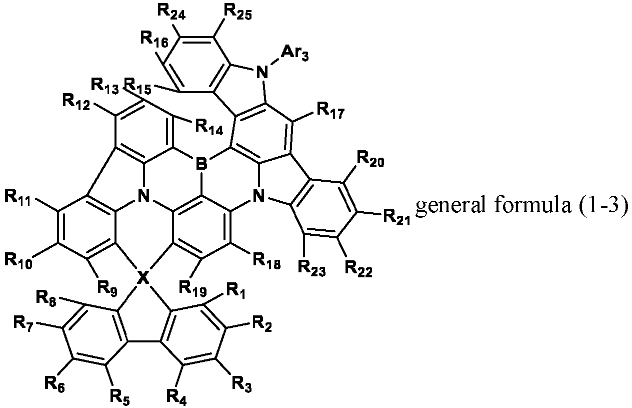
in general formula (1-1) to general formula (1-3), R₁ to R₂₅ each time present identically or differently represent one of a hydrogen atom, a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₁-C₁₀ alkoxy, substituted or unsubstituted C₁-C₁₀ aryloxy, substituted or unsubstituted arylamido, substituted or unsubstituted C₆-C₃₀ aryl, and substituted or unsubstituted C₂-C₃₀ heteroaryl;
any adjacent two of R₁ to R₂₅ are linkable to form a ring;
Ar₃ each time present identically or differently represents one of substituted or unsubstituted C₁-C₁₀ alkyl, substituted or unsubstituted C₃-C₁₀ cycloalkyl, substituted or unsubstituted C₁-C₁₀ alkoxy, substituted or unsubstituted C₁-C₁₀ aryloxy, substituted or unsubstituted arylamido, substituted or unsubstituted C₆-C₃₀ aryl, and substituted or unsubstituted C₂-C₃₀ heteroaryl;
X represents C or Si;
in general formula (1-1), R₁ to R₈, R₁₈, and R₁₉ do not all represent a hydrogen atom; and
a substituent for substituting a group is optionally selected from any one of deuterium, tritium, a halogen atom, cyano, C₁-C₁₀ alkyl, deuterium- or tritium-substituted C₁-C₁₀ alkyl, C₆-C₃₀ aryl, deuterium- or tritium-substituted C₆-C₃₀ aryl, C₅-C₃₀ heteroaryl, and deuterium- or tritium-substituted C₂-C₃₀ heteroaryl.

4. The boron-containing resonance organic compound according to claim 2, wherein a structure of the boron-containing resonance organic compound is shown in any one of general formula (1-4) to general formula (1-6): 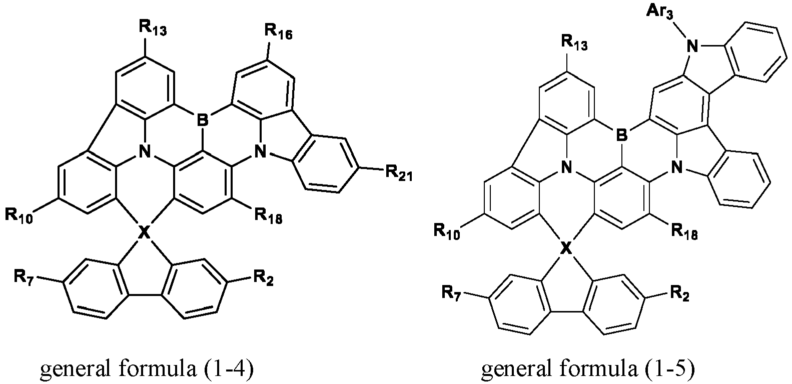 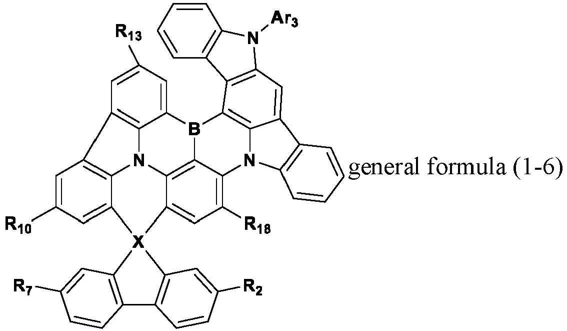
in general formula (1-4) to general formula (1-6), meanings of R₂, R₇, R₁₀, R₁₃, R₁₆, R₁₈, R₂₁, and X are the same as those defined according to claim 2;
Ar₃ represents one of substituted or unsubstituted C₁-C₁₀ alkyl, substituted or unsubstituted C₃-C₁₀ cycloalkyl, substituted or unsubstituted C₁-C₁₀ alkoxy, substituted or unsubstituted C₁-C₁₀ aryloxy, substituted or unsubstituted arylamido, substituted or unsubstituted C₆-C₃₀ aryl, and substituted or unsubstituted C₂-C₃₀ heteroaryl; and
a substituent for substituting a group is optionally selected from any one of deuterium, tritium, a halogen atom, cyano, C₁-C₁₀ alkyl, deuterium- or tritium-substituted C₁-C₁₀ alkyl, C₆-C₃₀ aryl, deuterium- or tritium-substituted C₆-C₃₀ aryl, C₅-C₃₀ heteroaryl, and deuterium- or tritium-substituted C₂-C₃₀ heteroaryl.

5. The boron-containing resonance organic compound according to claim 2, wherein a structure of the boron-containing resonance organic compound is shown in any one of general formula (1-7) to general formula (1-12): 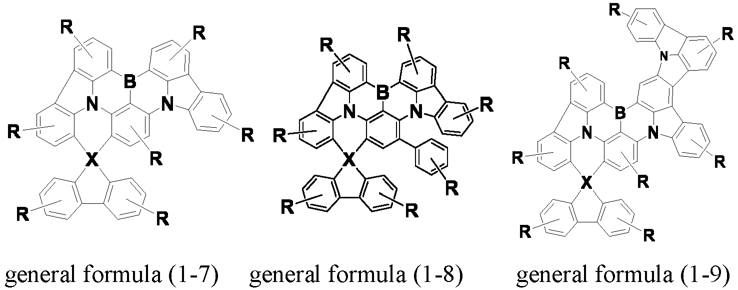 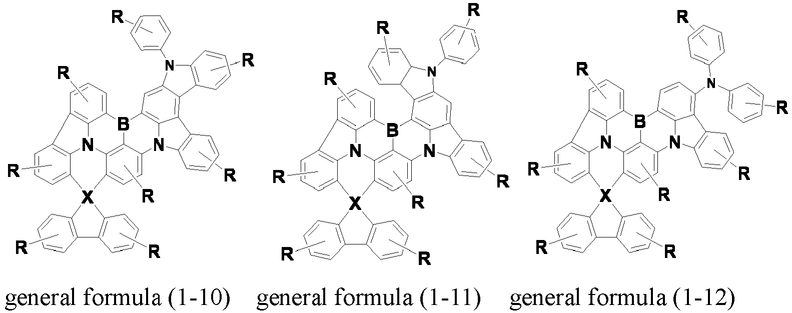
in general formula (1-7) to general formula (1-12), R each time present identically or differently represents one of a hydrogen atom, a deuterium atom, a tritium atom, a halogen atom, cyano, substituted or unsubstituted C₁-C₁₀ alkyl, substituted or unsubstituted C₃-C₁₀ cycloalkyl, substituted or unsubstituted C₁-C₁₀ alkoxy, substituted or unsubstituted C₁-C₁₀ aryloxy, substituted or unsubstituted arylamido, substituted or unsubstituted C₆-C₃₀ aryl, and substituted or unsubstituted C₂-C₃₀ heteroaryl;
X represents C or Si; and
a substituent for substituting a group is optionally selected from any one of deuterium, tritium, a halogen atom, cyano, C₁-C₁₀ alkyl, deuterium- or tritium-substituted C₁-C₁₀ alkyl, C₆-C₃₀ aryl, deuterium- or tritium-substituted C₆-C₃₀ aryl, C₅-C₃₀ heteroaryl, and deuterium- or tritium-substituted C₂-C₃₀ heteroaryl.

6. The boron-containing resonance organic compound according to any one of claims 2 to 5, wherein R and R₁ to R₂₅ each independently represent one of a hydrogen atom, a deuterium atom, a tritium atom, a fluorine atom, cyano, adamantyl, methyl, deuterated methyl, tritiated methyl, trifluoromethyl, ethyl, deuterated ethyl, tritiated ethyl, isopropyl, deuterated isopropyl, tritiated butyl, tert-butyl, deuterated tert-butyl, tritiated tert-butyl, cyclopentyl, deuterated cyclopentyl, tritiated cyclopentyl, methyl-substituted cyclopentyl, cyclohexyl, phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, tert-butyl-substituted dibenzofuryl, phenyl-substituted tert-butyl, xanthone, phenyl-substituted triazinyl, phenyl-substituted boranyl, methoxy, and tert-butoxy;
Ar₃ independently represents one of phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, phenyl-substituted amino, tert-butylbenzene-substituted amino, tert-butyl-substituted dibenzofuryl, phenyl-substituted tert-butyl, xanthone, phenyl-substituted triazinyl, phenyl-substituted boranyl, methoxy, and tert-butoxy;
M₁ represents one of phenyl, deuterated phenyl, diphenyl, deuterated diphenyl, triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, phenyl-substituted amino, tert-butyl-substituted dibenzofuryl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, and xanthone;
M₂ represents one of phenyl, deuterated phenyl, pyridinyl, phenyl-substituted pyridinyl, methyl-substituted phenyl, ethyl-substituted phenyl, isopropyl-substituted phenyl, and tert-butyl-substituted phenyl; and
a substituent for substituting a substitutable group is optionally selected from one or more of a deuterium atom, a chlorine atom, a fluorine atom, trifluoromethyl, adamantyl, cyano, methyl, ethyl, propyl, isopropyl, tert-pentyl, tert-butyl, butyl, methoxy, phenyl, diphenyl, naphthyl, anthryl, phenanthryl, pyridinyl, pyrimidinyl, pyrazinyl, pyridazinyl, benzoxazolyl, benzothiazolyl, quinoxalinyl, quinolyl, isoquinolyl, furyl, thienyl, indolyl, pyrrolyl, dibenzofuryl, dibenzothienyl, 9,9-dimethylfluorenyl, spirofluorenyl, carbazolyl, N-phenylcarbazolyl, carbazolinyl, and azaphenanthryl.

7. The boron-containing resonance organic compound according to any one of claims 2 to 5, wherein R and R₁ to R₂₅ each independently represent the following structures:
any one of a hydrogen atom, cyano, 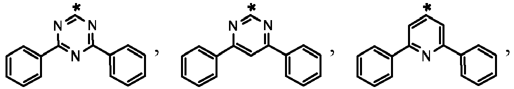 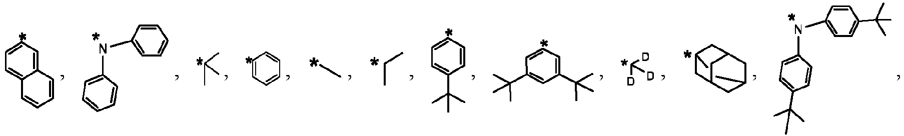 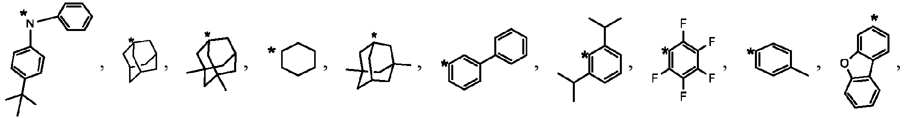 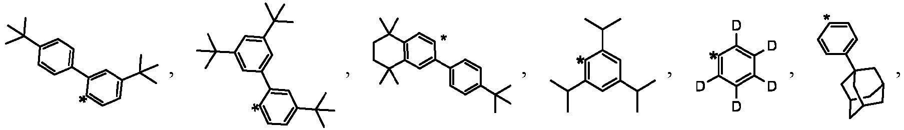 and 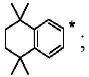
Ar₃ represents the following structures:
any one of 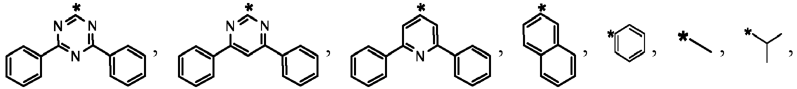 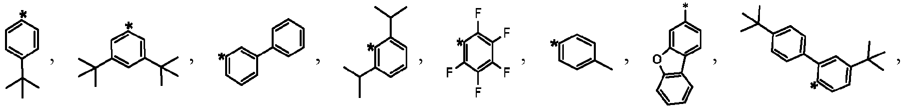 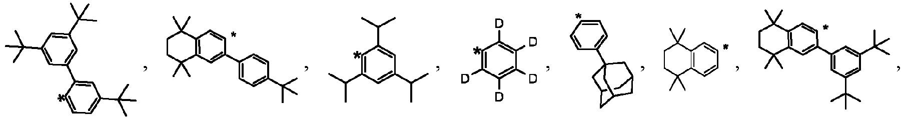 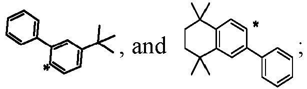
M₁ represents any one of the following ring structures: 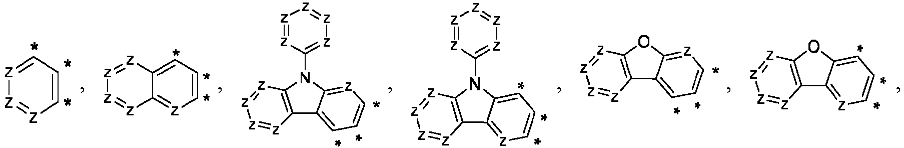 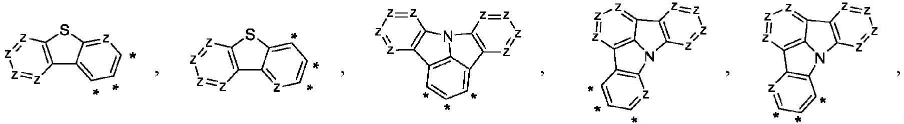 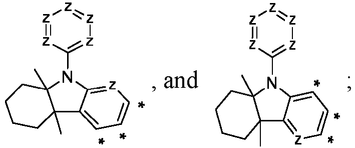
M₂ represents the following ring structure: 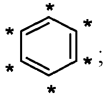
Z represents C-Rₐ; and
Rₐ each time present independently represents one of a hydrogen atom, a deuterium atom, a tritium atom, a halogen atom, cyano, adamantyl, methyl, deuterated methyl, tritiated methyl, trifluoromethyl, ethyl, deuterated ethyl, tritiated ethyl, isopropyl, deuterated isopropyl, tritiated isopropyl, tert-butyl, deuterated tert-butyl, tritiated tert-butyl, cyclopentyl, deuterated cyclopentyl, tritiated cyclopentyl, methyl-substituted cyclopentyl, cyclohexyl, phenyl, deuterated phenyl, tritiated phenyl, diphenyl, deuterated diphenyl, tritiated diphenyl, triphenyl, deuterated triphenyl, tritiated triphenyl, diphenyl ether, methyl-substituted diphenyl ether, naphthyl, anthryl, phenanthryl, pyridinyl, phenyl-substituted pyridinyl, quinolyl, furyl, thienyl, benzofuryl, dibenzofuryl, dibenzothienyl, carbazolyl, N-phenylcarbazolyl, 9,9-dimethylfluorenyl, spirofluorenyl, methyl-substituted phenyl, ethyl-substituted phenyl, isopropyl-substituted phenyl, tert-butyl-substituted phenyl, methyl-substituted diphenyl, ethyl-substituted diphenyl, isopropyl-substituted diphenyl, tert-butyl-substituted diphenyl, deuterated methyl-substituted phenyl, deuterated ethyl-substituted phenyl, deuterated isopropyl-substituted phenyl, deuterated tert-butyl-substituted phenyl, deuterated methyl-substituted diphenyl, deuterated ethyl-substituted diphenyl, deuterated isopropyl-substituted diphenyl, deuterated tert-butyl-substituted diphenyl, phenyl-substituted amino, tert-butylbenzene-substituted amino, tert-butyl-substituted dibenzofuryl, phenyl-substituted tert-butyl, xanthone, phenyl-substituted triazinyl, phenyl-substituted boranyl, methoxy, and tert-butoxy.

8. The boron-containing resonance organic compound according to claim 1, wherein a structure of the boron-containing resonance organic compound is shown in general formula (A-1): 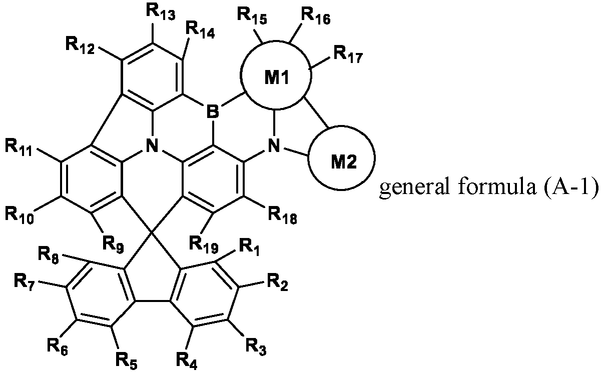
in general formula (A-1), R₁ to R₁₉ each time present each independently represent one of a hydrogen atom, a deuterium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
any two adjacent groups in R₁ to R₁₉ are linkable to form a ring;
M₁ represents one of a substituted or unsubstituted C₆-C₃₀ aromatic ring and a substituted or unsubstituted 5-membered to 30-membered heteroaromatic ring;
M₂ represents an R-substituted or unsubstituted six-membered ring;
R represents one of a deuterium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
a substitution manner of R is a single-bond linkage or a polycyclic linkage;
R₁, R₂, R₃, R₄, R₅, R₆, R₇, R₈, R₁₈, and R₁₉ do not all represent a hydrogen atom when M₁ and M₂ both represent a substituted or unsubstituted benzene ring;
a substituent for substituting a substitutable group is optionally selected from one or more of a deuterium atom, a halogen atom, cyano, C₁-C₁₀ alkyl, C₃-C₁₀ cycloalkyl, C₆-C₃₀ aryl, and 5-membered to 30-membered heteroaryl; and
a heteroatom in the heteroaryl and the heteroaromatic ring is optionally selected from one or more of O, S, N, Si, and B.

9. The boron-containing resonance organic compound according to claim 1, wherein a structure of the boron-containing resonance organic compound is shown in general formula (A-2): 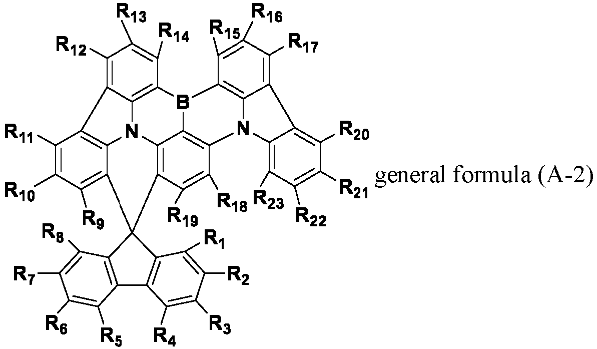
in general formula (A-2), R₁ to R₂₃ each time present each independently represent one of a hydrogen atom, a deuterium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
any two adjacent groups in R₁ to R₂₃ are linkable to form a ring;
R₁, R₂, R₃, R₄, R₅, R₆, R₇, R₈, R₁₈, and R₁₉ do not all represent a hydrogen atom;
a substituent for substituting a substitutable group is optionally selected from one or more of a deuterium atom, a halogen atom, cyano, C₁-C₁₀ alkyl, C₃-C₁₀ cycloalkyl, C₆-C₃₀ aryl, and 5-membered to 30-membered heteroaryl; and
a heteroatom in the heteroaryl is optionally selected from one or more of O, S, N, Si, and B.

10. The boron-containing resonance organic compound according to claim 9, wherein a structure of the boron-containing resonance organic compound is shown in general formula (A-3): 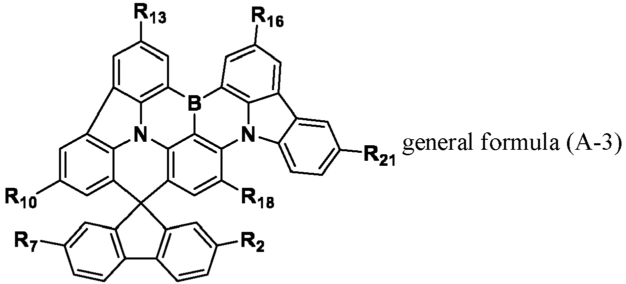
in general formula (A-3), R₂, R₇, R₁₀, R₁₃, R₁₆, and R₂₁ each time present each independently represent one of a hydrogen atom, a deuterium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
R₁₈ represents one of a deuterium atom, a halogen atom, cyano, substituted or unsubstituted C₁-C₁₀ alkyl, substituted or unsubstituted C₃-C₁₀ cycloalkyl, substituted or unsubstituted C₂-C₁₀ alkenyl, substituted or unsubstituted C₂-C₁₀ alkynyl, substituted or unsubstituted C₁-C₁₀ alkoxy, substituted or unsubstituted arylamido, substituted or unsubstituted C₆-C₃₀ aryl, substituted or unsubstituted 5-membered to 30-membered heteroaryl, and substituted or unsubstituted C₂-C₃₀ boranyl;
a substituent for substituting a substitutable group is optionally selected from one or more of a deuterium atom, a halogen atom, cyano, C₁-C₁₀ alkyl, C₃-C₁₀ cycloalkyl, C₆-C₃₀ aryl, and 5-membered to 30-membered heteroaryl; and
a heteroatom in the heteroaryl is optionally selected from one or more of O, S, N, Si, and B.

11. The boron-containing resonance organic compound according to claim 1, 8, 9, or 10, wherein M₁ represents any one of the following substituted or unsubstituted groups: phenyl, naphthyl, anthryl, phenanthryl, pyridinyl, quinolyl, furyl, thienyl, benzofuryl, benzothienyl, dibenzofuryl, dibenzothienyl, N-phenylcarbazolyl, 9,9-dimethylfluorenyl, indolo[3,2,1-jk]carbazolyl, 1,1,4,4-tetramethyl-1,2,3,4-tetrahydronaphthyl, and spirofluorenyl;
M₂ represents any one of the following R-substituted or unsubstituted groups: phenyl, naphthyl, anthryl, phenanthryl, pyridinyl, and quinolyl;
R represents a deuterium atom, a halogen atom, cyano, substituted or unsubstituted methyl, substituted or unsubstituted ethyl, substituted or unsubstituted isopropyl, substituted or unsubstituted tert-butyl, substituted or unsubstituted cyclohexyl, substituted or unsubstituted adamantyl, substituted or unsubstituted phenyl, substituted or unsubstituted diphenyl, substituted or unsubstituted triphenyl, substituted or unsubstituted naphthyl, substituted or unsubstituted anthryl, substituted or unsubstituted phenanthryl, substituted or unsubstituted pyridinyl, substituted or unsubstituted quinolyl, substituted or unsubstituted furyl, substituted or unsubstituted thienyl, substituted or unsubstituted benzofuryl, substituted or unsubstituted benzothienyl, substituted or unsubstituted dibenzofuryl, substituted or unsubstituted dibenzothienyl, substituted or unsubstituted carbazolyl, substituted or unsubstituted N-phenylcarbazolyl, substituted or unsubstituted 9,9-dimethylfluorenyl, substituted or unsubstituted 9,9-diphenylfluorenyl, substituted or unsubstituted spirofluorenyl, substituted or unsubstituted amido, or substituted or unsubstituted triazinyl;
R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀, R₂₁, R₂₂, and R₂₃ each independently represent a hydrogen atom, a deuterium atom, a halogen atom, cyano, substituted or unsubstituted methyl, substituted or unsubstituted ethyl, substituted or unsubstituted isopropyl, substituted or unsubstituted tert-butyl, substituted or unsubstituted cyclohexyl, substituted or unsubstituted adamantyl, substituted or unsubstituted phenyl, substituted or unsubstituted diphenyl, substituted or unsubstituted triphenyl, substituted or unsubstituted naphthyl, substituted or unsubstituted anthryl, substituted or unsubstituted phenanthryl, substituted or unsubstituted pyridinyl, substituted or unsubstituted quinolyl, substituted or unsubstituted furyl, substituted or unsubstituted thienyl, substituted or unsubstituted benzofuryl, substituted or unsubstituted benzothienyl, substituted or unsubstituted dibenzofuryl, substituted or unsubstituted dibenzothienyl, substituted or unsubstituted carbazolyl, substituted or unsubstituted N-phenylcarbazolyl, substituted or unsubstituted 9,9-dimethylfluorenyl, substituted or unsubstituted 9,9-diphenylfluorenyl, substituted or unsubstituted spirofluorenyl, substituted or unsubstituted amido, or substituted or unsubstituted triazinyl; and
a substituent for substituting a group is optionally selected from one or more of a deuterium atom, a chlorine atom, a fluorine atom, trifluoromethyl, adamantyl, cyano, methyl, ethyl, propyl, isopropyl, tert-pentyl, tert-butyl, butyl, methoxy, phenyl, diphenyl, naphthyl, anthryl, phenanthryl, pyridinyl, pyrimidinyl, pyrazinyl, pyridazinyl, benzoxazolyl, benzothiazolyl, quinoxalinyl, quinolyl, isoquinolyl, furyl, thienyl, indolyl, pyrrolyl, dibenzofuryl, dibenzothienyl, 9,9-dimethylfluorenyl, spirofluorenyl, carbazolyl, N-phenylcarbazolyl, carbazolinyl, and azaphenanthryl.

12. The boron-containing resonance organic compound according to claim **1,** 8, 9, or 10, wherein M₁ represents the following structures:
any one of 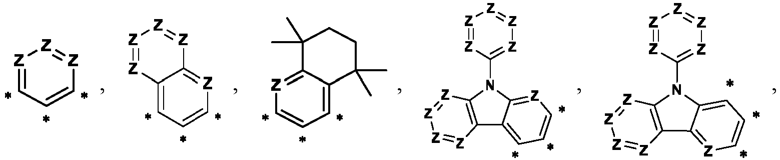 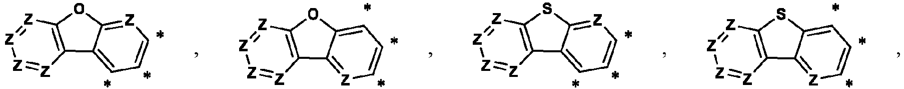 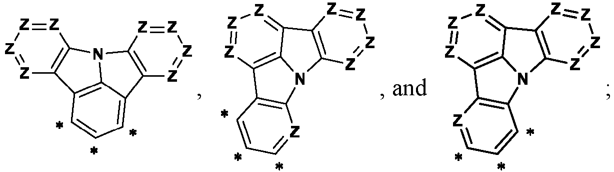
M₂ represents the following structures:
any one of 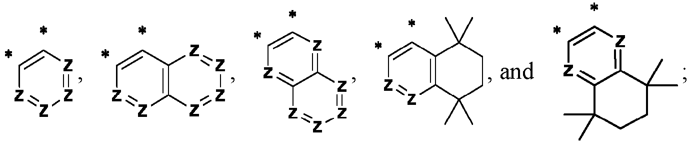
Z represents C-(H) or C-(R); and
R, R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀, R₂₁, R₂₂, and R₂₃ each independently represent the following structures:
any one of a hydrogen atom, a deuterium atom, methyl, ethyl, isopropyl, tert-butyl, cyano, trifluoromethyl,

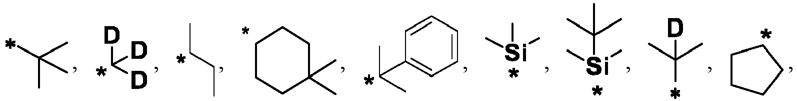

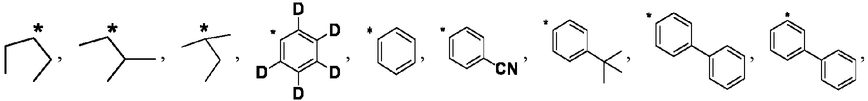

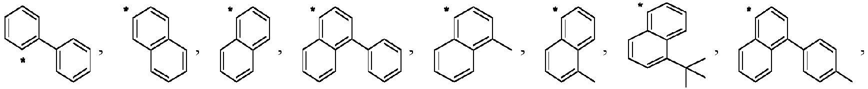

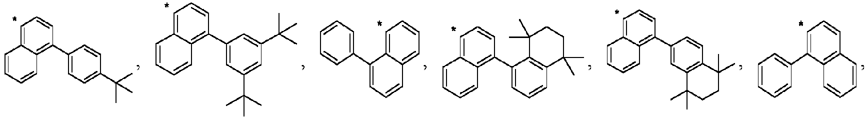

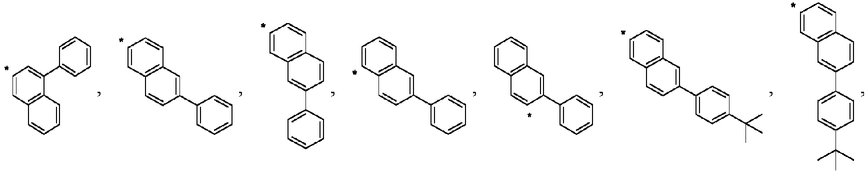

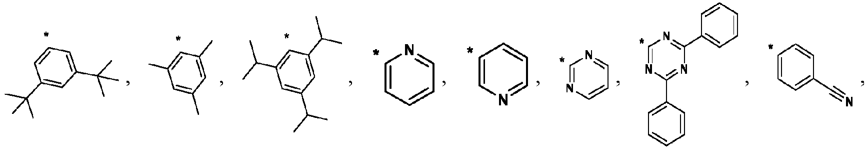

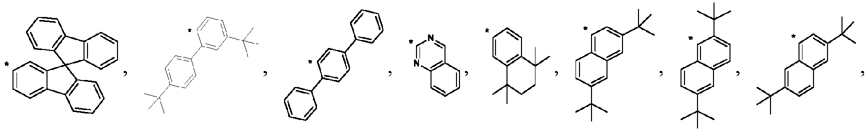

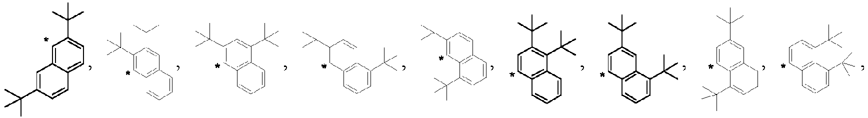

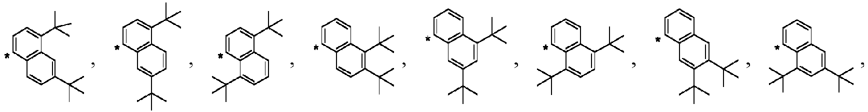

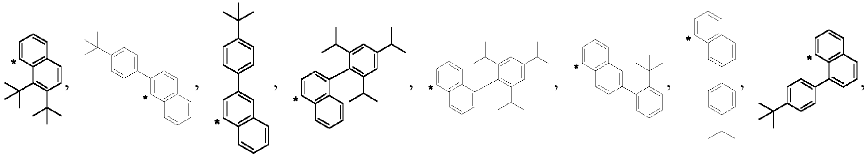

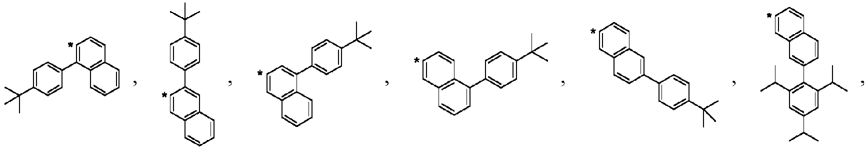

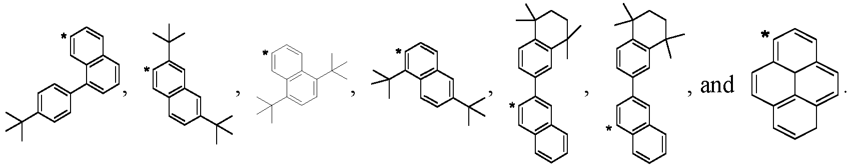

13. The boron-containing resonance organic compound according to any one of claims 1 to 12, wherein
M₁ represents the following structures:
any one of 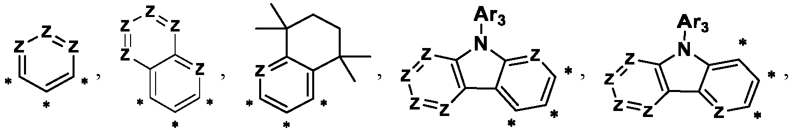 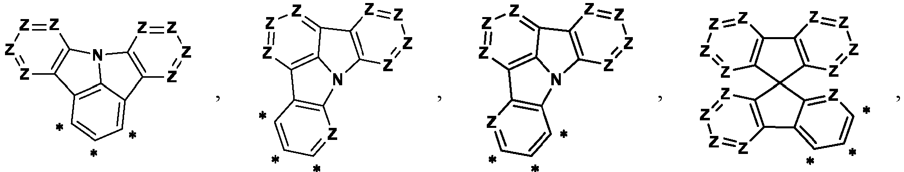 and 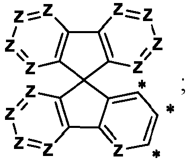
M₂ represents the following structures:
any one of 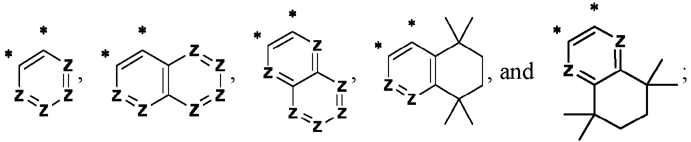
Z represents C-(H) or C-(R);
R, R₁, R₂, R₃, R₄, R₅, R₆, R₇, R₈, R₉, R₁₀, R₁₁, R₁₂, R₁₃, R₁₄, R₁₅, R₁₆, R₁₇, R₂₀, R₂₁, R₂₂, and R₂₃ each independently represent the following structures:
any one of a hydrogen atom, a deuterium atom, methyl, ethyl, isopropyl, tert-butyl, trifluoromethyl, 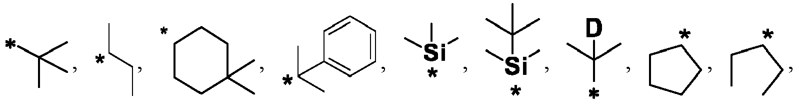 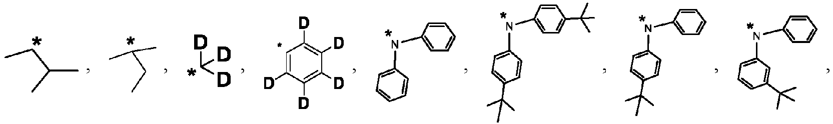 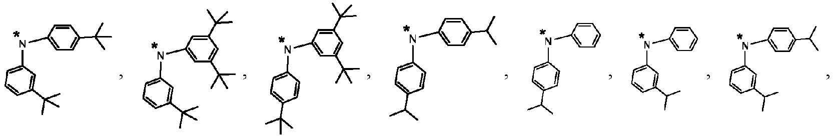 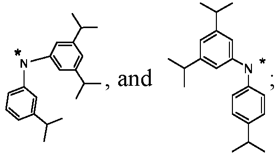
R₁₈ and R₁₉ each independently represent the following structures:
any one of a hydrogen atom, cyano, tert-butyl, 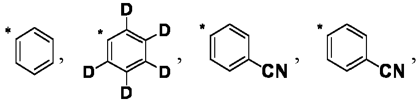 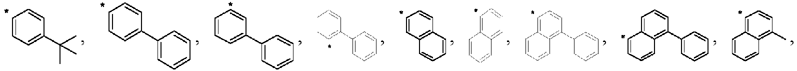 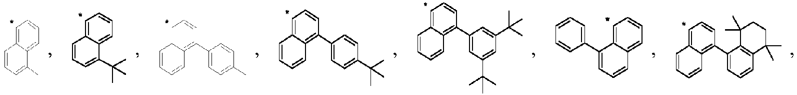 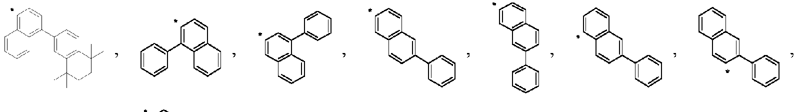 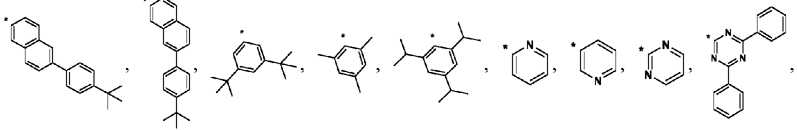 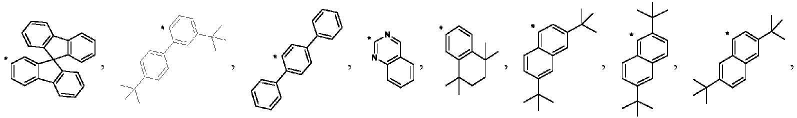 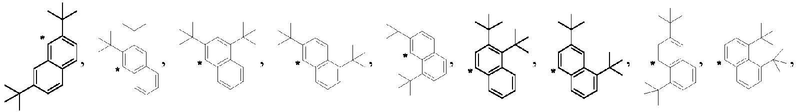 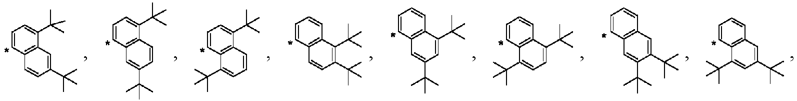 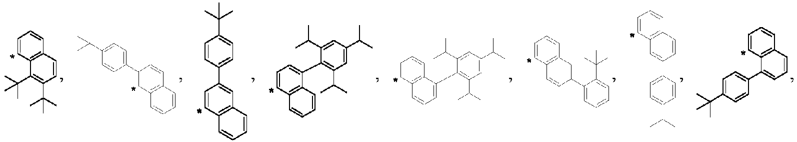 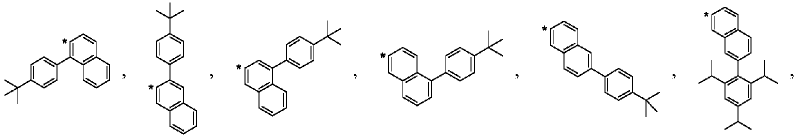 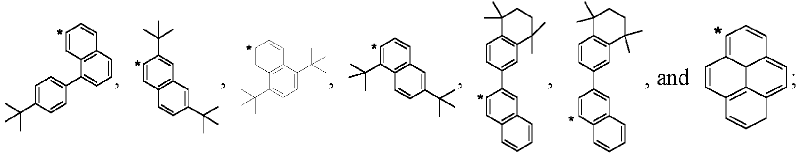 and
Ar₃ represents the following structures:
any one of

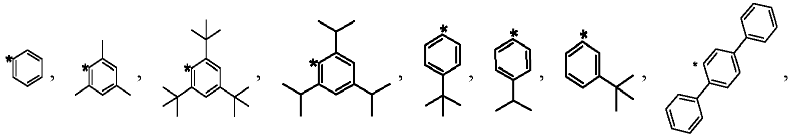

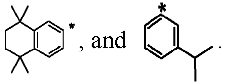

14. The boron-containing resonance organic compound according to claim 1, wherein a specific structural formula of the boron-containing resonance organic compound is any one of the following structures:

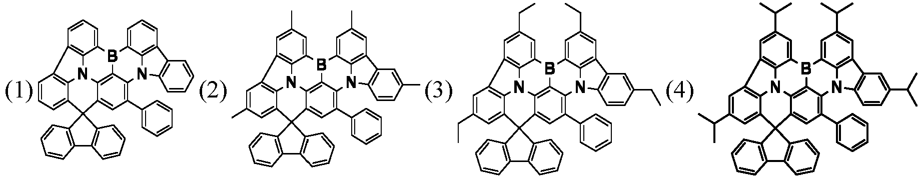

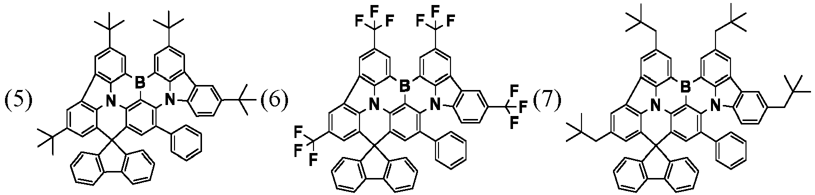

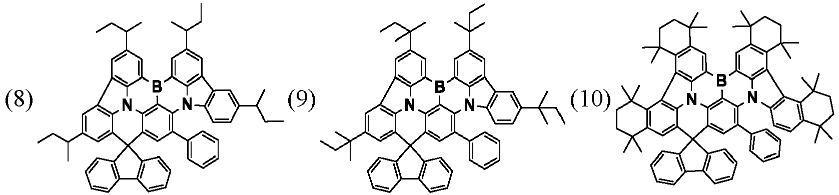

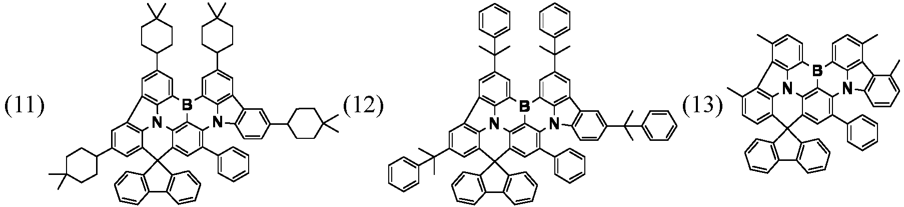

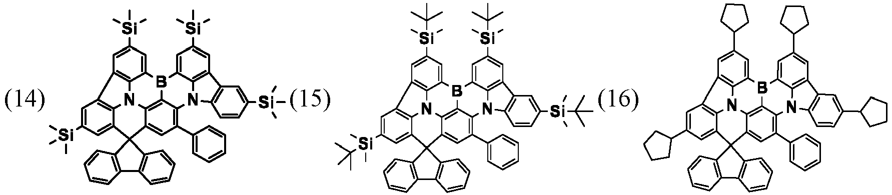

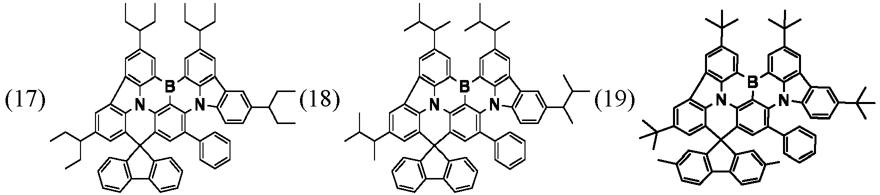

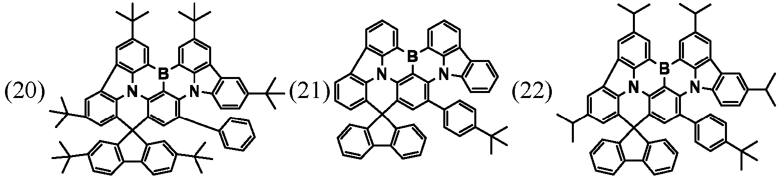

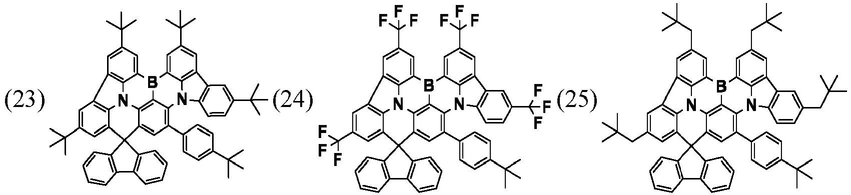

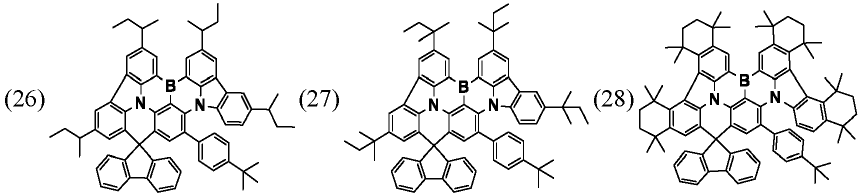

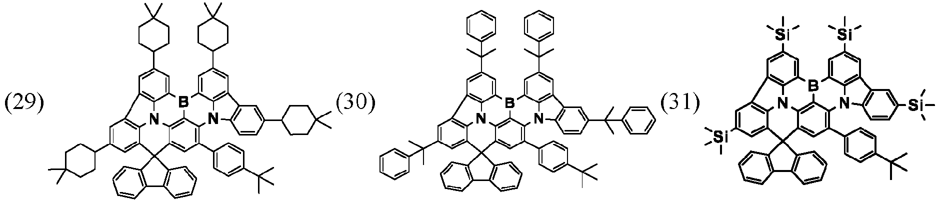

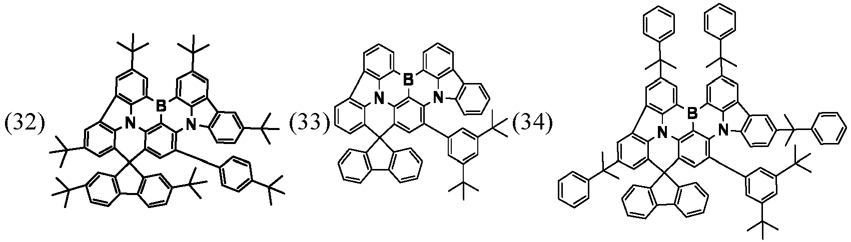

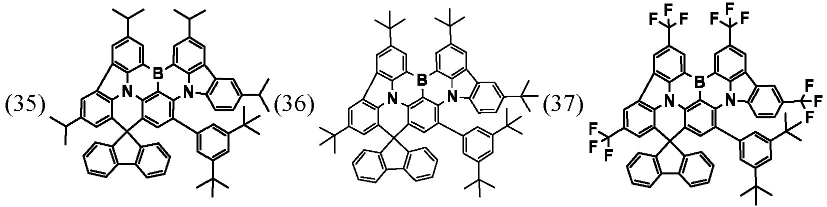

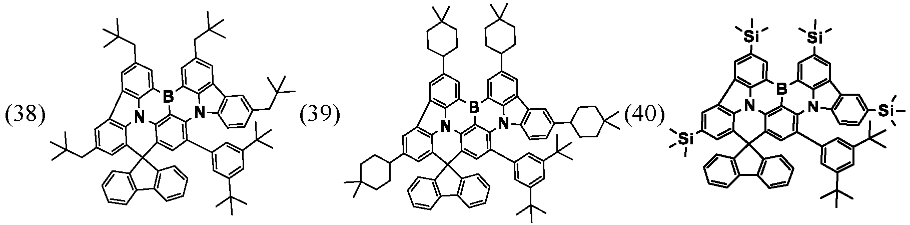

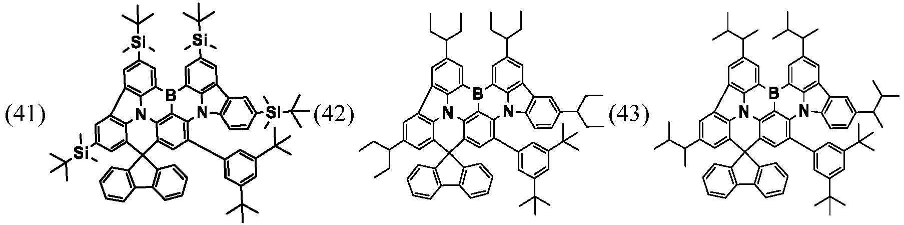

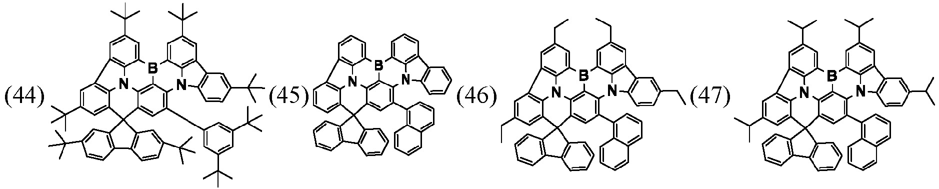

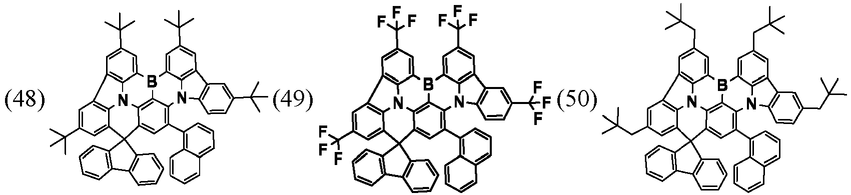

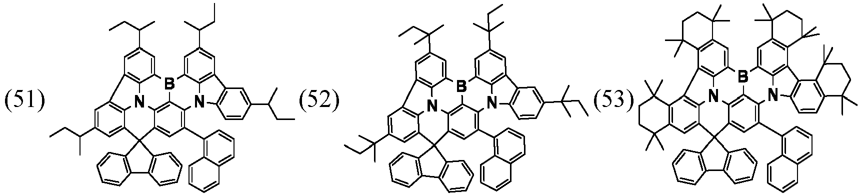

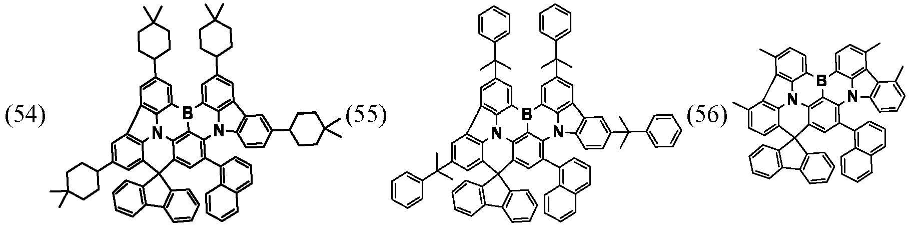

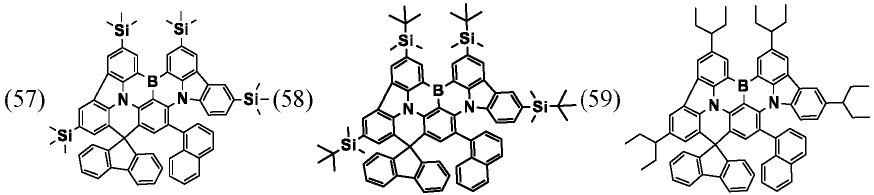

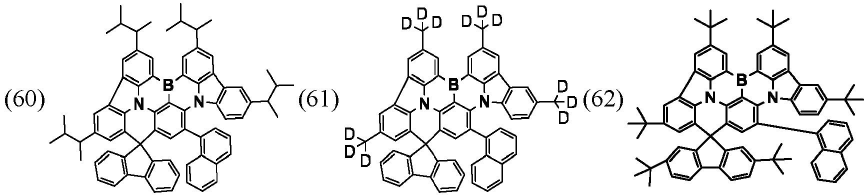

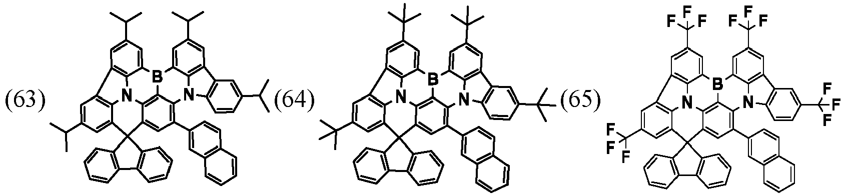

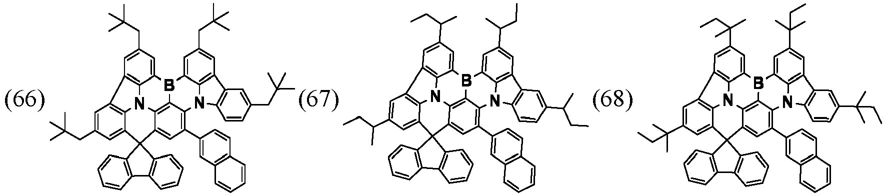

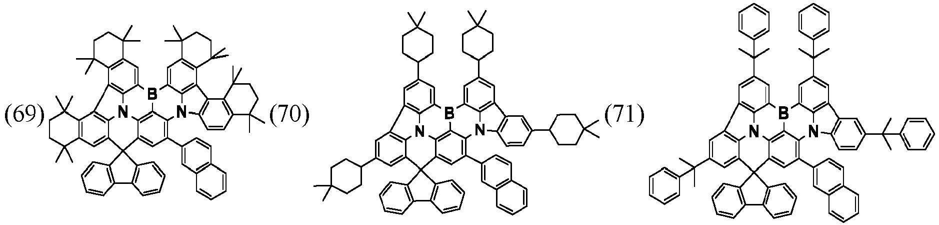

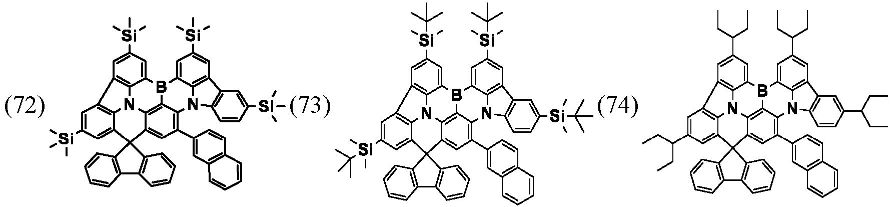

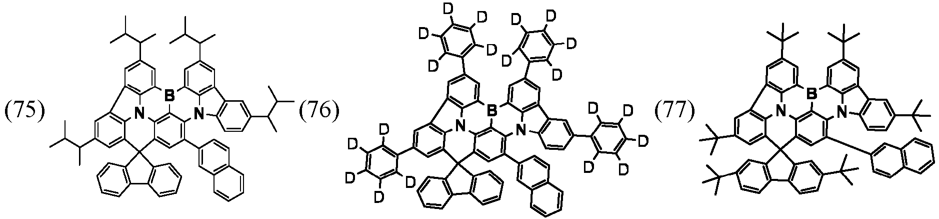

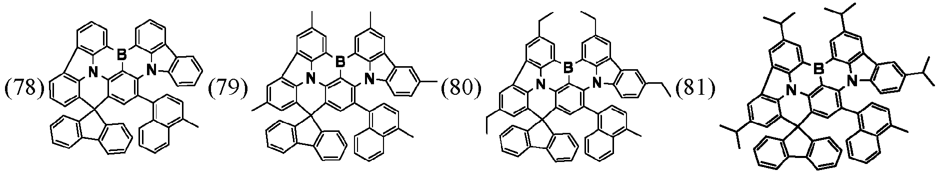

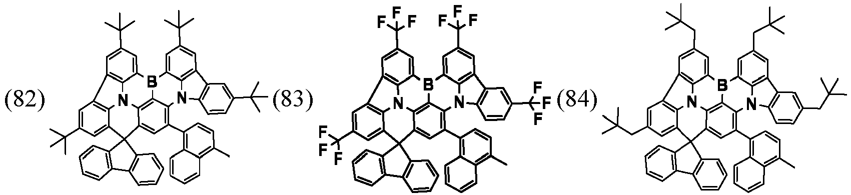

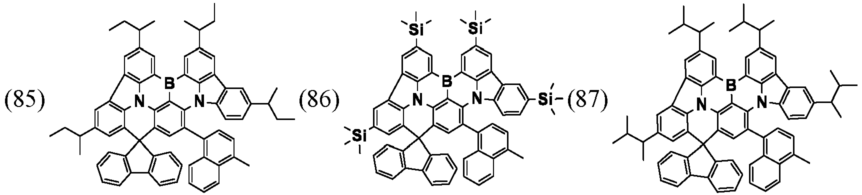

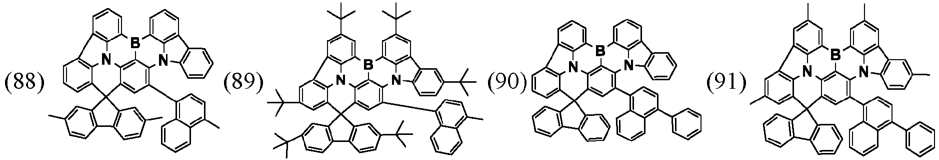

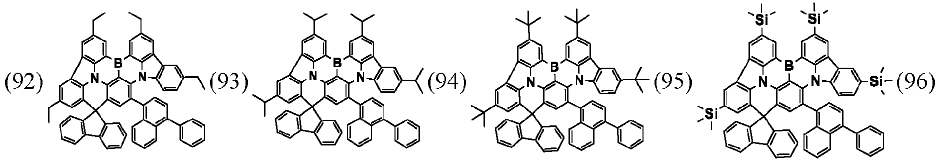

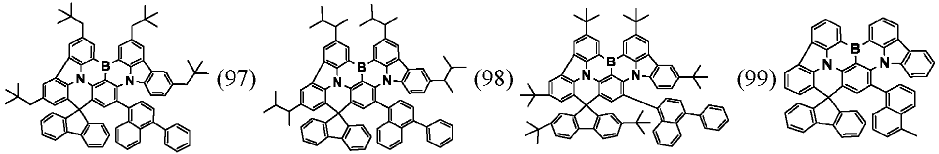

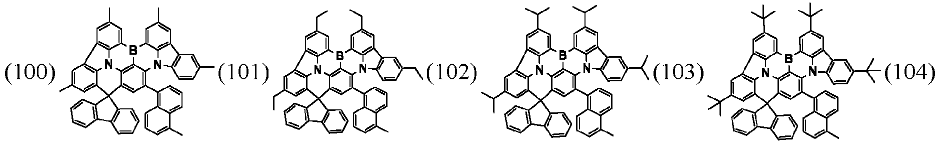

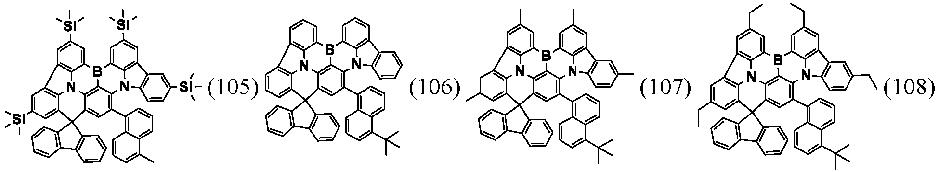

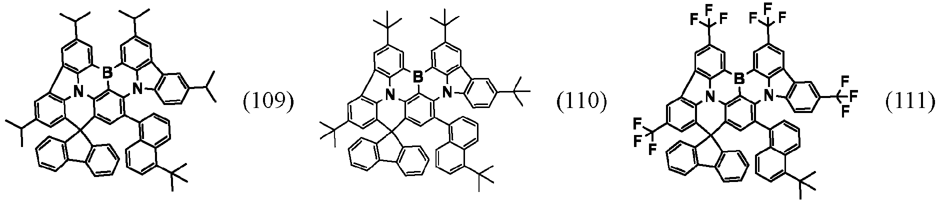

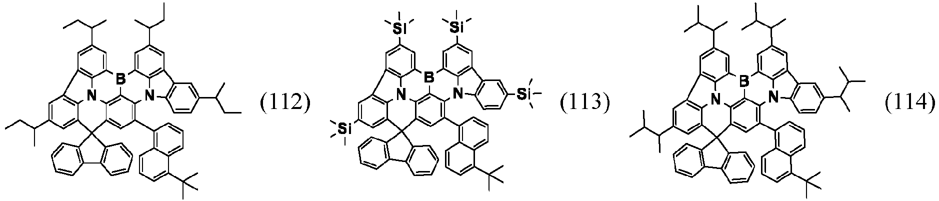

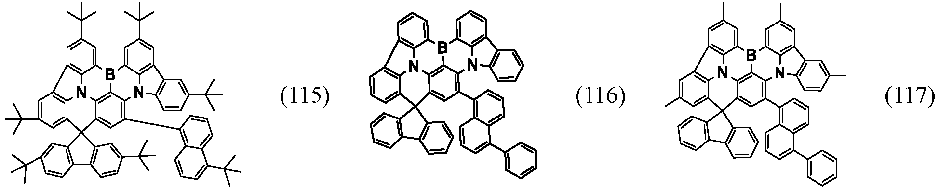

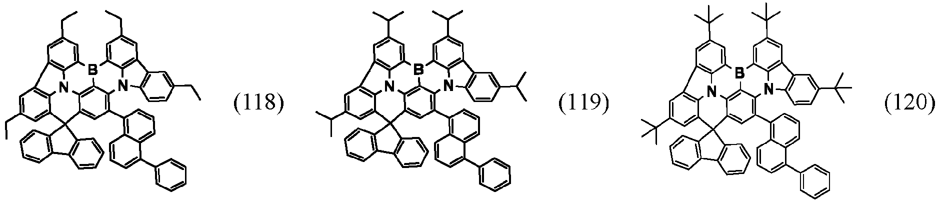

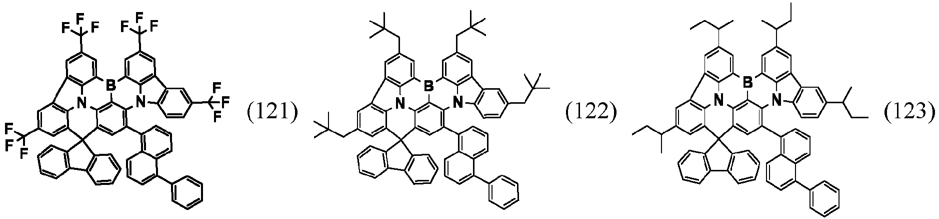

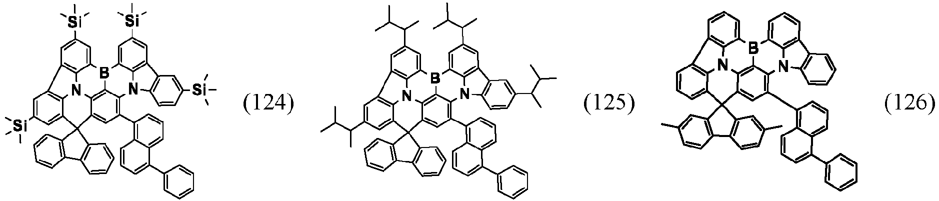

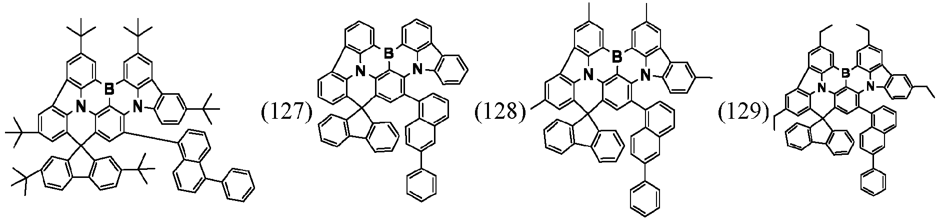

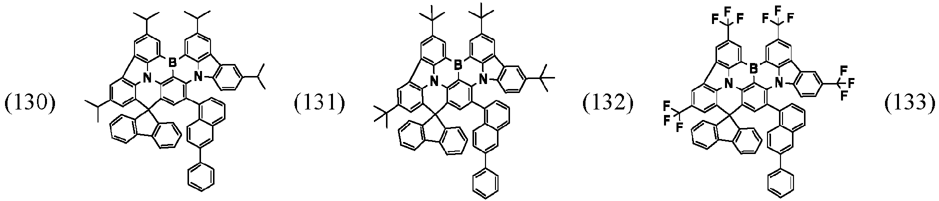

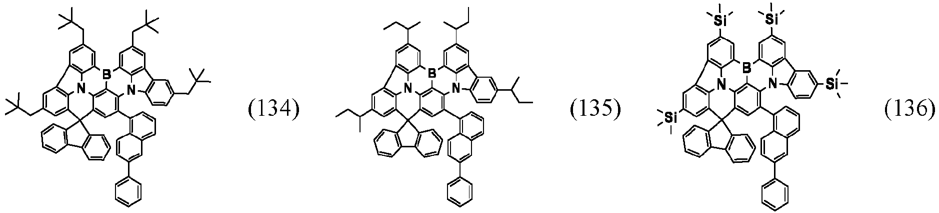

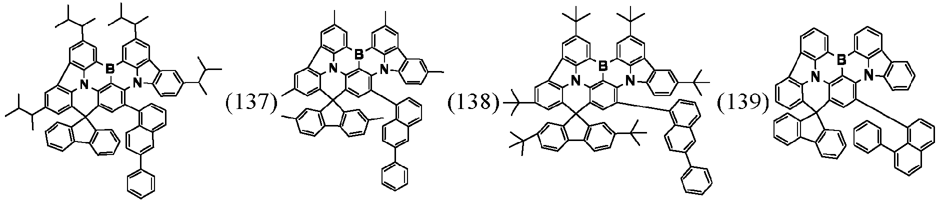

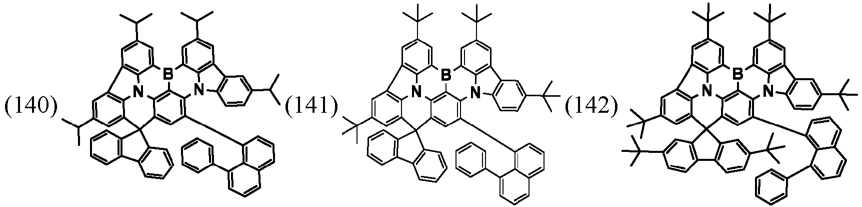

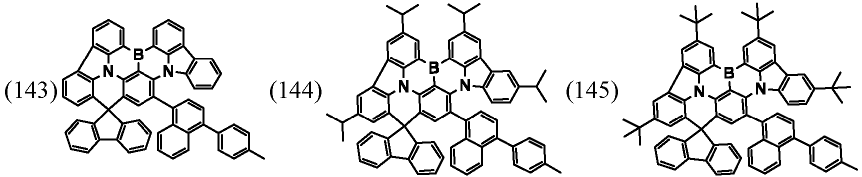

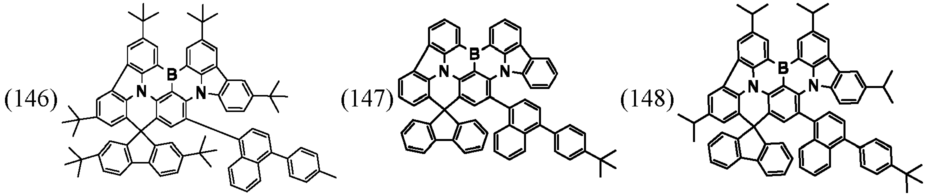

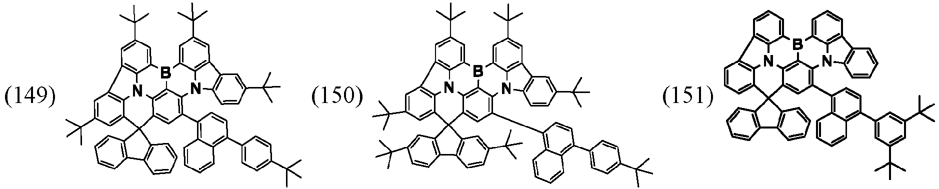

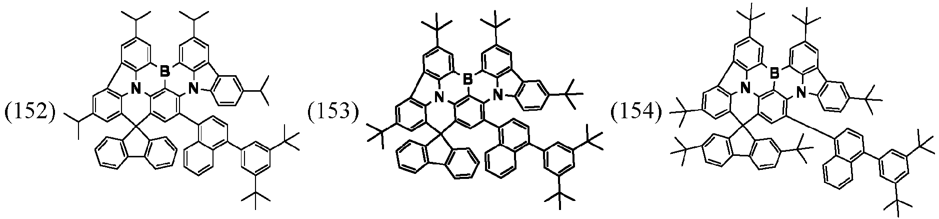

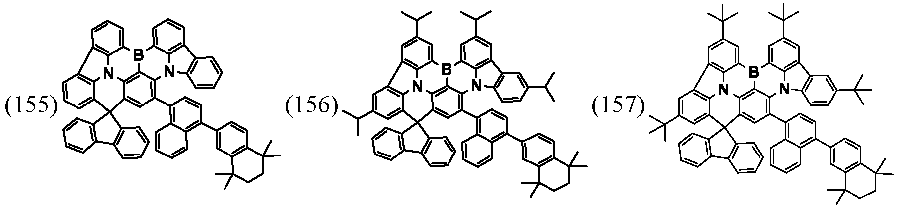

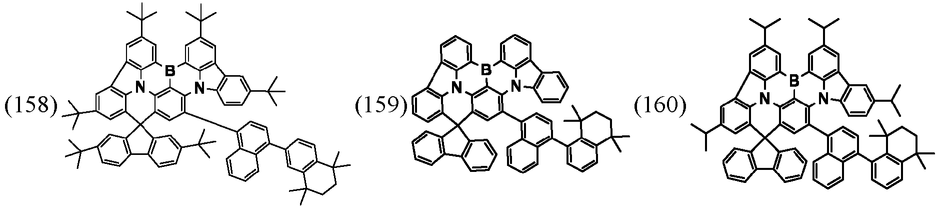

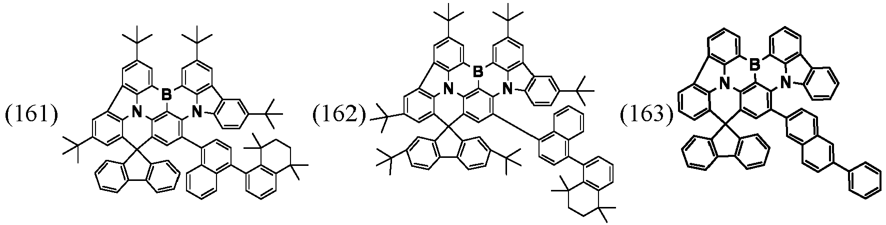

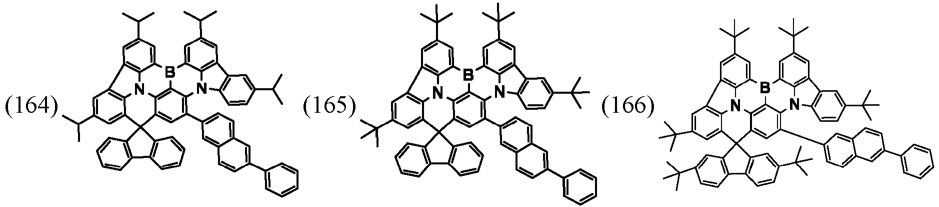

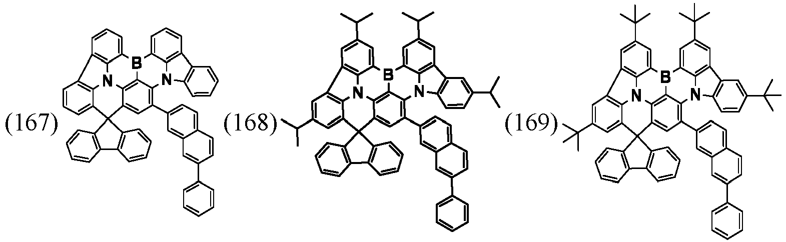

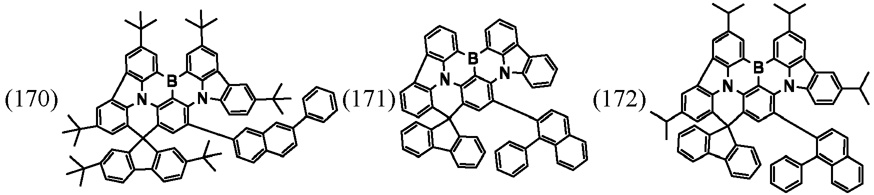

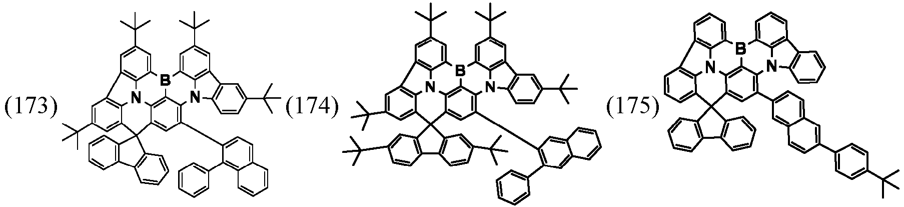

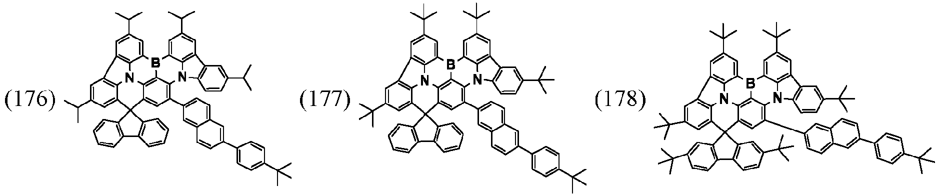

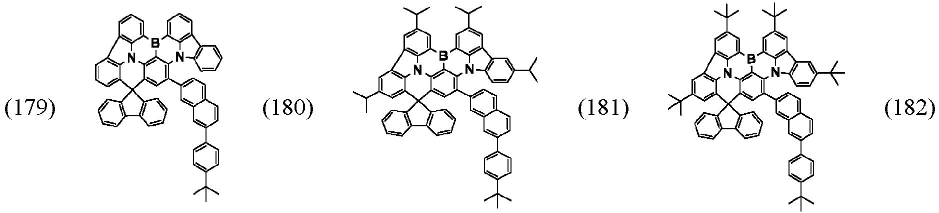

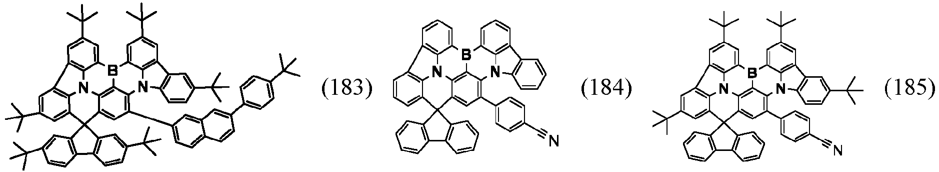

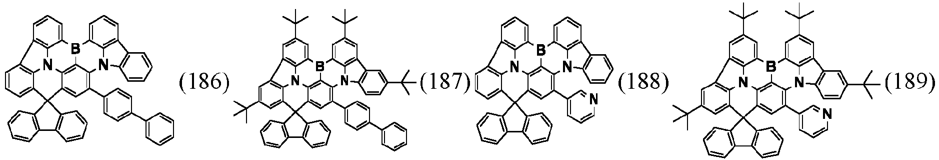

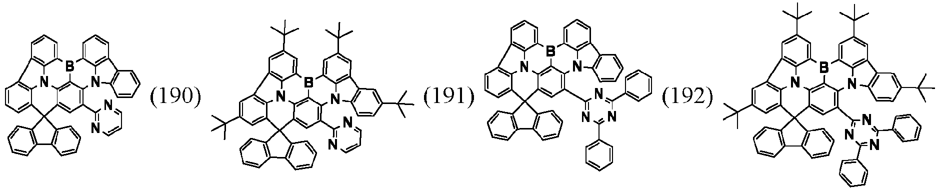

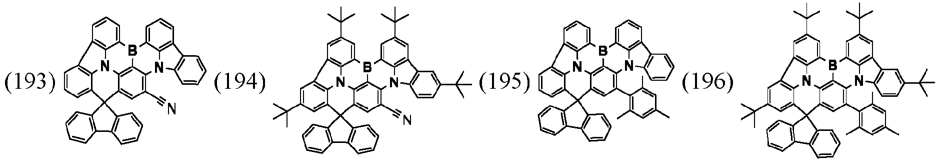

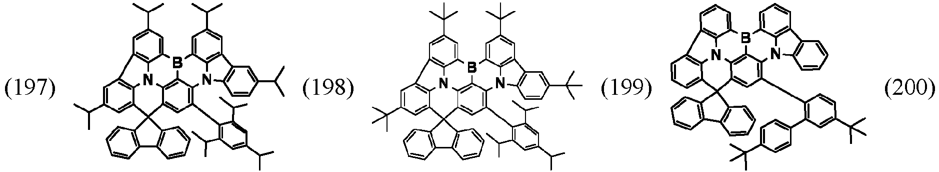

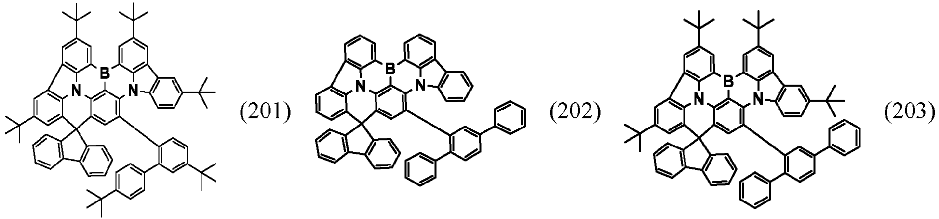

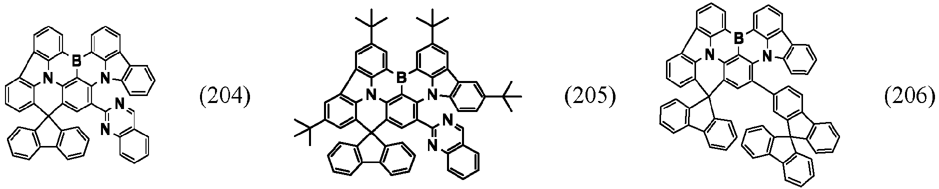

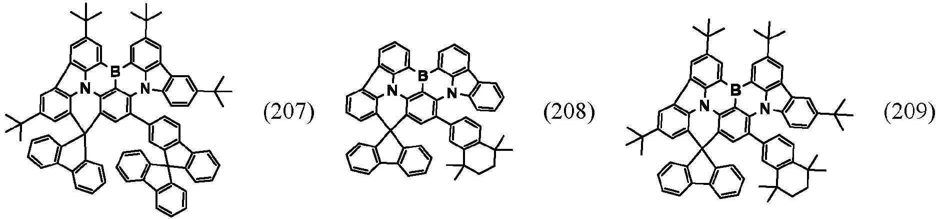

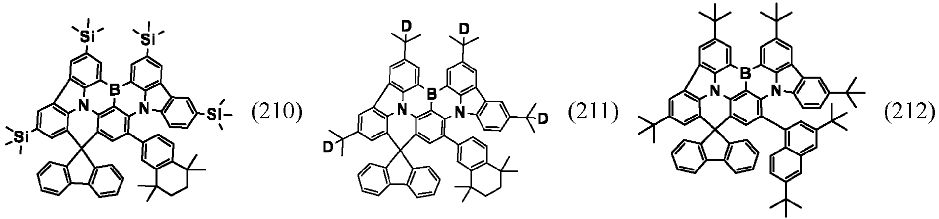

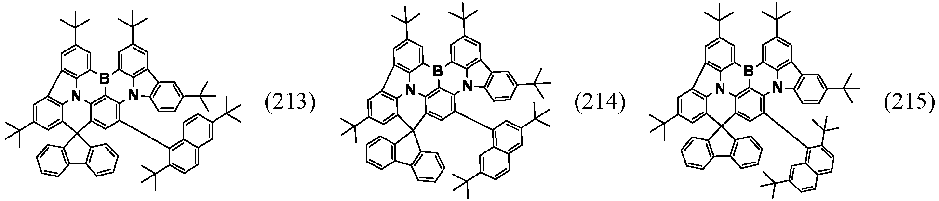

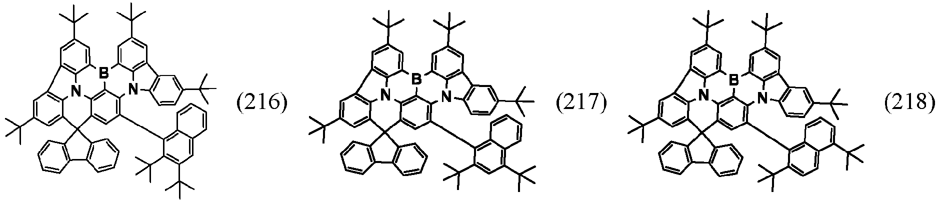

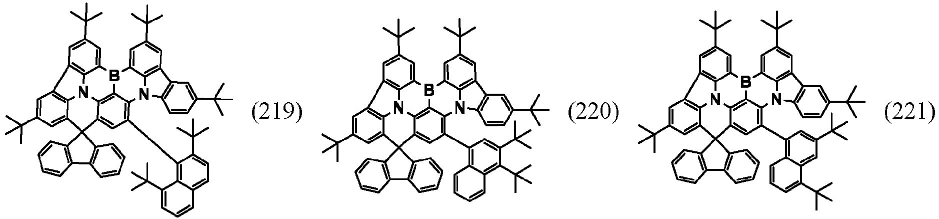

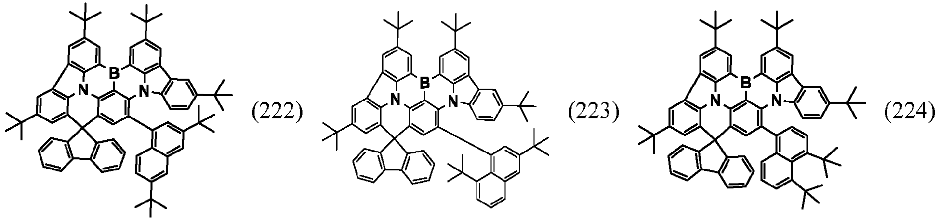

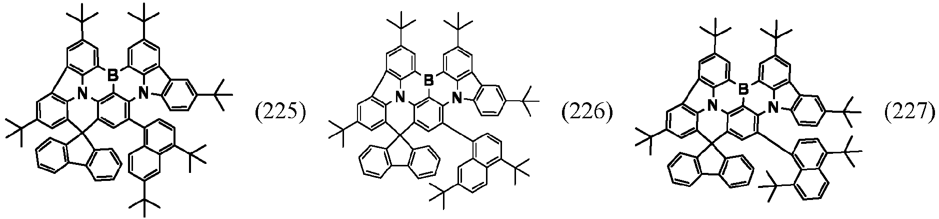

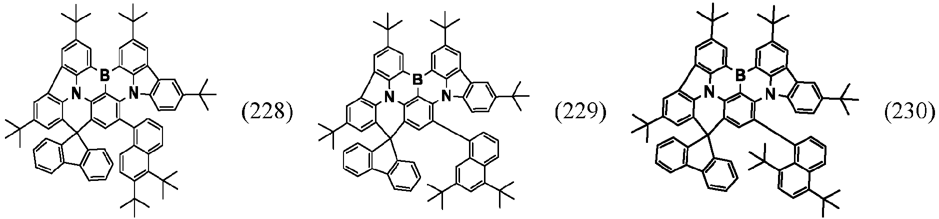

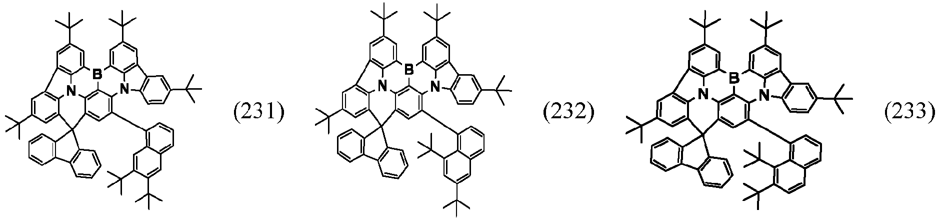

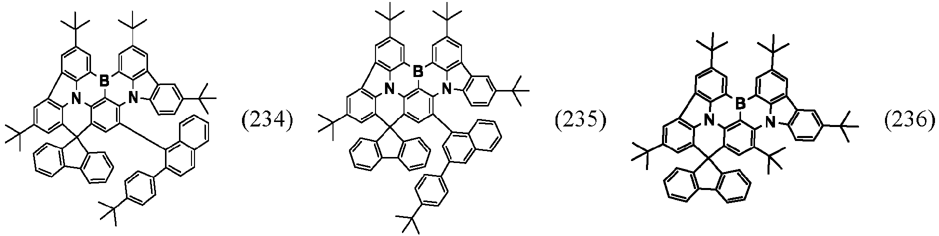

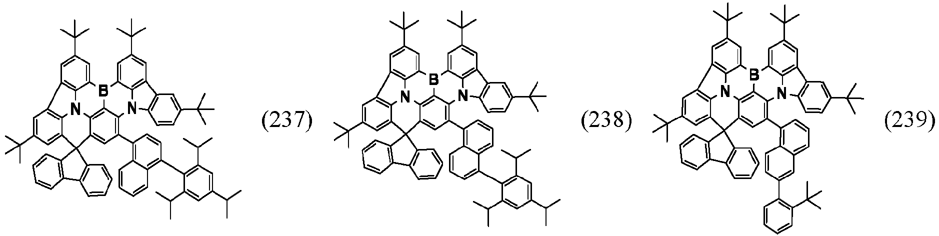

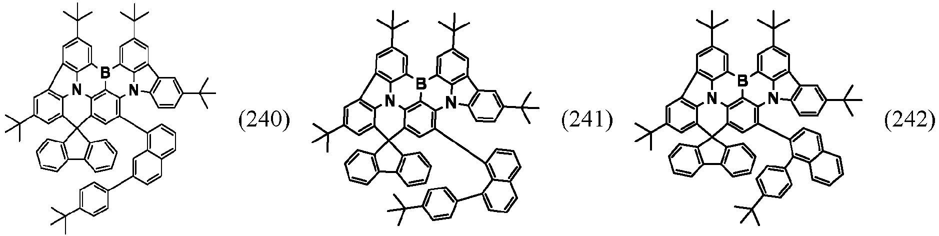

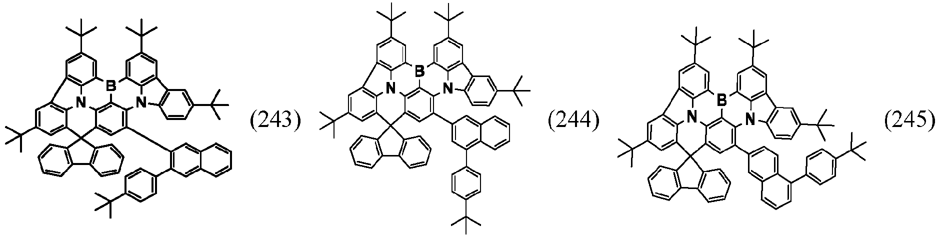

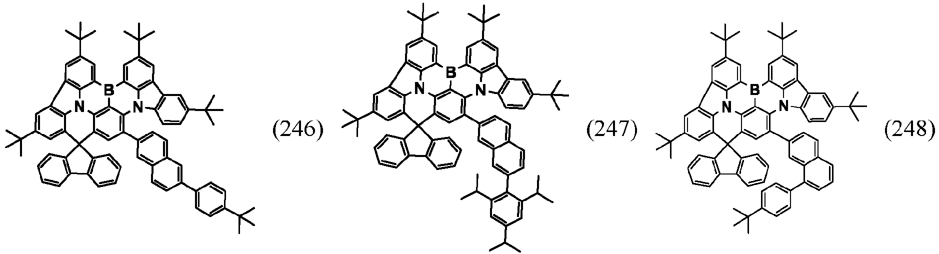

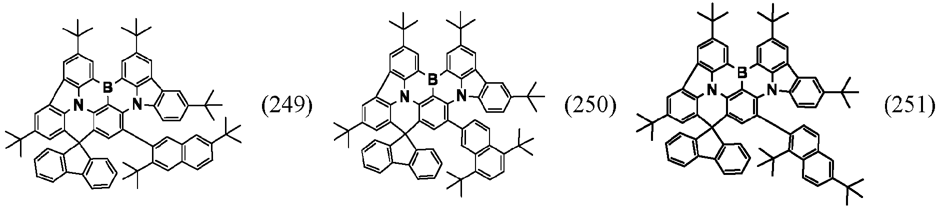

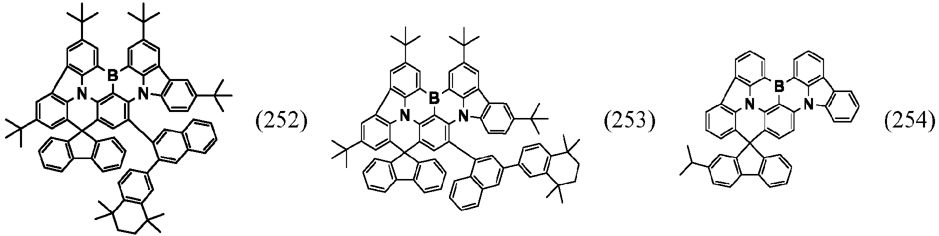

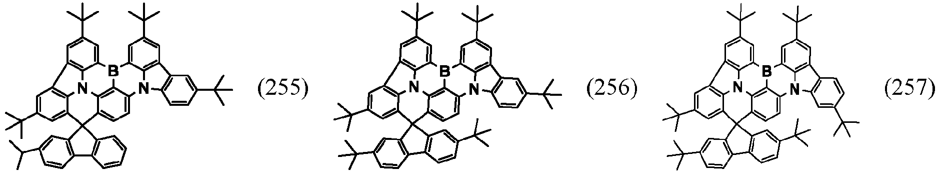

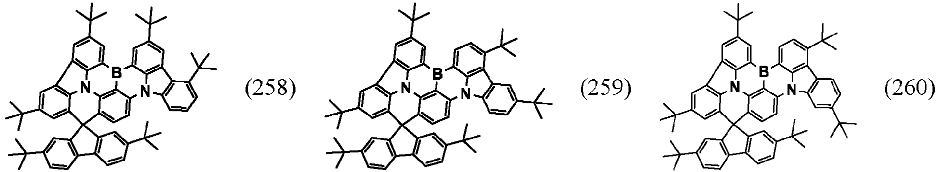

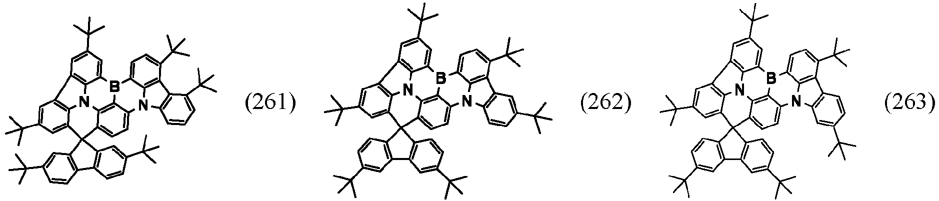

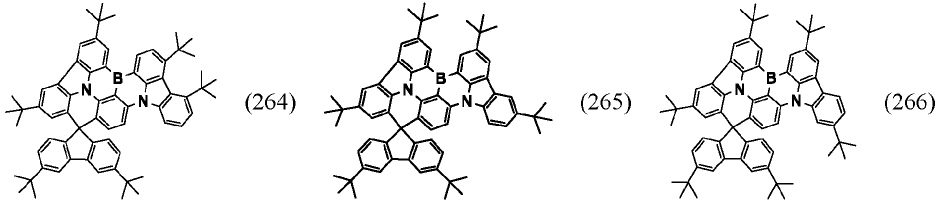

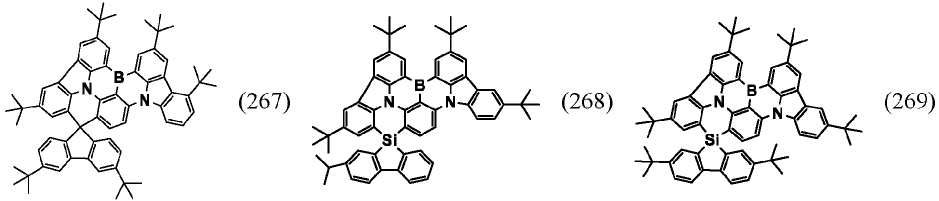

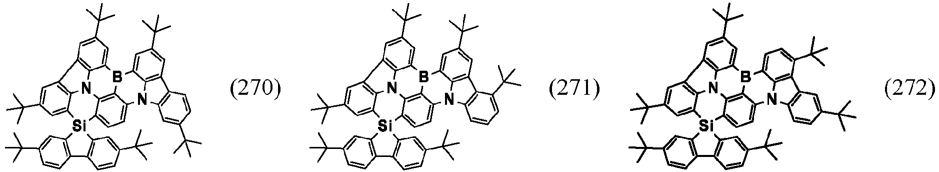

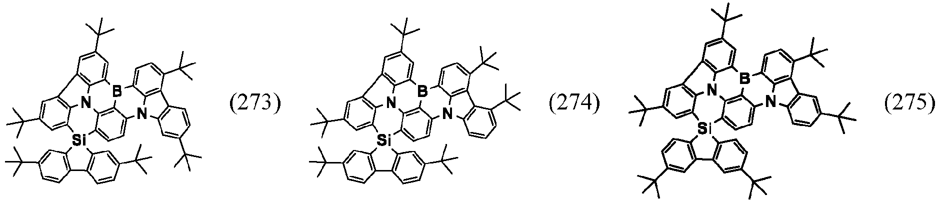

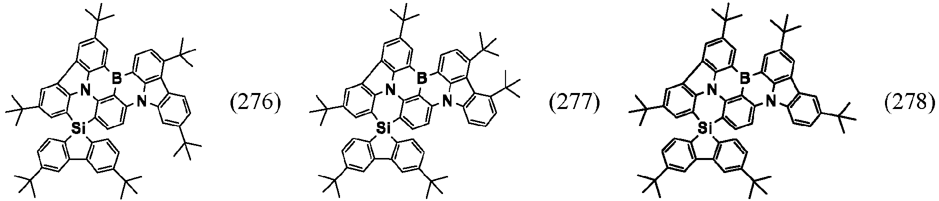

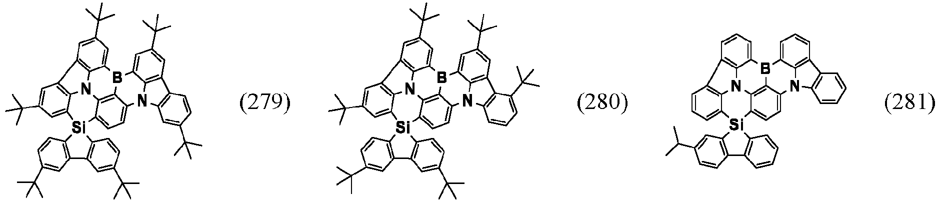

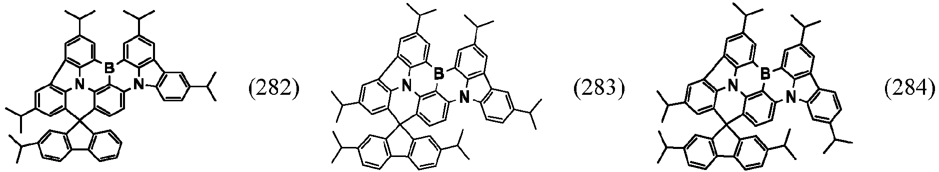

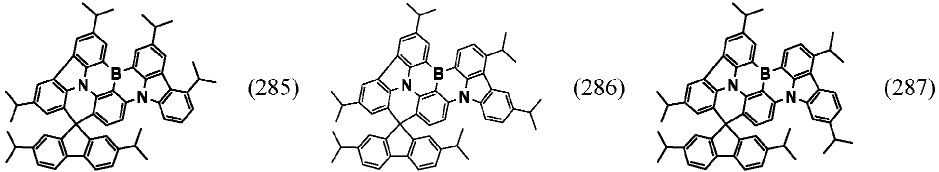

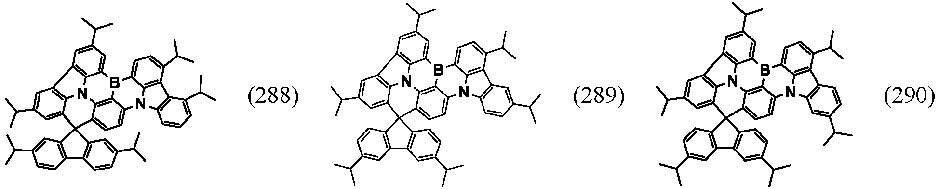

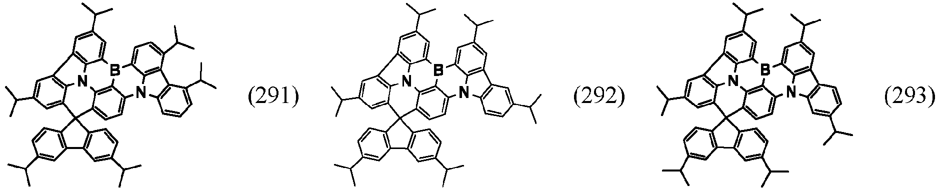

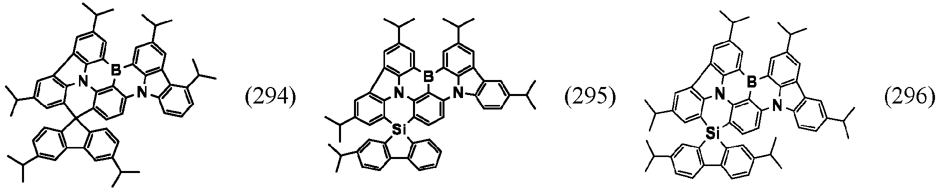

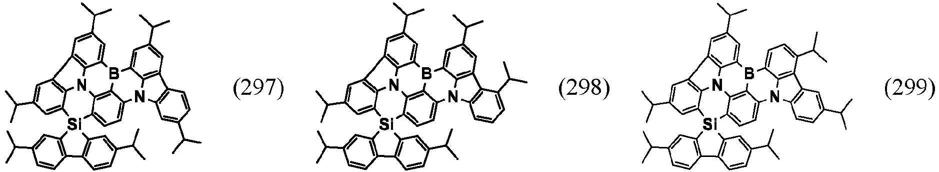

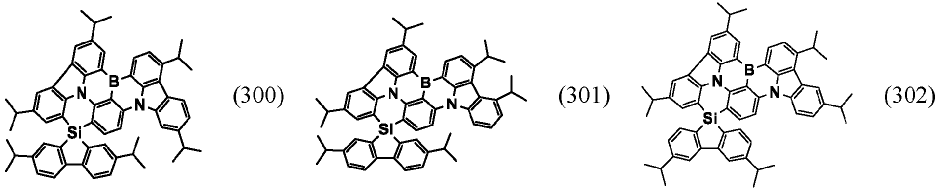

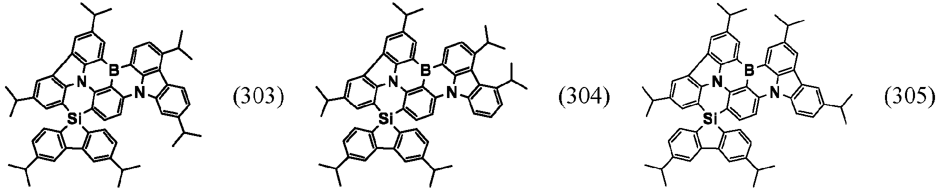

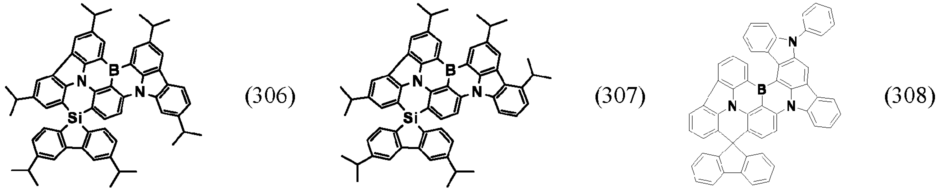

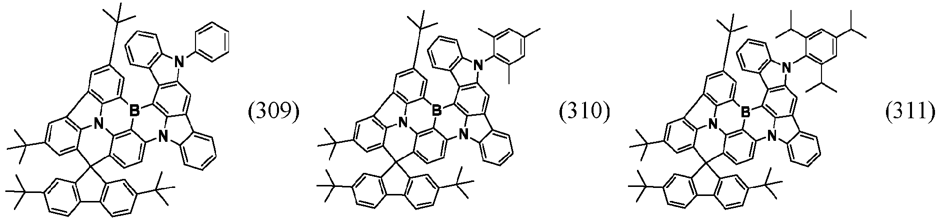

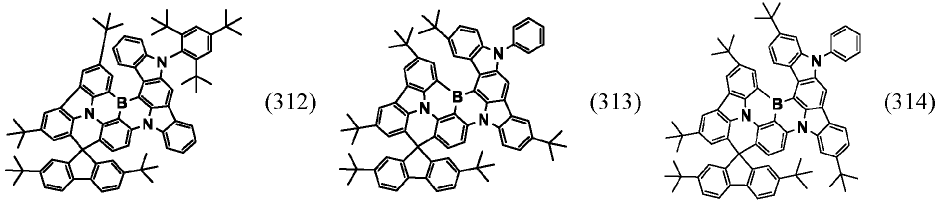

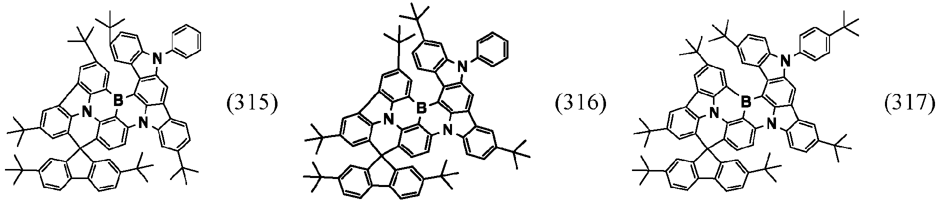

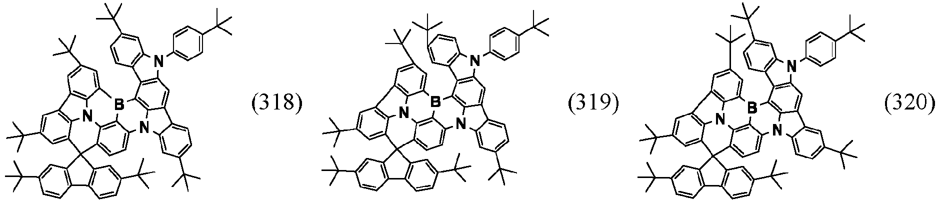

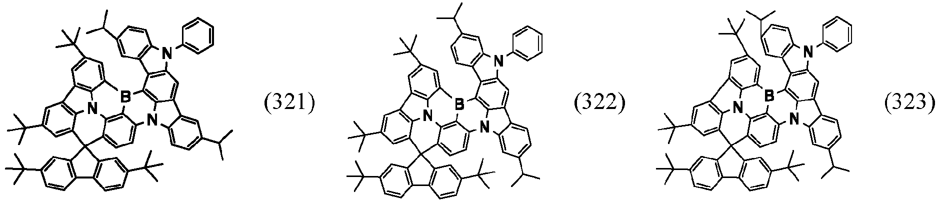

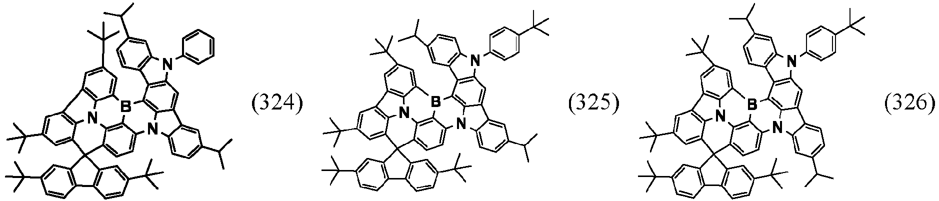

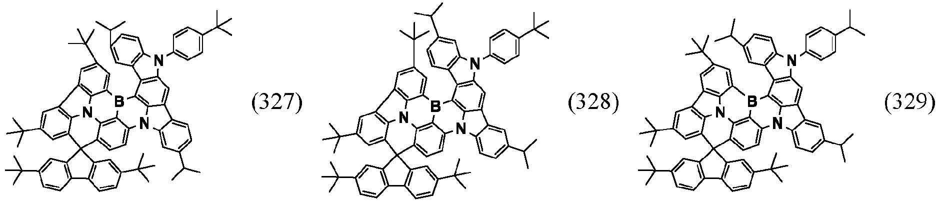

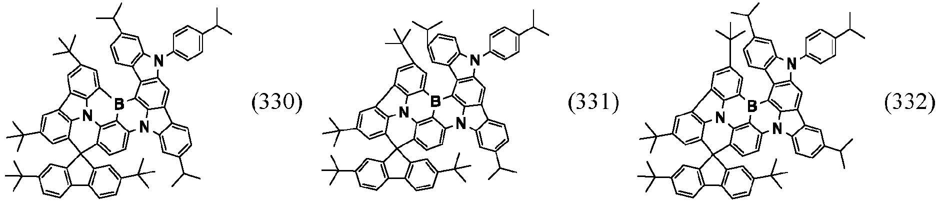

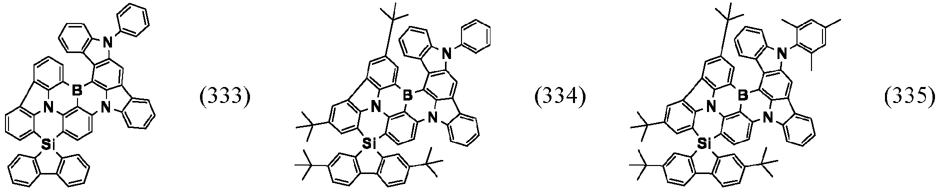

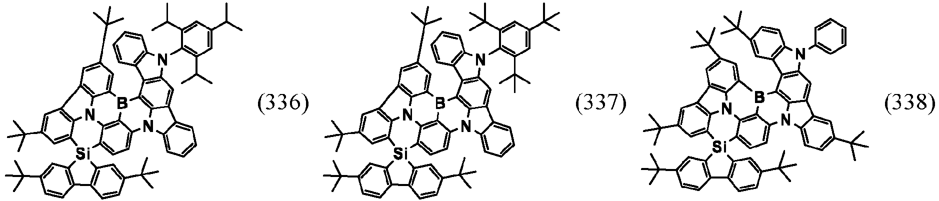

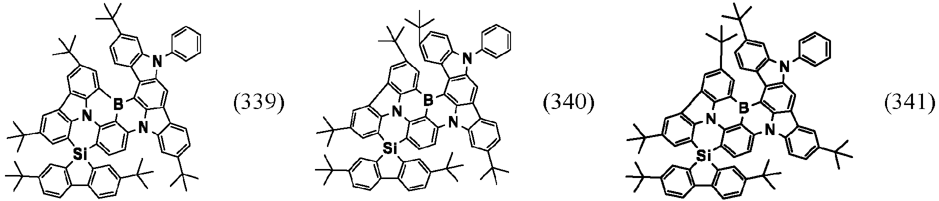

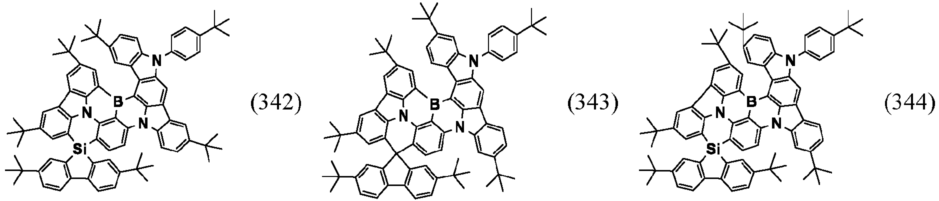

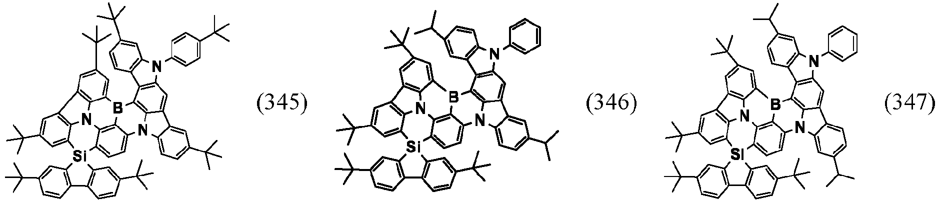

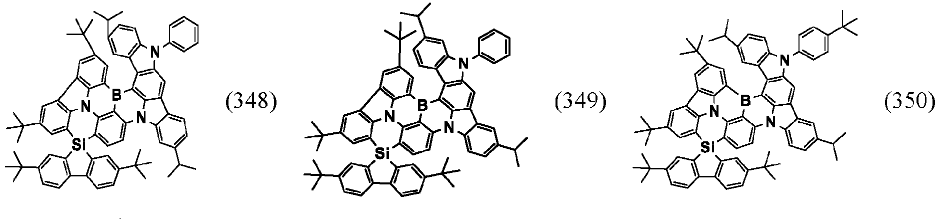

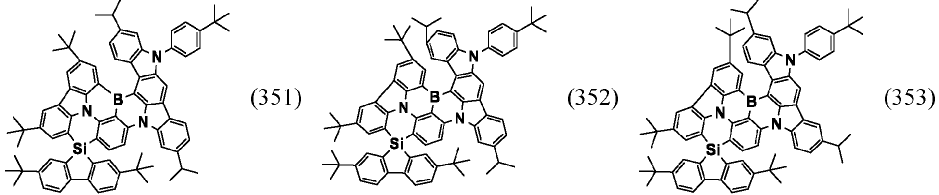

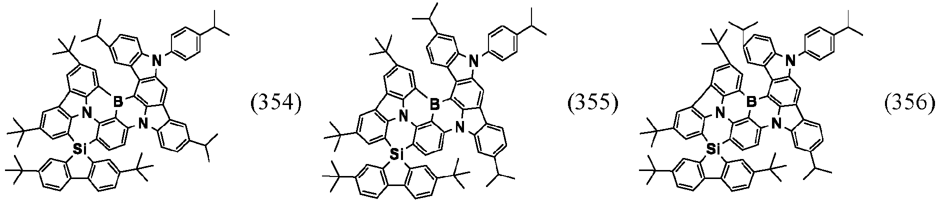

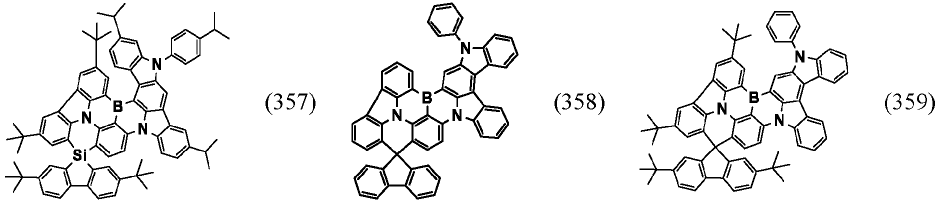

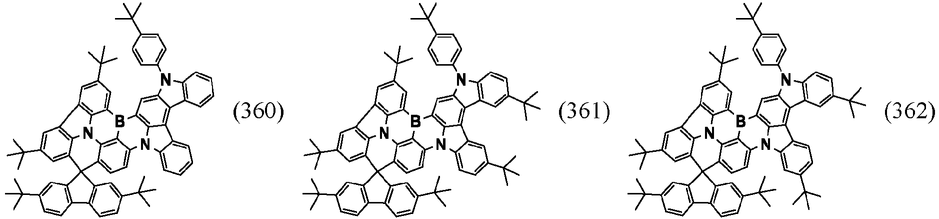

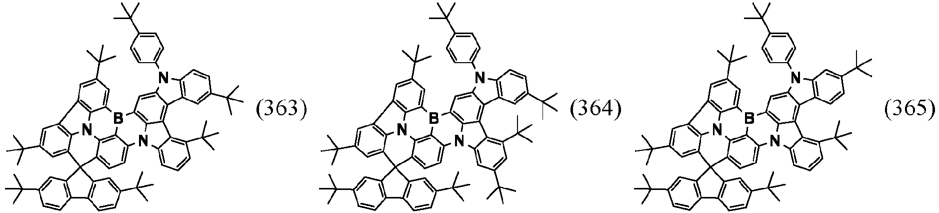

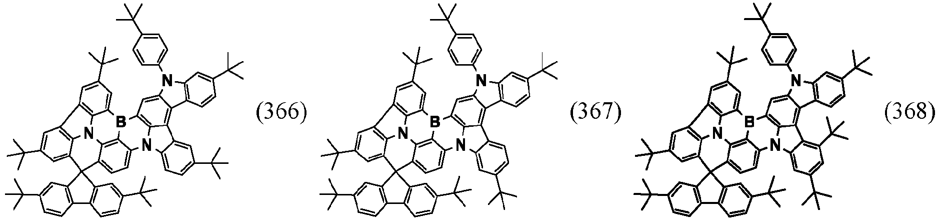

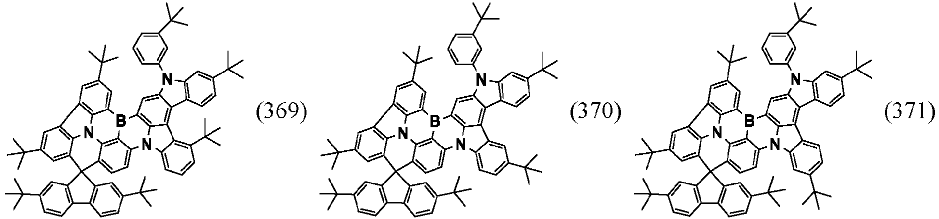

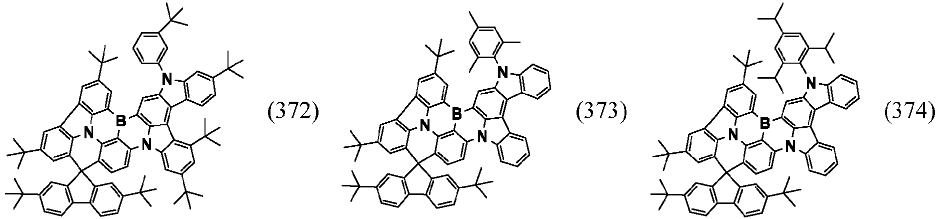

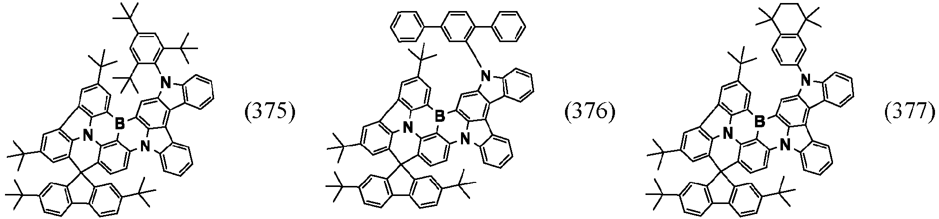

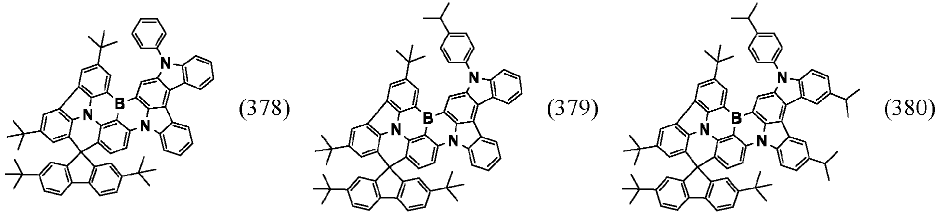

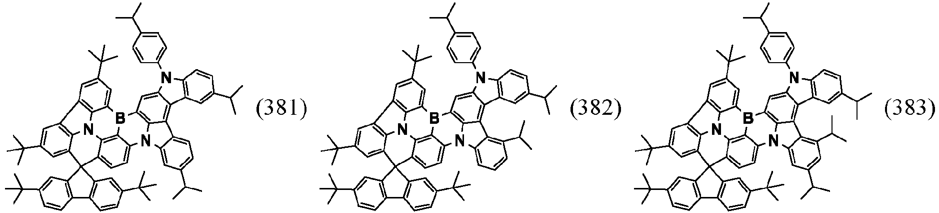

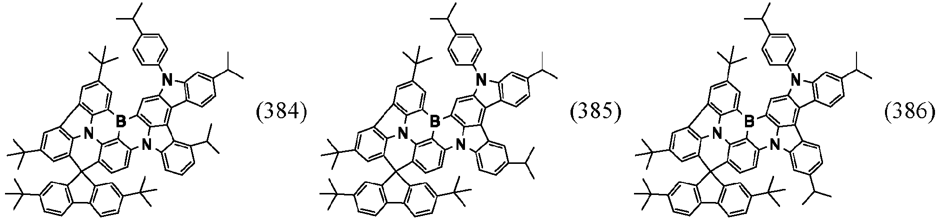

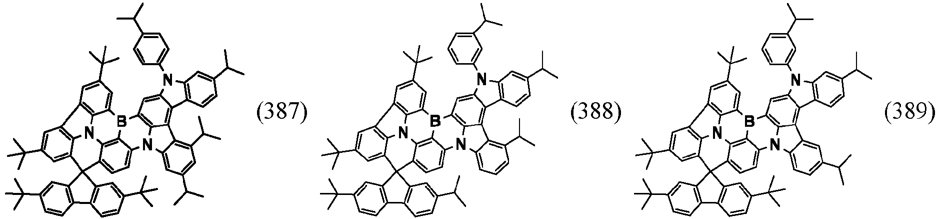

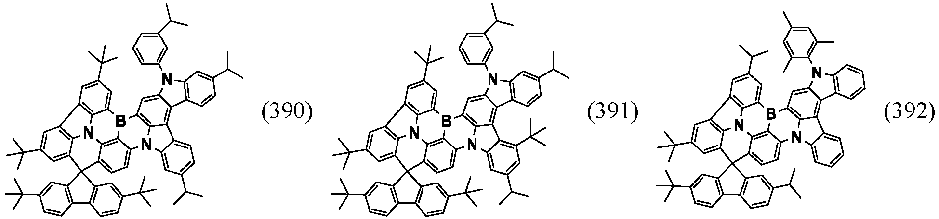

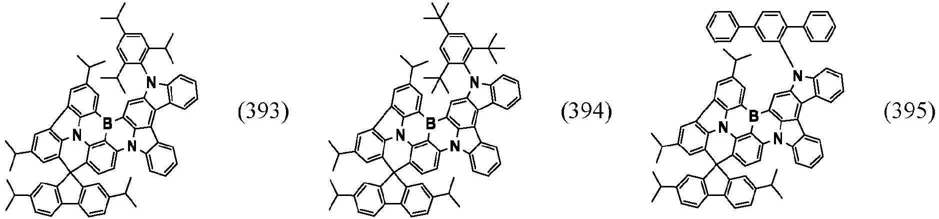

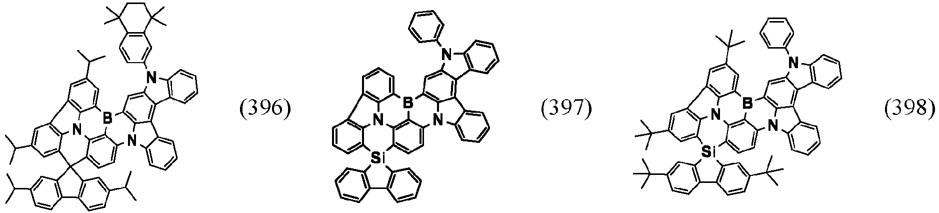

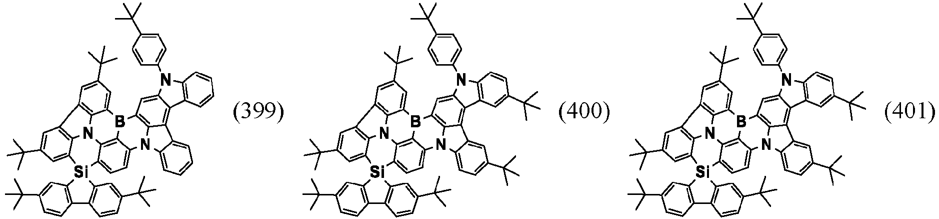

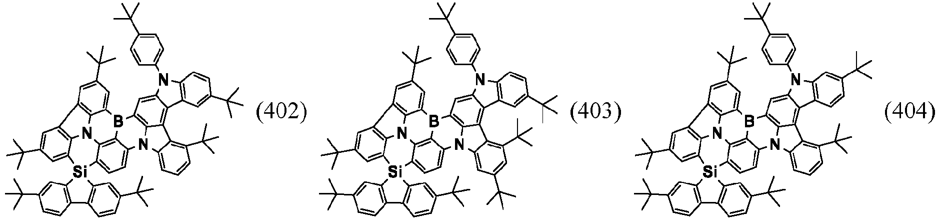

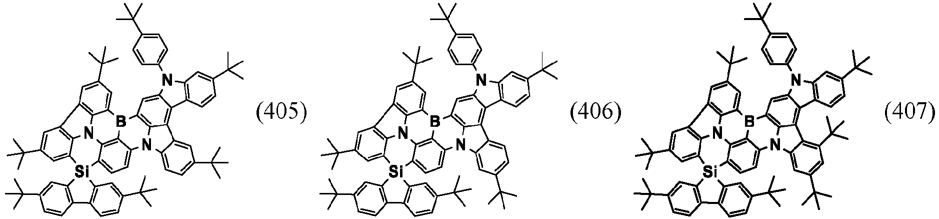

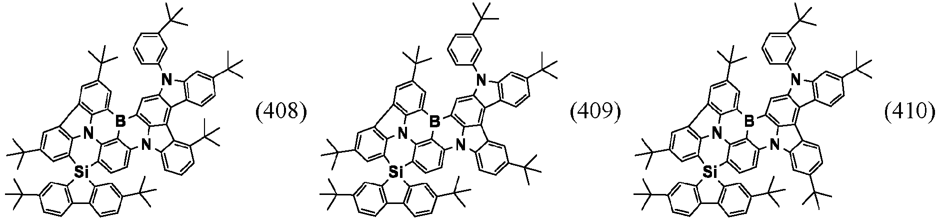

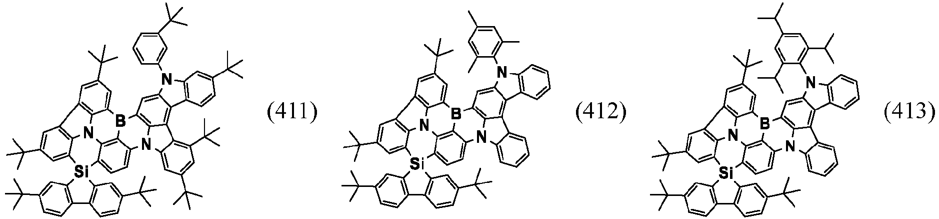

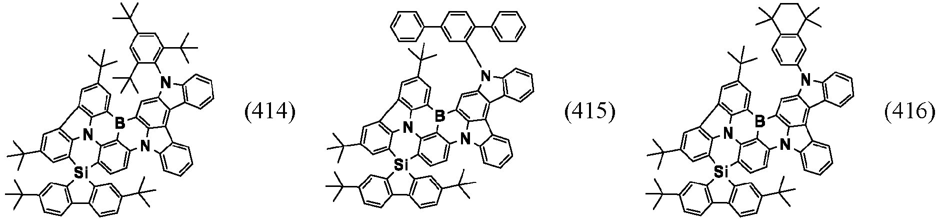

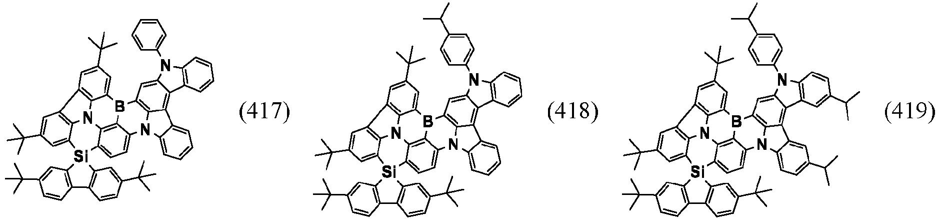

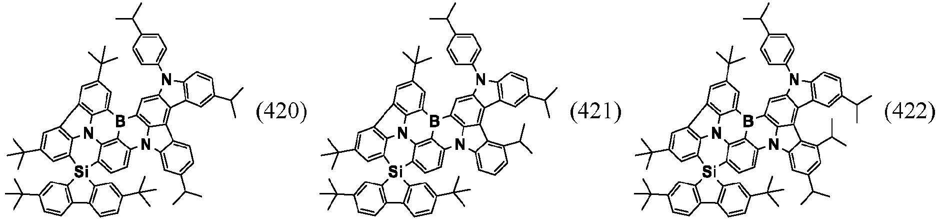

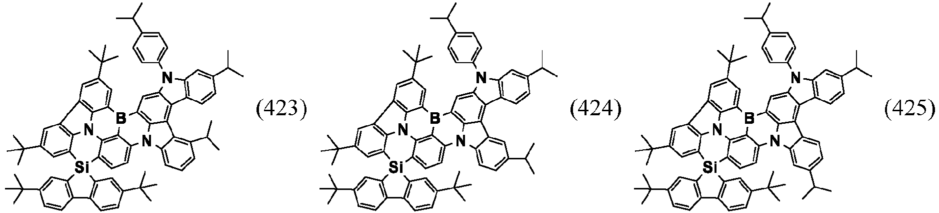

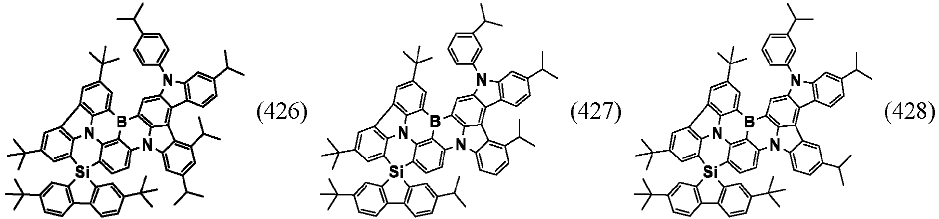

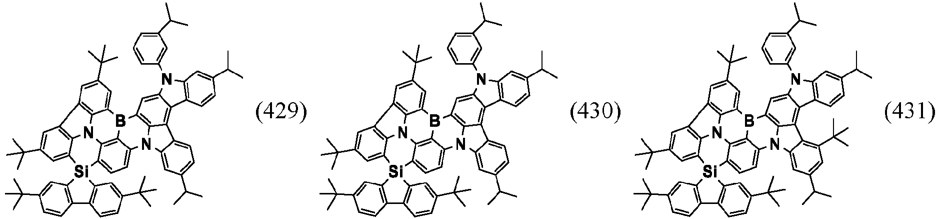

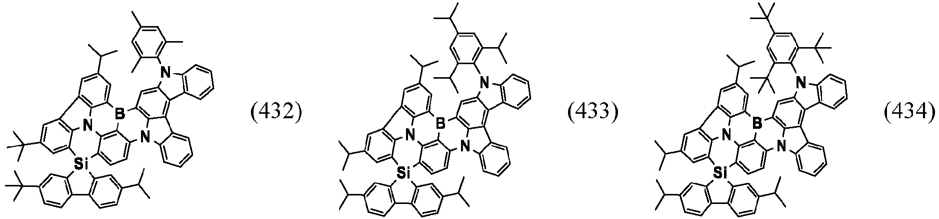

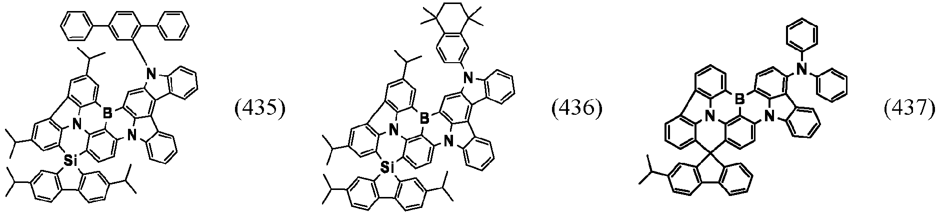

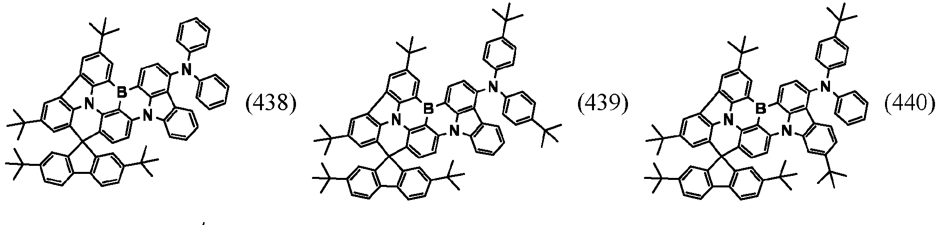

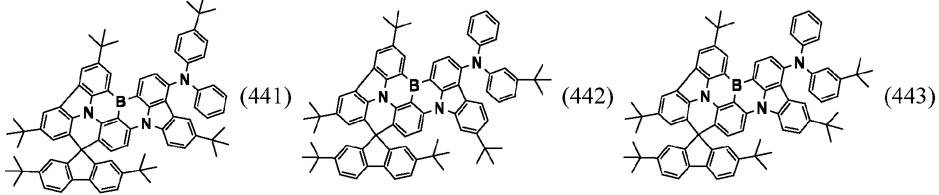

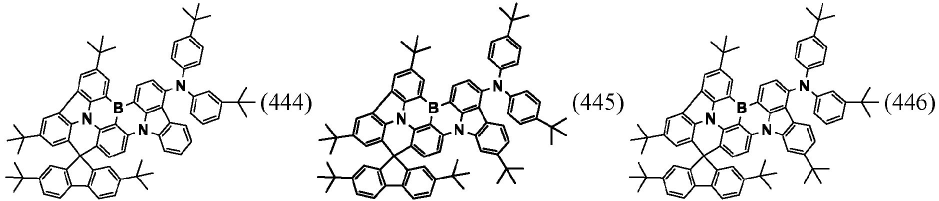

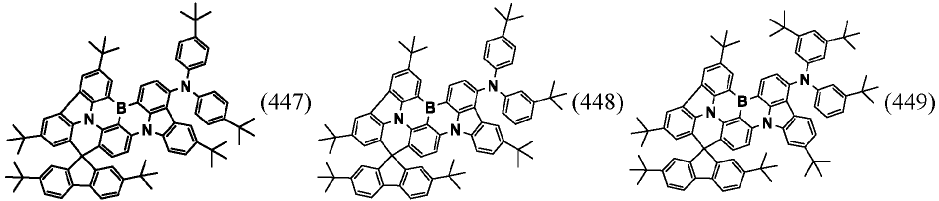

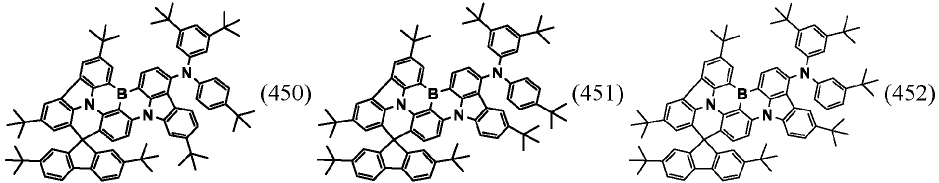

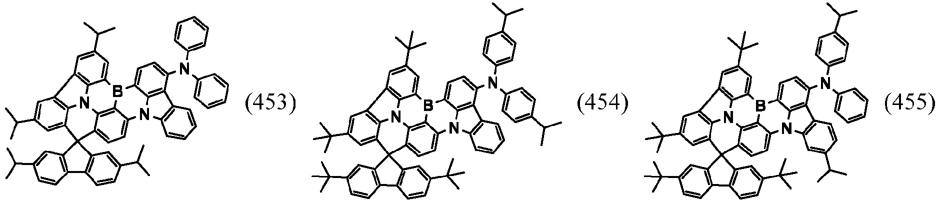

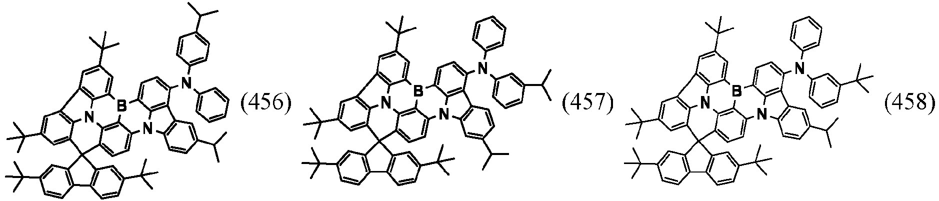

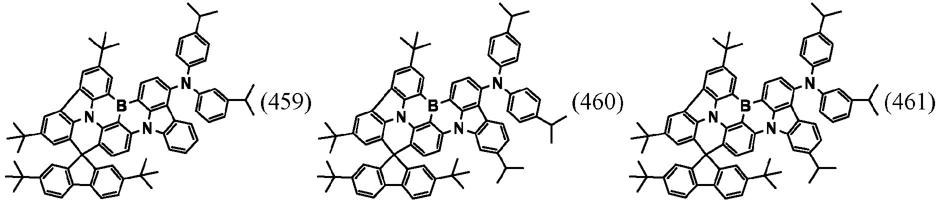

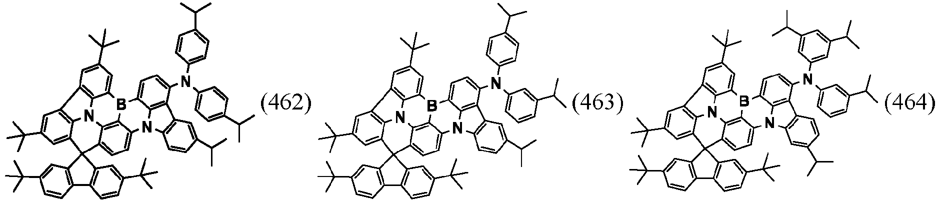

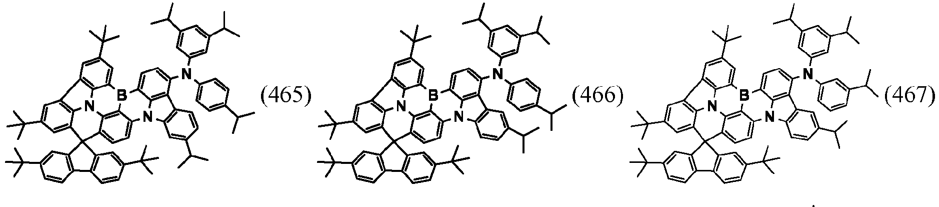

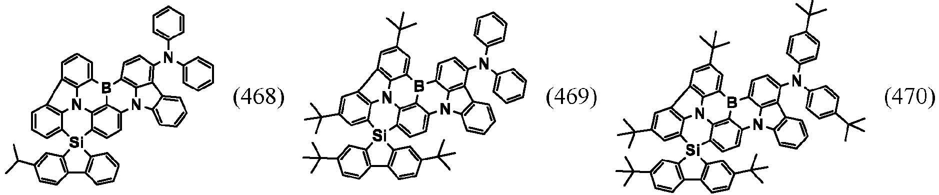

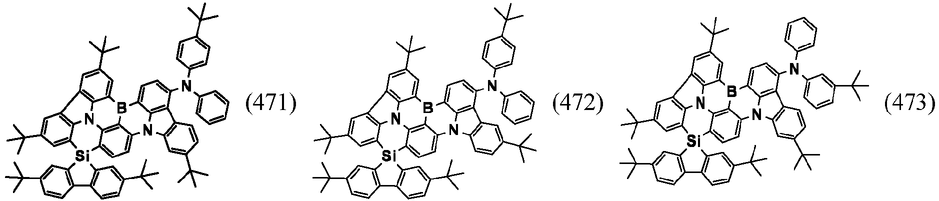

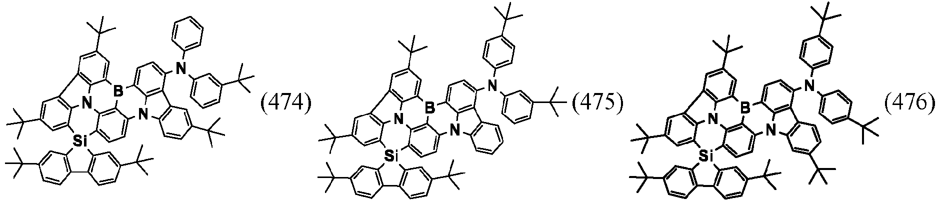

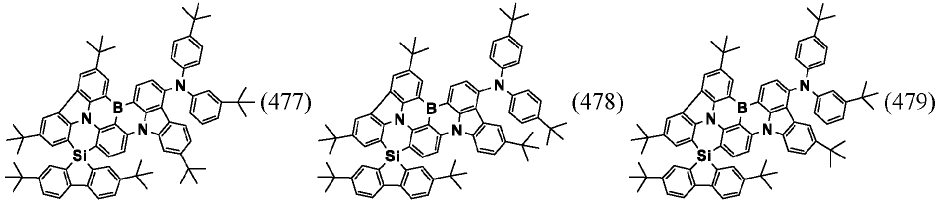

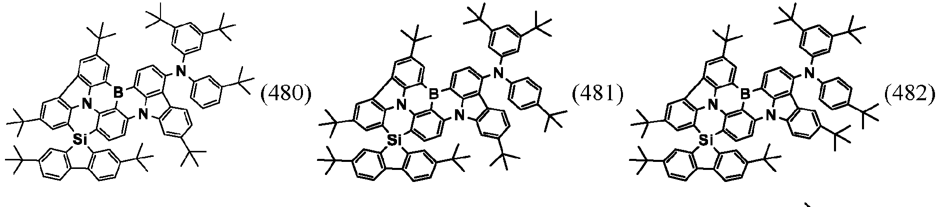

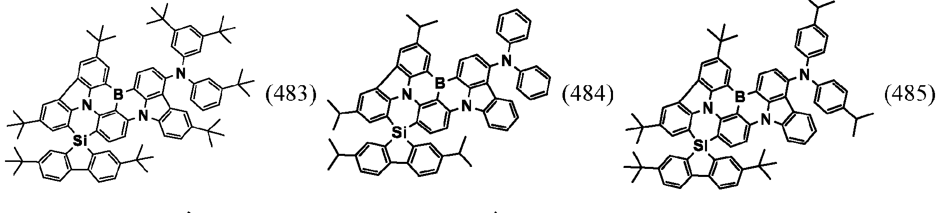

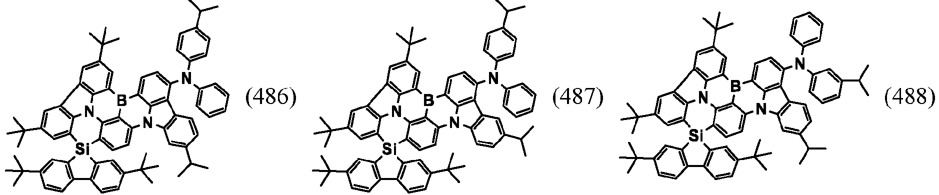

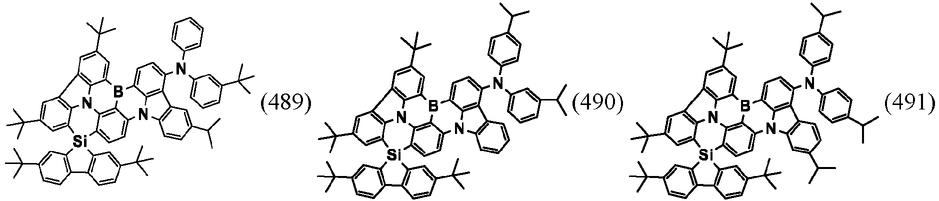

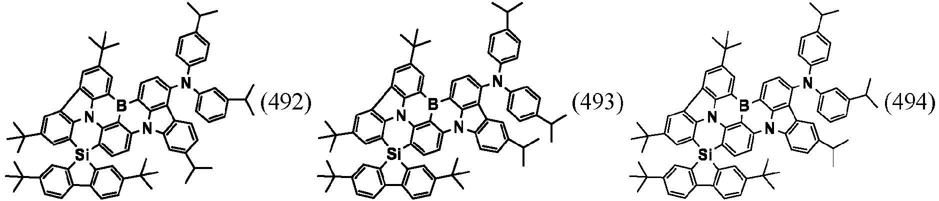

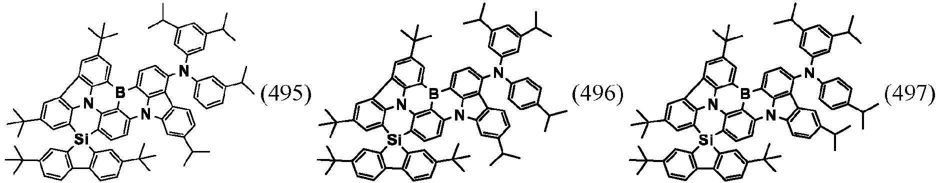

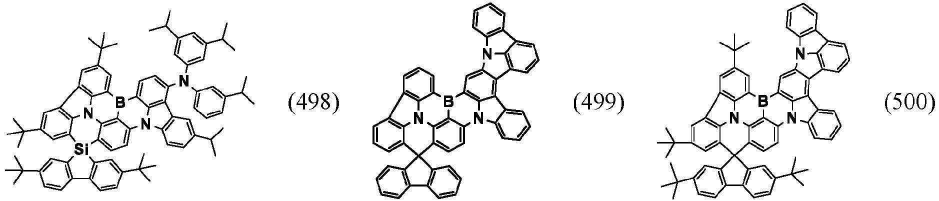

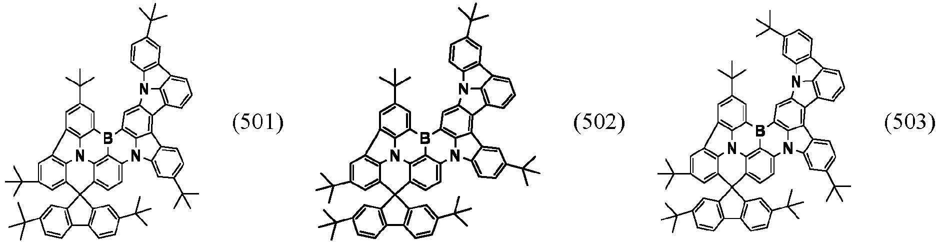

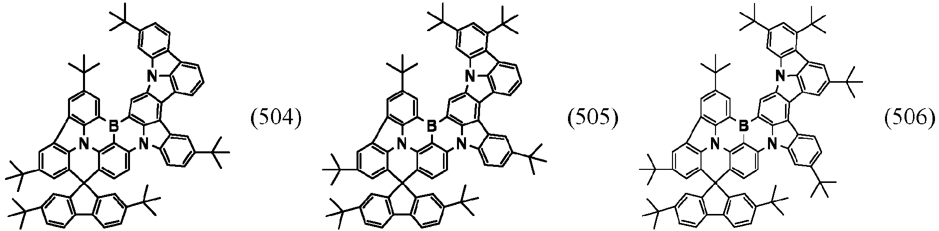

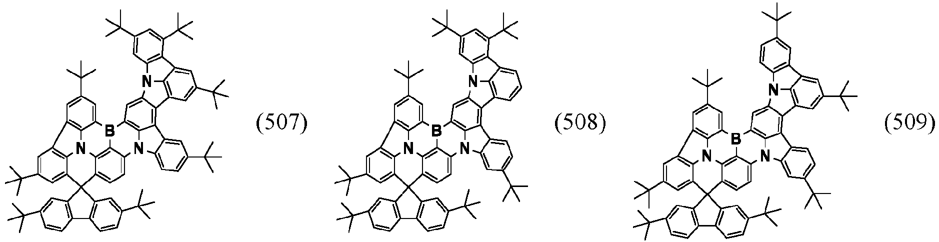

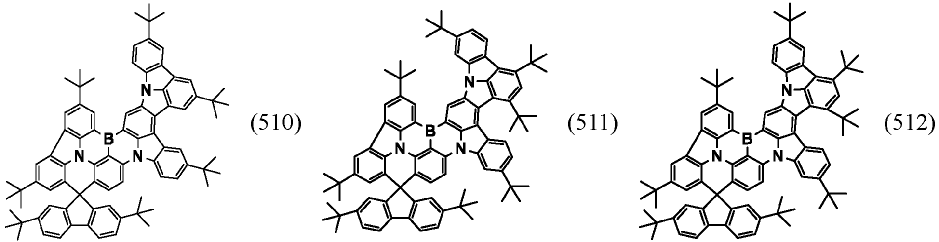

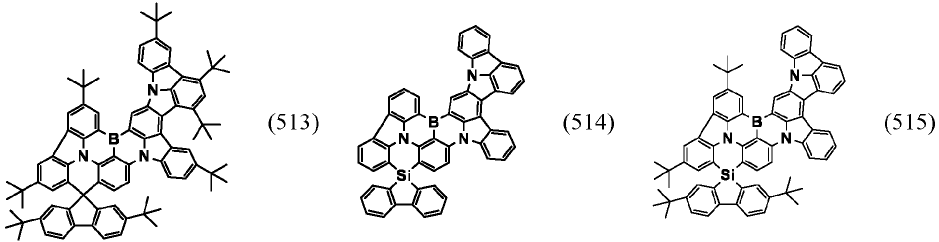

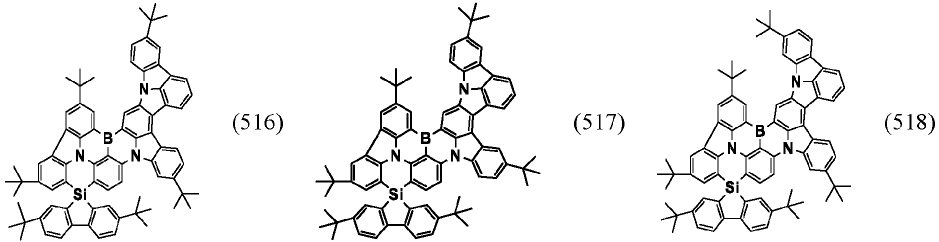

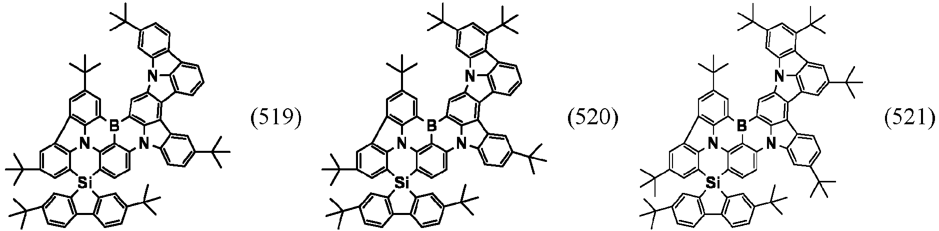

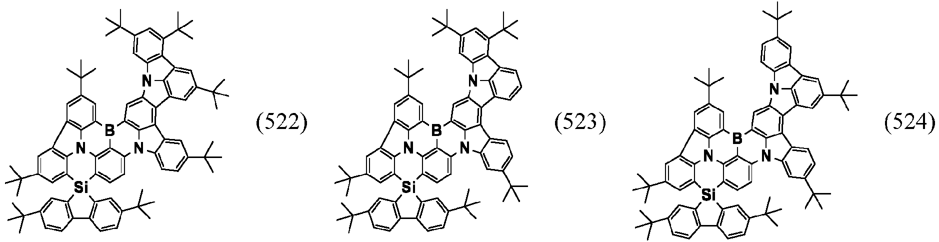

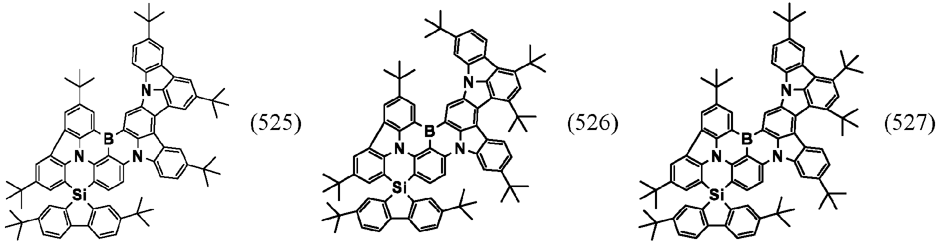

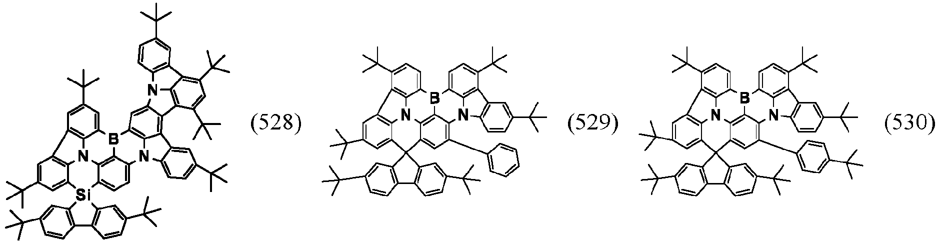

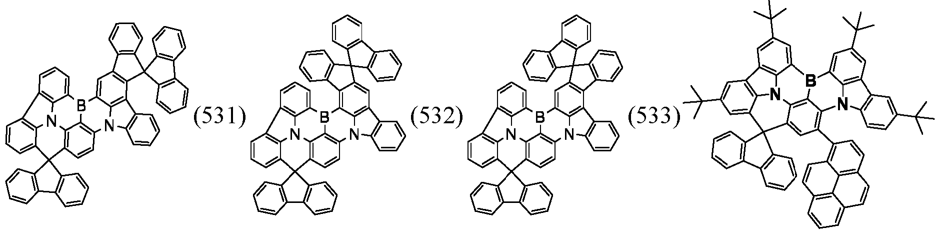

15. An organic light-emitting device, comprising a substrate, a first electrode, a second electrode, and a functional layer sequentially, wherein the functional layer is located between the first electrode and the second electrode, and the functional layer comprises the boron-containing resonance organic compound according to any one of claims 1 to 14.

16. The organic light-emitting device according to claim 15, wherein the functional layer comprises a light-emitting layer, the light-emitting layer comprises a host material and a doping material, and the doping material is the boron-containing resonance organic compound according to any one of claims 1 to 14.

17. The organic light-emitting device according to claim 15, wherein the functional layer comprises a light-emitting layer, the light-emitting layer comprises a first host material, a second host material, and a doping material, at least one of the first host material and the second host material is a TADF material, and the doping material is the boron-containing resonance organic compound according to any one of claims 1 to 14.

18. The organic light-emitting device according to claim 15, wherein the functional layer comprises a light-emitting layer, the light-emitting layer comprises a host material, an exciton-sensitizing material, and a doping material, the exciton-sensitizing material is a complex containing a metal element, and the doping material is the boron-containing resonance organic compound according to any one of claims 1 to 14.

19. A material for an organic electroluminescent device, comprising the boron-containing resonance organic compound according to any one of claims 1 to 14.

20. Use of the boron-containing resonance organic compound according to any one of claims 1 to 14, in an organic electroluminescent device.

21. The use according to claim 20, wherein the organic light-emitting functional layer comprises a light-emitting layer, and the boron-containing resonance organic compound according to any one of claims 1 to 14 is used in the light-emitting layer.

22. A display component, comprising the organic light-emitting device according to any one of claims 15 to 18.

23. A lighting apparatus, comprising the organic light-emitting device according to any one of claims 15 to 18.

24. An electronic device, carrying the organic light-emitting device according to any one of claims 15 to 18.
